# EUROPEAN PATENT SPECIFICATION

(11) **EP 3 792 270 B1**
(45) Date of publication and mention of the grant of the patent: **13.12.2023**
(21) Application number: 20195031.8
(22) Date of filing: 08.09.2020
(51) Int. Cl.: C07F 15/00, H10K 85/30, H10K 85/40, C09K 11/06, H10K 101/10, H05B 33/14

(54) **ORGANOMETALLIC COMPOUND, ORGANIC LIGHT-EMITTING DEVICE INCLUDING THE SAME AND ELECTRONIC APPARATUS INCLUDING THE ORGANIC LIGHT-EMITTING DEVICE**
ORGANOMETALLISCHE VERBINDUNG, ORGANISCHE LICHTEMITTIERENDE VORRICHTUNG DAMIT UND ELEKTRONISCHE VORRICHTUNG MIT DER ORGANISCHEN LICHTEMITTIERENDEN VORRICHTUNG
COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(30) Priority: 11.09.2019 KR 20190113025
(43) Date of publication of application: 17.03.2021
(73) Proprietor: Samsung Electronics Co., Ltd., Gyeonggi-do 16677 (KR)
(72) Inventor: HWANG, Kyuyoung, 16678 Gyeonggi-do (KR); KANG, Byungjoon, 16678 Gyeonggi-do (KR); KWAK, Seungyeon, 16678 Gyeonggi-do (KR); LEE, Kum Hee, 16678 Gyeonggi-do (KR); JEON, Aram, 16678 Gyeonggi-do (KR); ARATANI, Sukekazu, 16678 Gyeonggi-do (KR); LEE, Banglin, 16678 Gyeonggi-do (KR); IM, Kyuhyun, 16678 Gyeonggi-do (KR); CHOI, Byoungki, 16678 Gyeonggi-do (KR); KOISHIKAWA, Yasushi, 16678 Gyeonggi-do (KR)
(74) Representative: Elkington and Fife LLP

(56) References cited:
- EP-A1- 3 010 067
- EP-A1- 3 904 363
- US-A1- 2018 013 077
- US-A1- 2019 189 934

## Description

### FIELD OF THE INVENTION

One or more embodiments relate to an organometallic compound, an organic light-emitting device including the same and an electronic apparatus including the organic light-emitting device.

### BACKGROUND OF THE INVENTION

Organic light-emitting devices are self-emission devices, which have improved characteristics in terms of viewing angle, response time, brightness, driving voltage, and response speed, and produce full-color images.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light.

EP 3 010 067 discloses an organic light-emitting device including a first electrode; a second electrode facing the first electrode; an emission layer disposed between the first electrode and the second electrode; and a hole transport region disposed between the first electrode and the emission layer.

US 2018/013077 discloses phosphorescent metal complexes containing substituents with succinimide moiety that are useful for phosphorescent organic light emitting devices.

US 2019/189934 discloses an organic metal compound and an organic light-emitting device employing the same.

### SUMMARY OF THE INVENTION

Provided are novel organometallic compounds, organic light-emitting devices using the same and an electronic apparatus including the organic light-emitting device.

Additional aspects will be set forth in part in the description which follows and, in part, will be apparent from the description, or may be learned by practice of the presented embodiments of the disclosure.

According to one aspect of the invention, an organometallic compound is provided in accordance with claim 1.

Another aspect of the invention provides an organic light-emitting device including a first electrode; a second electrode; and an organic layer including an emission layer between the first electrode and the second electrode, wherein the organic layer includes at least one of the organometallic compound.

The organometallic compound may be included in an emission layer, and the organometallic compound included in the emission layer may act as a dopant.

Another aspect of the invention provides an electronic apparatus including the organic light-emitting device.

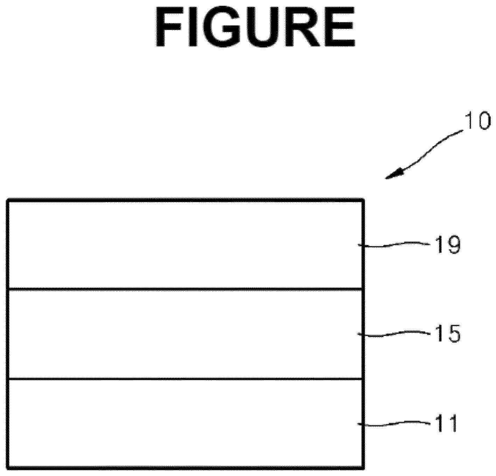

### BRIEF DESCRIPTION OF THE DRAWING

The above and other aspects, features, and advantages of certain embodiments of the disclosure will be more apparent from the following description taken in conjunction with FIGURE which shows a schematic cross-sectional view of an organic light-emitting device according to an embodiment.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features Moreover, sharp angles that are illustrated may be rounded. Thus, the regions illustrated in the figures are schematic in nature and their shapes are not intended to illustrate the precise shape of a region and are not intended to limit the scope of the present claims.

### DETAILED DESCRIPTION OF THE EMBODIMENTS

An organometallic compound according to an embodiment is represented by Formula 1 below:

<Formula 1 > M(L₁)n₁(L₂)n₂

M in Formula 1 is iridium (Ir).

L₁ in Formula 1 is a ligand represented by Formula 2 and L₂ in Formula 1 is a ligand represented by Formula 3:

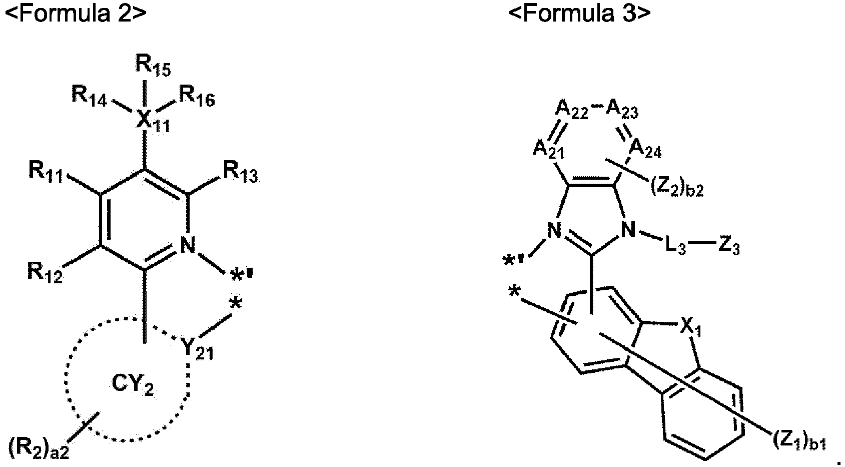

Formulae 2 and 3 are the same as described above.

L₁ and L₂ in Formula 1 may be different from each other.

n1 and n2 in Formula 1 indicate the number of L₁ and L₂. i) n1 is 2 and n2 is 1; or ii) n1 is 1 and n2 is 2. When n1 is 2, two L₁(s) are identical to or different from each other, and when n2 is 2, two L₂(s) are identical to or different from each other.

Y₂₁ in Formula 2 is C or N.

For example, Y₂₁ may be C.

Ring CY₂ in Formula 2 is a C₅-C₃₀ carbocyclic group or a C₁-C₃₀ heterocyclic group.

For example, ring CY₂ may be i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,
the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, ring CY₂ may be a cyclopentene group, a cyclohexane group, a cyclohexene group, a benzene group, a naphthalene group, an anthracene group, a phenanthrene group, a triphenylene group, a pyrene group, a chrysene group, cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, ring CY₂ may be a benzene group, a naphthalene group, an anthracene group, a phenanthrene group, a 1,2,3,4-tetrahydronaphthalene group, an indole group, a carbazole group, a fluorene group, a dibenzosilole group, a dibenzothiophene group, a dibenzofuran group, an azabenzosilole group, a pyridine group, a benzimidazole group, a benzoxazole group, or a benzothiazole group.

In one or more embodiments, ring CY₂ may be a benzene group, a naphthalene group, an anthracene group, a phenanthrene group, a 1,2,3,4-tetrahydronaphthalene group, a carbazole group, a fluorene group, a dibenzosilole group, a dibenzothiophene group, or a dibenzofuran group.

X₁₁ in Formula 2 is Si or Ge.

X₁ in Formula 3 is O, S, Se, N(Z₁₉), C(Z₁₉)(Z₂₀), or Si(Z₁₉)(Z₂₀). Z₁₉ and Z₂₀ are the same as described above.

For example, X₁ may be O, S, or N(Z₁₉).

A₂₁ to A₂₄ in Formula 3 are each independently C or N.

In one or more embodiments, A₂₁ to A₂₄ may each be C.

In one or more embodiments, at least one of A₂₁ to A₂₄ may be N.

In one or more embodiments, one of A₂₁ to A₂₄ may be N.

L₃ in Formula 3 is a single bond, a C₅-C₃₀ carbocyclic group unsubstituted or substituted with at least one R₁₀ₐ, or a C₁-C₃₀ heterocyclic group unsubstituted or substituted with at least one R₁₀ₐ.

For example, L₃ may be:
a single bond; or
a benzene group, a naphthalene group, an anthracene group, a phenanthrene group, a triphenylene group, a pyrene group, a chrysene group, cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one R₁₀ₐ.

In one or more embodiments, L₃ in Formula 1 may be:
a single bond; or
a benzene group unsubstituted or substituted at least one R₁₀ₐ.

In one or more embodiments, L₃ in Formula 1 may be:
a single bond; or
a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

R₂, R₁₁ to R₁₆, Z₁ to Z₃, Z₁₉, and Z₂₀ in Formulae 2 and 3 are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉). Q₁ to Q₉ are the same as described above.

In one or more embodiments, R₂, R₁₁ to R₁₆, Z₁ to Z₃, Z₁₉. and Z₂₀ in Formulae 2 and 3 may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CDs, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, - Si(Q₃₃)(Q₃₄)(Q₃₅), -Ge(Q₃₃)(Q₃₄)(Q₃₅), or any combination thereof; or
   -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
wherein Q₁ to Q₉ and Q₃₃ to Q₃₅ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, 3-pentyl group, a sec-isopentyl group, a phenyl group, a biphenyl group, or a naphthyl group, each unsubstituted or substituted with deuterium, a C₁-C₂₀ alkyl group, a phenyl group, or any combination thereof.

In one or more embodiments, R₂, R₁₁ to R₁₃, Z₁ to Z₃, Z₁₉ and Z₂₀ in Formulae 2 and 3 may each independently be:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), -Ge(Q₃₃)(Q₃₄)(Q₃₅), or any combination thereof.

In one or more embodiments, R₁₄ to R₁₆ in Formula 2 may each independently be a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In one or more embodiments, R₁₄ to R₁₆ in Formula 2 may each independently be - CH₃, -CH₂CH₃, -CD₃, -CD₂H, -CDH₂, -CH₂CD₃, or -CD₂CH₃.

In one or more embodiments, R₁₄ to R₁₆ in Formula 2 may be identical to or different from each other.

In one or more embodiments, R₁₁ in Formula 2 may not be hydrogen.

In one or more embodiments, R₁₁ in Formula 2 may not be hydrogen or a methyl group.

In one or more embodiments, R₁₁ in Formula 2 may not be hydrogen, a methyl group or a cyano group.

In one or more embodiments, in Formula 2, R₁₁ may not be hydrogen and R₁₂ and R₁₃ may be hydrogen.

In one or more embodiments, R₁₁ in Formula 2 may be a group including at least two carbons, at least three carbons or at least four carbons.

In one or more embodiments, R₁₁ in Formula 2 may be:
a methyl group, substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof; or
a C₂-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In one or more embodiments, Z₃ may in Formula 3 be a C₆-C₂₀ aryl group substituted with at least one C₁-C₂₀ alkyl group and at least one C₆-C₂₀ aryl group at the same time.

In one or more embodiments, Formula 3 may satisfy at least one of <Condition A> and <Condition B> :
<Condition A>
   L₃ is a C₅-C₃₀ carbocyclic group unsubstituted or substituted with at least one R₁₀ₐ, or a C₁-C₃₀ heterocyclic group unsubstituted or substituted with at least one R₁₀ₐ;
<Condition B>
   Z₃ is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In some embodiments, R₂, R₁₁ to R₁₆, Z₁ to Z₃, Z₁₉ and Z₂₀ in Formulae 2 and 3 may each independently be hydrogen, deuterium, -F, a cyano group, a nitro group, -SF₅, -CH₃, - CDs, -CD₂H, -CDH₂, -CF₃, -CF₂H, -CFH₂, -OCH₃, -OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, -Si(Q₃)(Q₄)(Q₅), or - Ge(Q₃)(Q₄)(Q₅), wherein Q₃ to Q₅ may respectively be understood by referring to the descriptions of Q₃ to Q₅ provided herein.

In some embodiments, R₁₁ in Formula 2 may be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F.

In some embodiments, Z₃ in Formula 3 may be a group represented by one of Formulae 10-12 to 10-145, a group represented by one of Formulae 10-12 to 10-145 in which at least one hydrogen is substituted with deuterium, a group represented by one of Formulae 10-12 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F:

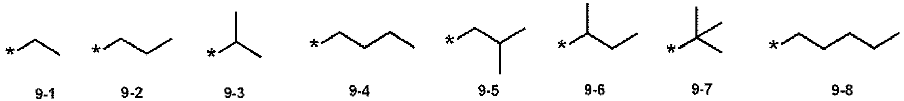

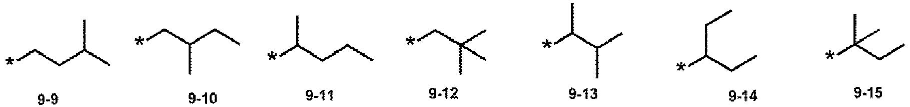

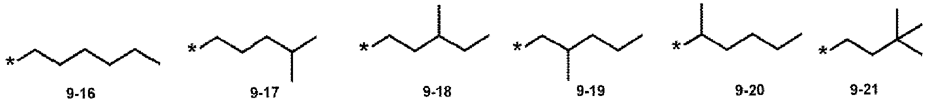

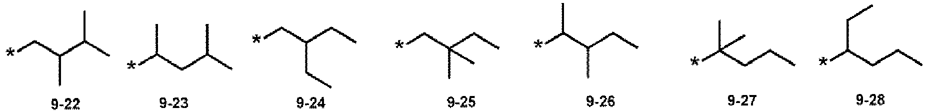

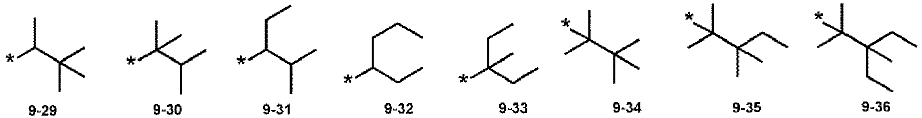

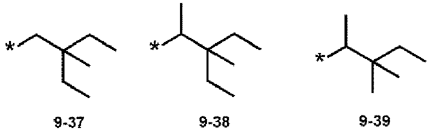

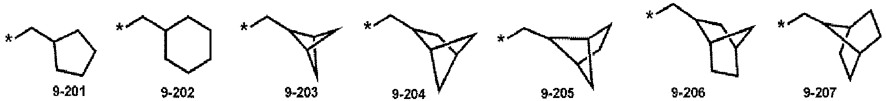

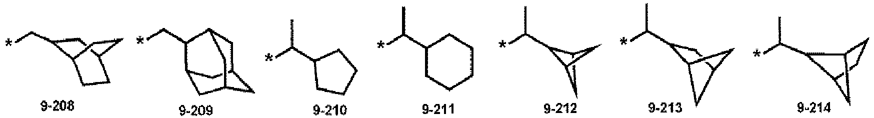

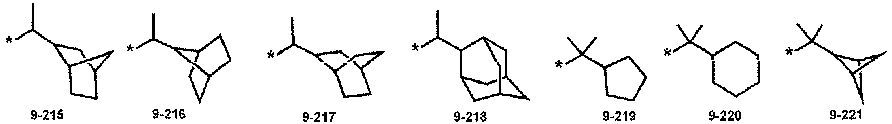

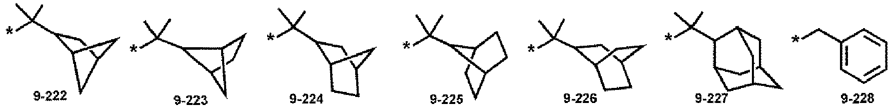

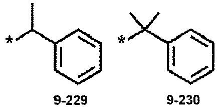

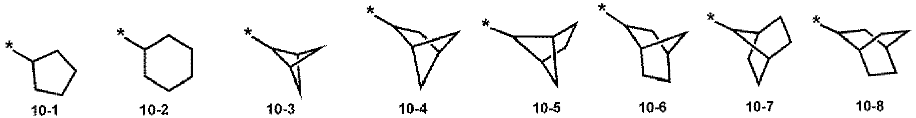

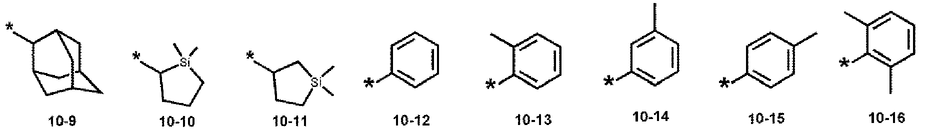

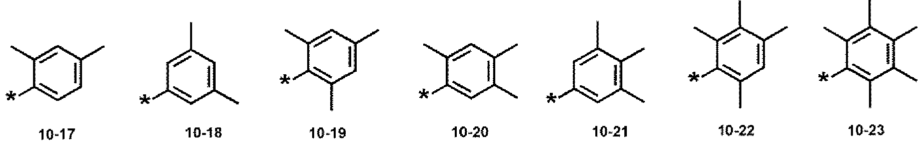

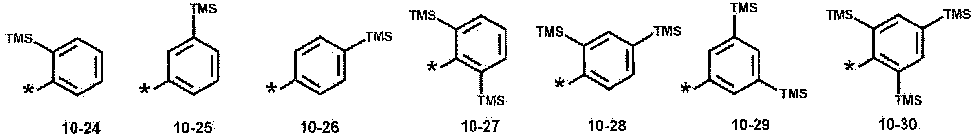

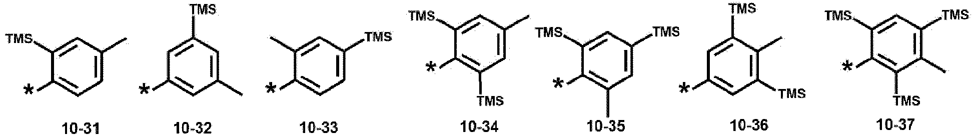

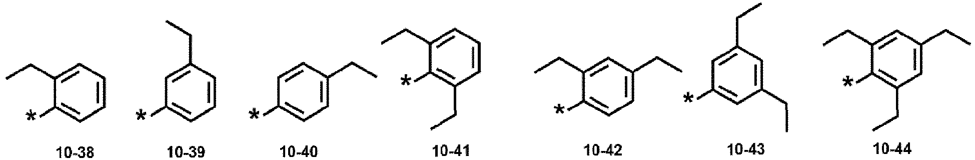

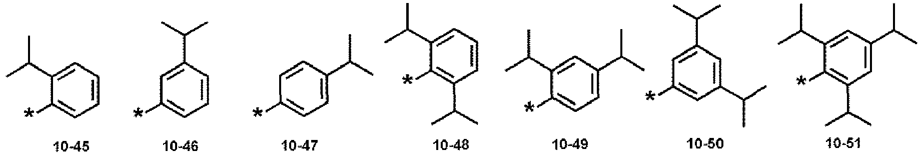

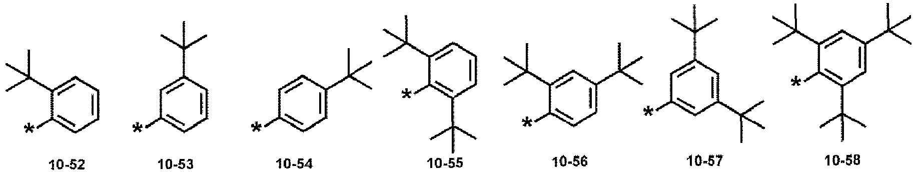

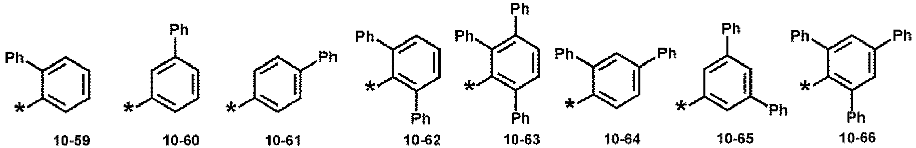

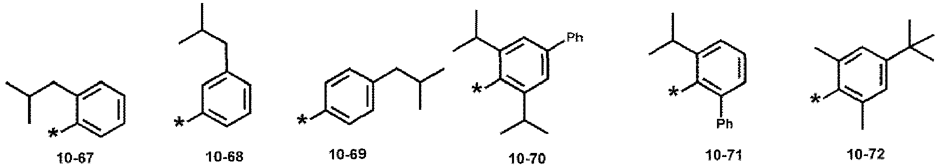

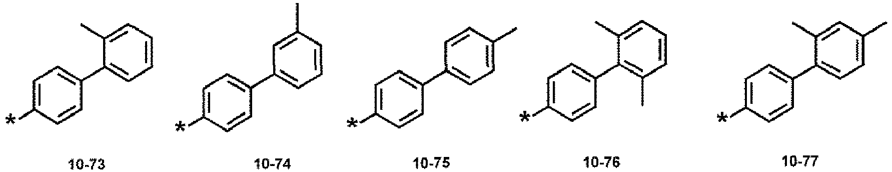

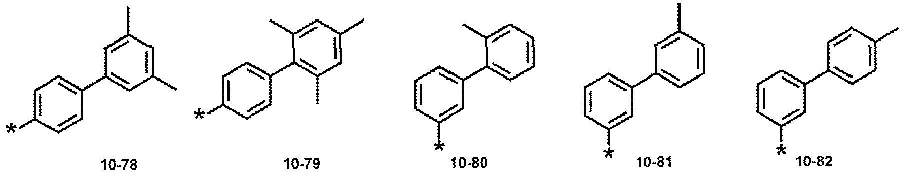

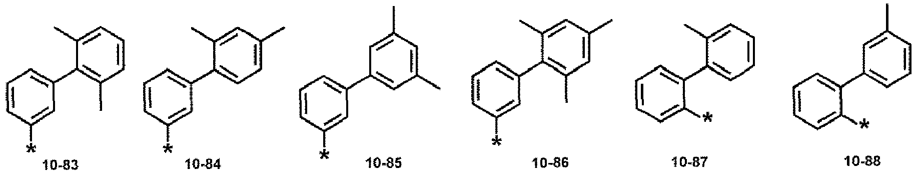

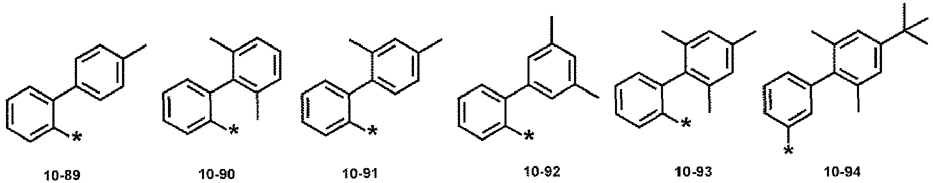

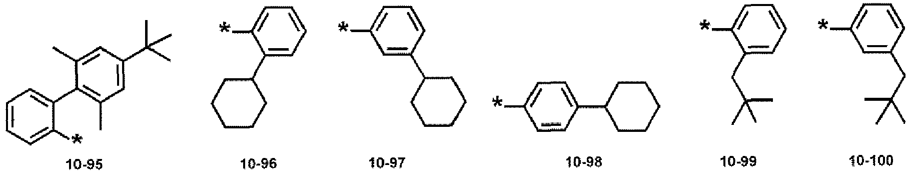

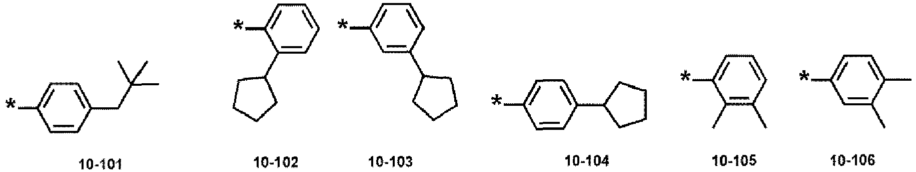

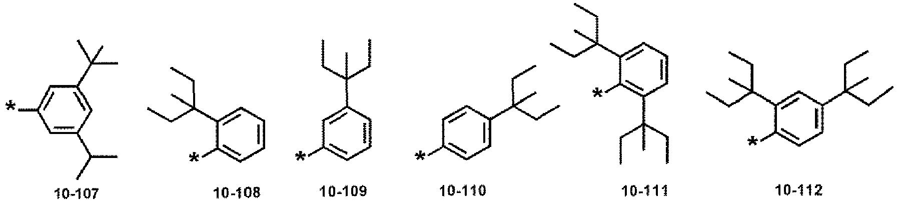

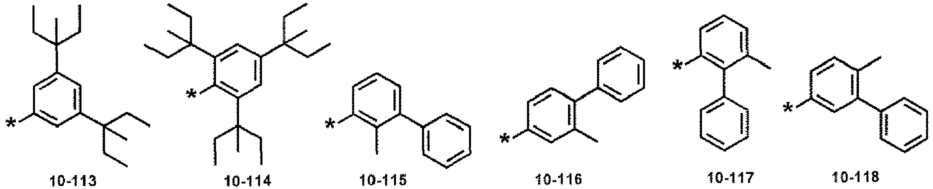

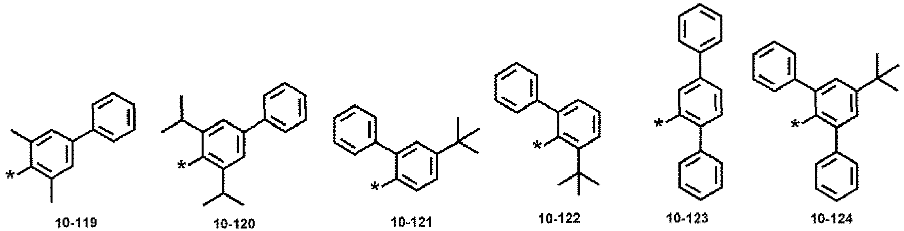

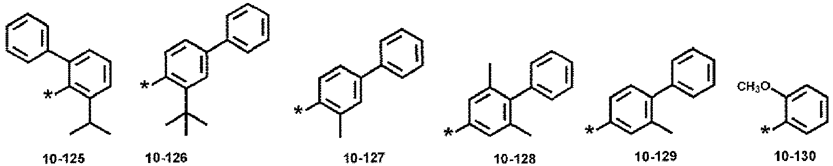

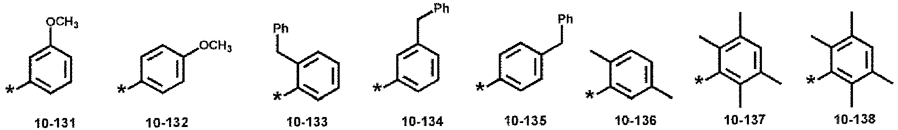

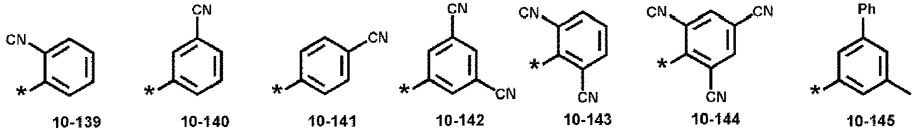

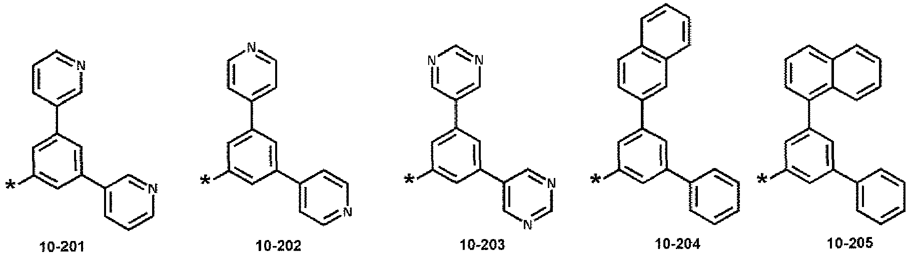

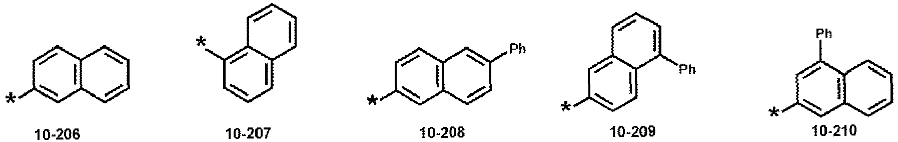

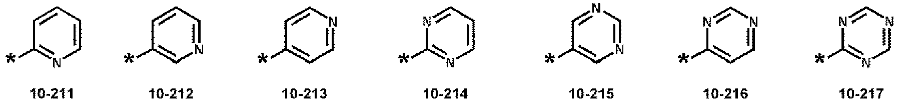

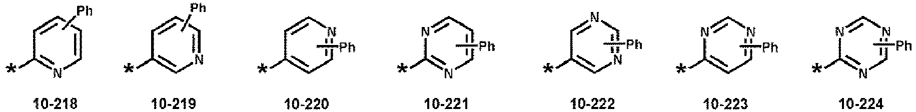

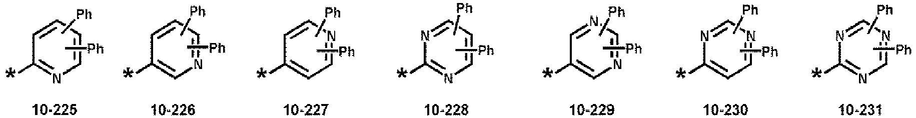

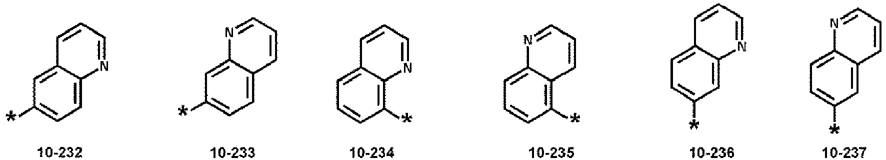

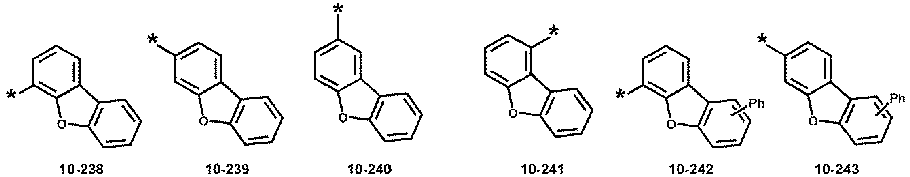

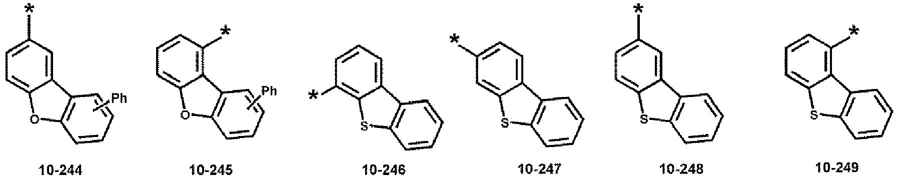

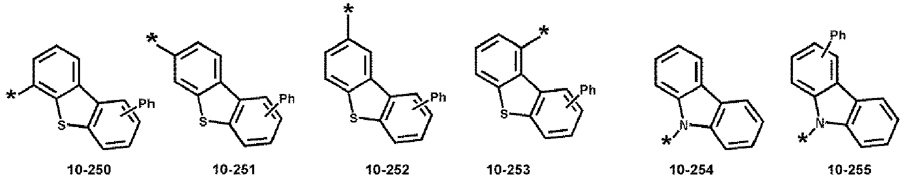

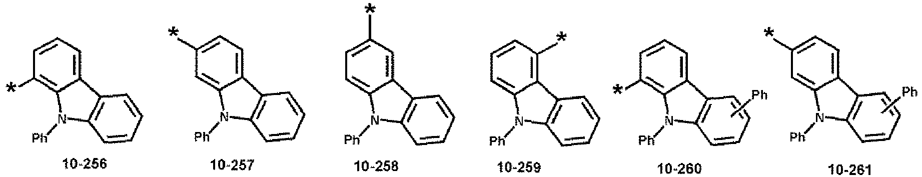

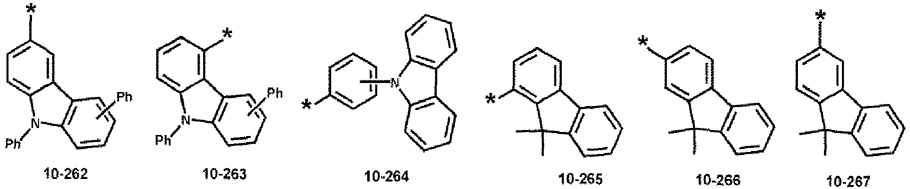

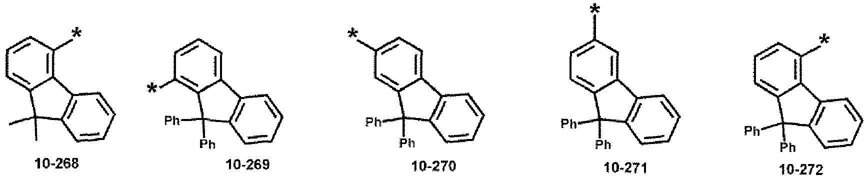

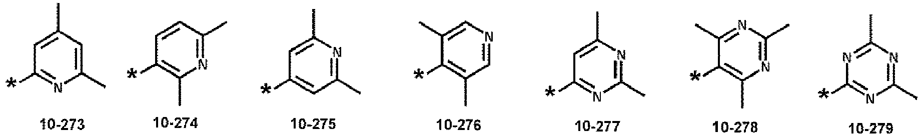

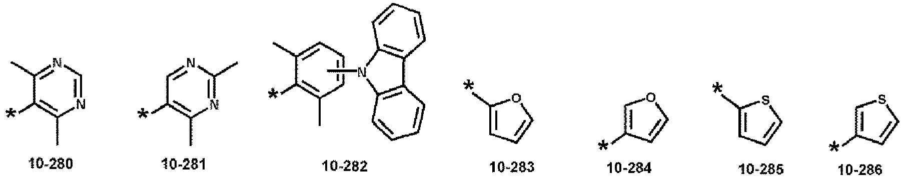

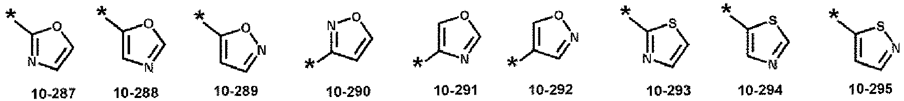

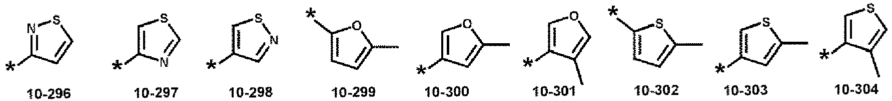

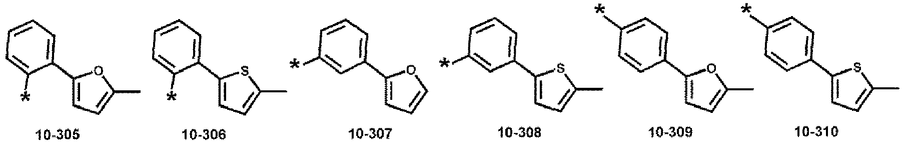

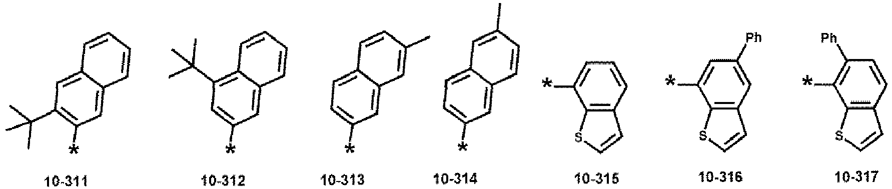

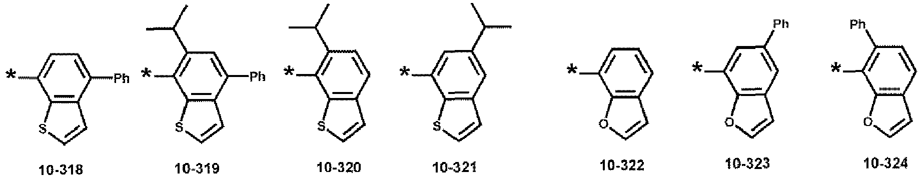

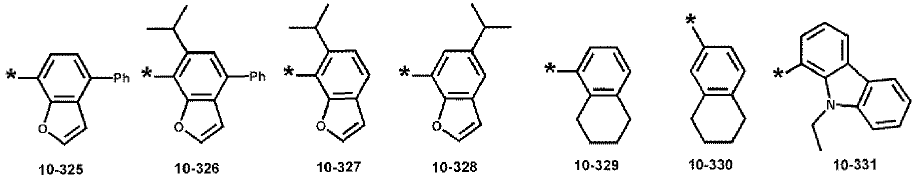

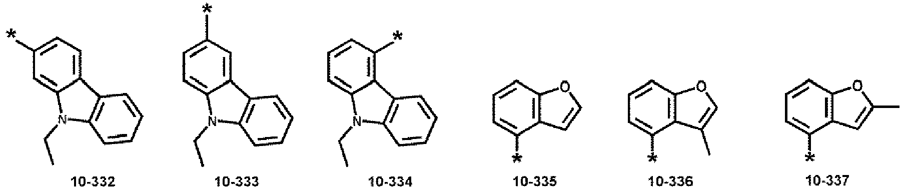

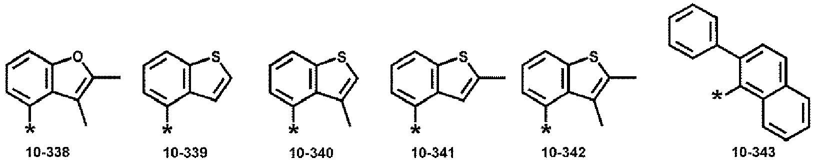

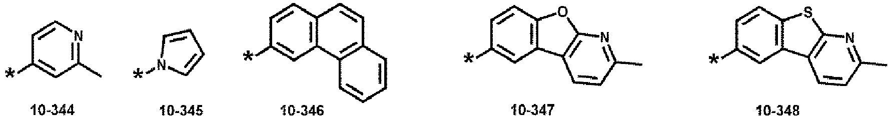

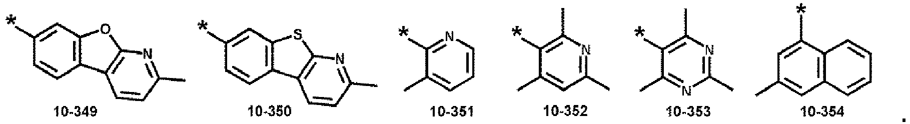

In Formulae 9-1 to 9-39, 9-201 to 9-230, 10-1 to 10-145, and 10-201 to 10-354, * indicates a binding site to an adjacent atom, "Ph" represents a phenyl group, "TMS" represents a trimethylsilyl group, "TMG" represents a trimethylgermyl group and "OMe" represents a methoxy group.

The "group represented by Formulae 9-1 to 9-39 in which at least one hydrogen is substituted with deuterium" and the "group represented by Formulae 9-201 to 9-230 in which at least one hydrogen is substituted with deuterium" may each be, for example, a group represented by one of Formulae 9-501 to 9-514 and 9-601 to 9-637:

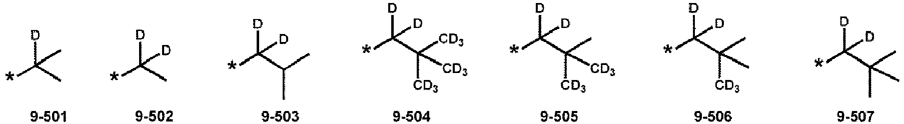

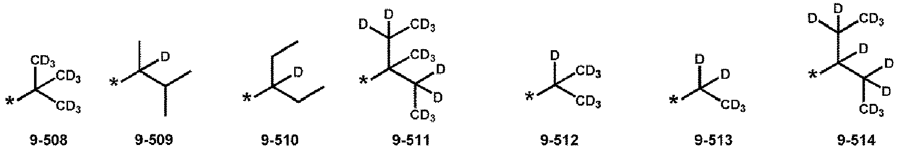

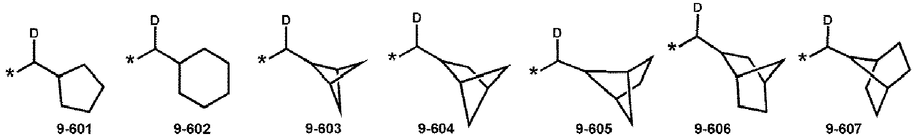

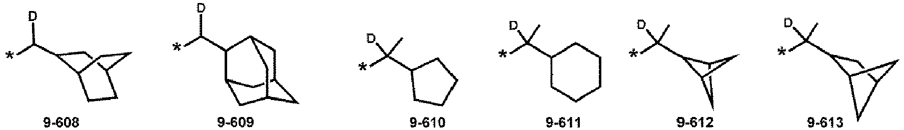

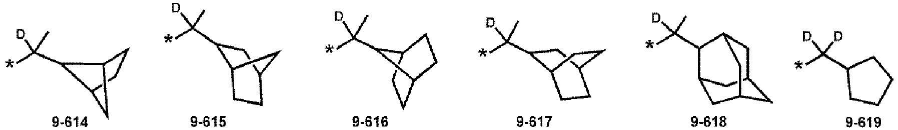

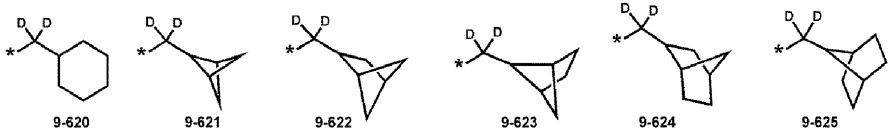

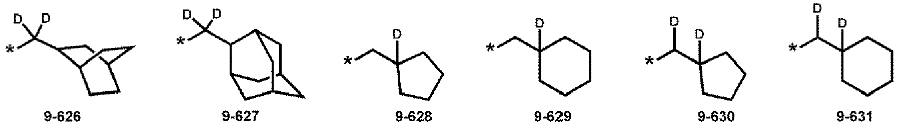

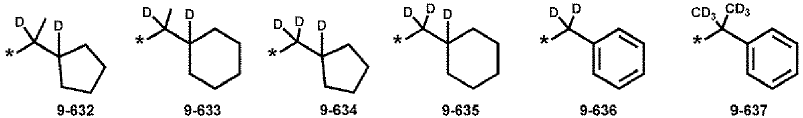

The "group represented by Formulae 9-1 to 9-39 in which at least one hydrogen is substituted with -F" and the "group represented by Formulae 9-201 to 9-230 in which at least one hydrogen is substituted with -F" may each be, for example, a group represented by one of Formulae 9-701 to 9-710:

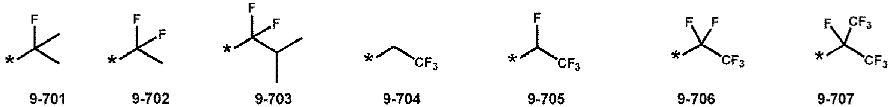

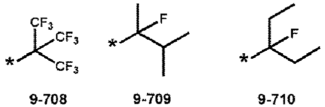

The "group represented by Formulae 10-1 to 10-145 in which at least one hydrogen is substituted with a deuterium" and the "group represented by Formulae 10-201 to 10-354 in which at least one hydrogen is substituted with deuterium" may each be, for example, a group represented by one of Formulae 10-501 to 10-553:

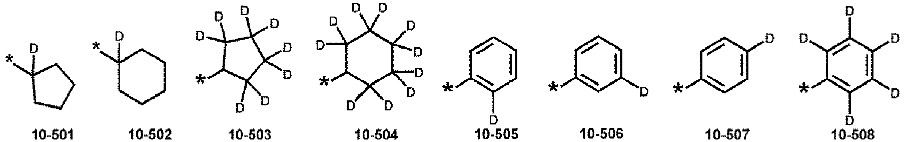

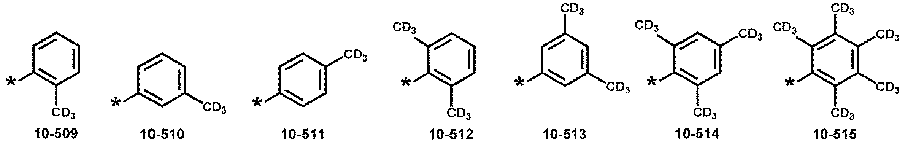

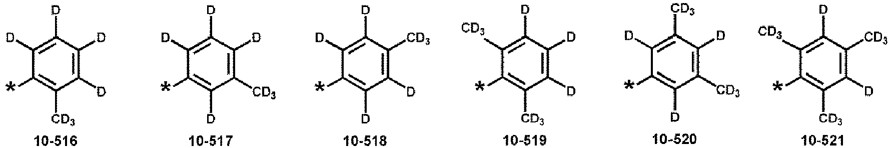

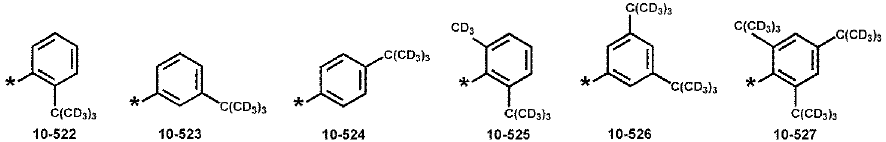

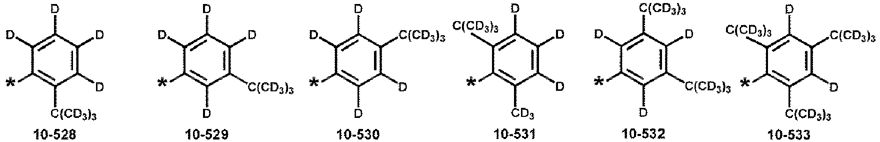

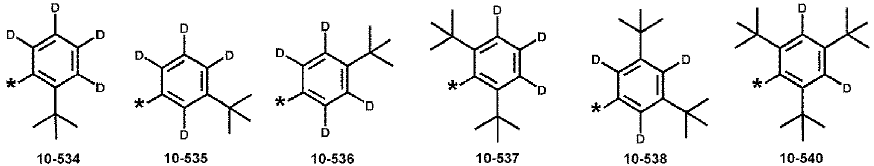

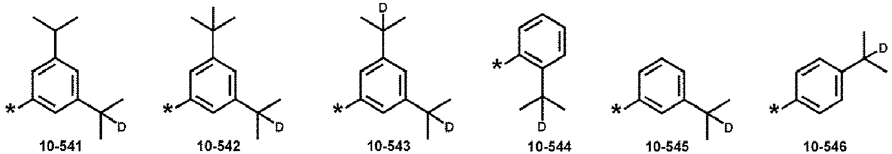

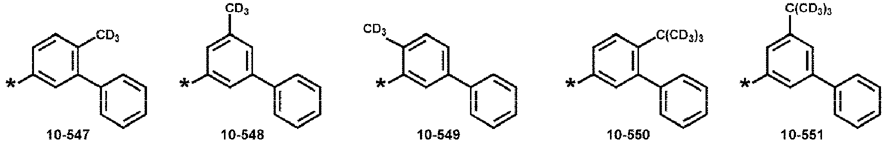

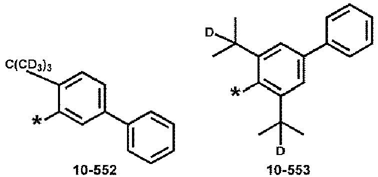

The "group represented by Formulae 10-1 to 10-145 in which at least one hydrogen is substituted with -F" and the "group represented by Formulae 10-201 to 10-354 in which at least one hydrogen is substituted with -F" may each be, for example, a group represented by one of Formulae 10-601 to 10-636:

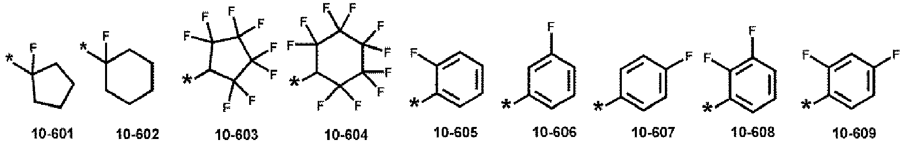

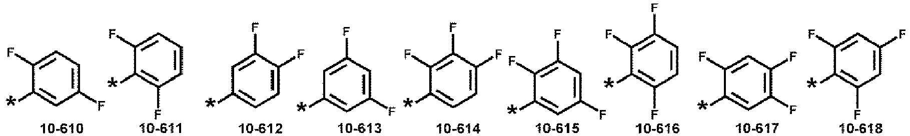

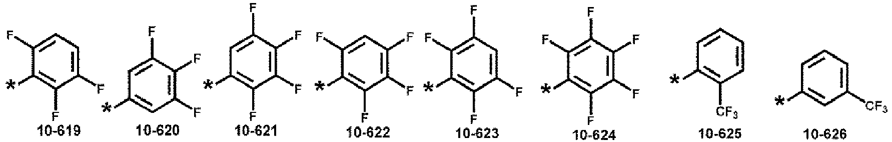

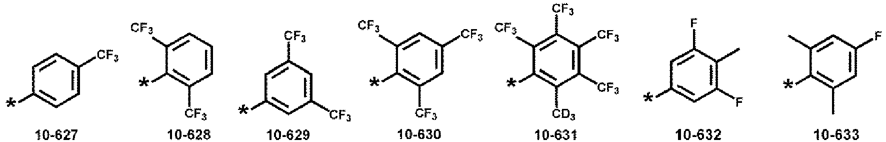

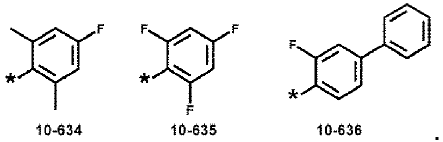

a2, b1, and b2 in Formulae 2 and 3 respectively indicate the number of R₂, Z₁, and Z₂, and a2 may be an integer from 0 to 20 (for example, an integer from 0 to 10), b1 may be an integer from 0 to 6, and b2 may be an integer from 0 to 4. When a2 is two or more, two or more of R₂(s) may be identical to or different from each other, and when b1 is two or more, two or more of Z₁(s) may be identical to or different from each other, and when b2 is two or more, two or more of Z₂(s) may be identical to or different from each other.

In one or more embodiments, in Formula 3, Z₁ may not be hydrogen and b1 may be an integer from 1 to 6.

In one or more embodiments, Z₂ in Formula 3 may not be hydrogen and b2 may be an integer from 1 to 4.

In one or more embodiments, the organometallic compound represented by Formula 1 may include deuterium, -F, or a combination thereof.

In one or more embodiments, the organometallic compound represented by Formula 1 may satisfy at least one of <Condition 1> to <Condition 12>:
<Condition 1>
   R₁₁ is not hydrogen and includes at least one deuterium;
<Condition 2>
   at least one of R₁₁ to R₁₃ is not hydrogen and includes at least one deuterium;
<Condition 3>
   at least one of R₂(s) in the number of a2 is not hydrogen and includes at least one deuterium;
<Condition 4>
   L₃ is not a single bond and may include at least one deuterium;
<Condition 5>
   Z₃ is not hydrogen and includes at least one deuterium;
<Condition 6>
   at least one of Z₁(s) in the number of b1 is not hydrogen and includes at least one deuterium;
<Condition 7>
   R₁₁ is not hydrogen and includes at least one flouro group (-F);
<Condition 8>
   at least one of R₁₁ to R₁₃ is not hydrogen and includes at least one flouro group;
<Condition 9>
   at least one of R₂(s) in the number of a2 is not hydrogen and includes at least one flouro group;
<Condition 10>
   L₃ is not a single bond and may include at least one flouro group;
<Condition 11>
   Z₃ is not hydrogen and includes at least one flouro group;
<Condition 12>
   at least one of Z₁(s) in the number of b1 is not hydrogen and includes at least one flouro group.

In Formulae 2 and 3, i) R₁₁ and R₁₂ may be optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, ii) two or more of a plurality of R₂(s) may be optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, iii) two or more of a plurality of Z₁ may be optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ (for example, ring CY₃₀ and ring CY₃₁, unsubstituted or substituted with at least one R₁₀ₐ, described herein), iv) two or more of a plurality of Z₂(s) may be optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ (for example, ring CY₁₀ and ring CY₁₁, unsubstituted or substituted with at least one R₁₀ₐ, described herein). R₁₀ₐ may be the same as described in connection with Z₁. For example, R₁₀ₐ may be the same as described in connection with Z₁, and may not be hydrogen.

Each of * and *' in Formula 2 and 3 may indicate a binding site to a neighboring atom.

In one or more embodiments, a group represented by 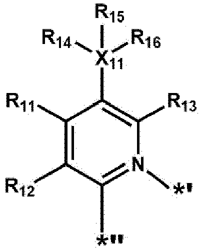 in Formula 2 may be a group represented by Formula 2-1 or 2-2:

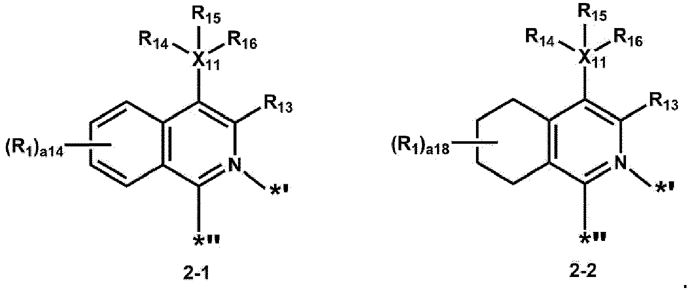

In Formulae 2-1 and 2-2,
X₁₁, and R₁₃ to R₁₆ are the same as described above,
R₁ may be the same as explained in connection with R₁₂,
a14 may be an integer from 0 to 4,
a18 may be an integer from 0 to 8,
*' indicates a binding site to M in Formula 1, and
*" indicates a binding site to a neighboring atom in Formula 2.

In one or more embodiments, a group represented by 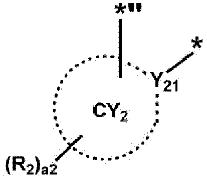 in Formula 2 may be a group represented by one of Formulae CY2-1 to CY2-33:

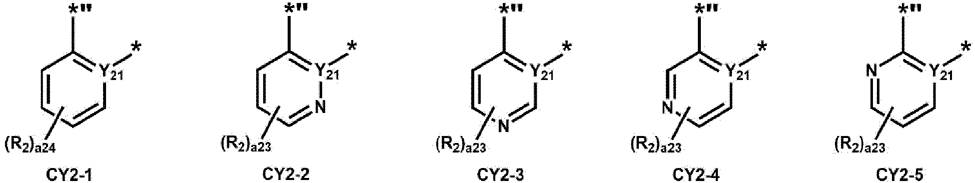

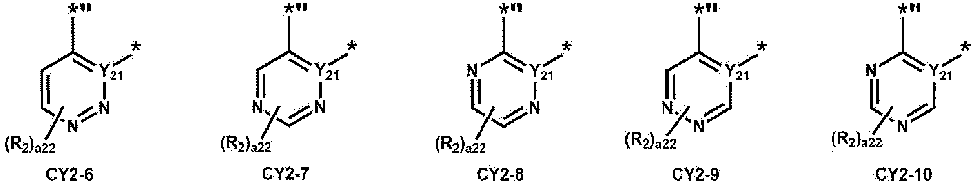

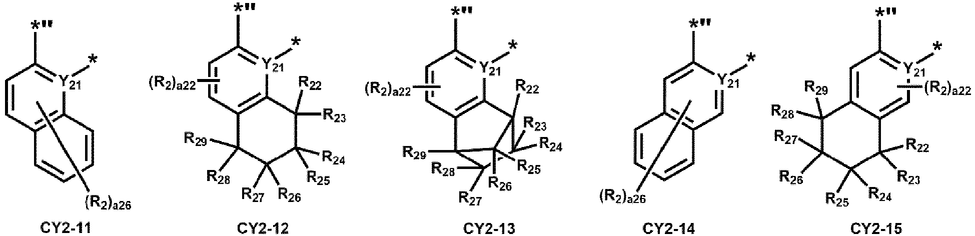

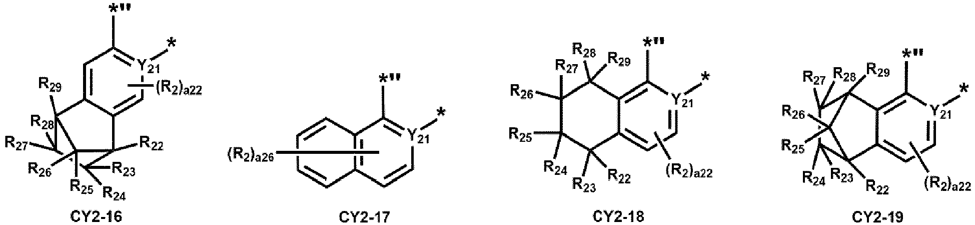

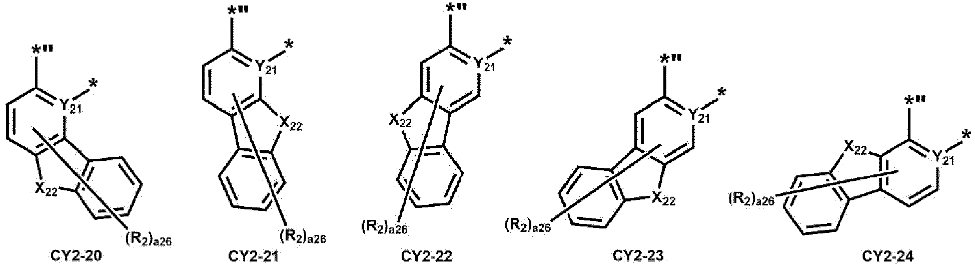

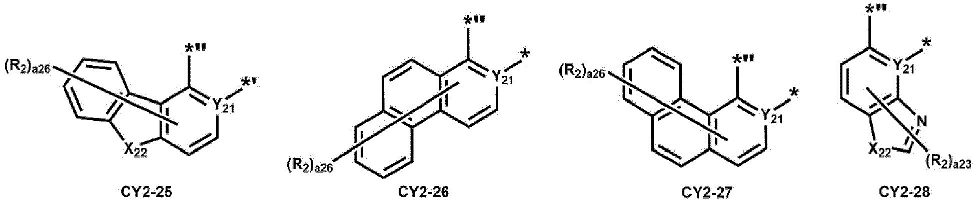

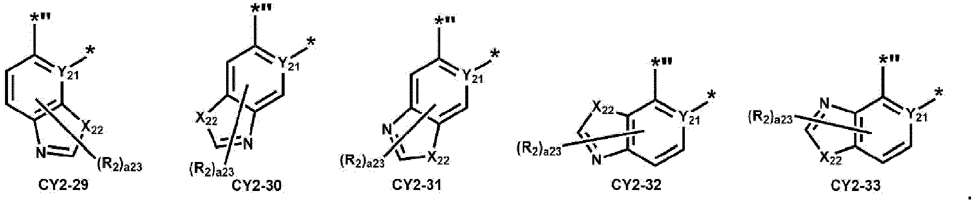

In Formulae CY2-1 to CY2-33,
Y₂₁ and R₂ are the same as described above,
X₂₂ may be C(R₂₂)(R₂₃), N(R₂₂), O, S, or Si(R₂₂)(R₂₃),
R₂₂ to R₂₉ are the same as described in connection with R₂,
a28 may be an integer from 0 to 8,
a26 may be an integer from 0 to 6,
a24 may be an integer from 0 to 4,
a23 may be an integer from 0 to 3,
a22 may be an integer from 0 to 2,
*" indicates a binding site to a neighboring atom in Formula 2, and
* indicates a binding site to M in Formula 1.

In one or more embodiments, a group represented by 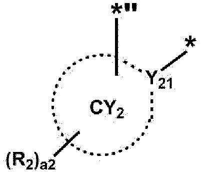 in Formula 2 may be a group represented by one of Formulae CY2(1) to CY2(56) or a group represented by one of Formulae CY2-20 to CY2-33:

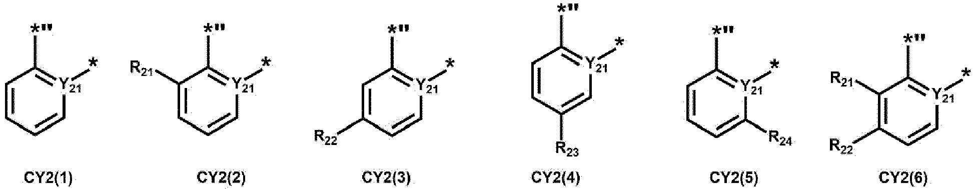

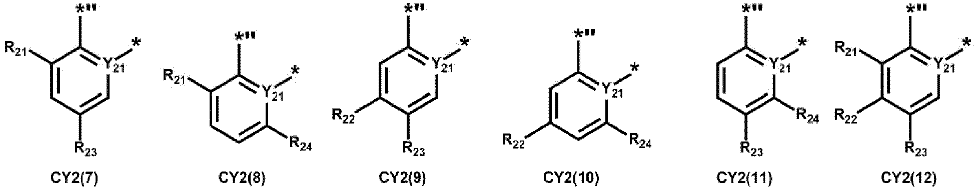

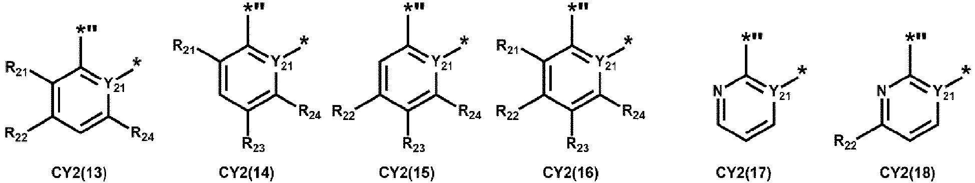

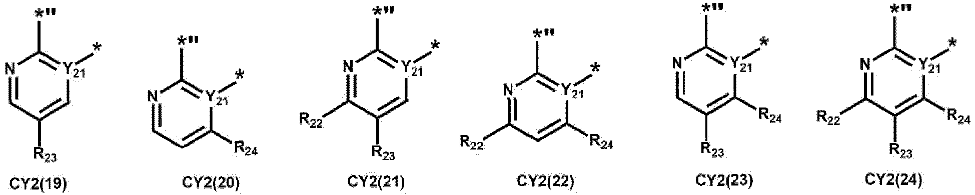

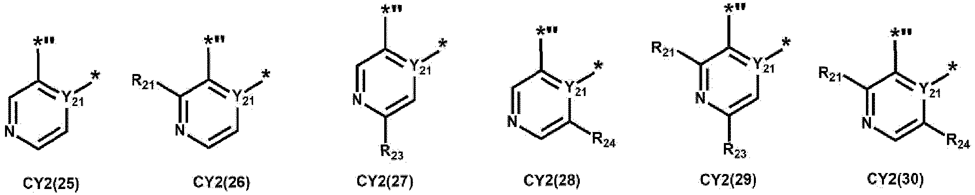

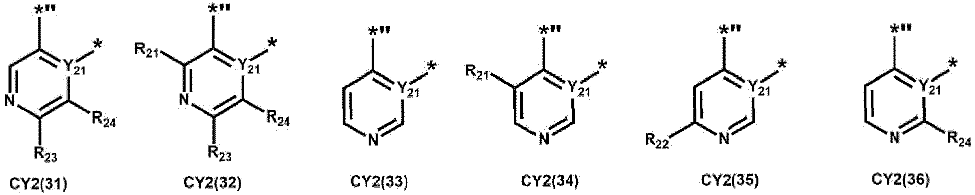

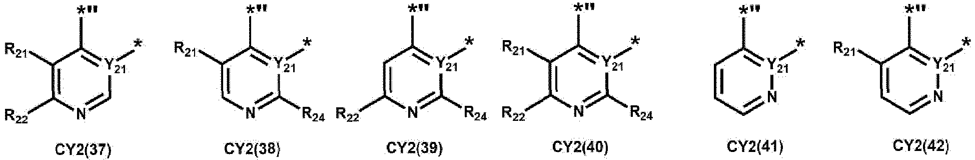

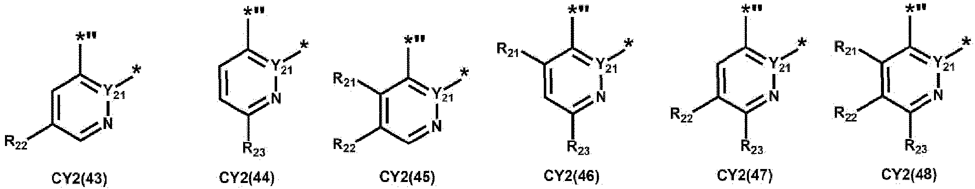

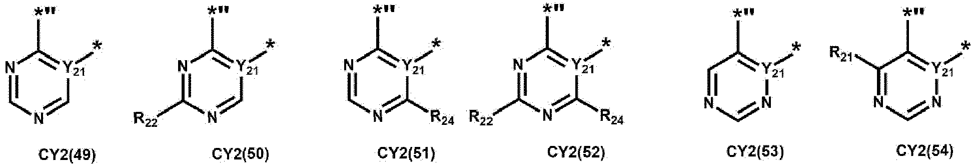

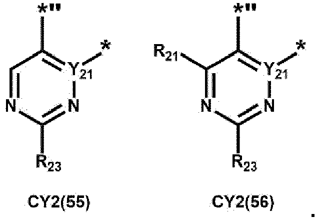

In Formula CY2(1) to CY2(56),
Y₂₁ may be C,
R₂₁ to R₂₄ are the same as described in connection with R₂, and R₂₁ to R₂₄ are each not hydrogen,
*" indicates a binding site to a neighboring atom in Formula 2, and
* indicates a binding site to M in Formula 1.

In one or more embodiments, a group represented by 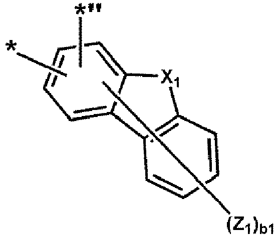 in Formula 3 may be a group represented by one of Formulae CY3-1 to CY3-6:

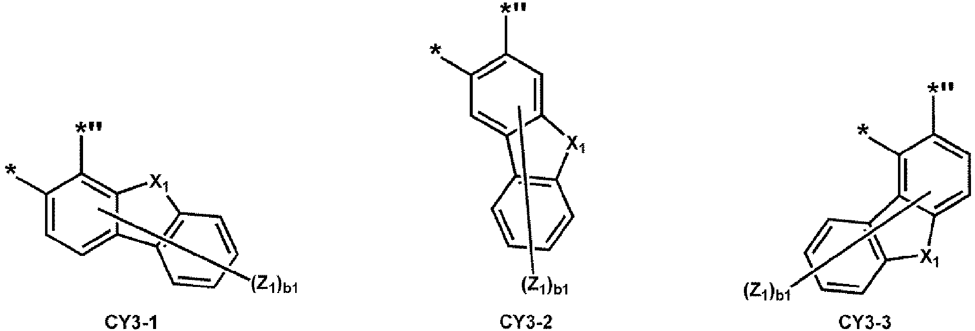

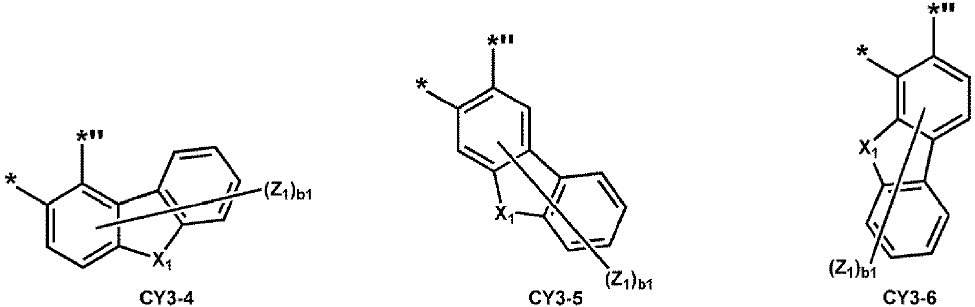

In Formulae CY3-1 to CY3-6,
X₁, Z₁, and b1 are the same as described above,
* indicates a binding site to M in Formula 1, and
*" indicates a binding site to a neighboring atom in Formula 3.

In one or more embodiments, two or more of a plurality of Z₁(s) in a group represented by 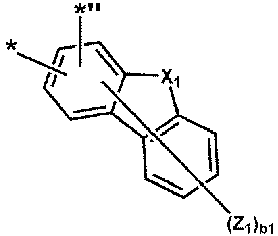 in Formula 3 may be linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ. As a result, a group represented by 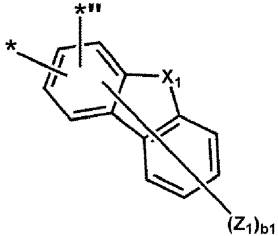 in Formula 3 may be a group represented by one of Formulae CY3-1A to CY3-1D, CY3-2A to CY3-2D, CY3-3A to CY3-3D, CY3-4A to CY3-4D, CY3-5A to CY3-5D, and CY3-6A to CY3-6D:

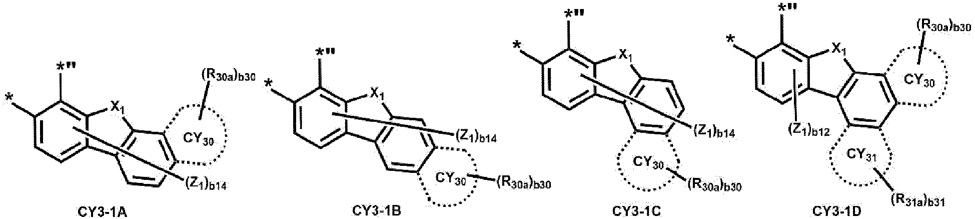

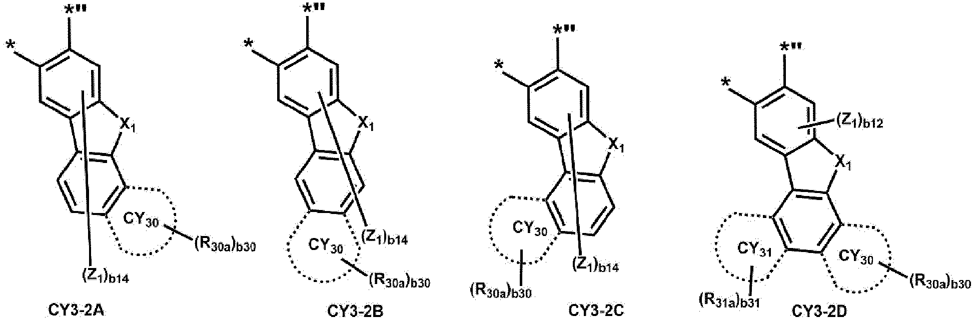

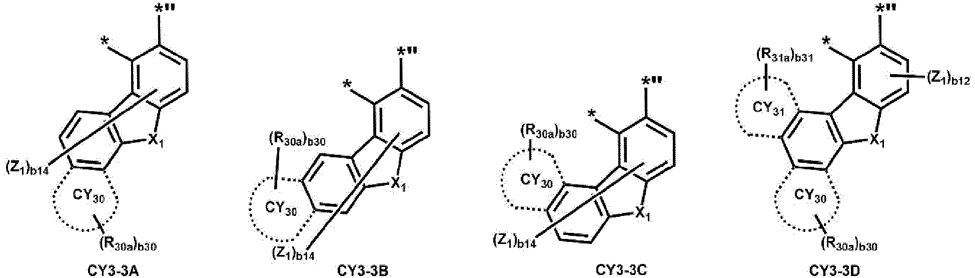

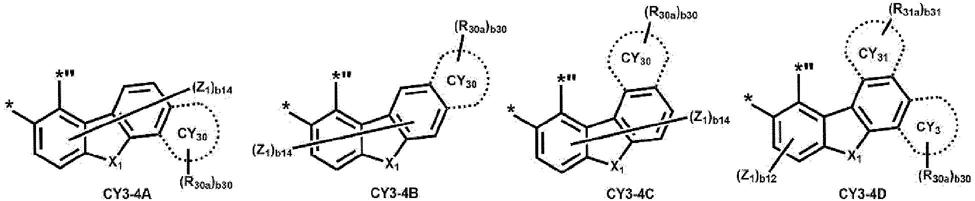

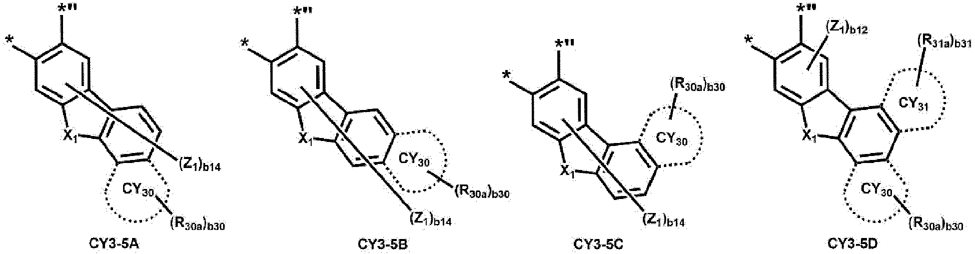

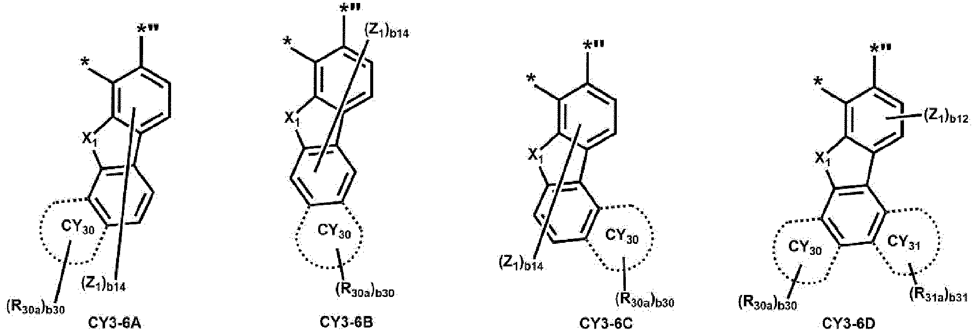

In Formulae CY3-1A to CY3-1D, CY3-2A to CY3-2D, CY3-3A to CY3-3D, CY3-4A to CY3-4D, CY3-5A to CY3-5D, and CY3-6A to CY3-6D,
X₁ and Z₁ are the same as described above,
ring CY₃₀ and ring CY₃₁ may each independently be a C₅-C₃₀ carbocyclic group or a C₁-C₃₀ heterocyclic group,
R₃₀ₐ and R₃₁ₐ may each be the same as explained in connection with R₁₀ₐ,
b12 may be an integer from 0 to 2,
b14 may be an integer from 0 to 4,
b30 and b31 may each independently be an integer from 0 to 20, when b30 is 2 or more, two or more R₃₀ₐ(s) may be identical to or different from each other, and when b31 is 2 or more, two or more R₃₁ₐ(s) may be identical to or different from each other,
* indicates a binding site to M in Formula 1, and
*" indicates a binding site to a neighboring atom in Formula 3.

For example, the ring CY₃₀ and ring CY₃₁ may each independently be a cyclohexane group, an adamantane group, a norbornane group, a benzene group, a naphthalene group, a phenanthrene group, a pyridine group, a pyrimidine group, a quinoline group, an isoquinoline group, a benzene group condented with a cyclohexane group, a benzene group condented with a norbornane group, a pyrimidine group condented with a cyclohexane group, or a pyrimidine group condented with a norbornane group.

In one or more embodiments, a group represented by 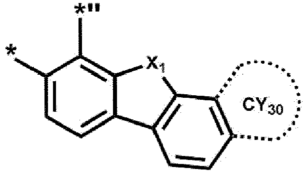 in Formula CY3-1A may be a group represented by one of Formulae CY3-1A-1 to CY3-1A-12:

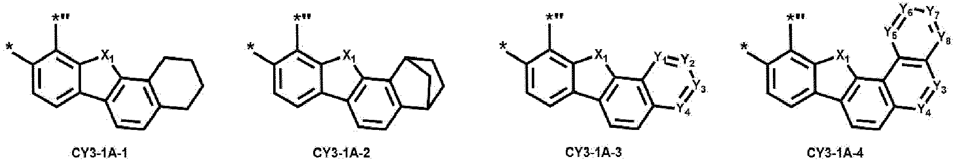

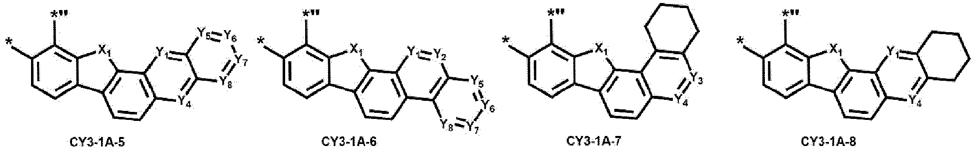

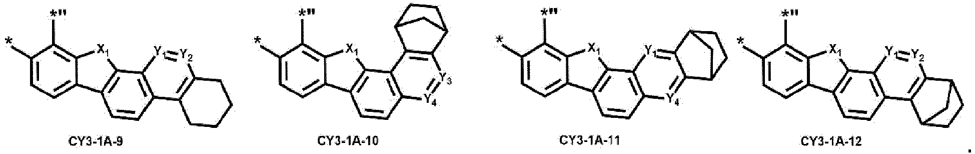

In one or more embodiments, a group represented by 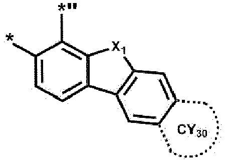 in Formula CY3-1B may be a group represented by one of Formulae CY3-1B-1 to CY3-1B-12:

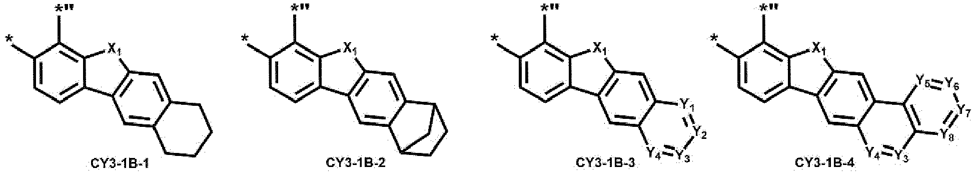

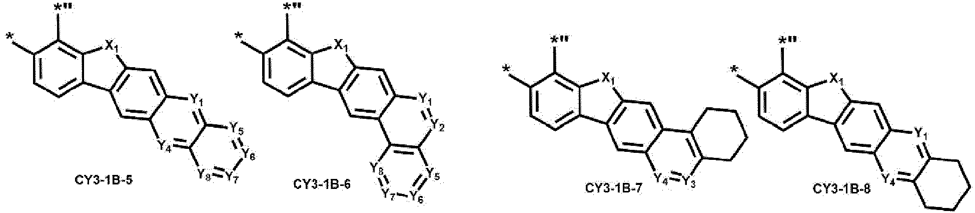

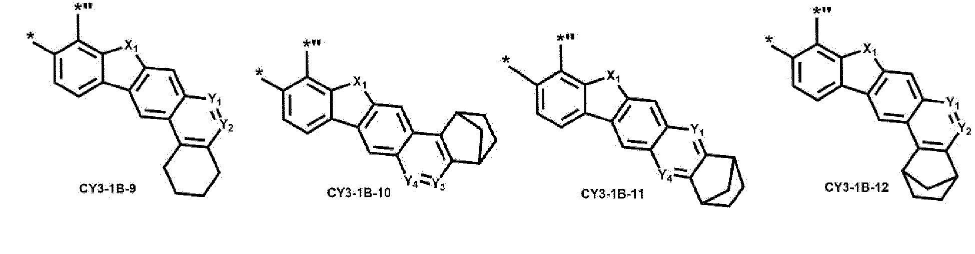

In one or more embodiments, a group represented by 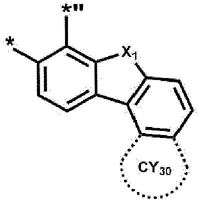 in Formula CY3-1C may be a group represented by one of Formulae CY3-1C-1 to CY3-1C-12:

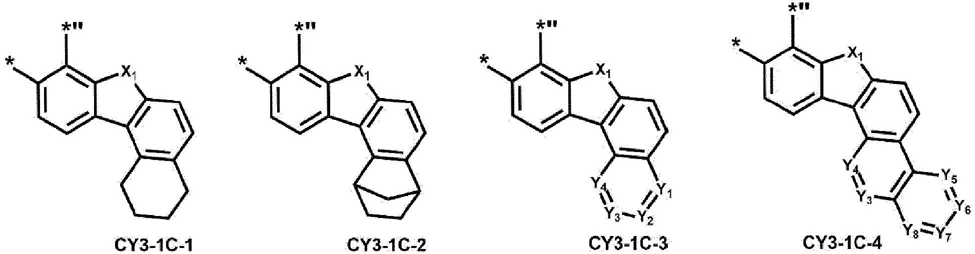

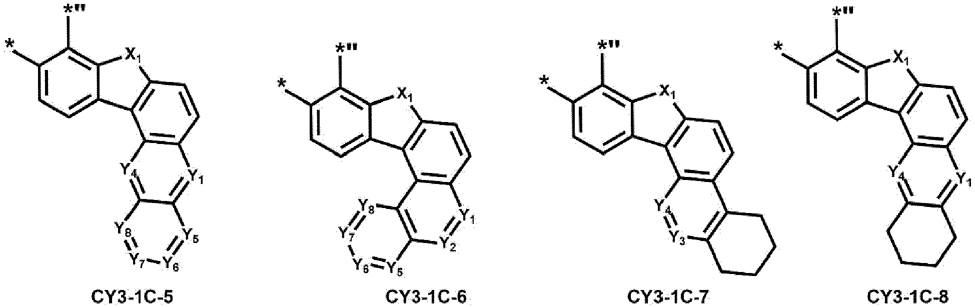

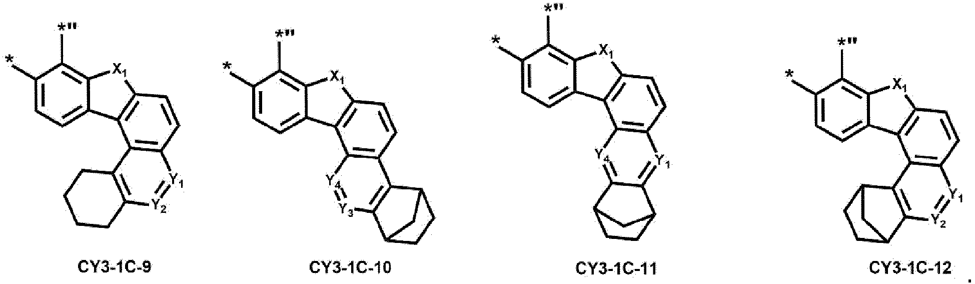

In one or more embodiments, a group represented by 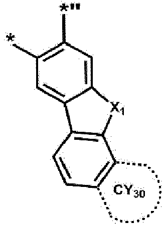 in Formula CY3-2A may be a group represented by one of Formulae CY3-2A-1 to CY3-2A-12:

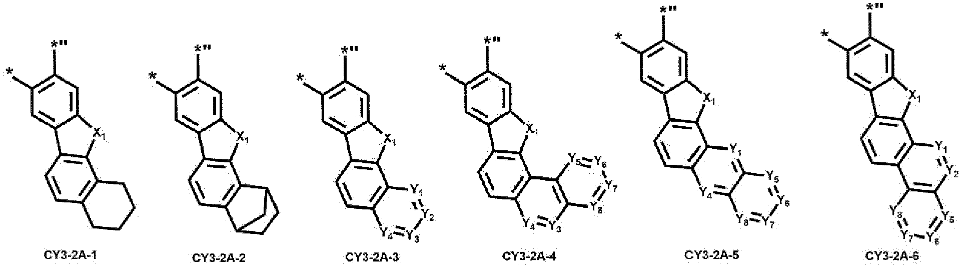

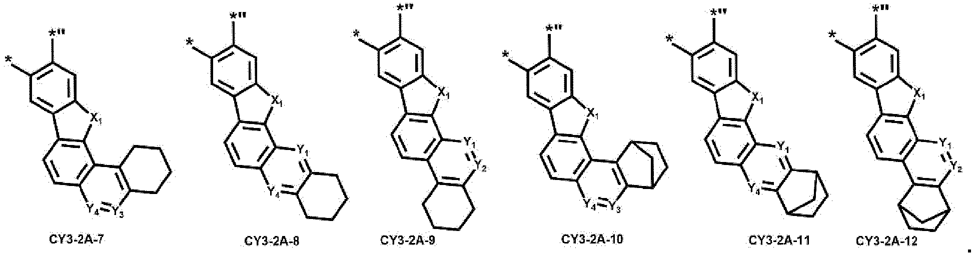

In one or more embodiments, a group represented by 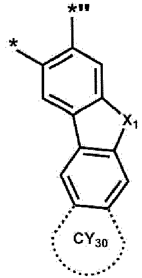 in Formula CY3-2B may be a group represented by one of Formulae CY3-2B-1 to CY3-2B-12:

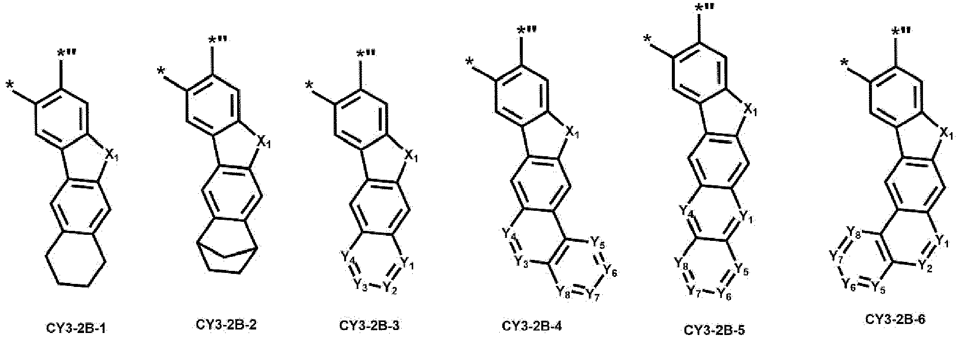

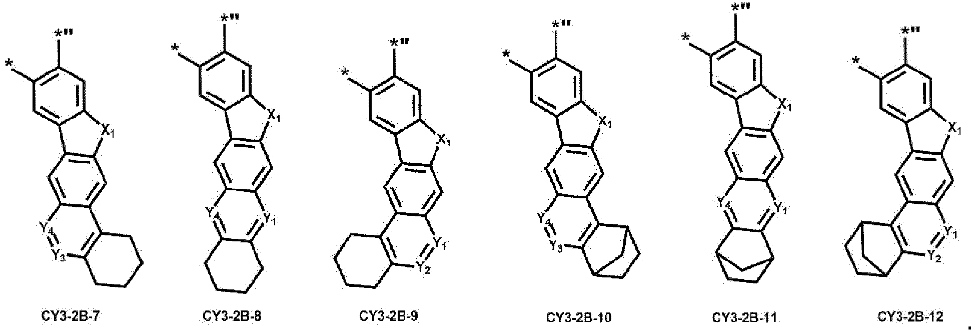

In one or more embodiments, a group represented by 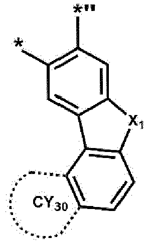 in Formula CY3-2C may be a group represented by one of Formulae CY3-2C-1 to CY3-2C-12:

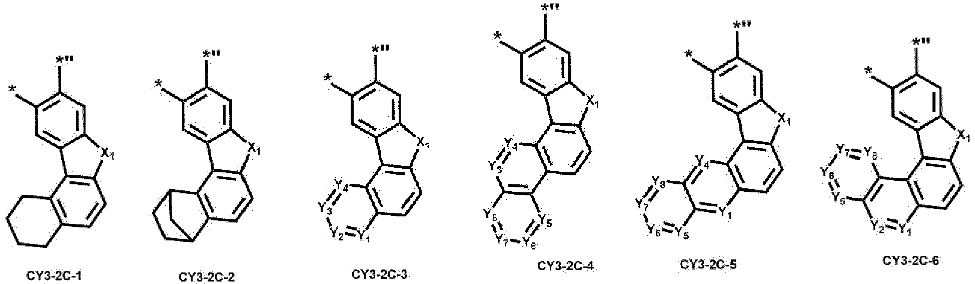

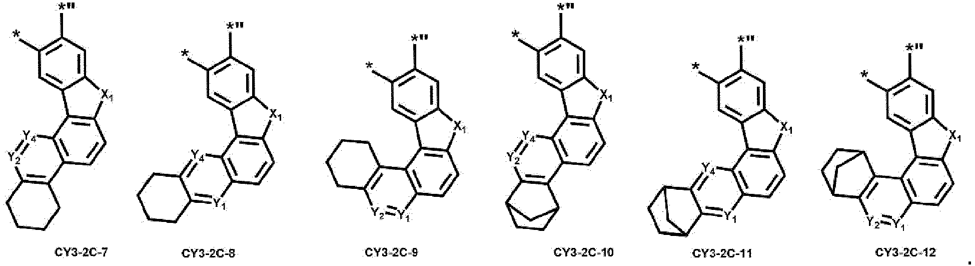

In one or more embodiments, a group represented by 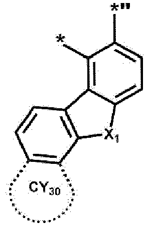 in Formula CY3-3A may be a group represented by one of Formulae CY3-3A-1 to CY3-3A-12:

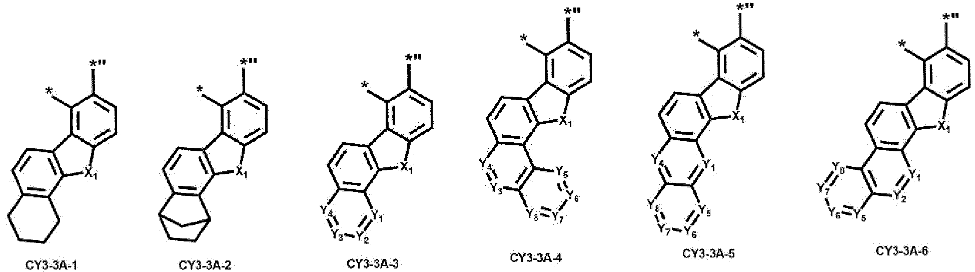

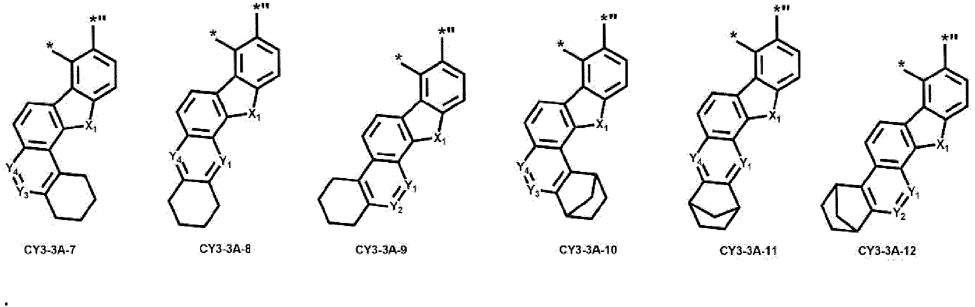

In one or more embodiments, a group represented by 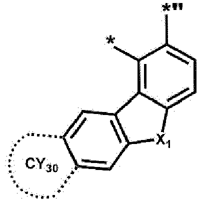 in Formula CY3-3B may be a group represented by one of Formulae CY3-3B-1 to CY3-3B-12:

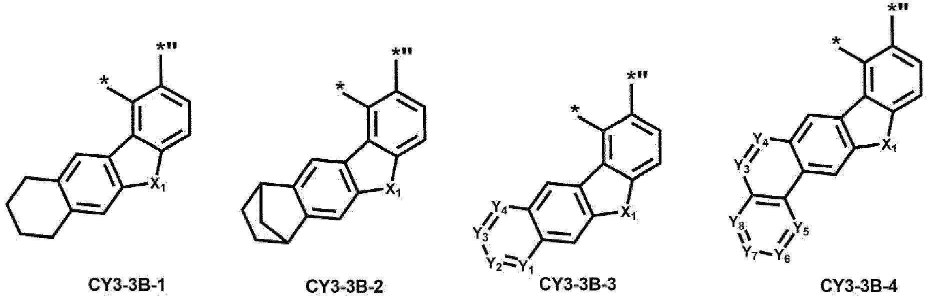

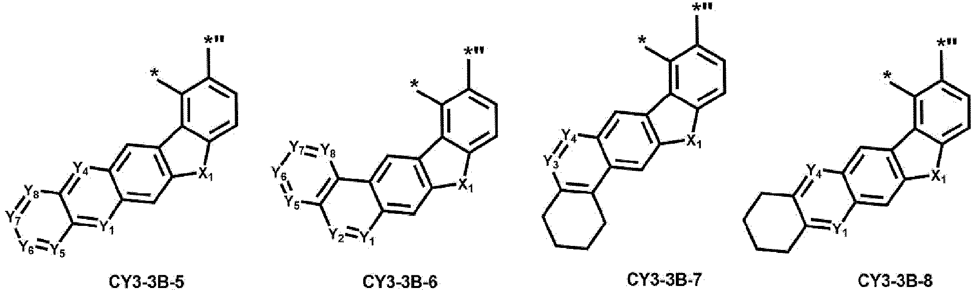

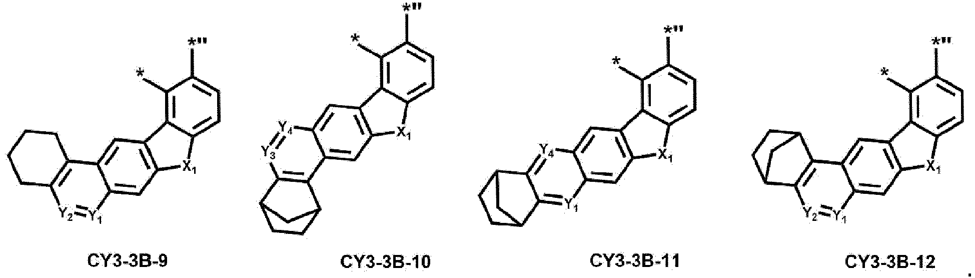

In one or more embodiments, a group represented by 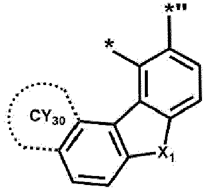 in Formula CY3-3C may be a group represented by one of Formulae CY3-3C-1 to CY3-3C-12:

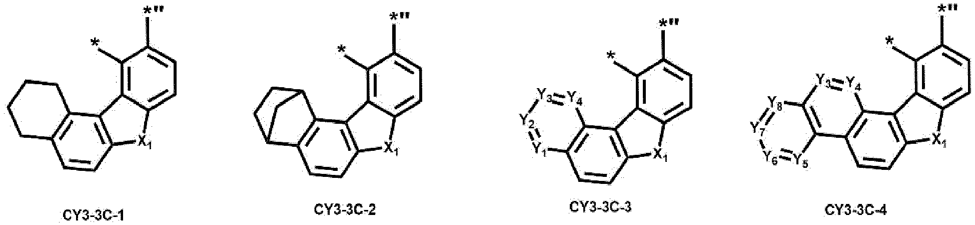

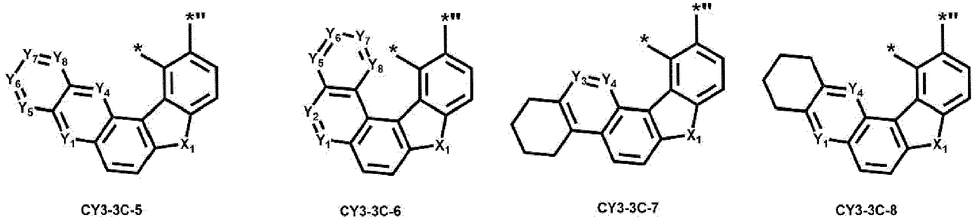

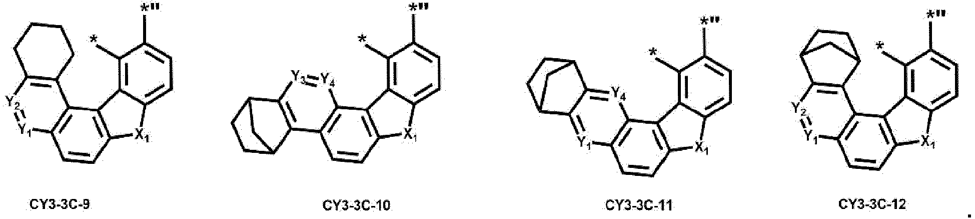

In one or more embodiments, a group represented by 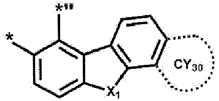 in Formula CY3-4A may be a group represented by one of Formulae CY3-4A-1 to CY3-4A-12:

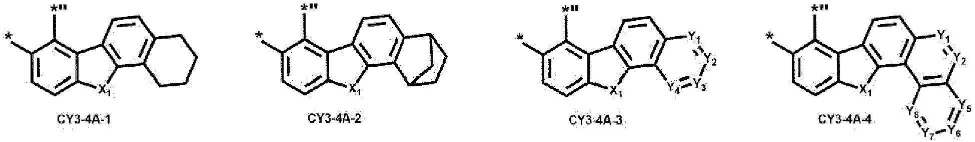

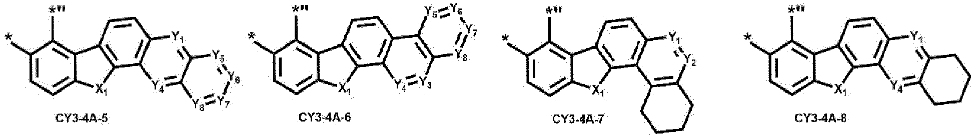

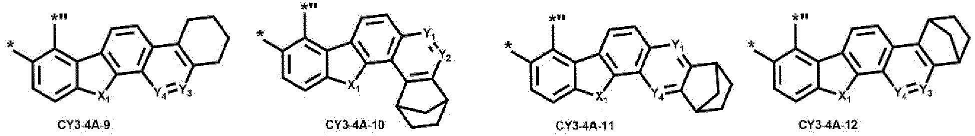

In one or more embodiments, a group represented by 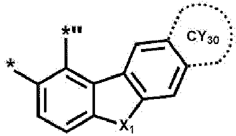 in Formula CY3-4B may be a group represented by one of Formulae CY3-4B-1 to CY3-4B-12:

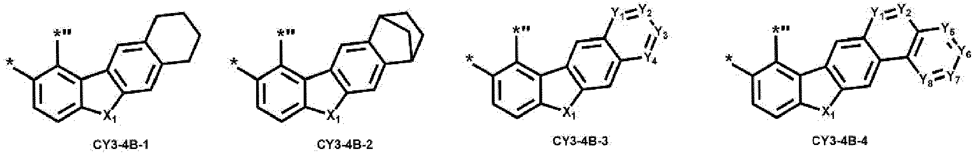

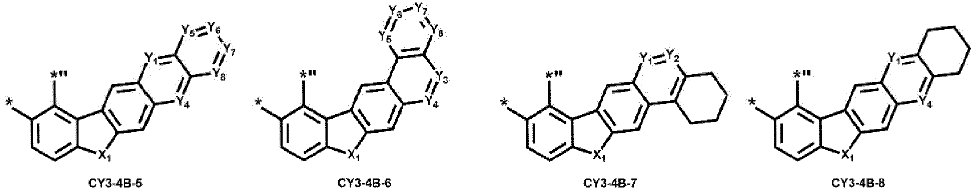

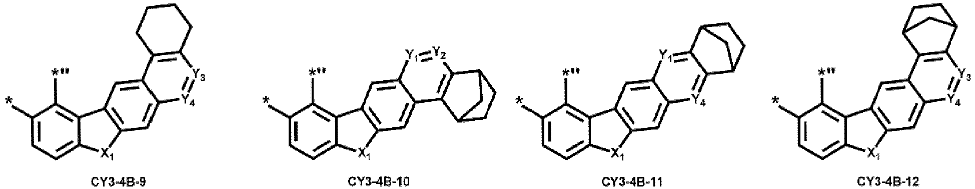

In one or more embodiments, a group represented by 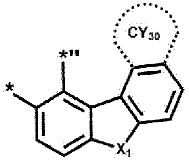 in Formula CY3-4C may be a group represented by one of Formulae CY3-4C-1 to CY3-4C-12:

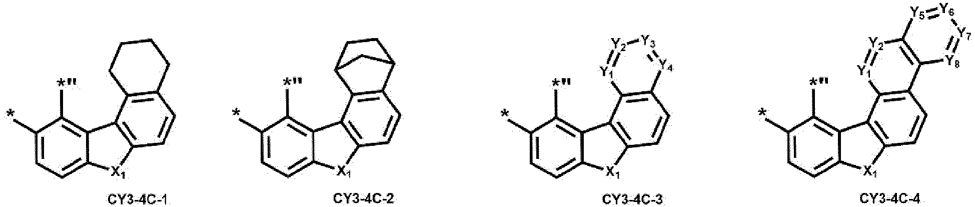

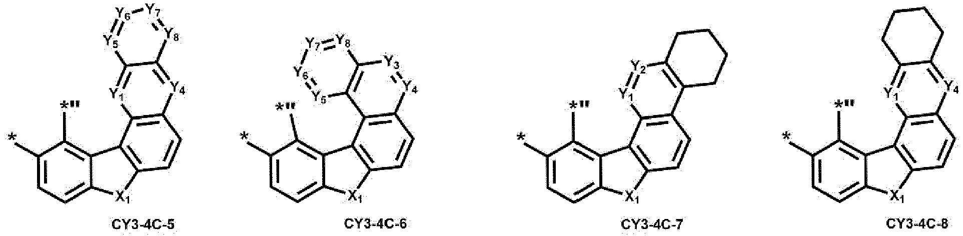

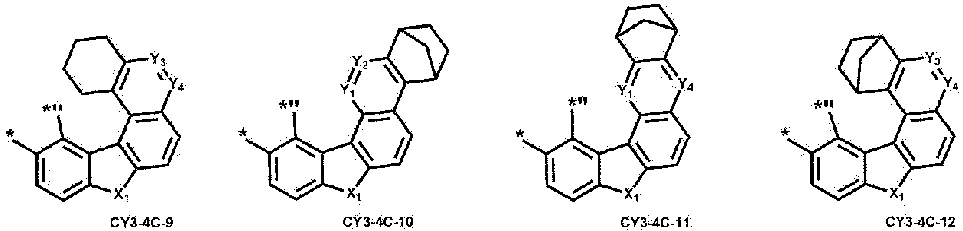

In one or more embodiments, a group represented by 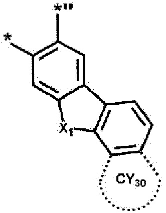 in Formula CY3-5A may be a group represented by one of Formulae CY3-5A-1 to CY3-5A-12:

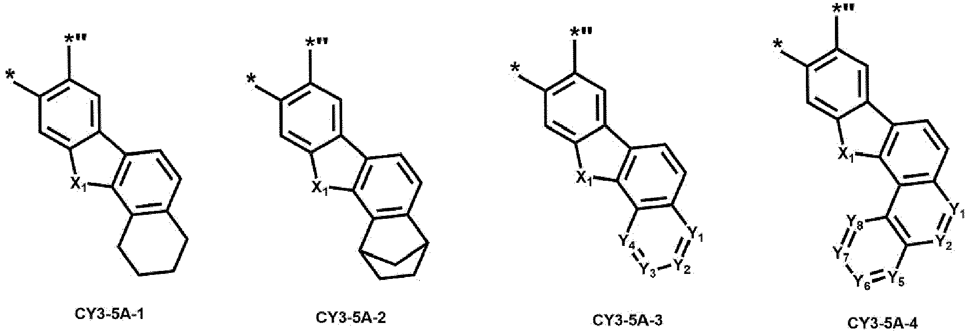

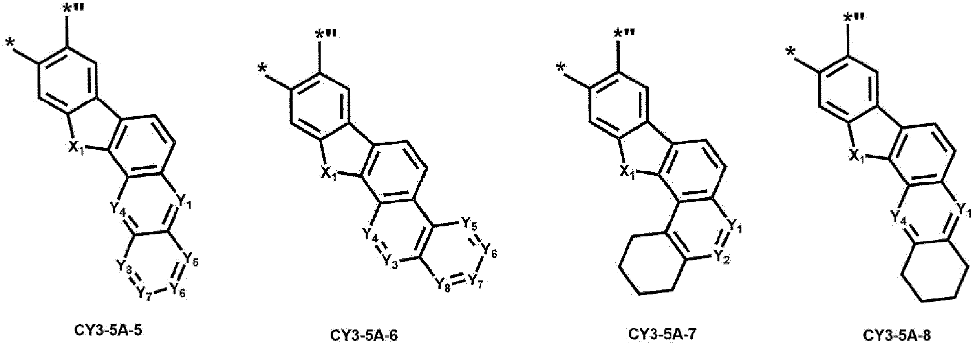

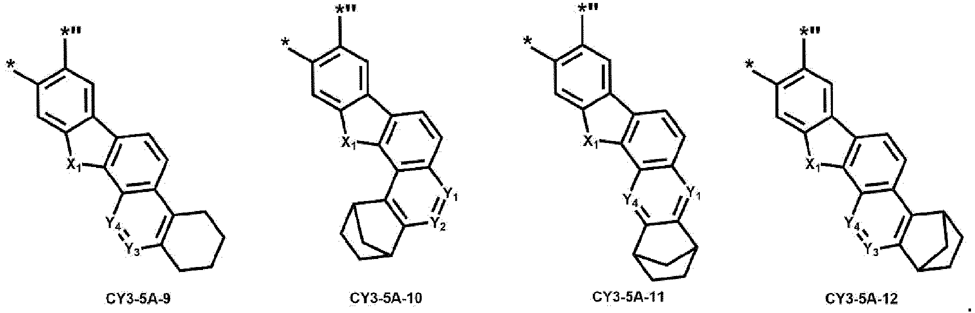

In one or more embodiments, a group represented by 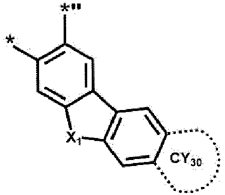 in Formula CY3-5B may be a group represented by one of Formulae CY3-5B-1 to CY3-5B-12:

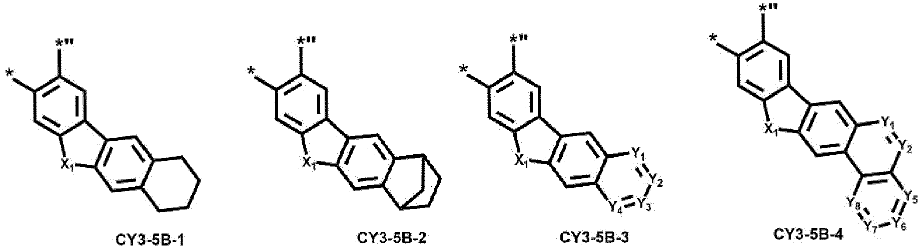

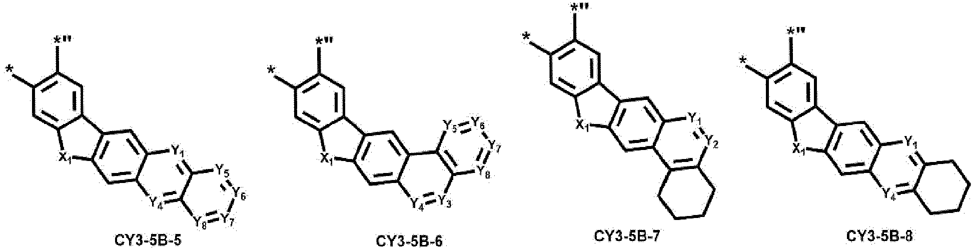

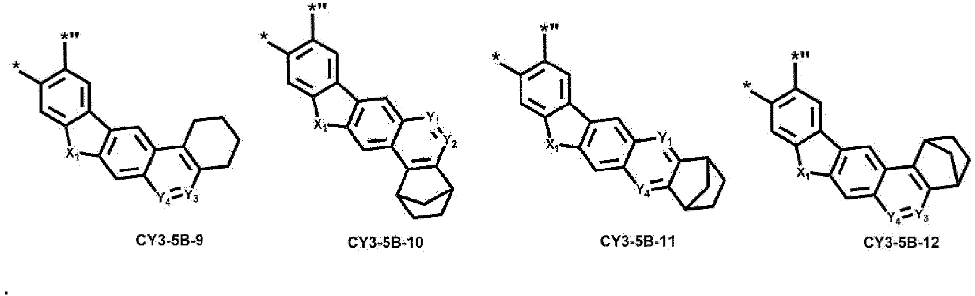

In one or more embodiments, a group represented by 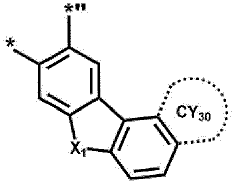 in Formula CY3-5C may be a group represented by one of Formulae CY3-5C-1 to CY3-5C-12:

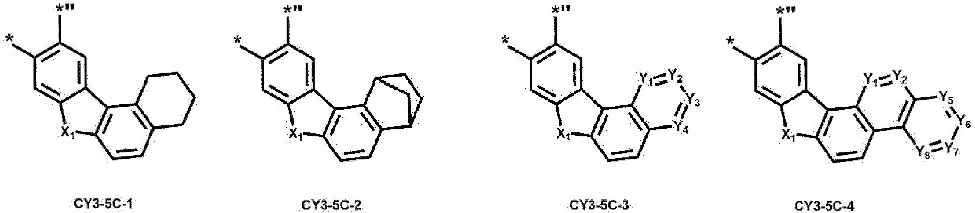

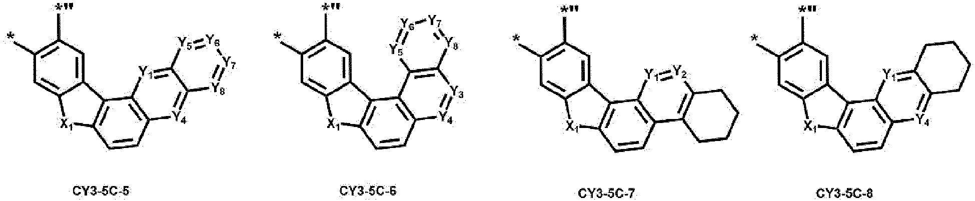

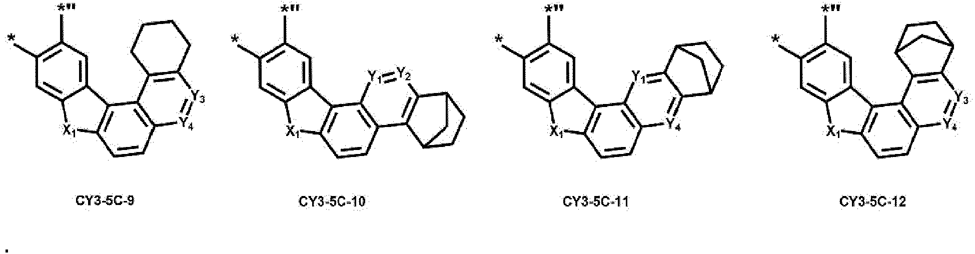

In one or more embodiments, a group represented by 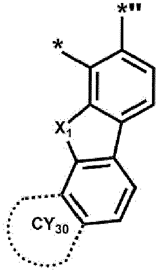 in Formula CY3-6A may be a group represented by one of Formulae CY3-6A-1 to CY3-6A-12:

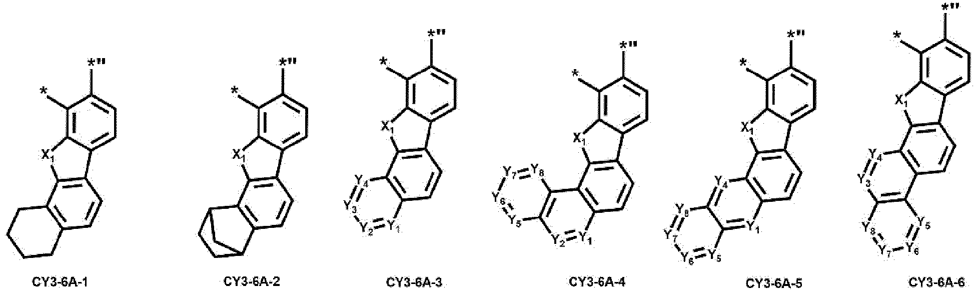

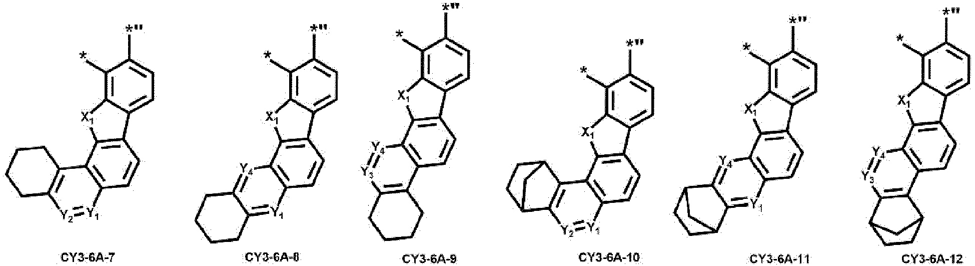

In one or more embodiments, a group represented by 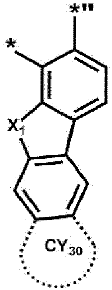 in Formula CY3-6B may be a group represented by one of Formulae CY3-6B-1 to CY3-6B-12:

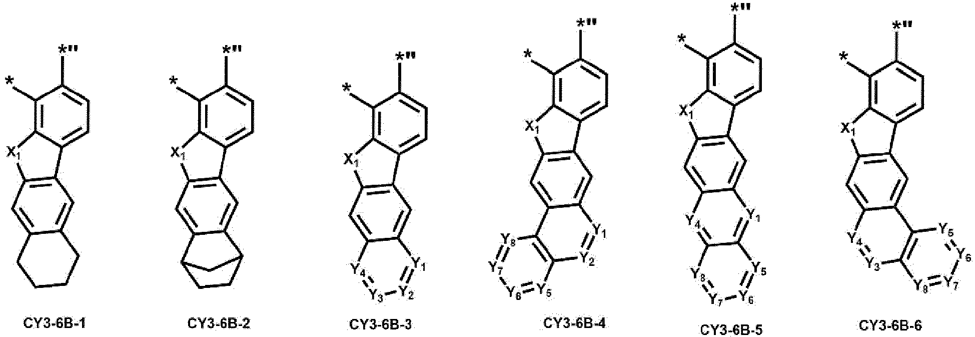

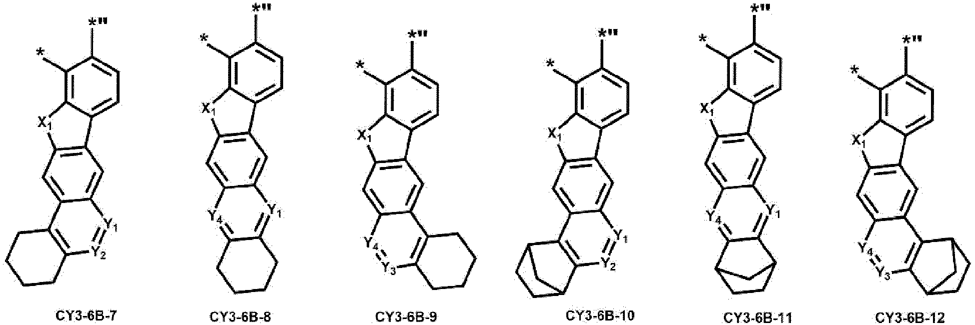

In one or more embodiments, a group represented by 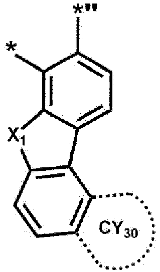 in Formula CY3-6C may be a group represented by one of Formulae CY3-6C-1 to CY3-6C-12:

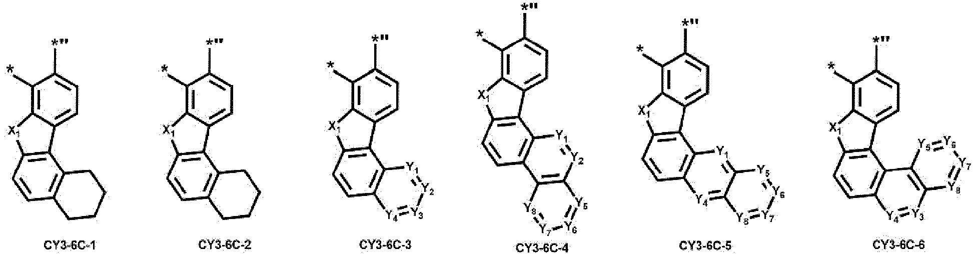

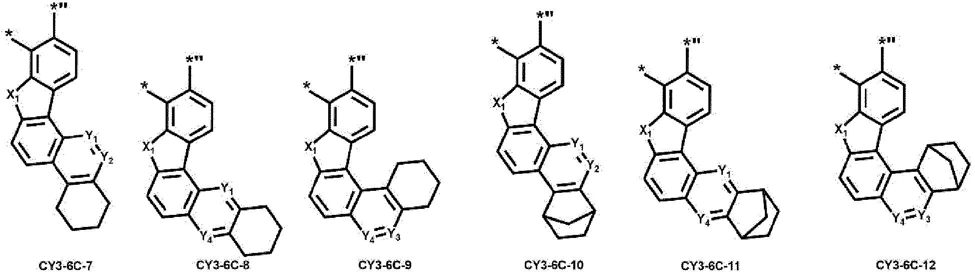

In the Formulae CY3-1A-1 to CY3-1A-12, CY3-1B-1 to CY3-1B-12, CY3-1C-1 to CY3-1C-12, CY3-2A-1 to CY3-2A-12, CY3-2B-1 to CY3-2B-12, CY3-2C-1 to CY3-2C-12, CY3-3A-1 to CY3-3A-12, CY3-3B-1 to CY3-3B-12, CY3-3C-1 to CY3-3C-12, CY3-4A-1 to CY3-4A-12, CY3-4B-1 to CY3-4B-12, CY3-4C-1 to CY3-4C-12, CY3-5A-1 to CY3-5A-12, CY3-5B-1 to CY3-5B-12, CY3-5C-1 to CY3-5C-12, CY3-6A-1 to CY3-6A-12, CY3-6B-1 to CY3-6B-12, and CY3-6C-1 to CY3-6C-12,
X₁ may be the same as described above,
Y₁ to Y₈ may each independently be C or N,
* indicates a binding site to M in Formula 1, and
*" indicates a binding site to a neighboring atom in Formula 3.

For example, Y₁ to Y₈ may each independently be C.

For example, one of Y₁ to Y₈ may be N and reminders may be C.

In one or more embodiments, a group represented by 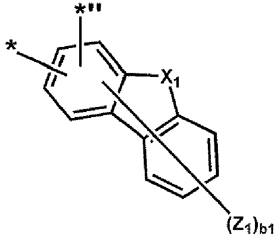 in Formula 3 may be a group represented by one of Formulae CY3(1) to CY3(132):

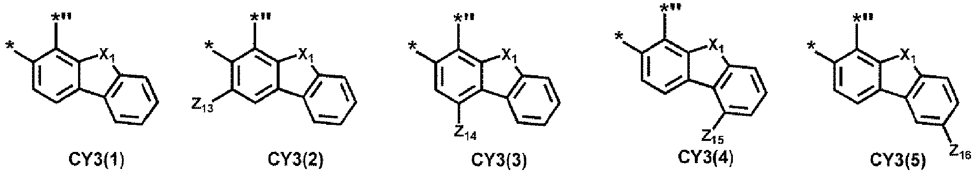

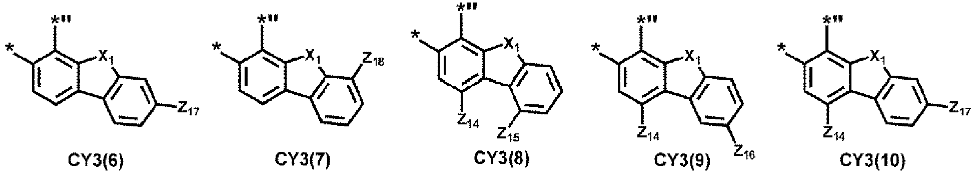

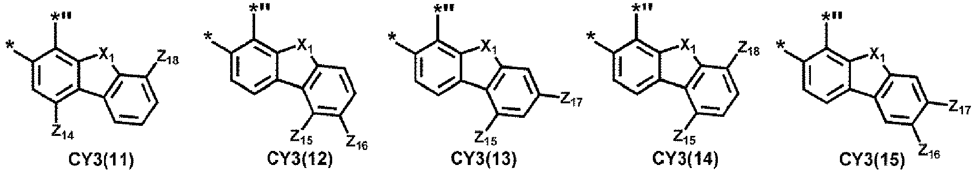

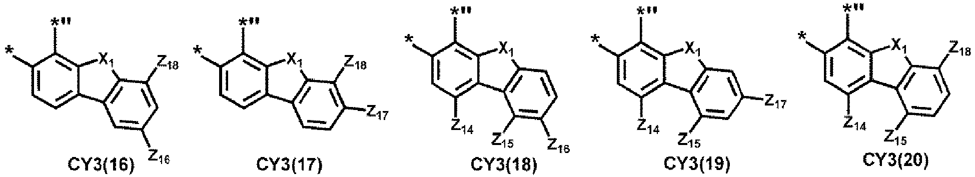

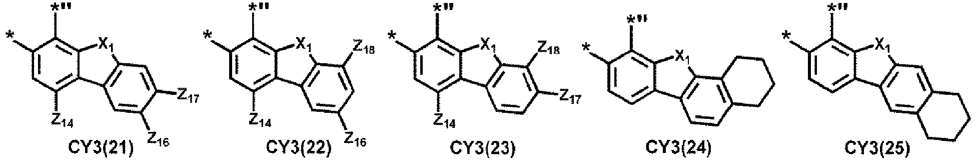

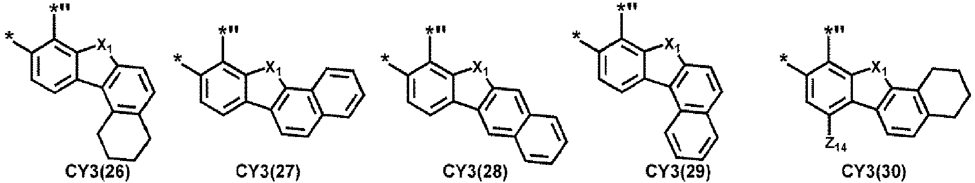

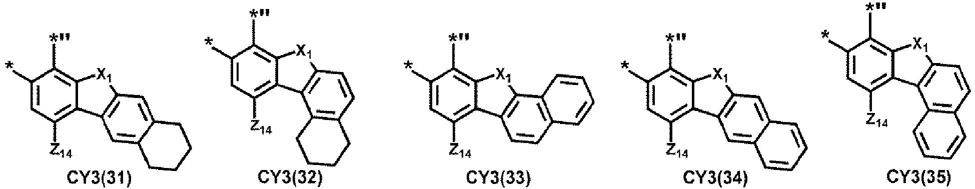

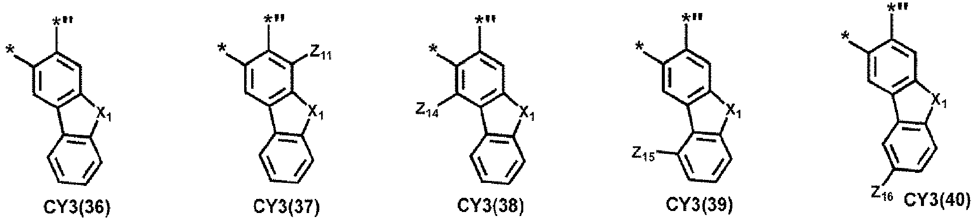

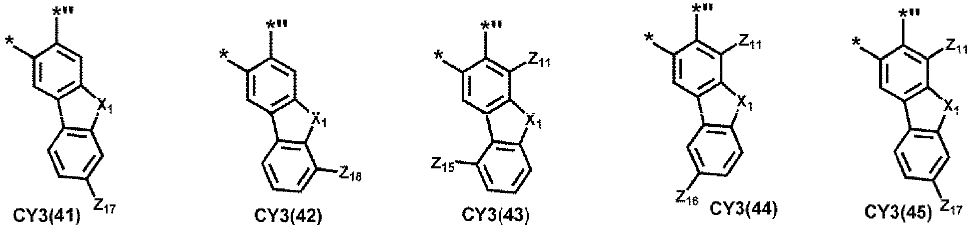

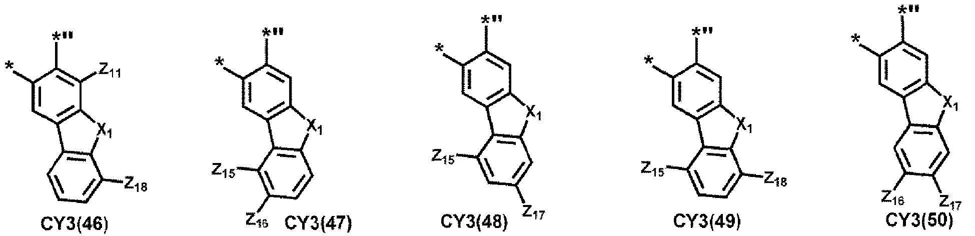

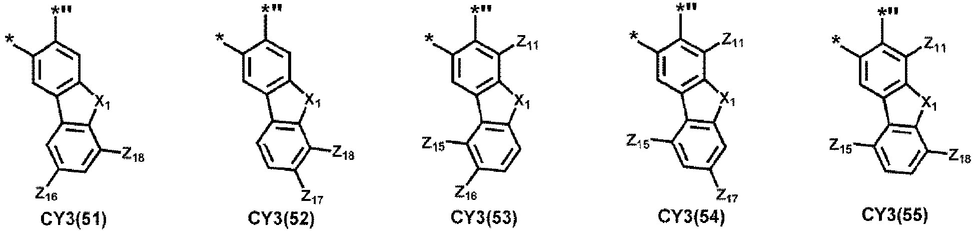

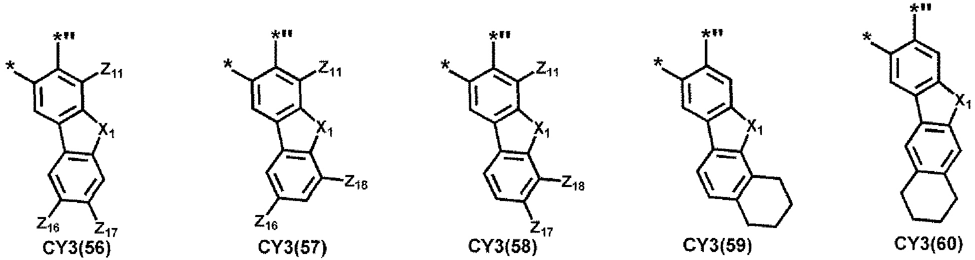

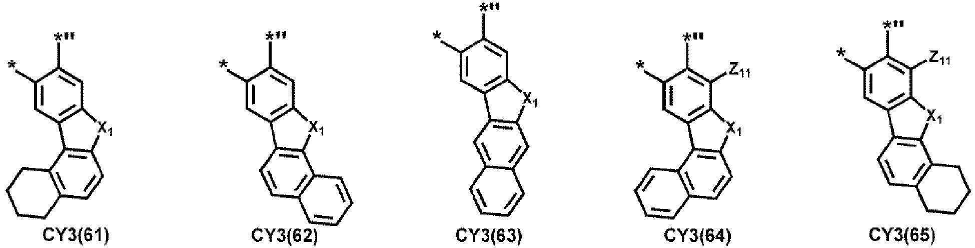

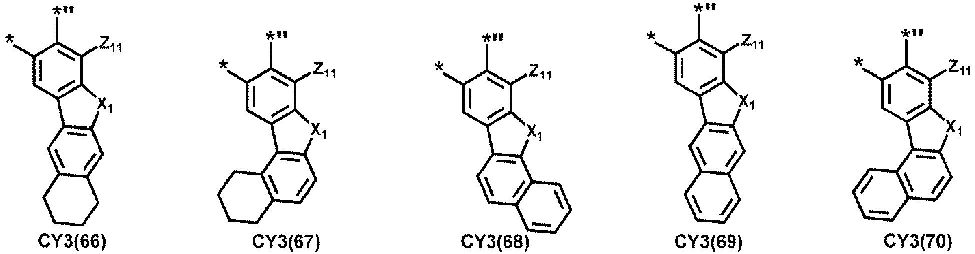

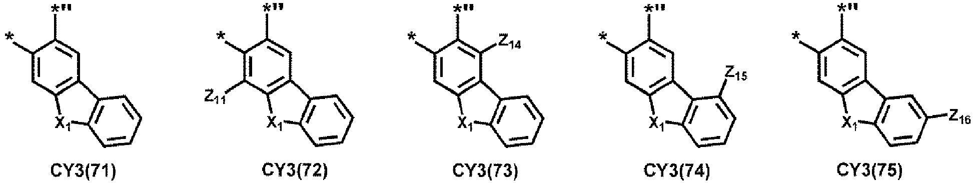

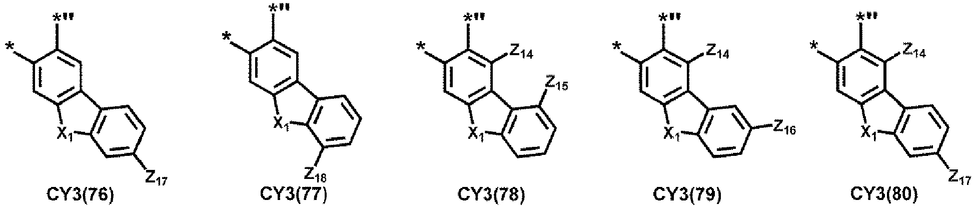

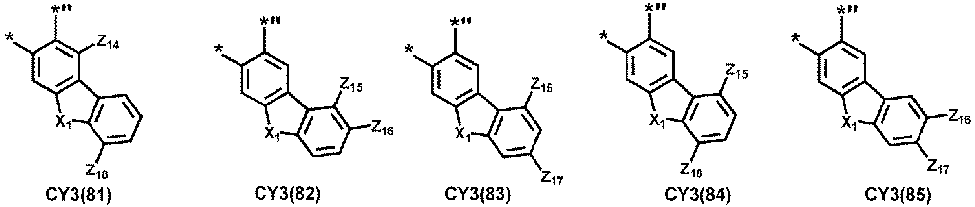

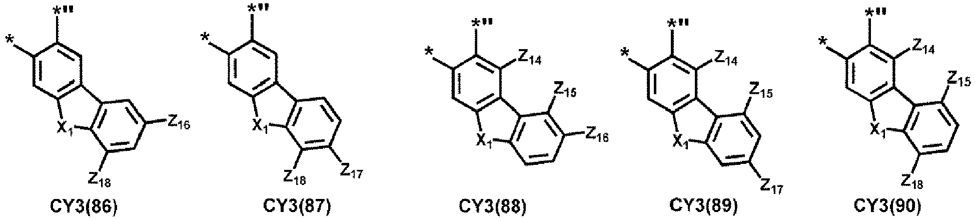

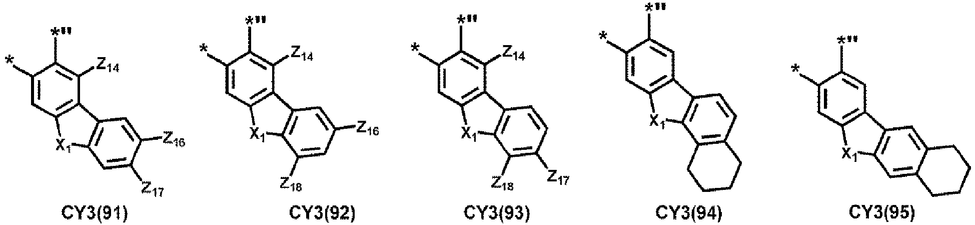

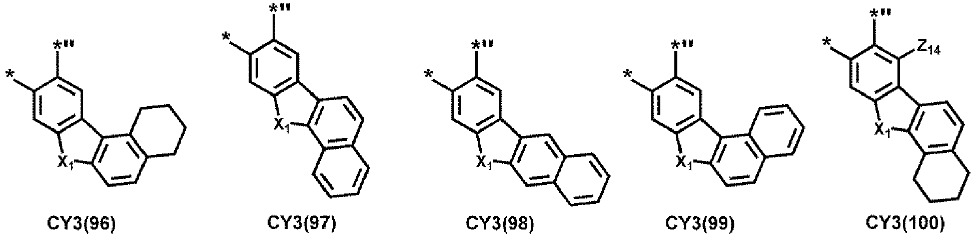

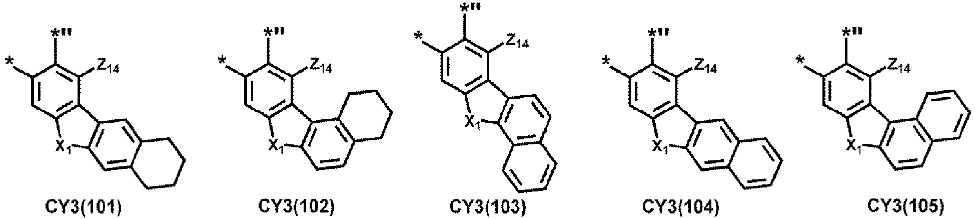

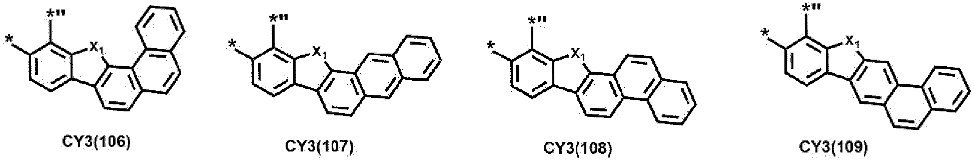

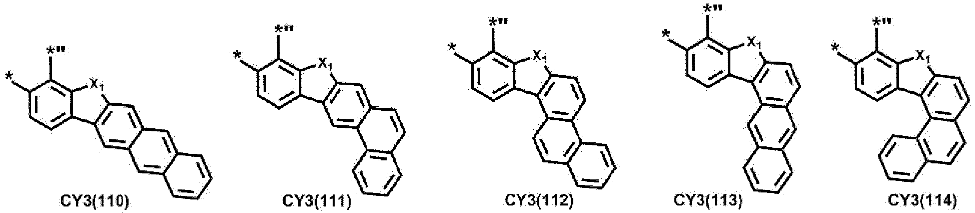

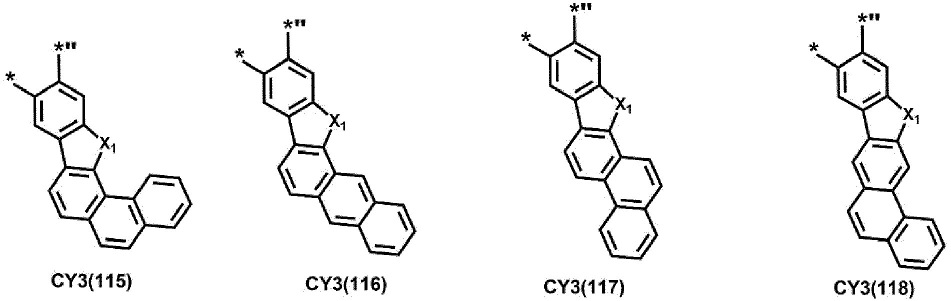

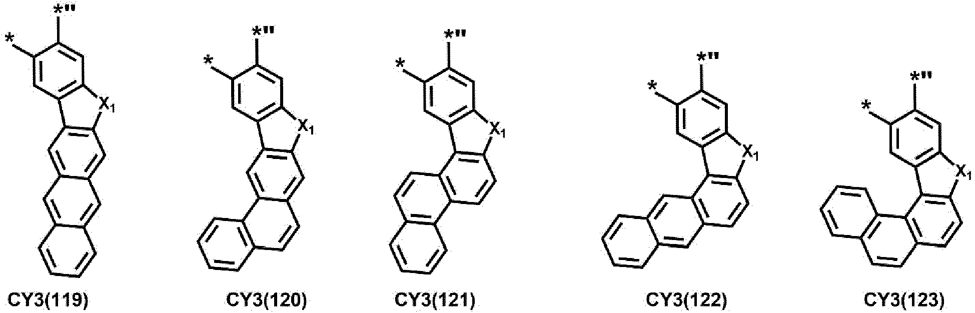

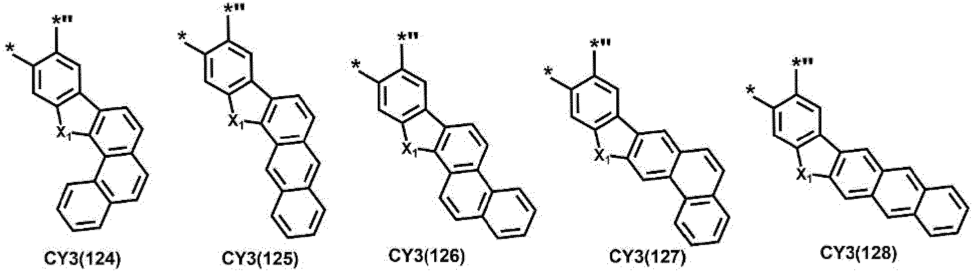

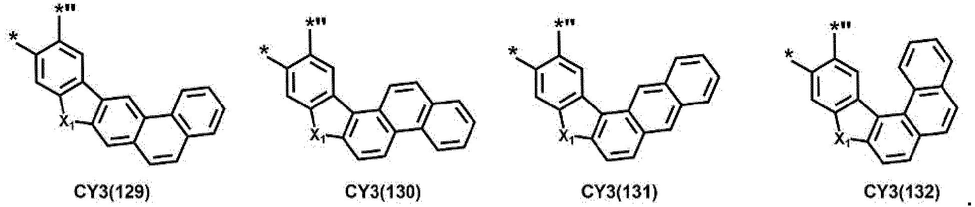

In Formulae CY3(1) to CY3(132),
X₁ is the same as described above,
Z₁₁ to Z₁₈ are the same as described in connection with Z₁, and each of Z₁₁ to Z₁₈ is not hydrogen,
* indicates a binding site to M in Formula 1, and
*" indicates a binding site to a neighboring atom in Formula 3.

In one or more embodiments, a group represented by 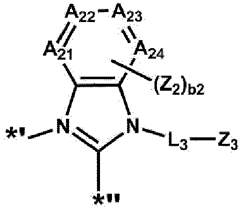 in Formula 3 may be a group represented by one of Formulae CY4-1 to CY4-60:

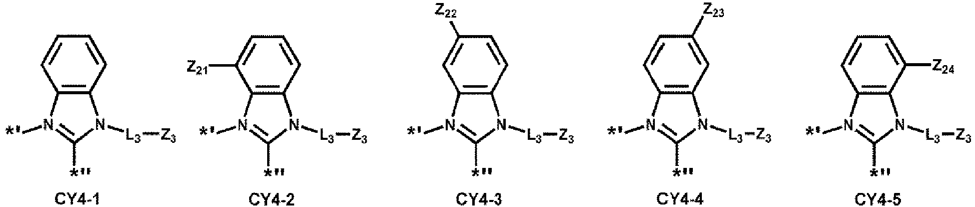

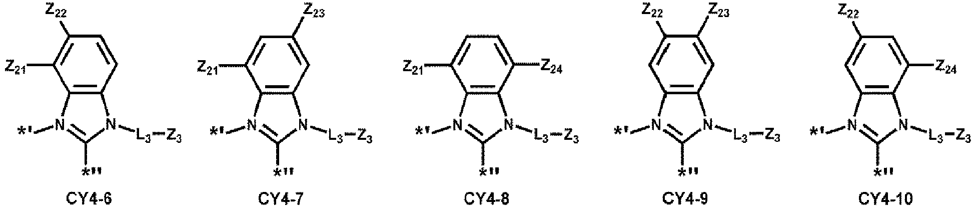

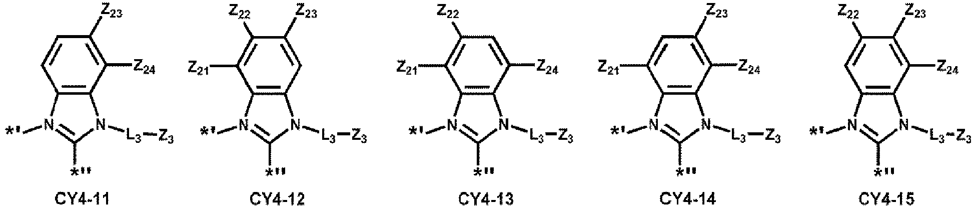

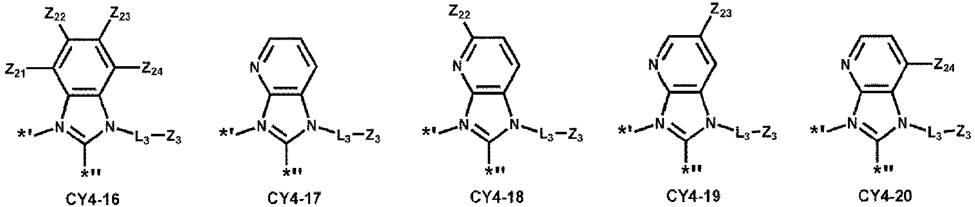

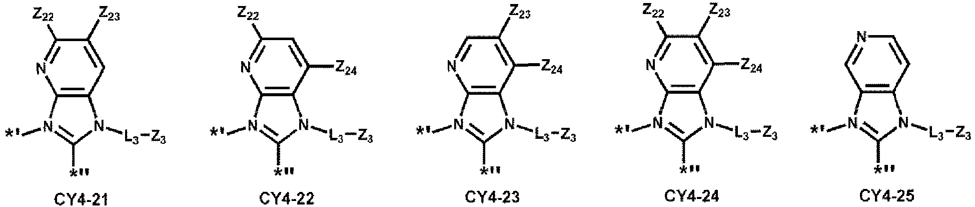

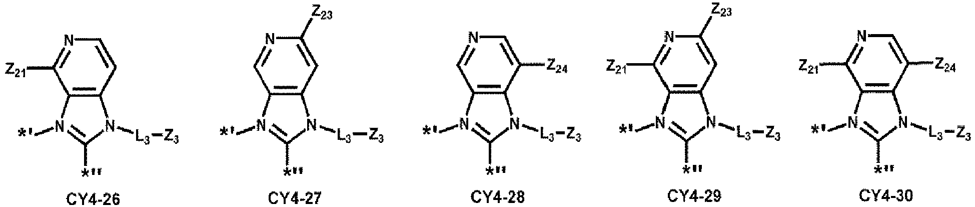

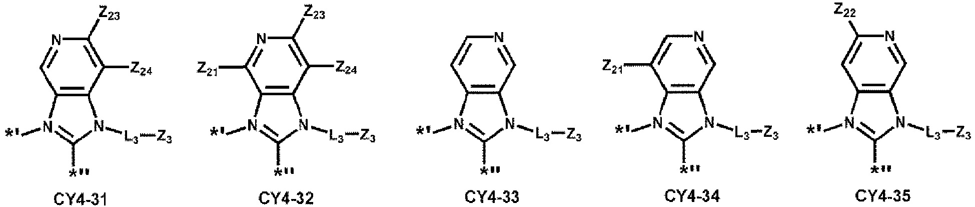

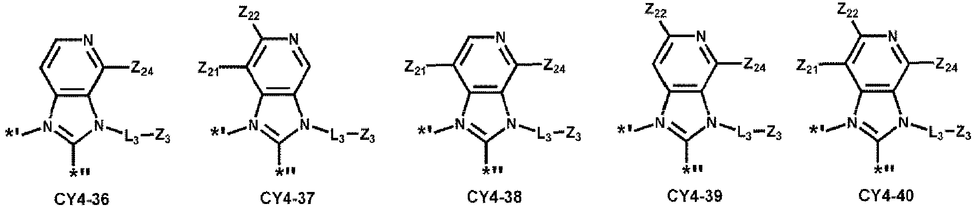

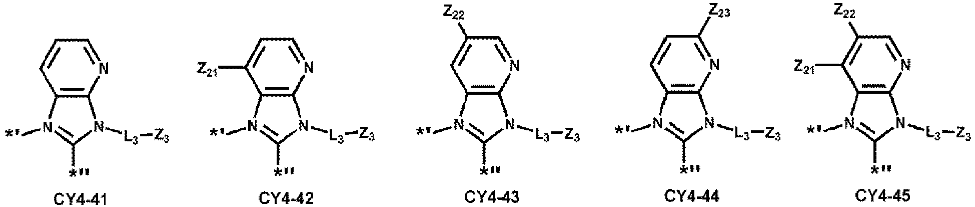

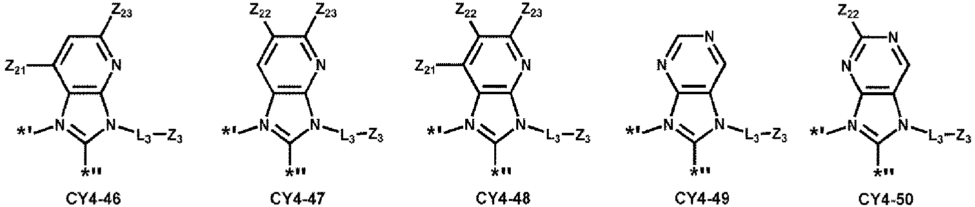

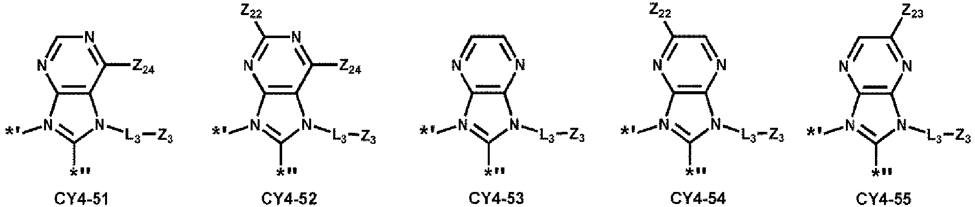

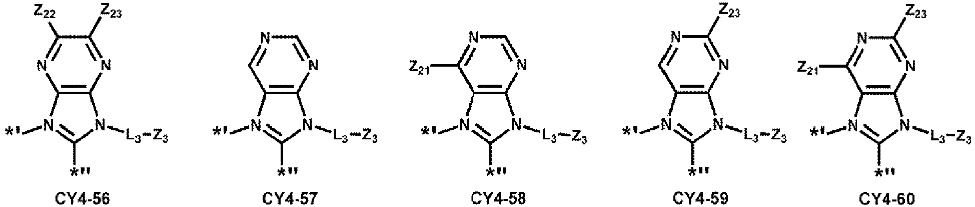

In Formulae CY4-1 to CY4-60,
L₃ and Z₃ are the same as described above,
Z₂₁ to Z₂₄ are the same as described in connection with Z₂, and each of Z₂₁ to Z₂₄ is not hydrogen,
*' indicates a binding site to M in Formula 1, and
*" indicates a binding site to a neighboring atom in Formula 3.

In one or more embodiments, two or more of a plurality of Z₂(s) in a group represented by 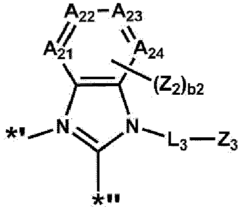 in Formula 3 may be linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ. As a result, a group represented by 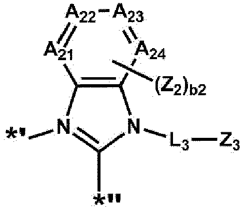 in Formula 3 may be a group represented by one of Formulae CY4(1) to CY4(4):

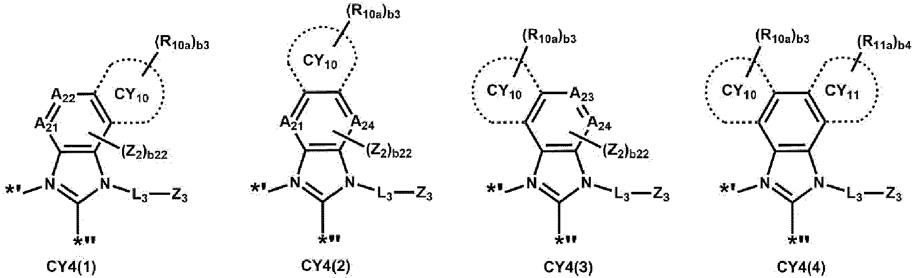

In Formulae CY4(1) to CY4(4),
A₂₁ to A₂₄, L₃, Z₂ , Z₃ and R₁₀ₐ are the same as described above,
b22 may be an integer from 0 to 2,
ring CY₁₀ and ring CY₁₁ may each independently be a C₅-C₃₀ carbocyclic group or a C₁-C₃₀ heterocyclic group,
R₁₁ₐ is the same as described in connection with R₁₀ₐ,
b3 and b4 may each independently be an integer from 0 to 20, when b3 is 2 or more, two or more R₁₀ₐ(s) may be identical to or different from each other, and when b4 is 2 or more, two or more R₁₁ₐ(s) may be identical to or different from each other,
*' indicates a binding site to M in Formula 1, and
*" indicates a binding site to a neighboring atom in Formula 3.

For example, ring CY₁₀ and ring CY₁₁ in Formulae CY4(1) to CY4(4) may each independently be a benzene group or a naphthalene group.

In one or more embodiments, a group represented by 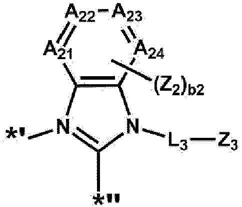 in Formula 3 may be a group represented by one of Formulae CY4(1)-1 to CY4(1)-4, CY4(2)-1 to CY4(2)-4, CY4(3)-1 to CY4(3)-4 and CY4(4)-1:

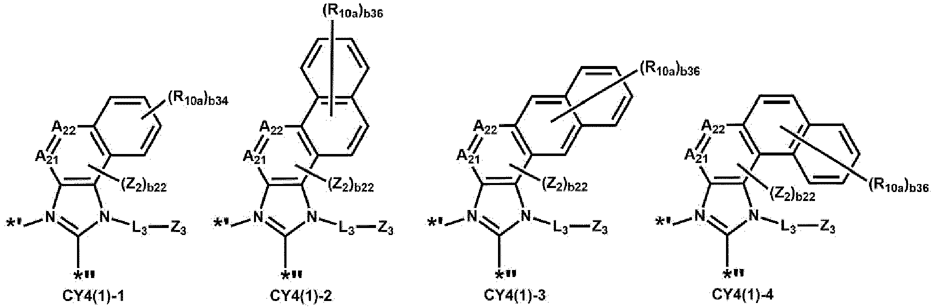

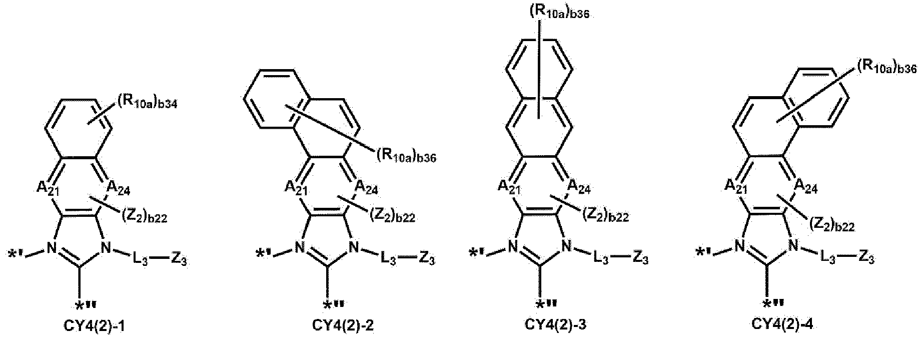

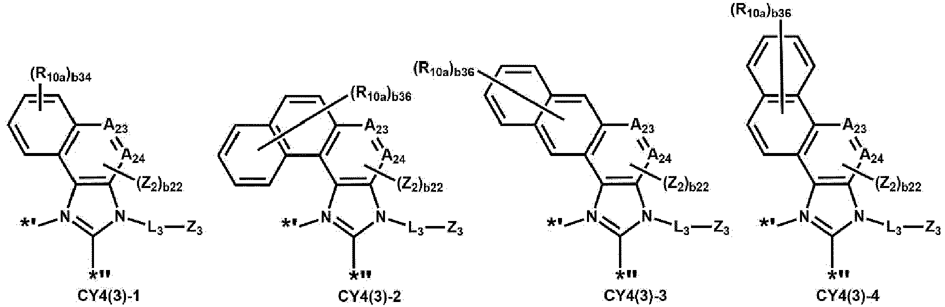

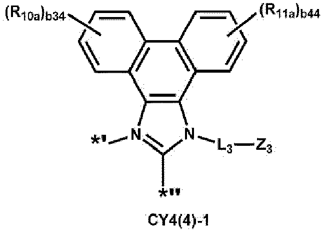

In Formulae CY4(1)-1 to CY4(1)-4, CY4(2)-1 to CY4(2)-4, CY4(3)-1 to CY4(3)-4 and CY4(4)-1,
A₂₁ to A₂₄, L₃, Z₂ , Z₃ and R₁₀ₐ are the same as described above,
b22 may be an integer from 0 to 2,
R₁₁ₐ is the same as described in connection with R₁₀ₐ,
b34 and b44 may each independently be an integer from 0 to 4, when b34 is 2 or more, two or more R₁₀ₐ(s) may be identical to or different from each other, and when b44 is 2 or more, two or more R₁₁ₐ(s) may be identical to or different from each other,
b36 may be an integer from 0 to 6, when b36 is 2 or more, two or more R₁₀ₐ(s) may be identical to or different from each other,
*' indicates a binding site to M in Formula 1, and
*" indicates a binding site to a neighboring atom in Formula 3.

In one or more embodiments, the organometallic compound represented by Formula 1 may emit red light or green light, for example, red light or green light, each having a maximum emission wavelength of about 500 nm or more, for example, from about 500 nm or more and about 850 nm or less. For example, the organometallic compound may emit green light.

For example, the organometallic compound may be one of Compounds 1 to 3350 below:

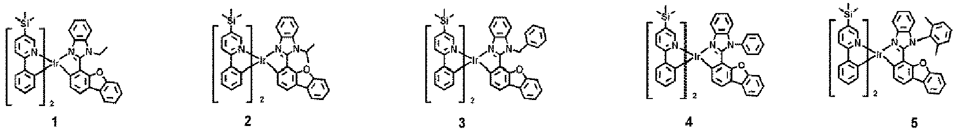

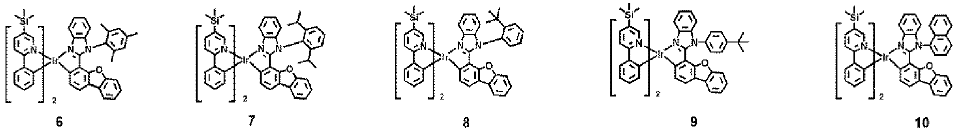

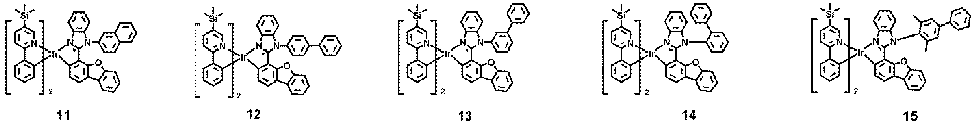

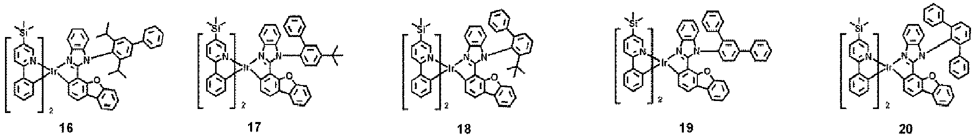

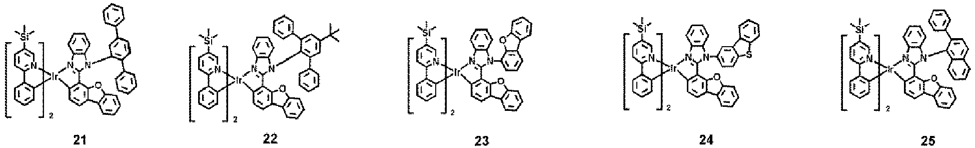

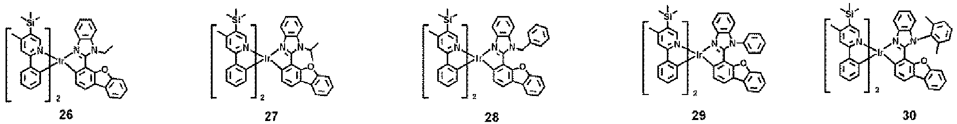

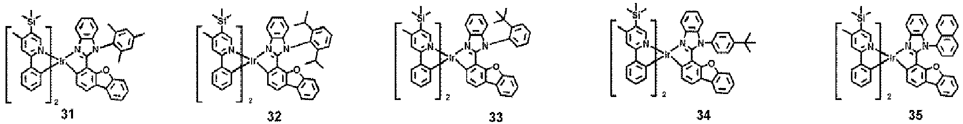

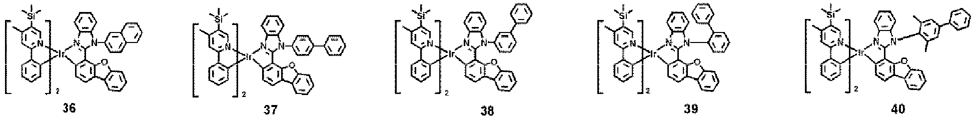

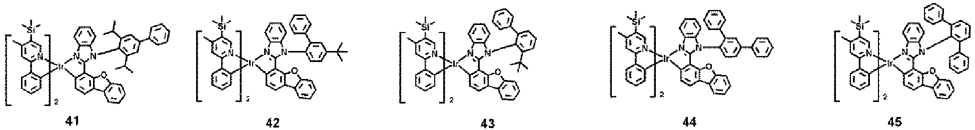

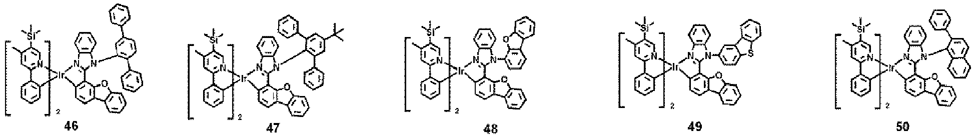

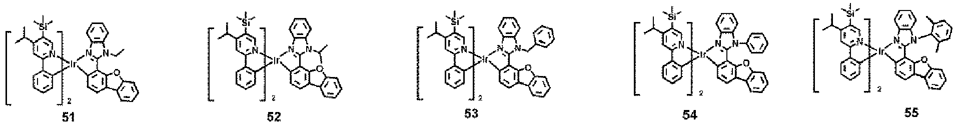

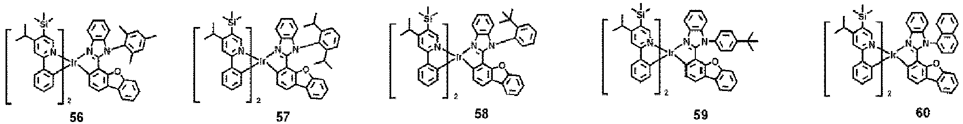

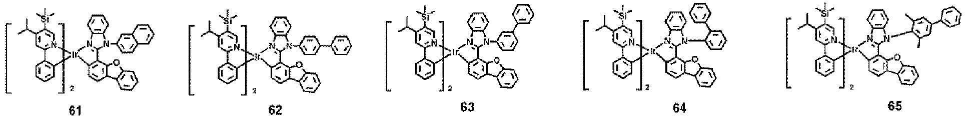

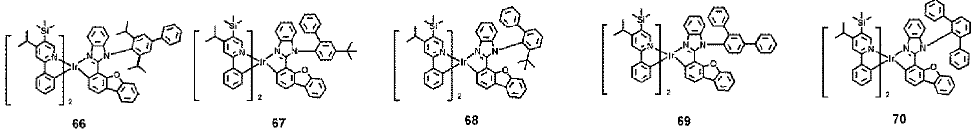

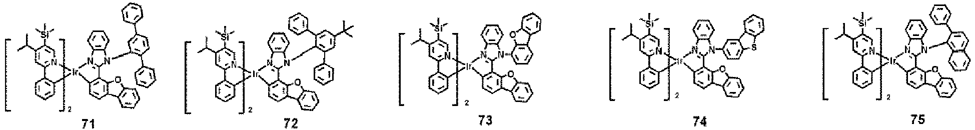

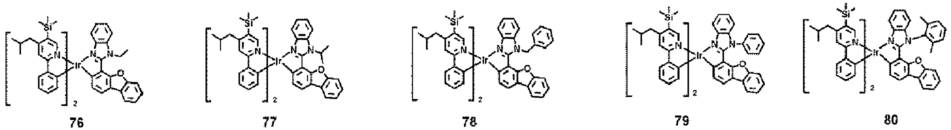

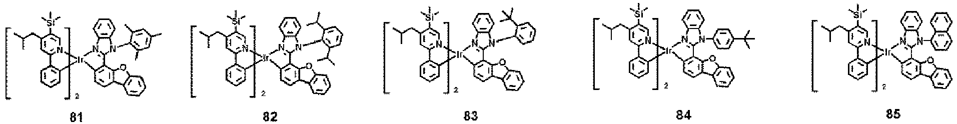

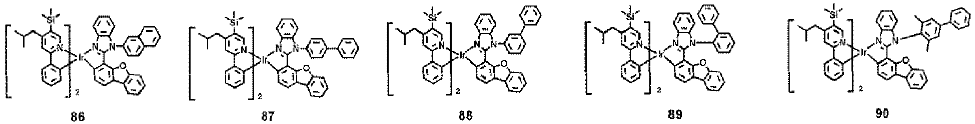

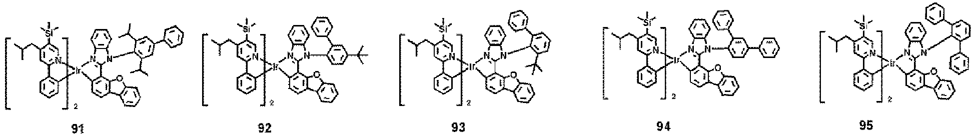

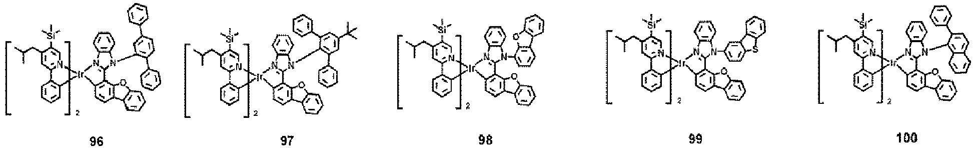

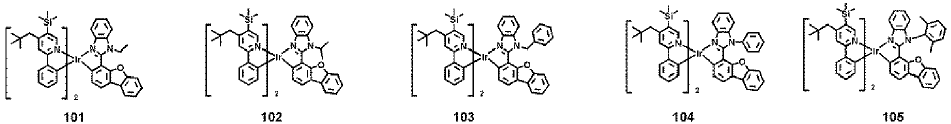

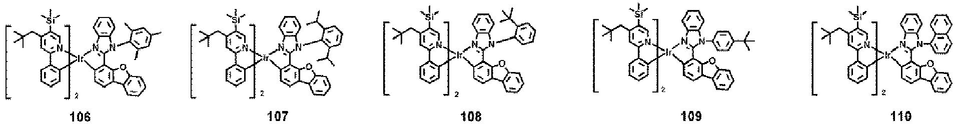

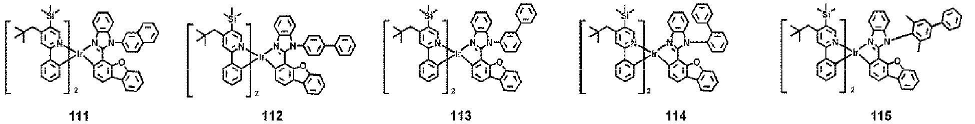

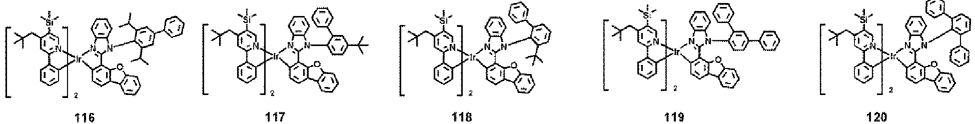

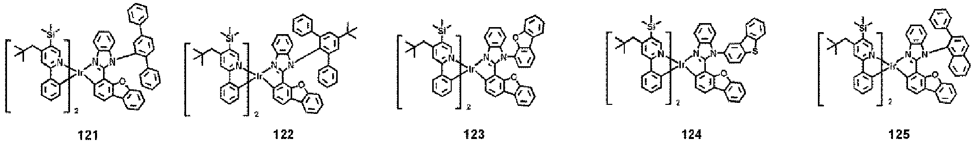

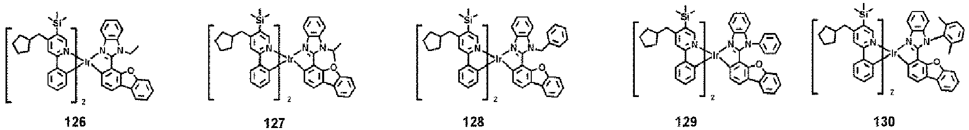

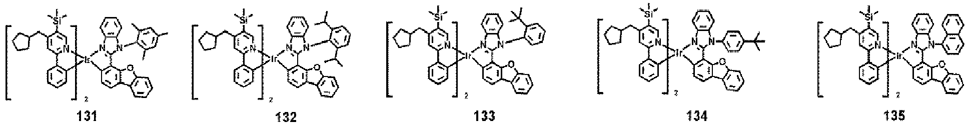

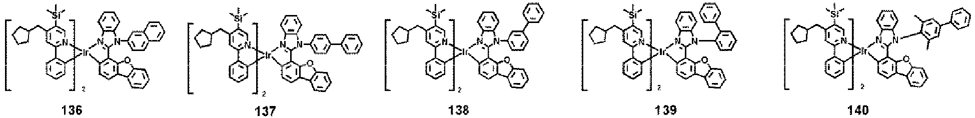

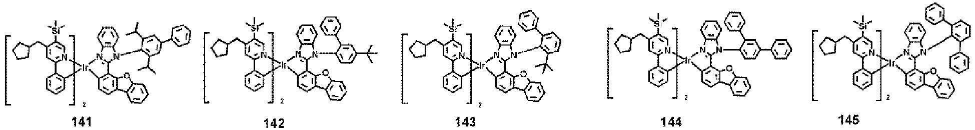

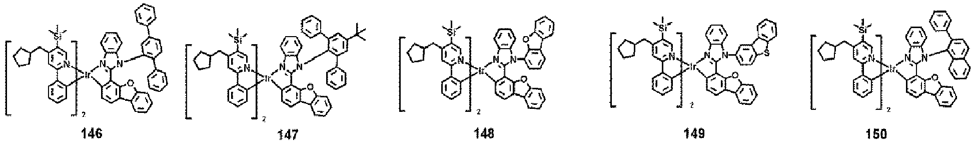

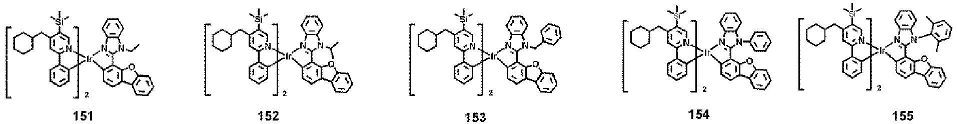

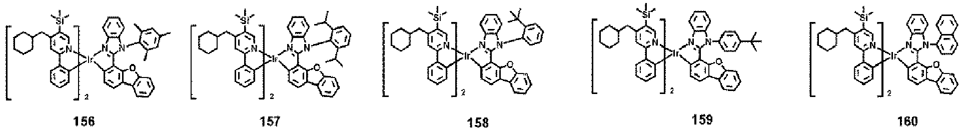

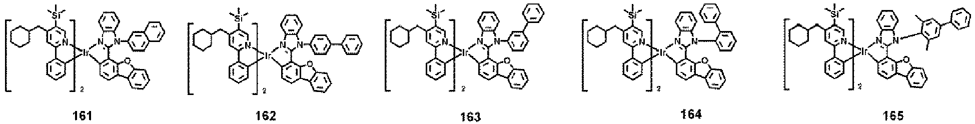

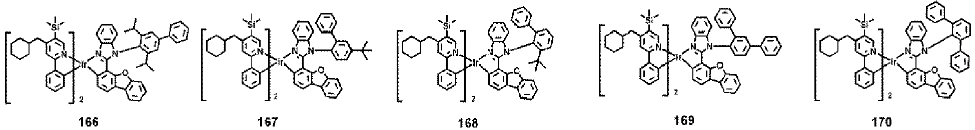

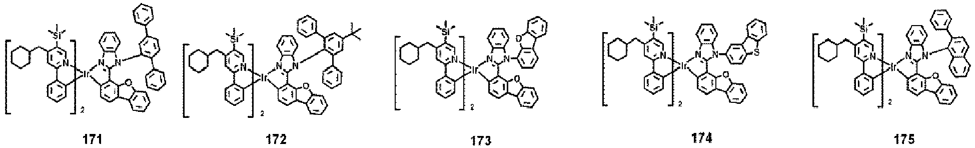

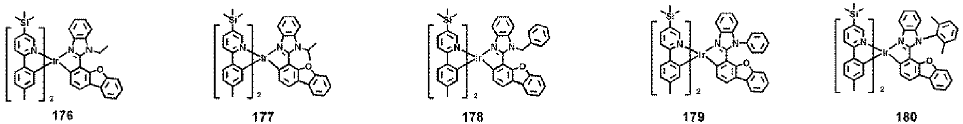

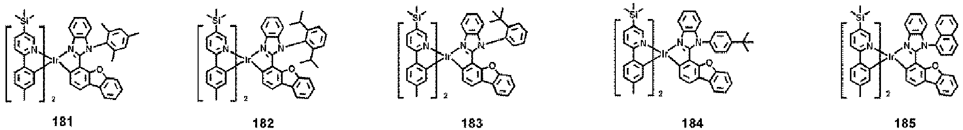

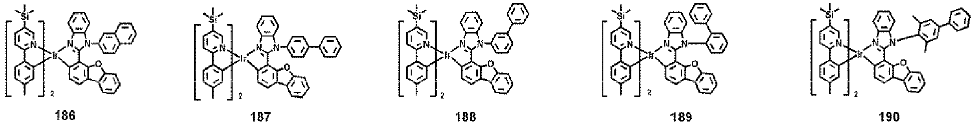

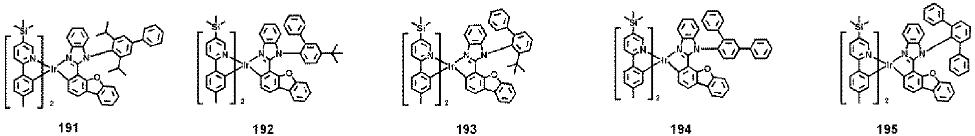

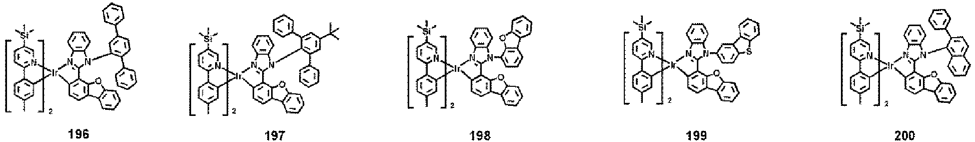

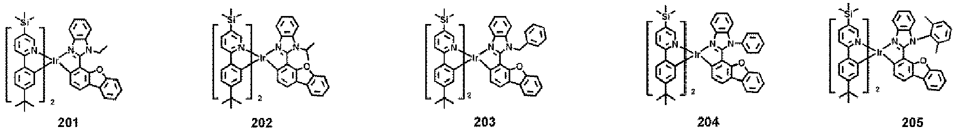

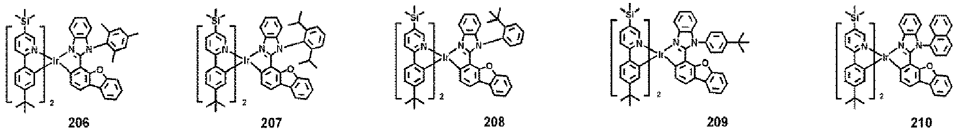

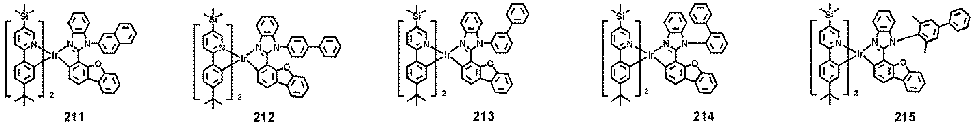

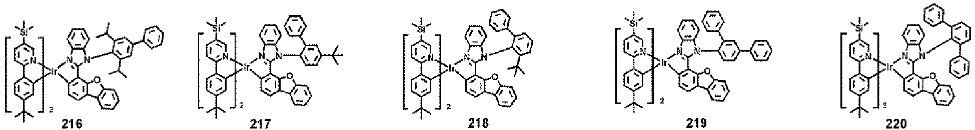

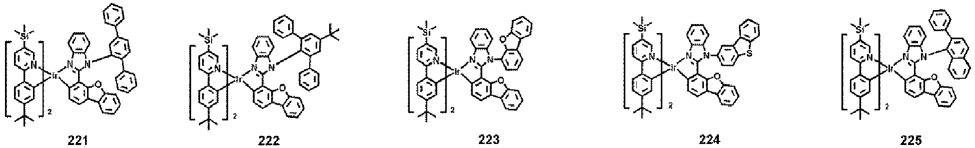

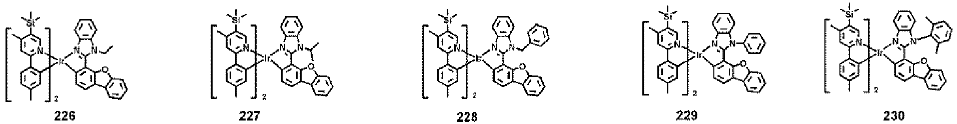

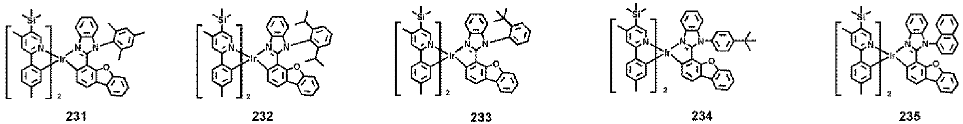

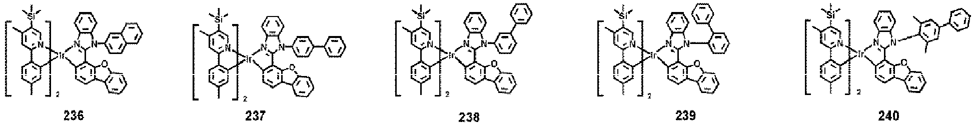

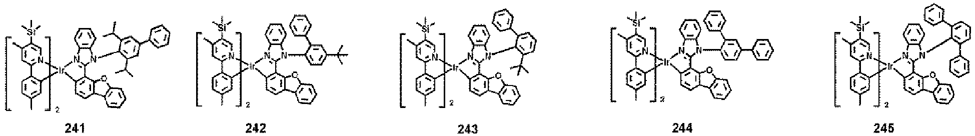

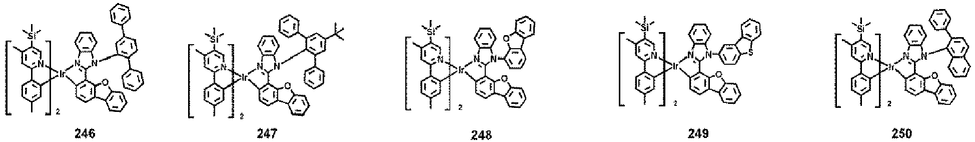

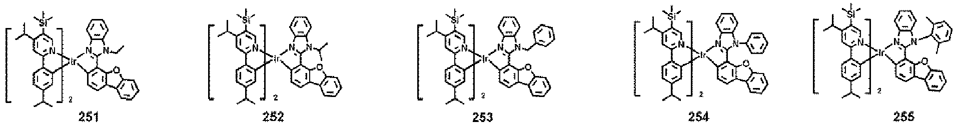

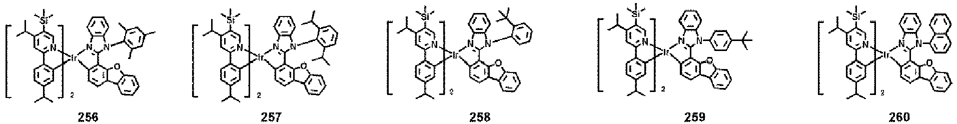

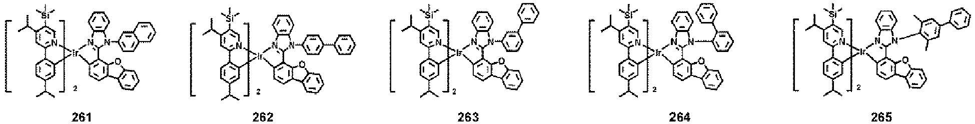

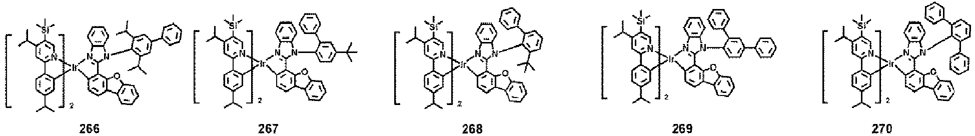

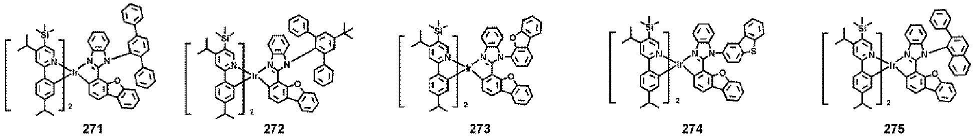

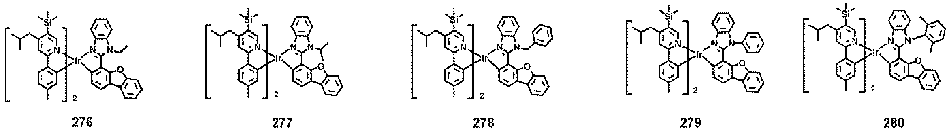

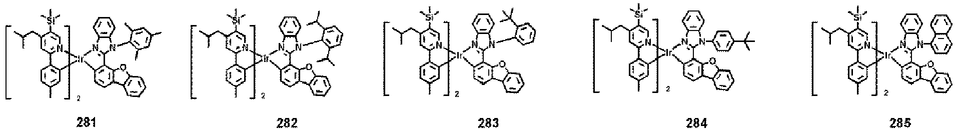

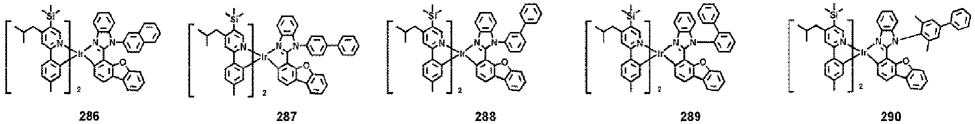

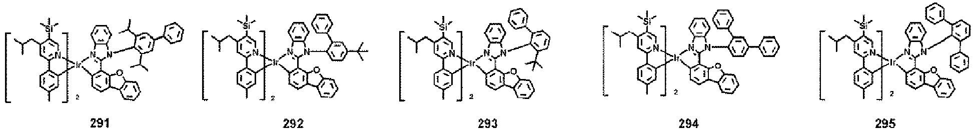

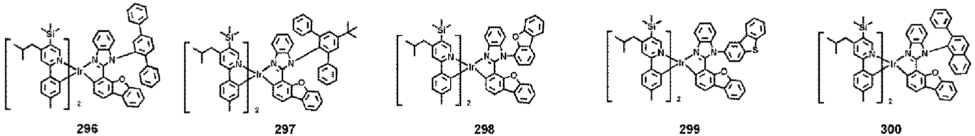

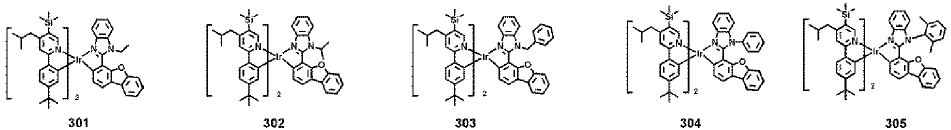

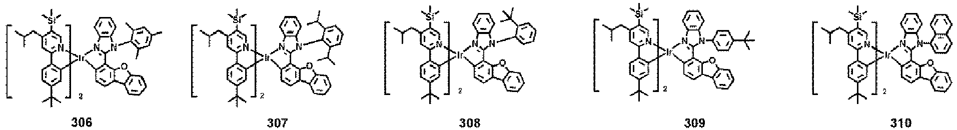

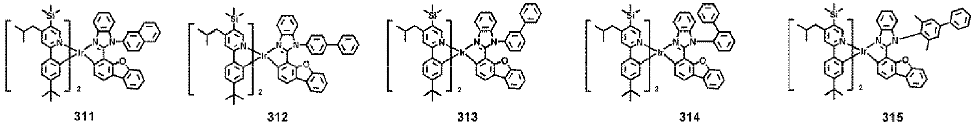

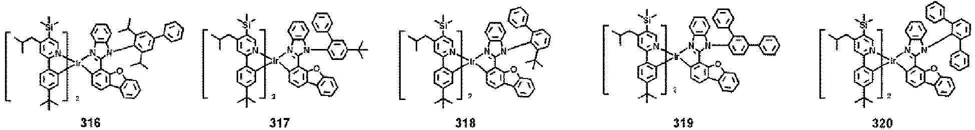

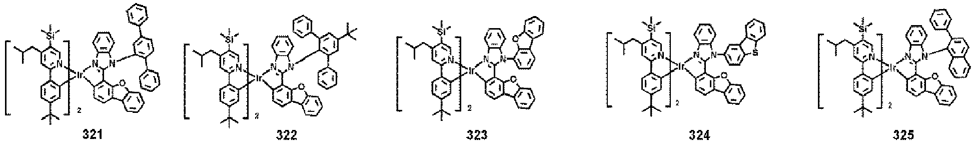

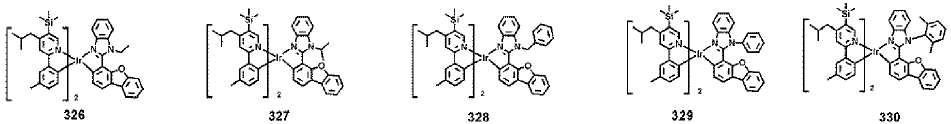

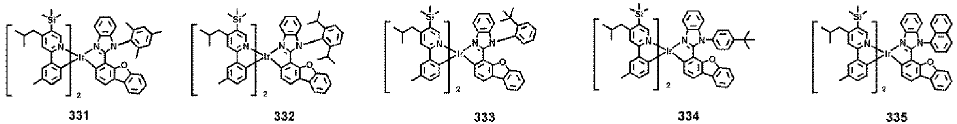

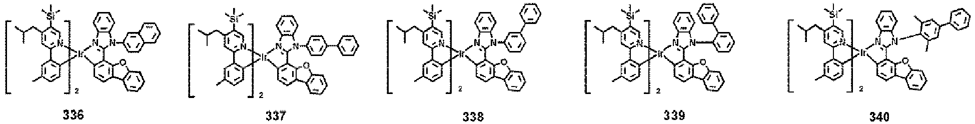

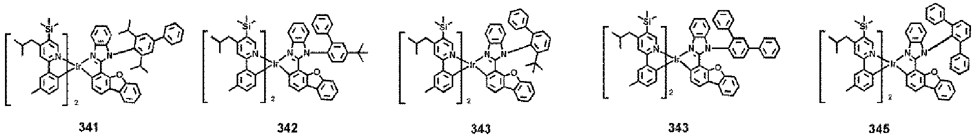

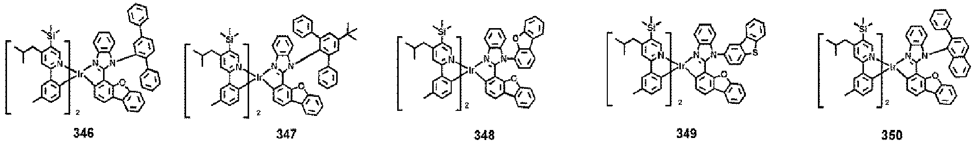

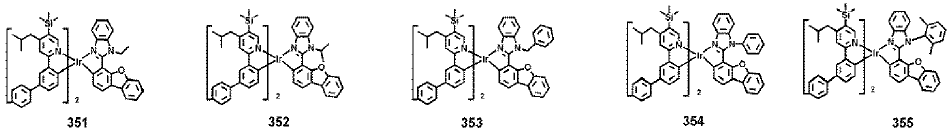

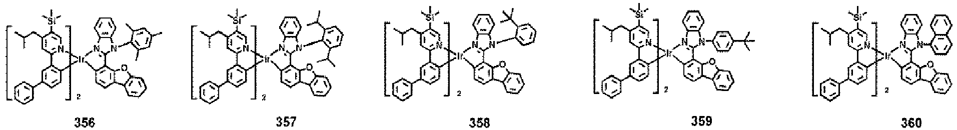

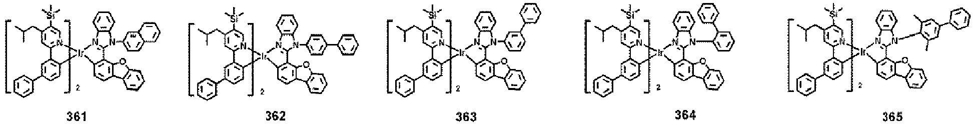

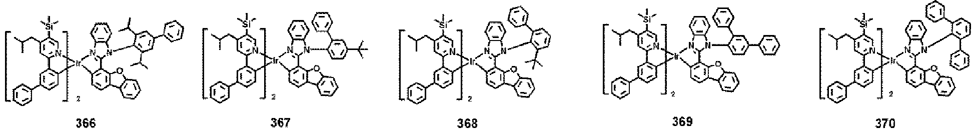

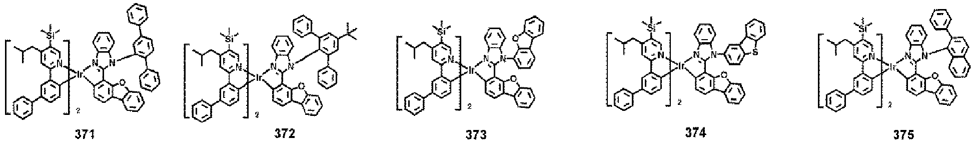

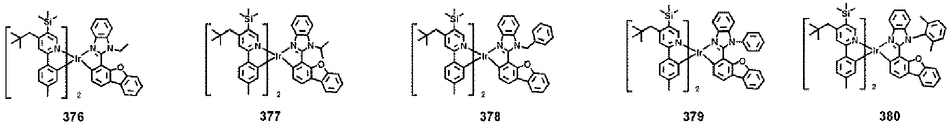

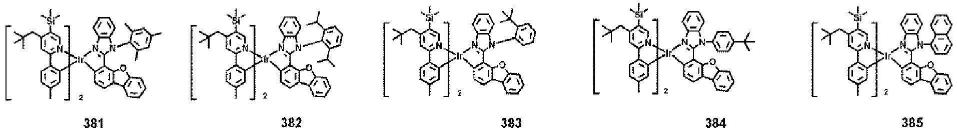

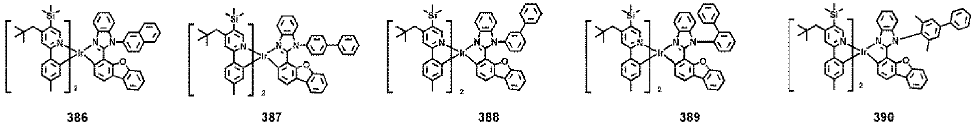

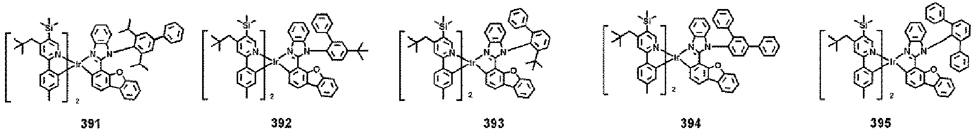

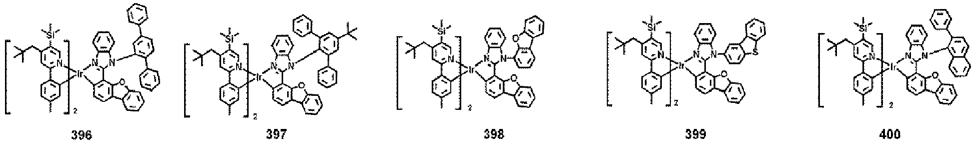

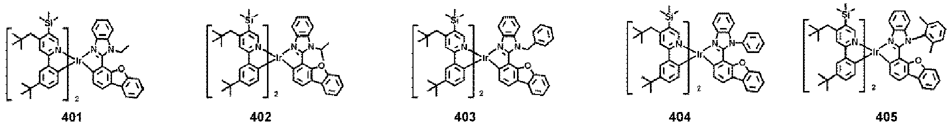

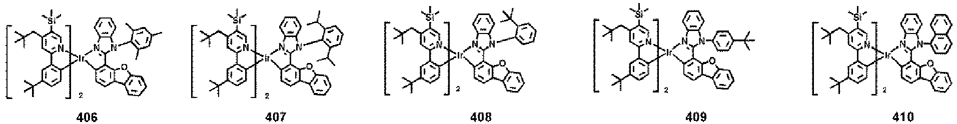

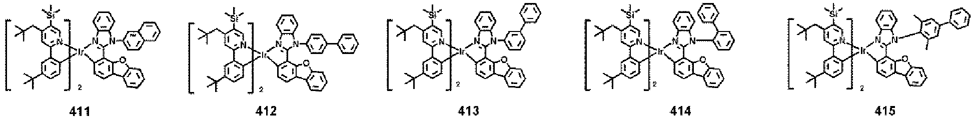

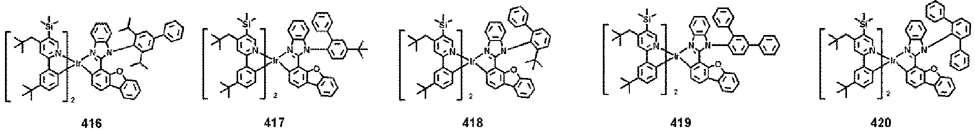

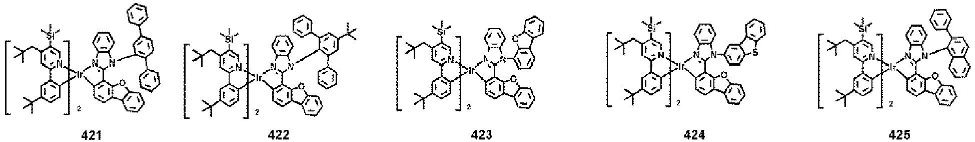

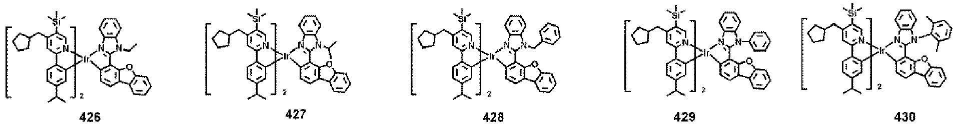

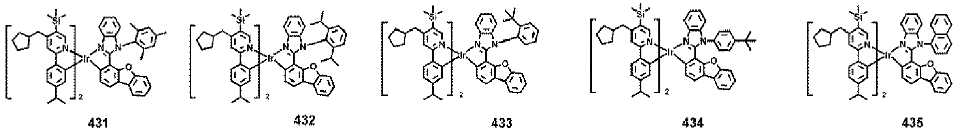

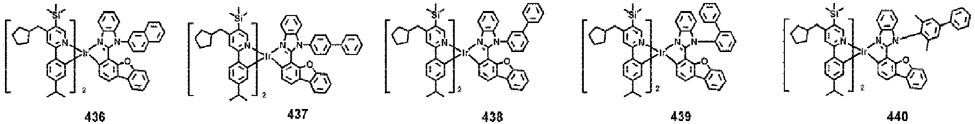

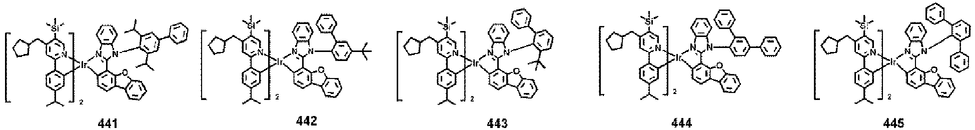

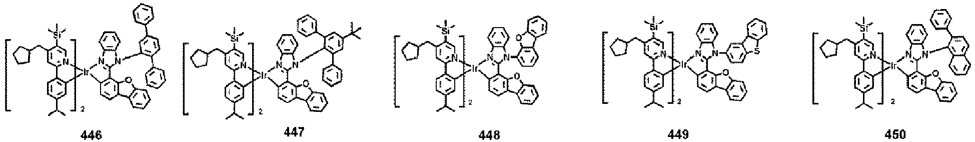

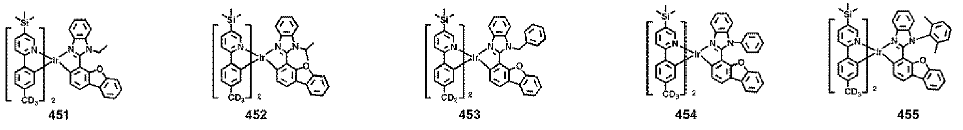

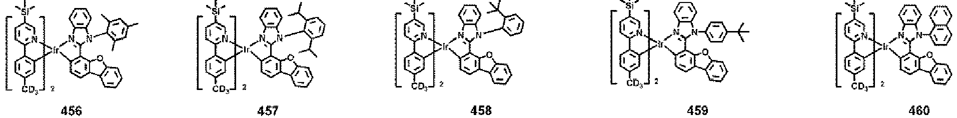

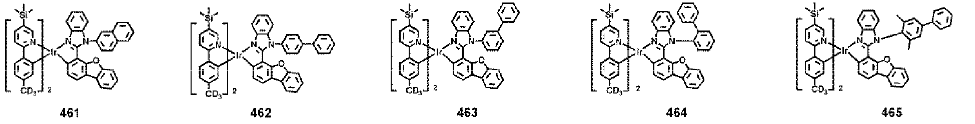

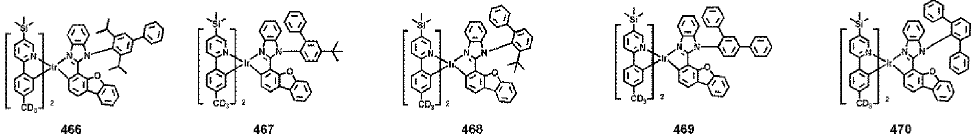

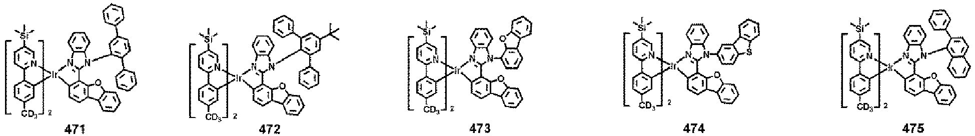

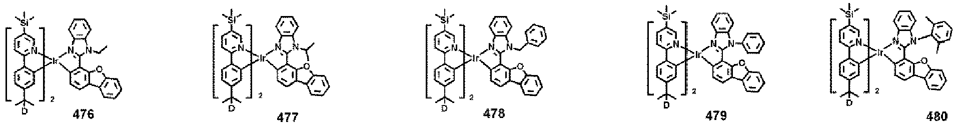

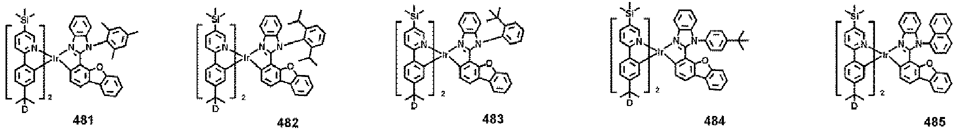

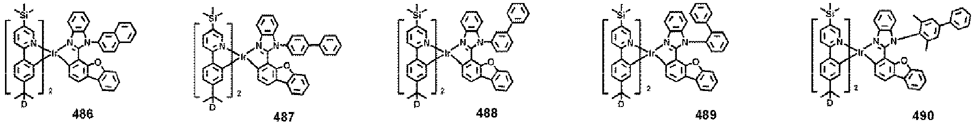

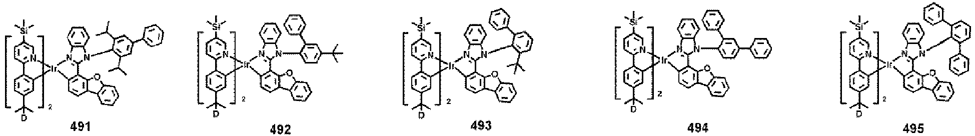

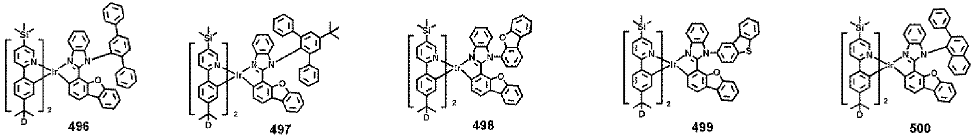

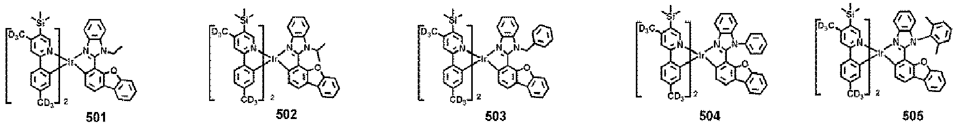

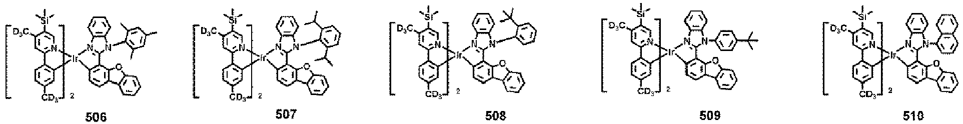

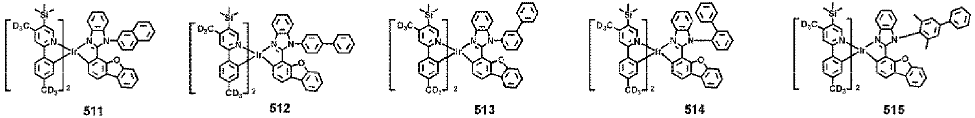

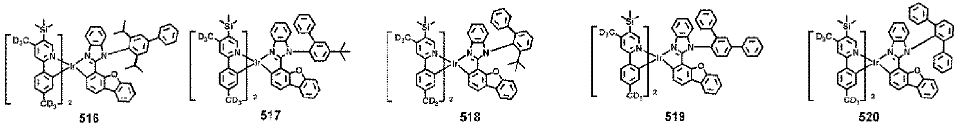

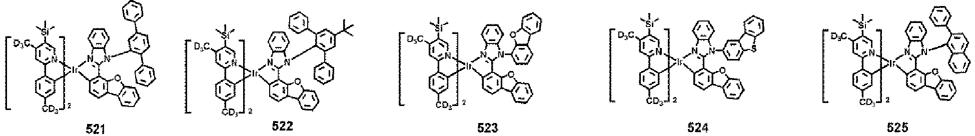

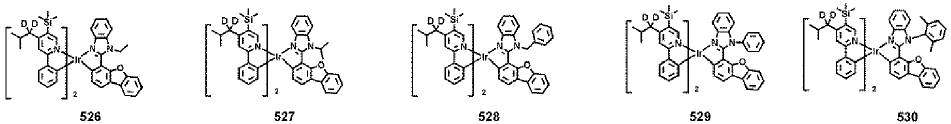

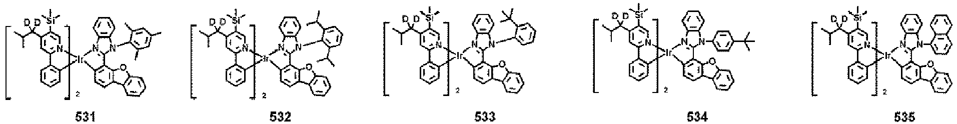

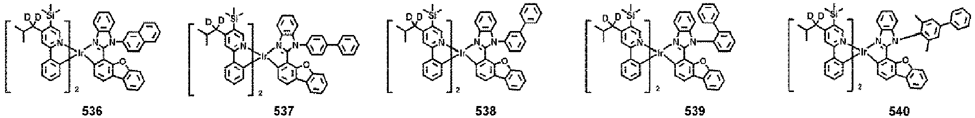

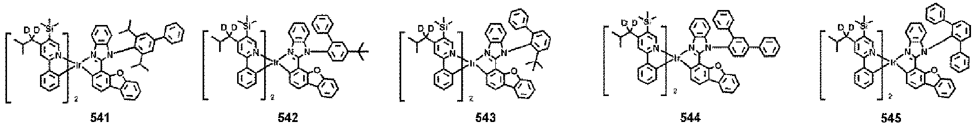

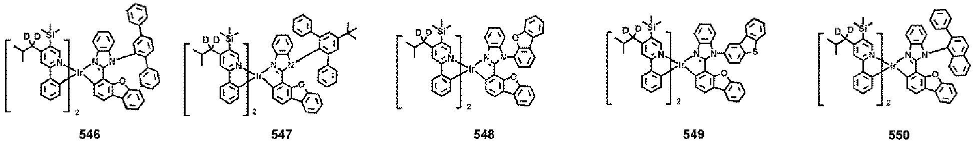

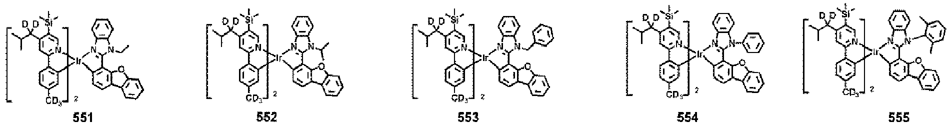

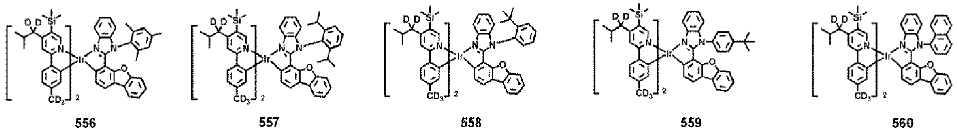

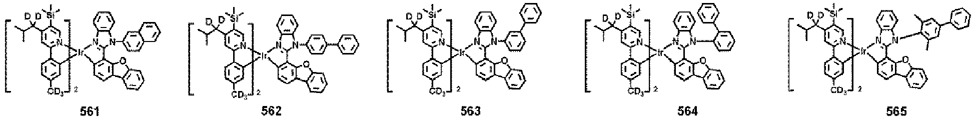

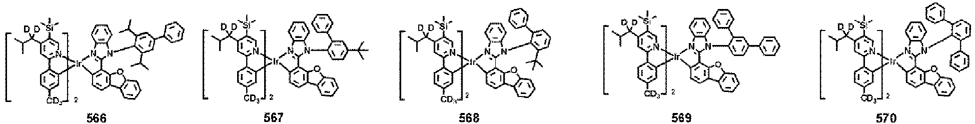

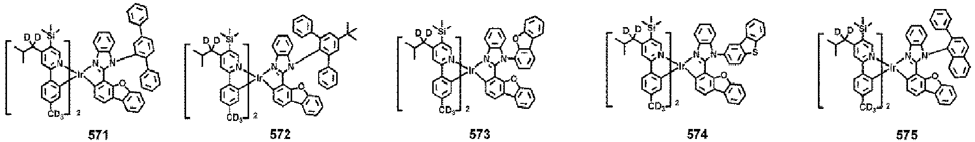

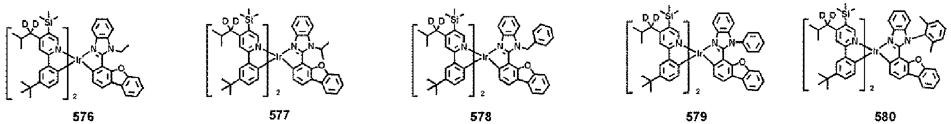

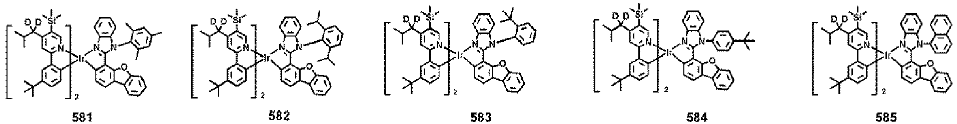

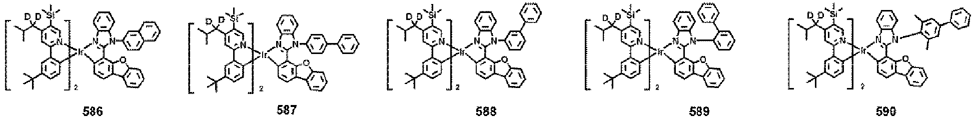

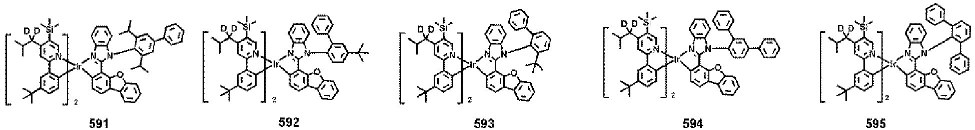

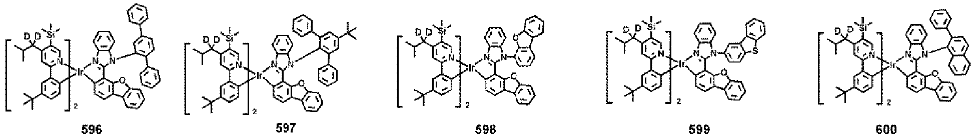

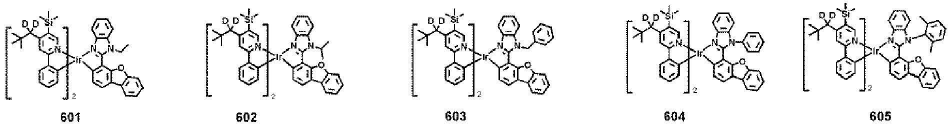

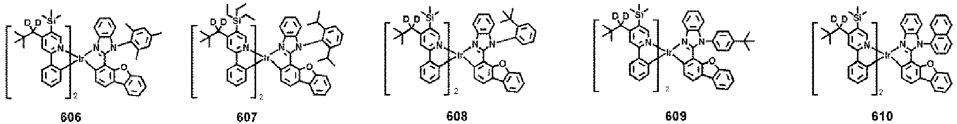

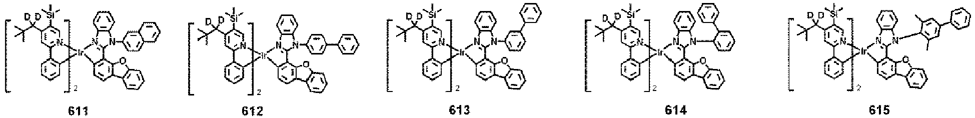

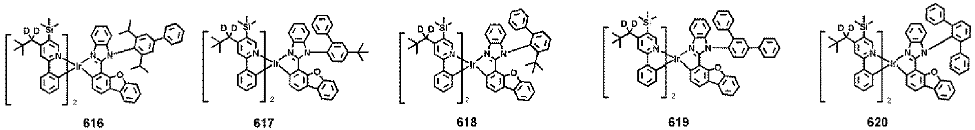

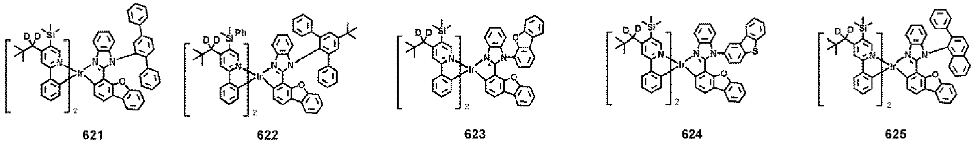

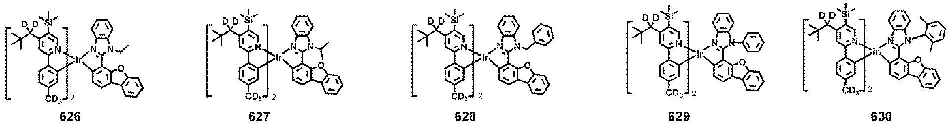

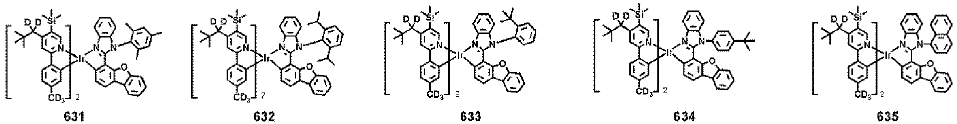

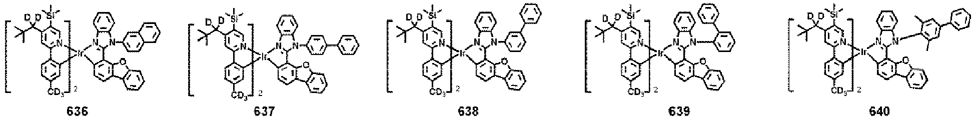

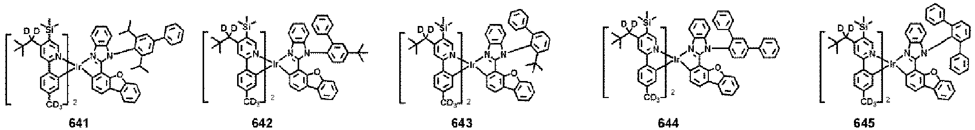

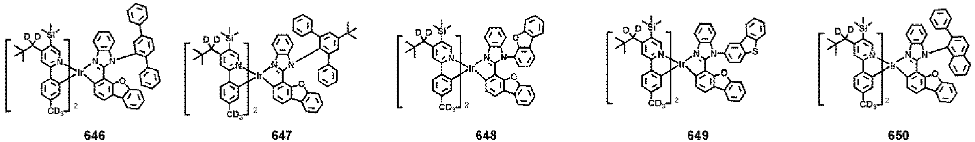

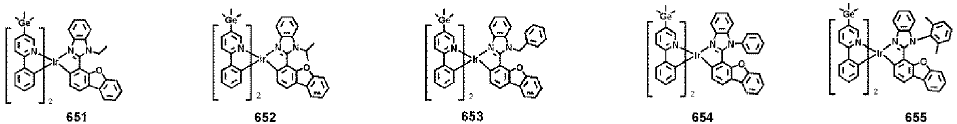

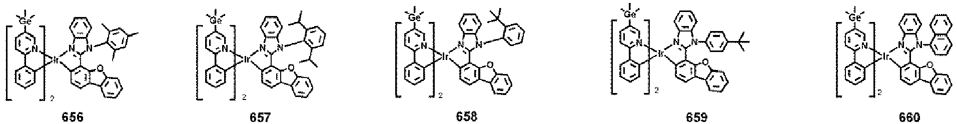

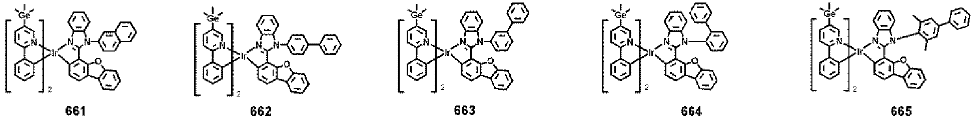

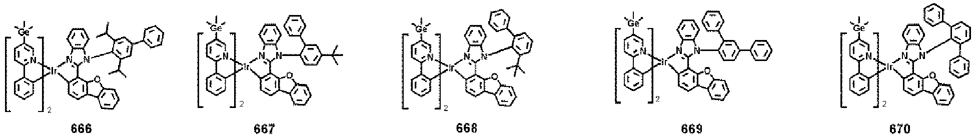

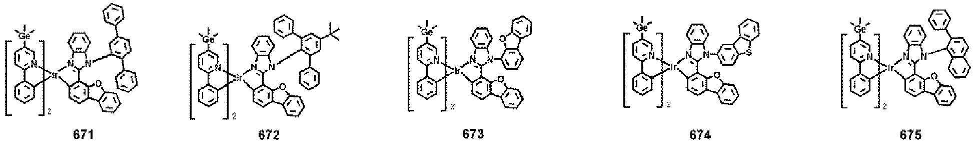

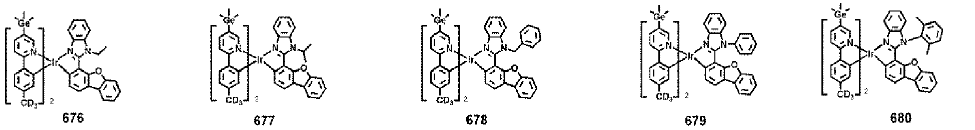

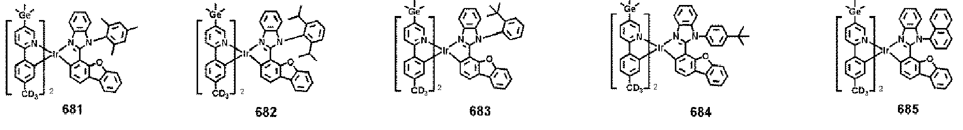

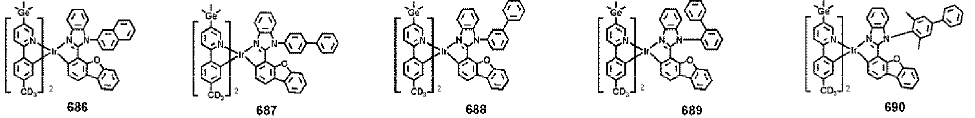

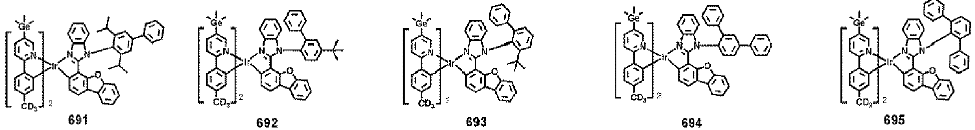

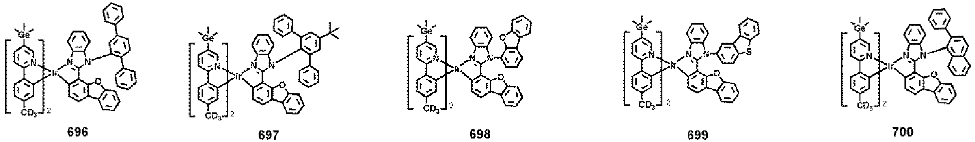

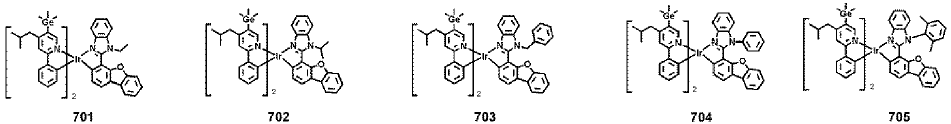

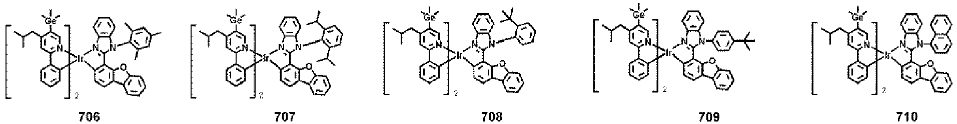

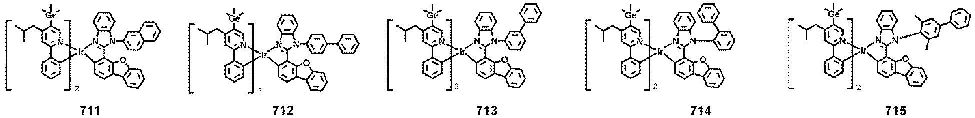

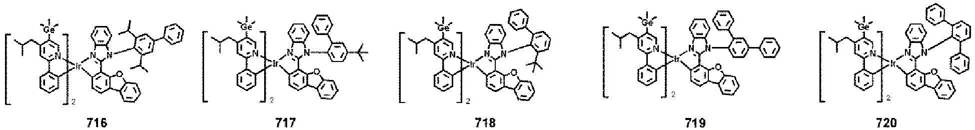

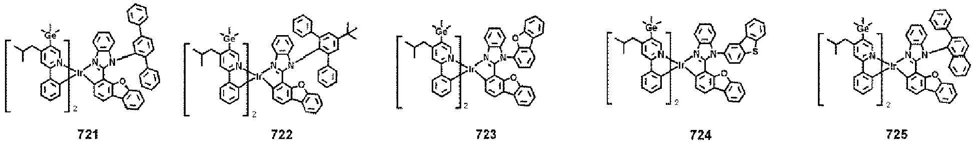

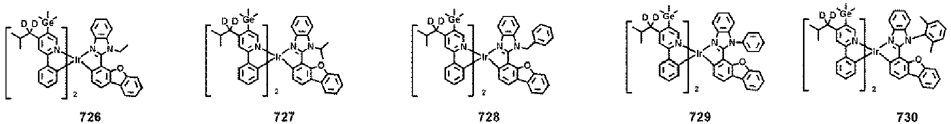

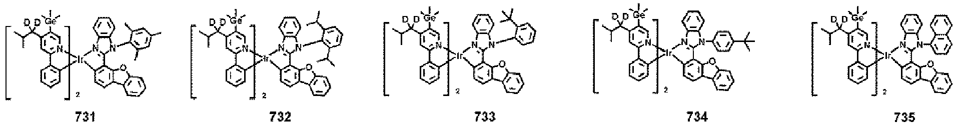

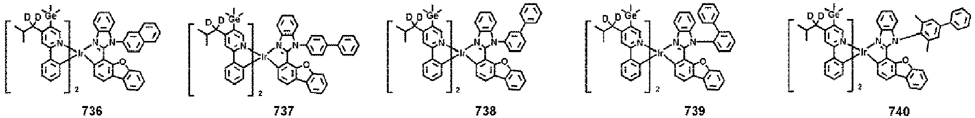

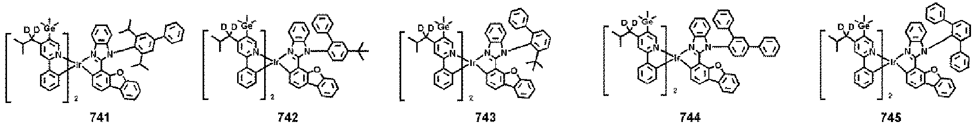

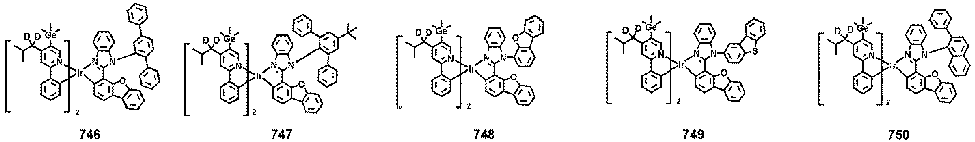

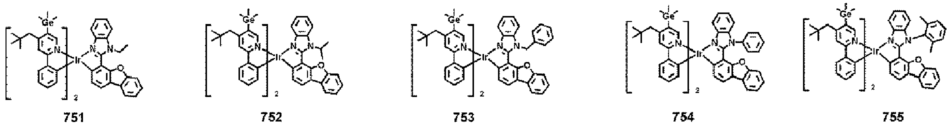

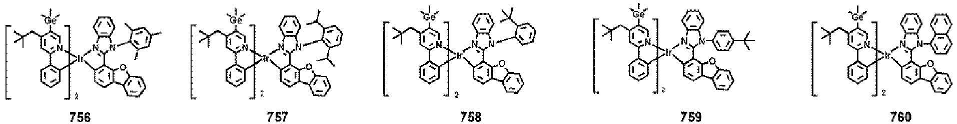

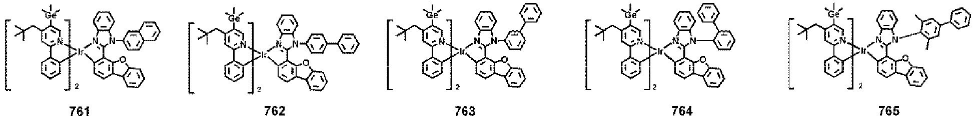

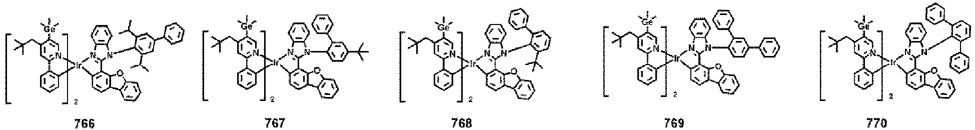

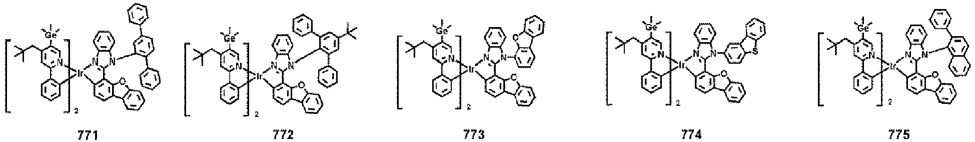

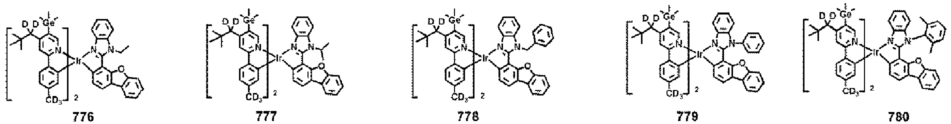

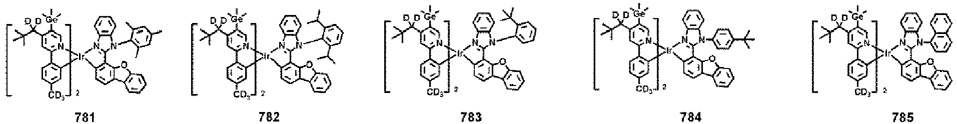

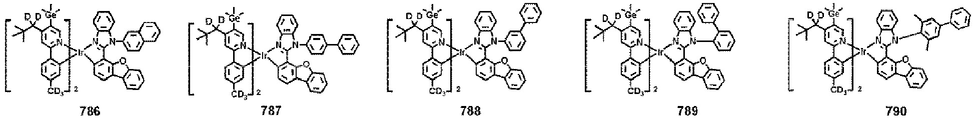

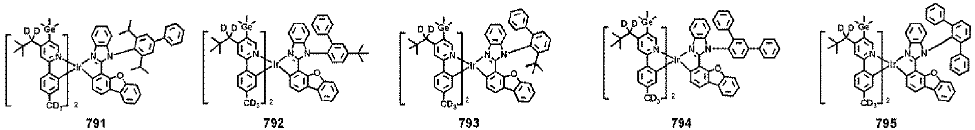

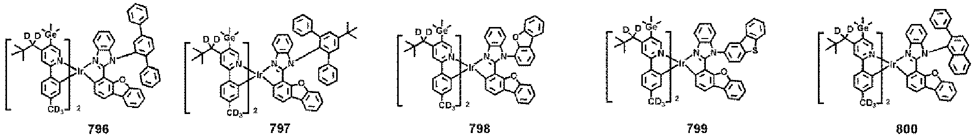

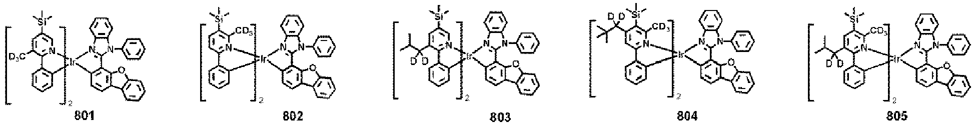

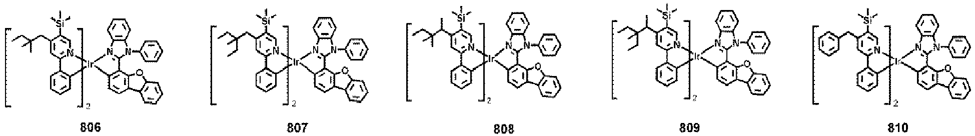

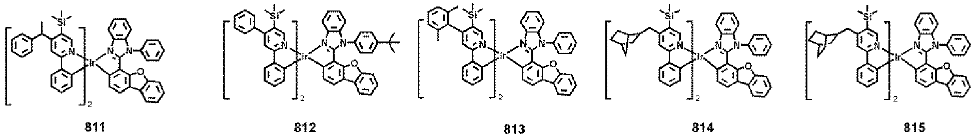

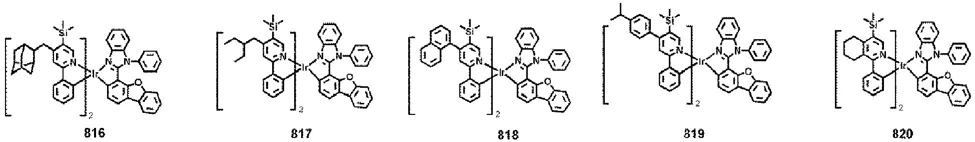

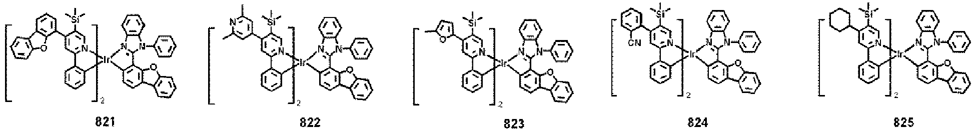

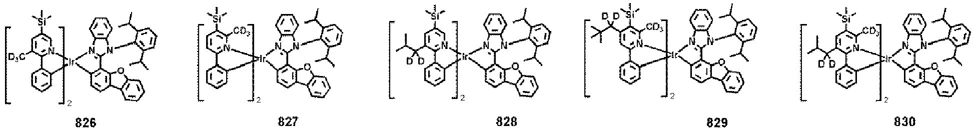

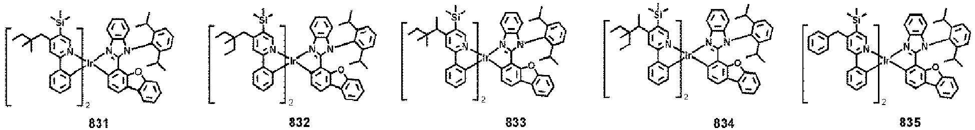

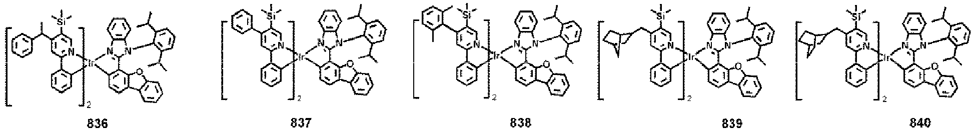

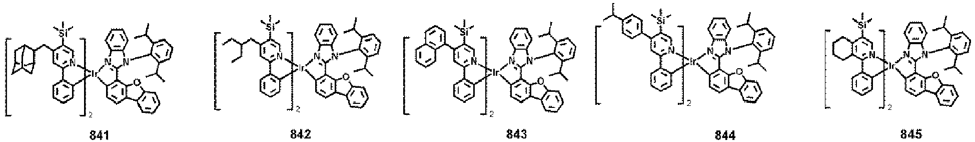

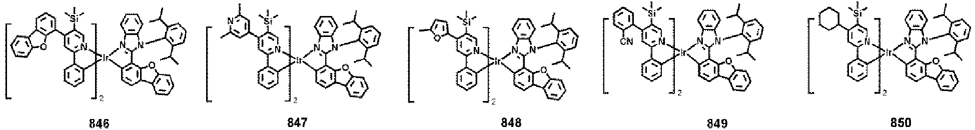

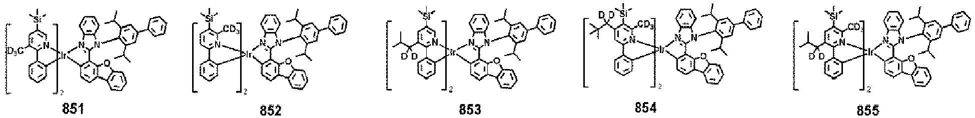

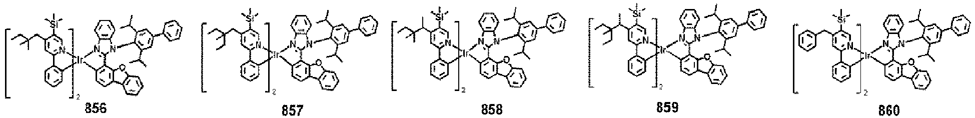

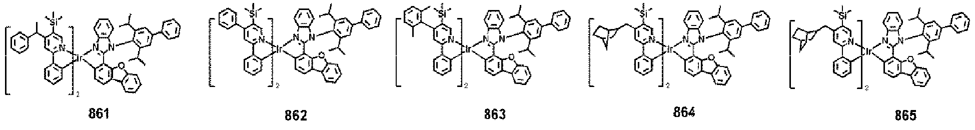

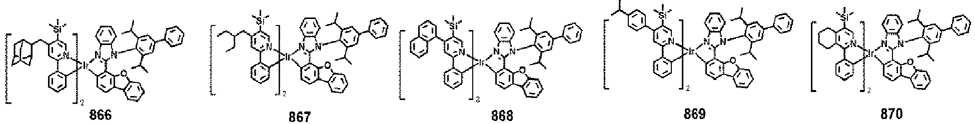

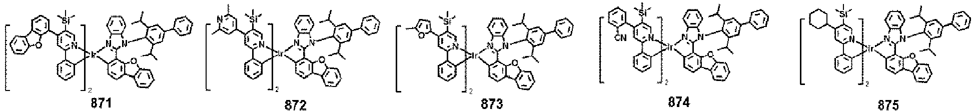

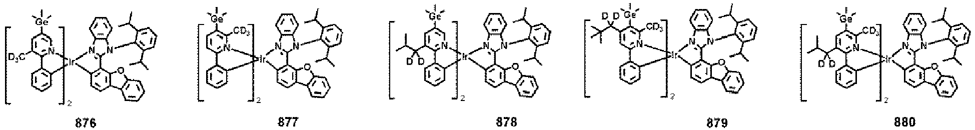

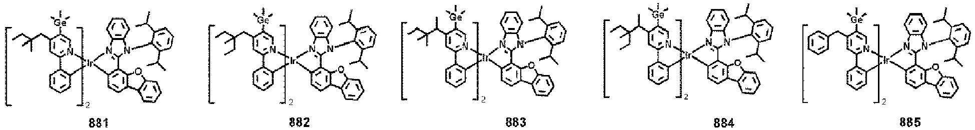

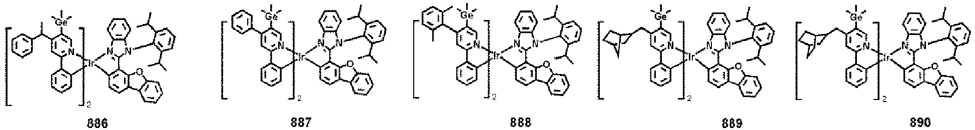

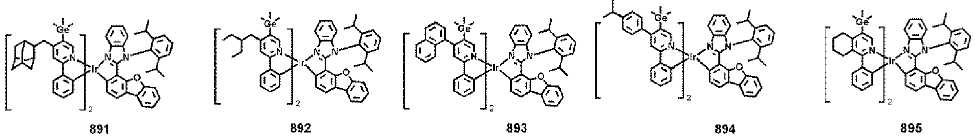

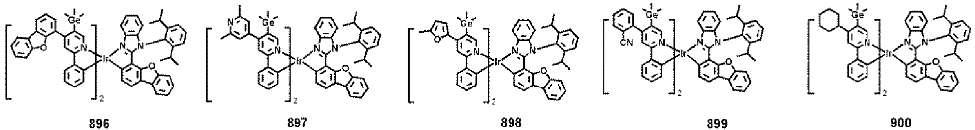

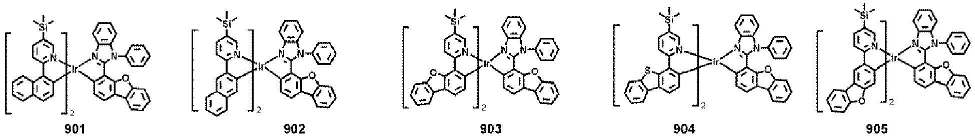

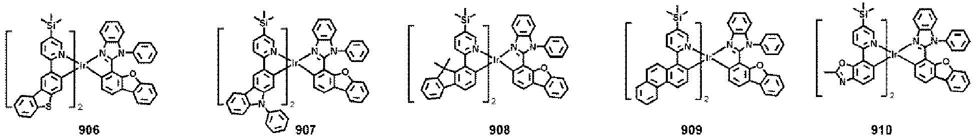

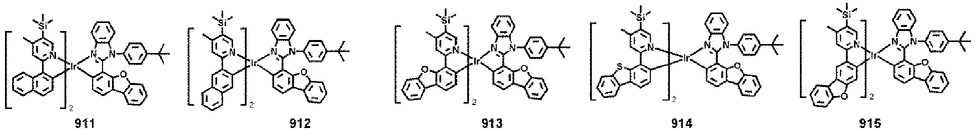

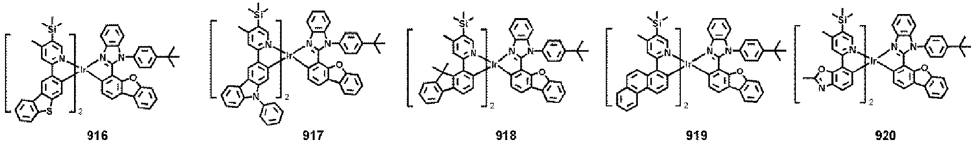

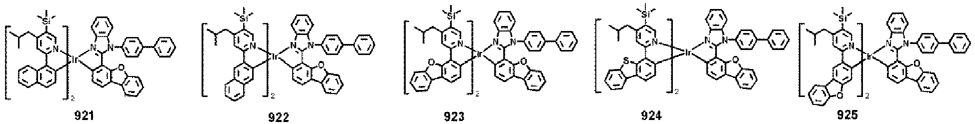

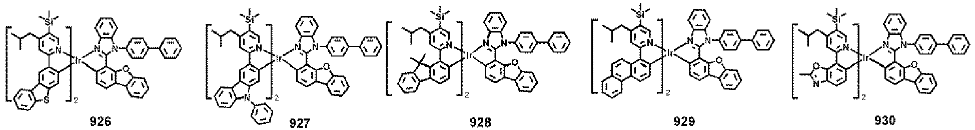

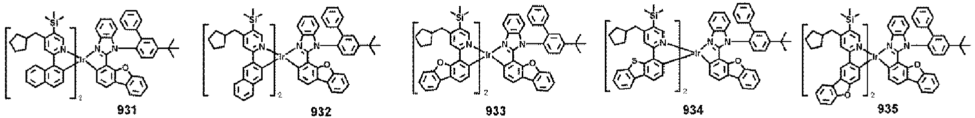

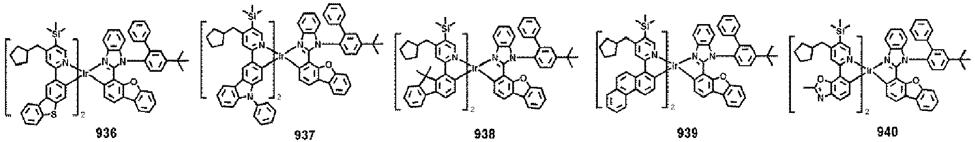

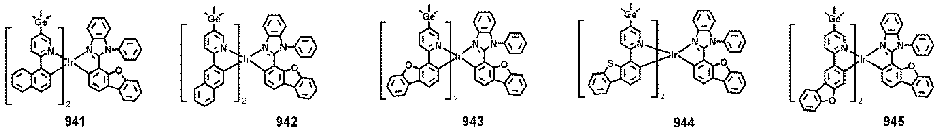

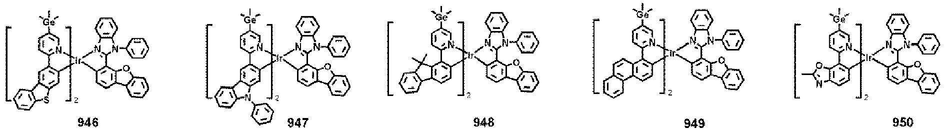

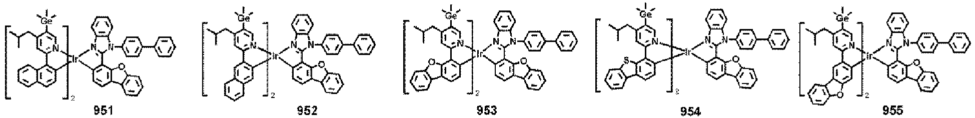

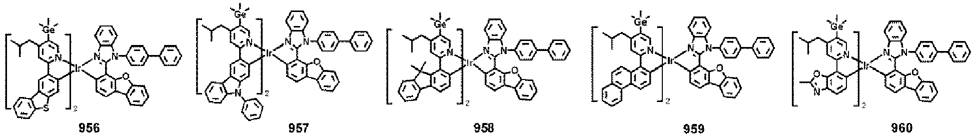

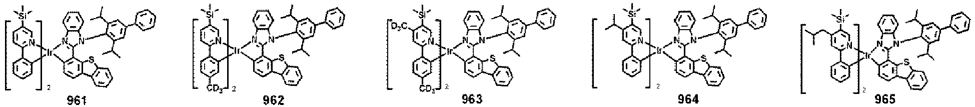

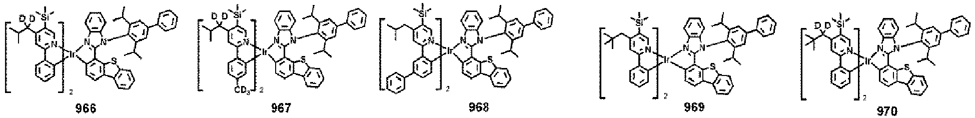

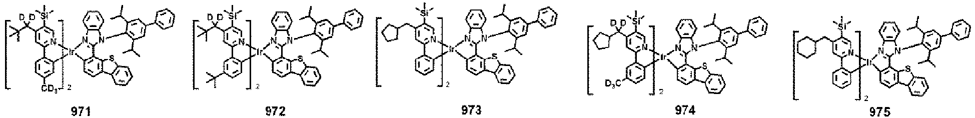

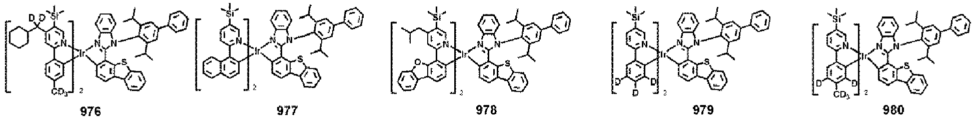

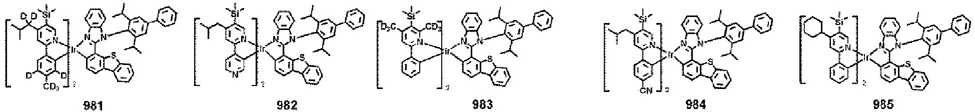

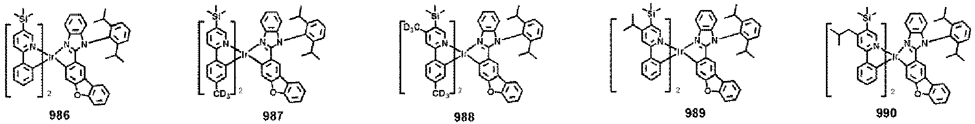

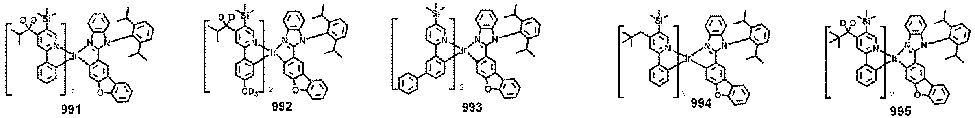

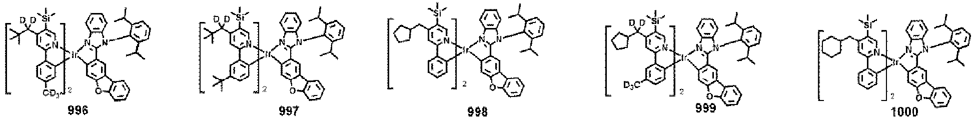

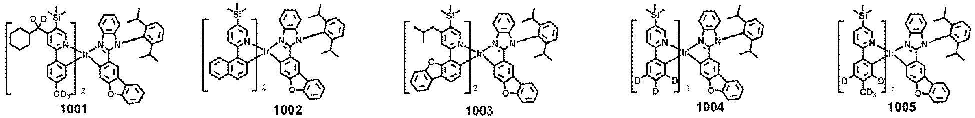

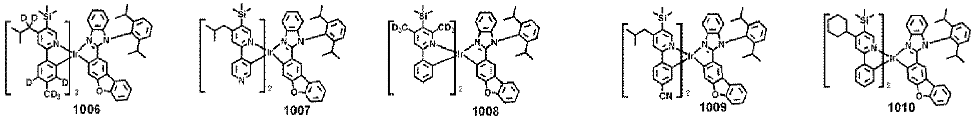

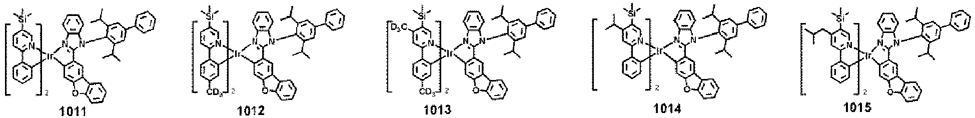

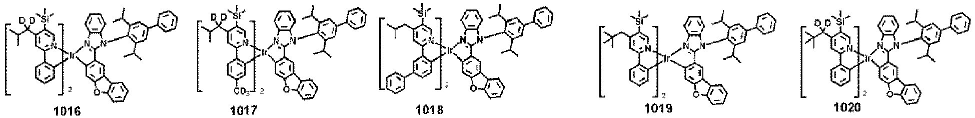

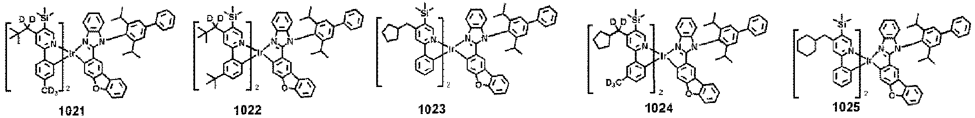

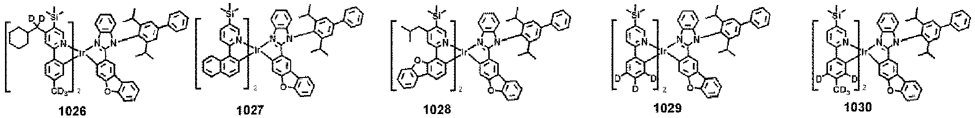

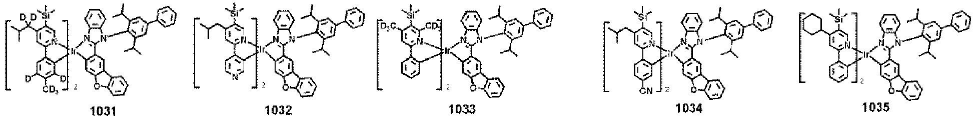

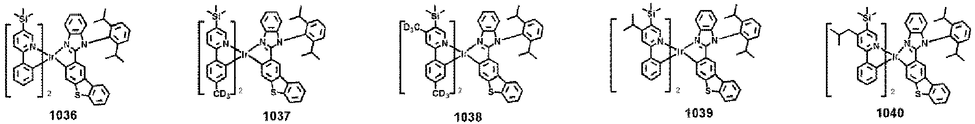

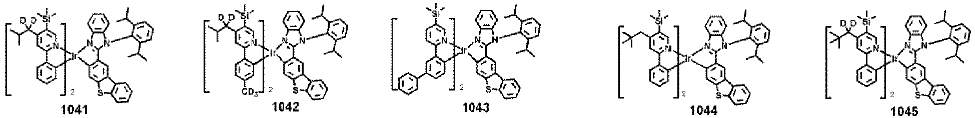

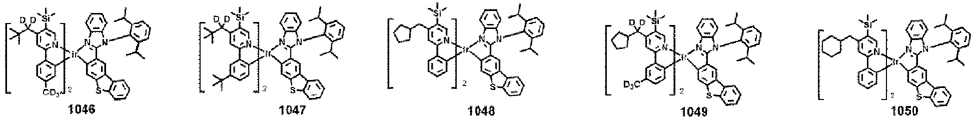

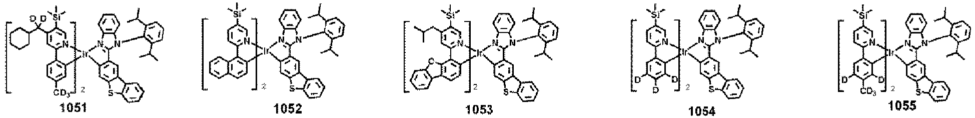

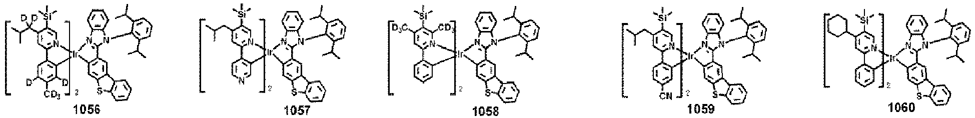

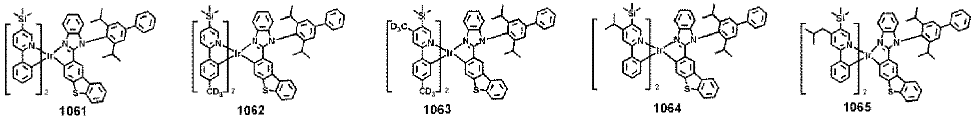

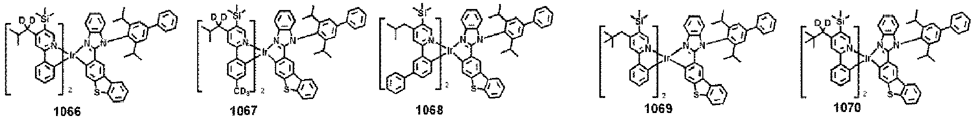

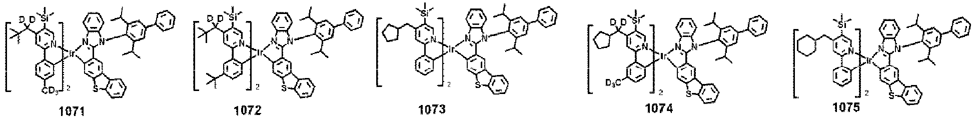

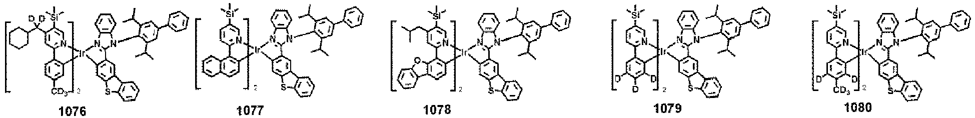

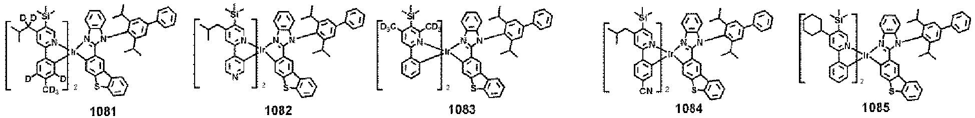

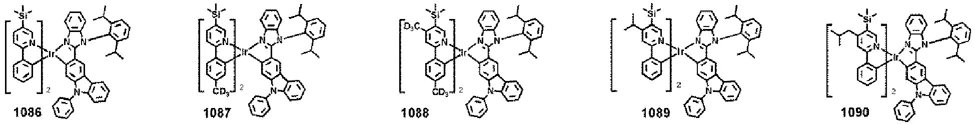

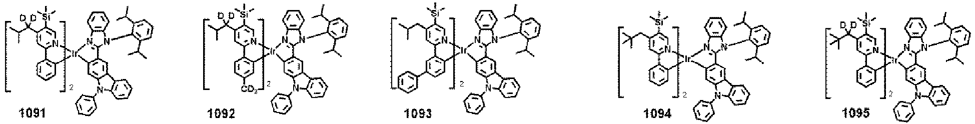

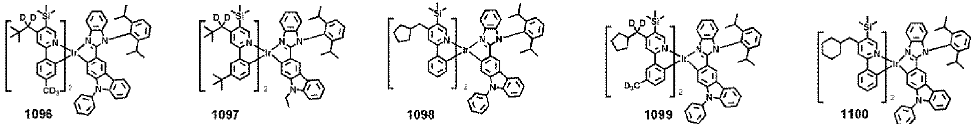

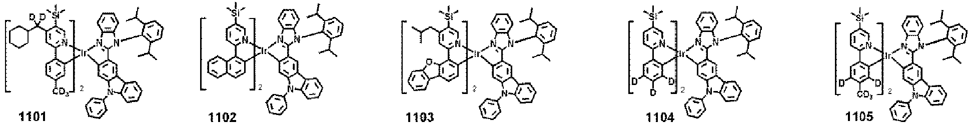

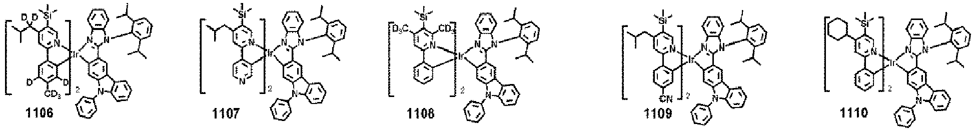

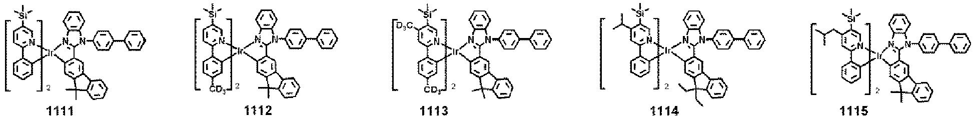

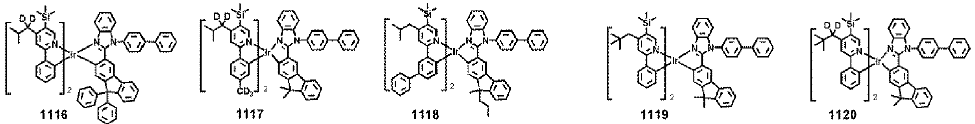

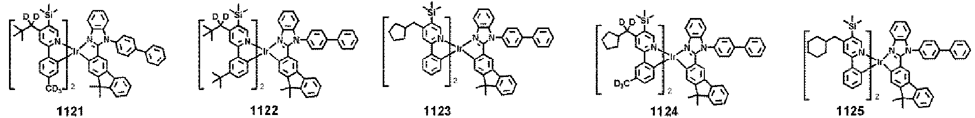

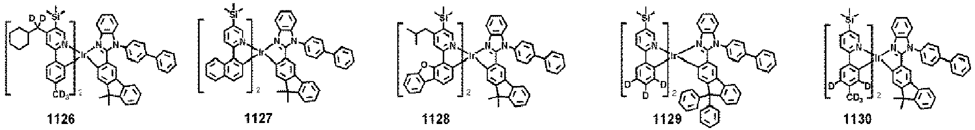

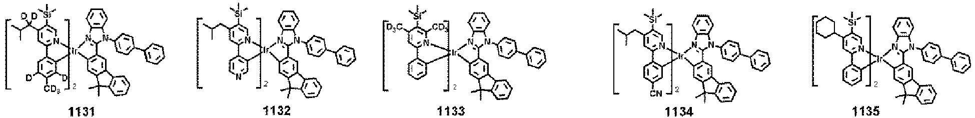

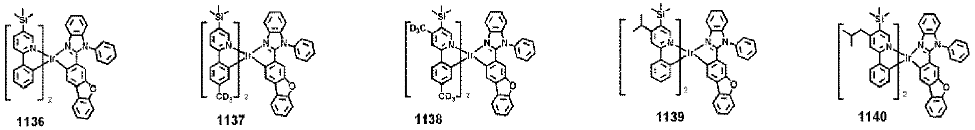

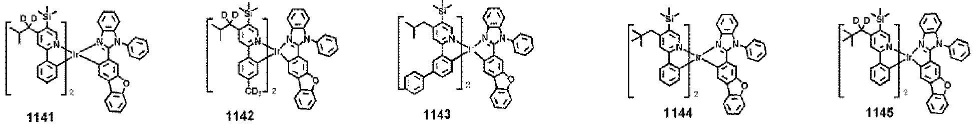

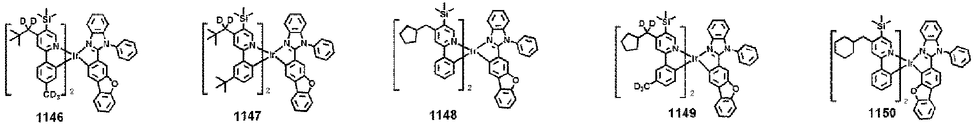

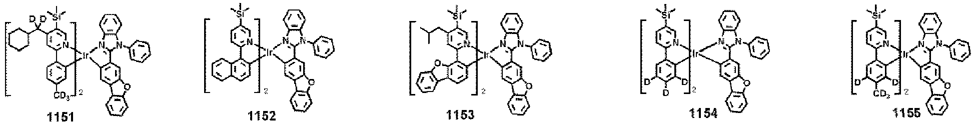

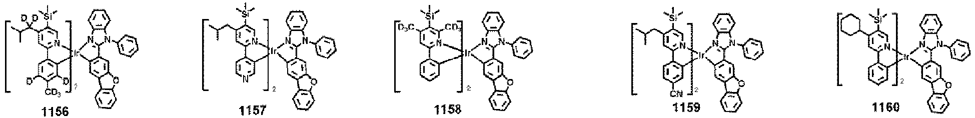

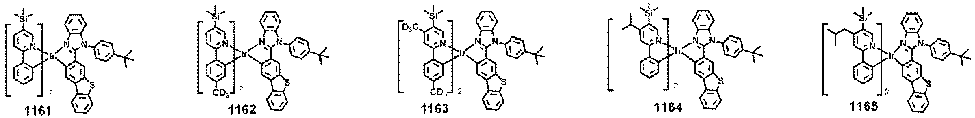

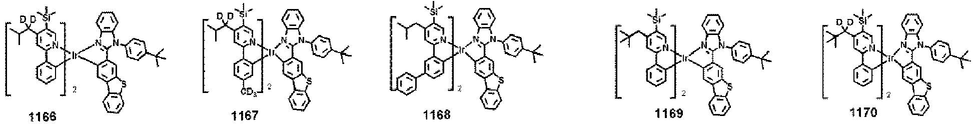

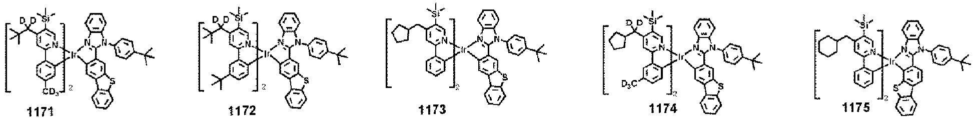

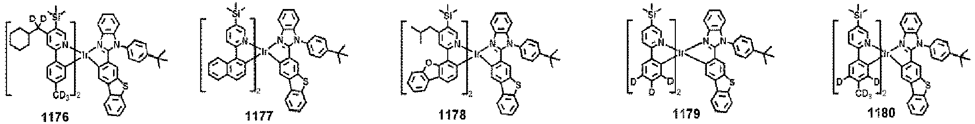

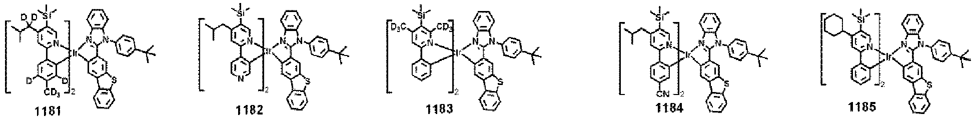

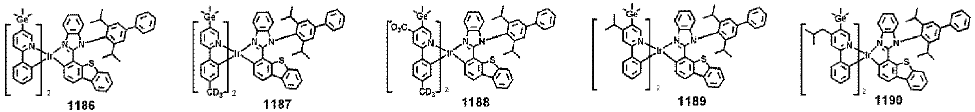

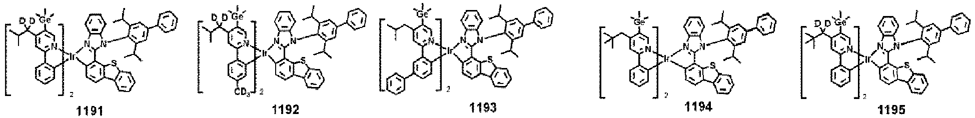

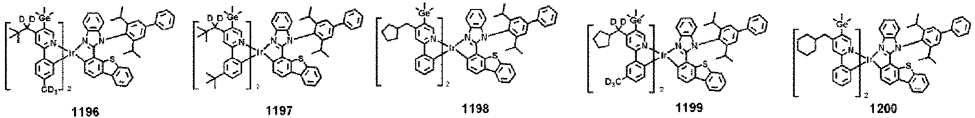

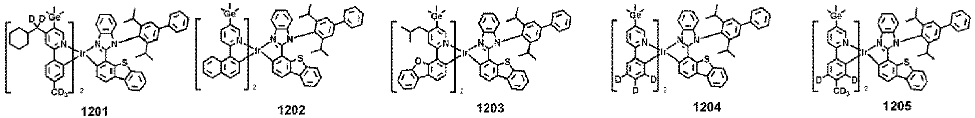

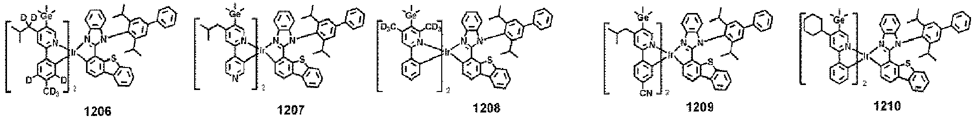

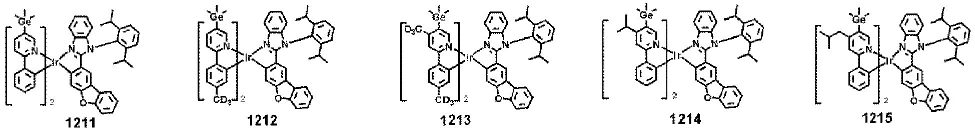

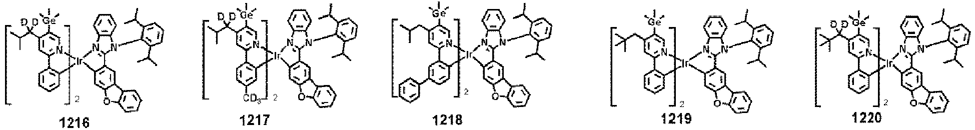

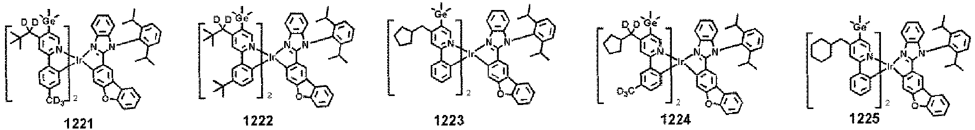

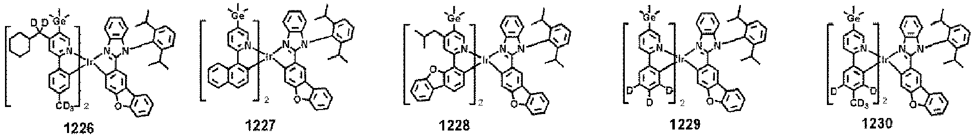

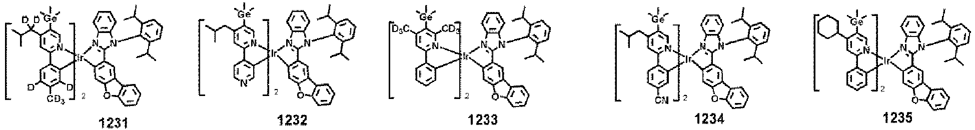

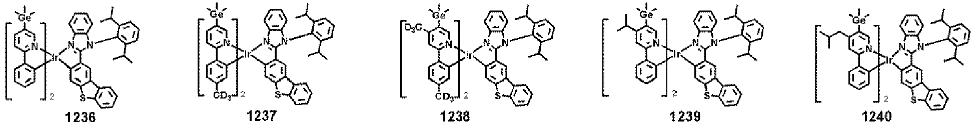

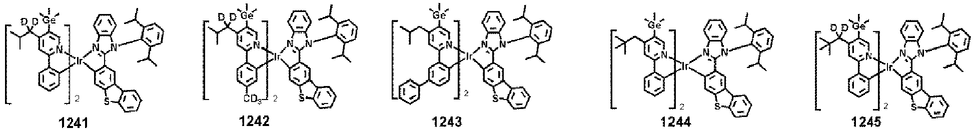

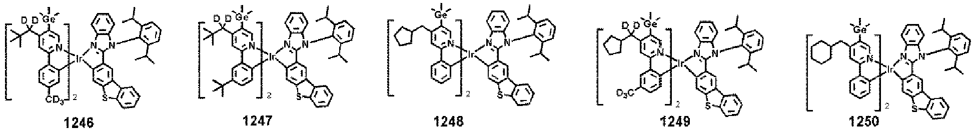

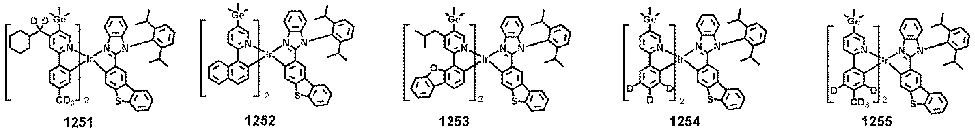

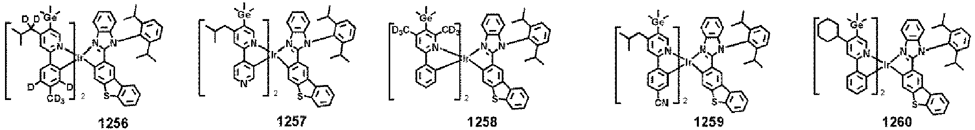

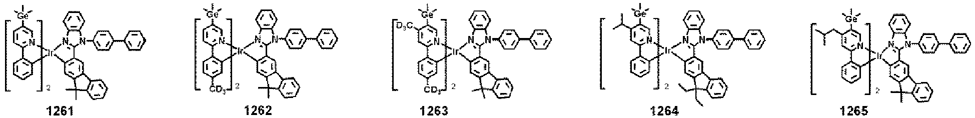

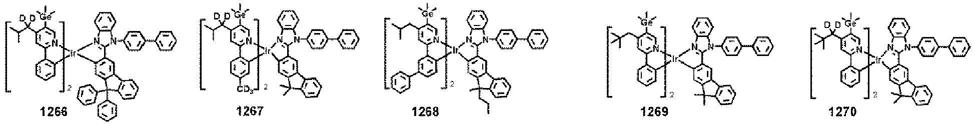

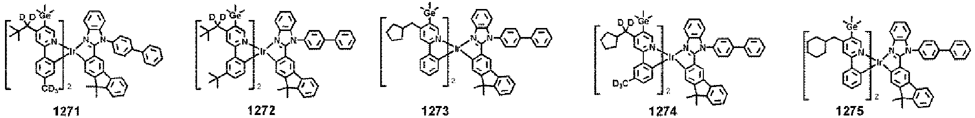

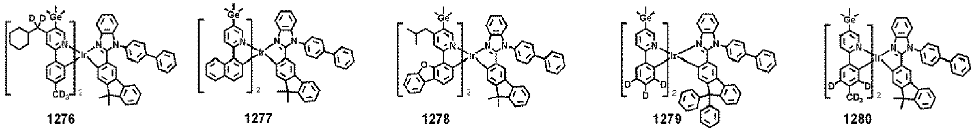

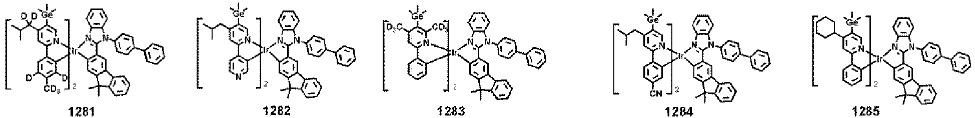

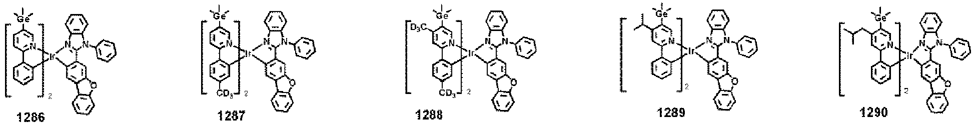

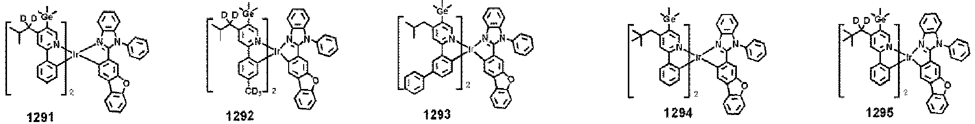

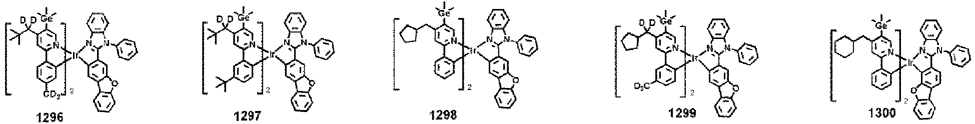

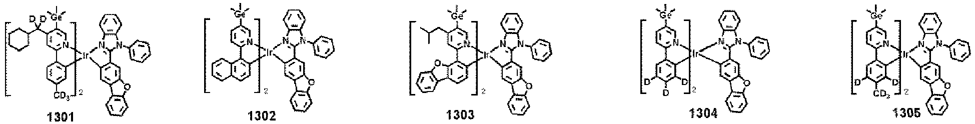

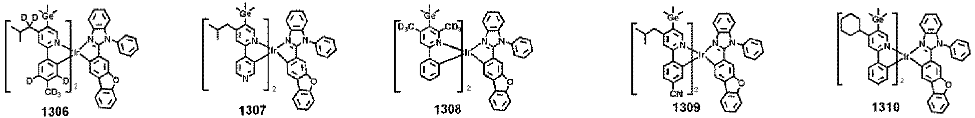

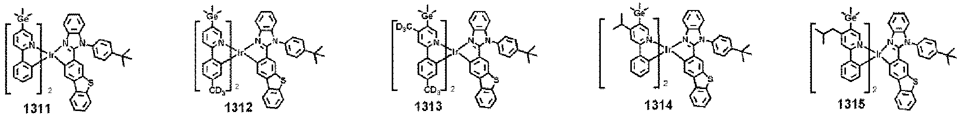

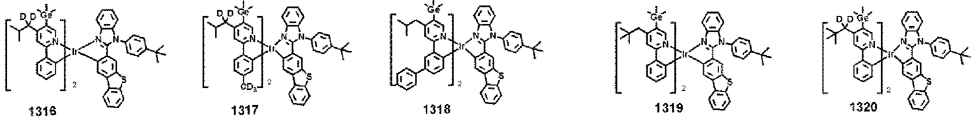

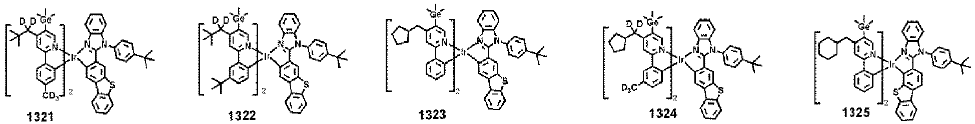

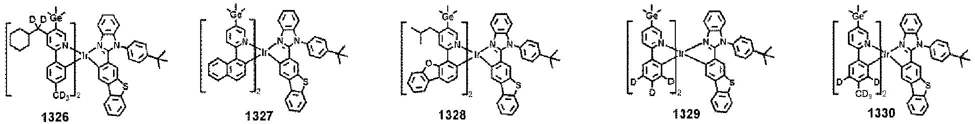

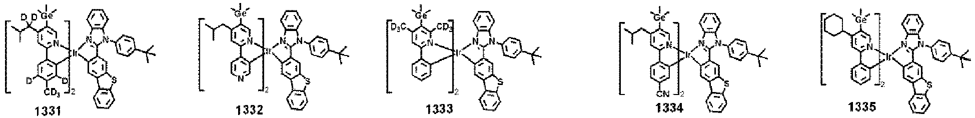

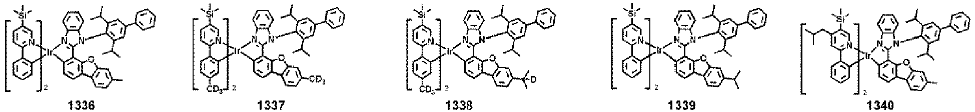

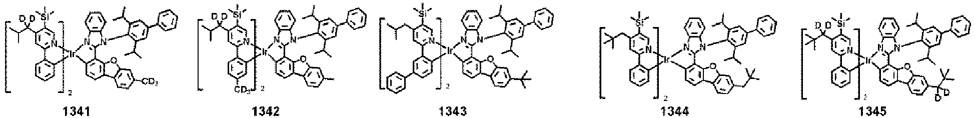

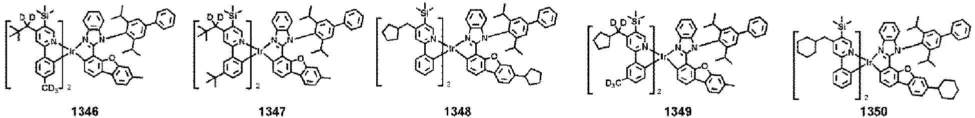

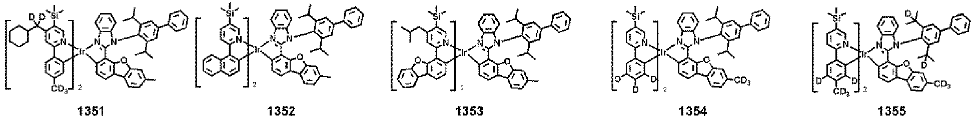

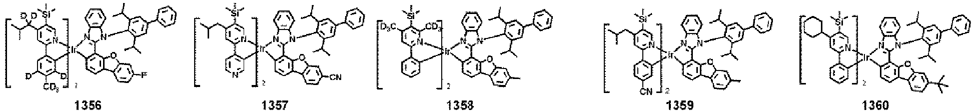

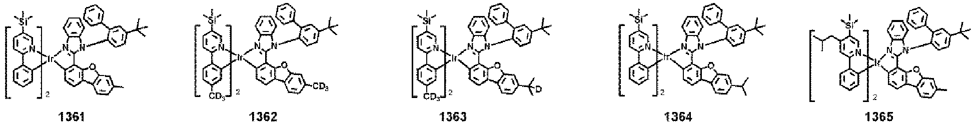

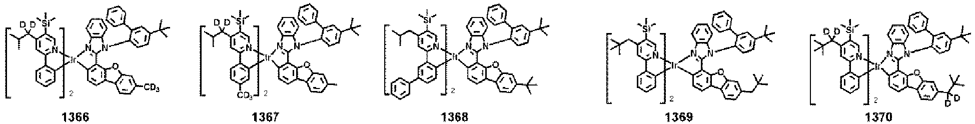

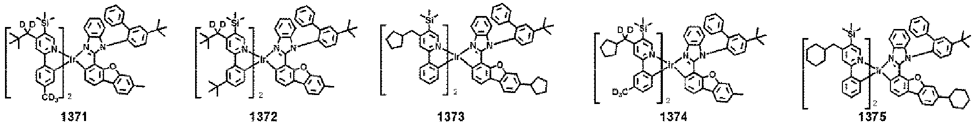

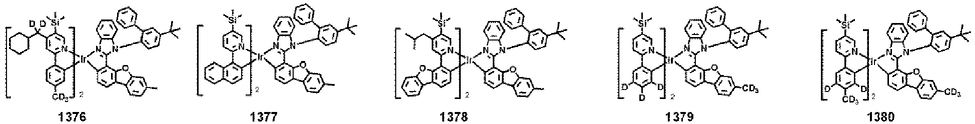

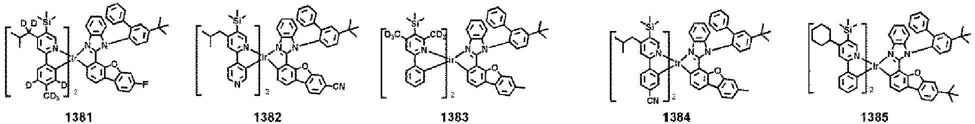

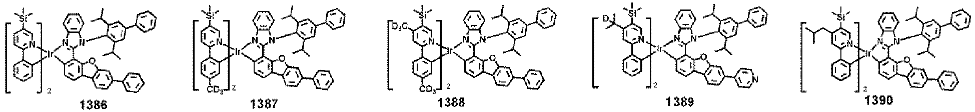

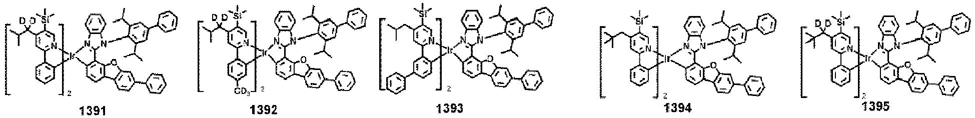

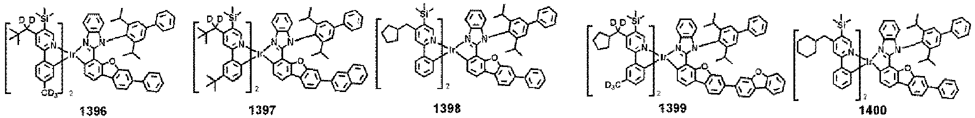

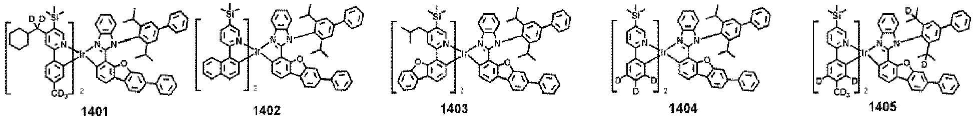

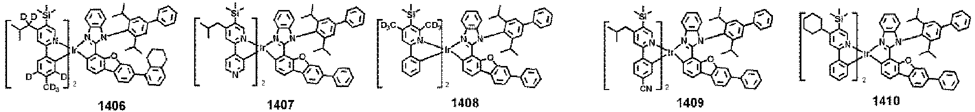

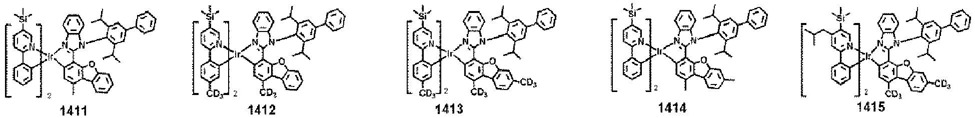

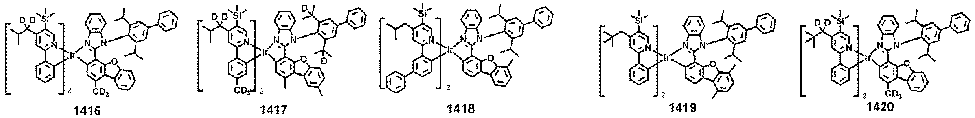

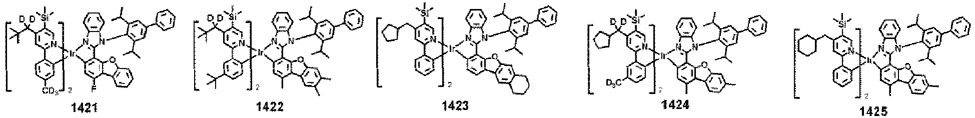

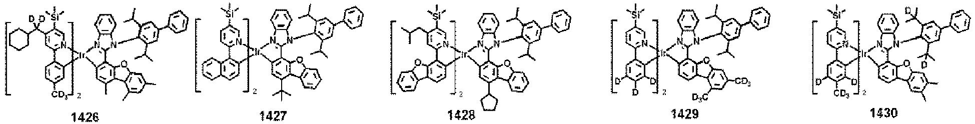

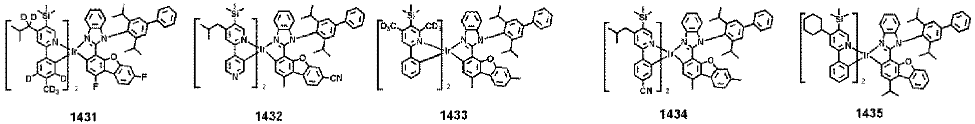

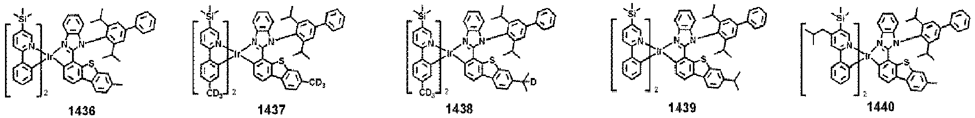

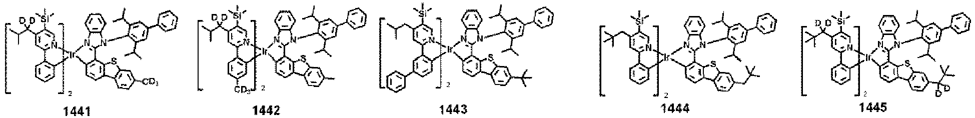

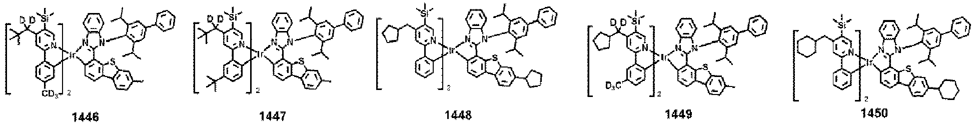

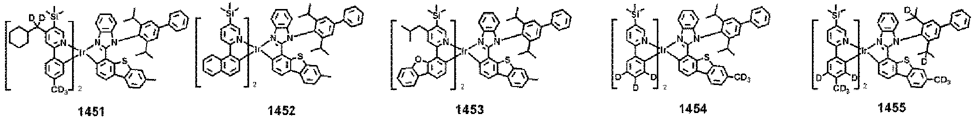

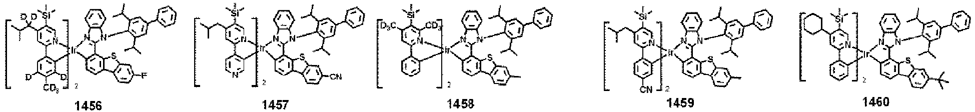

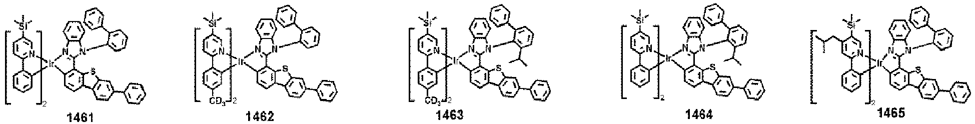

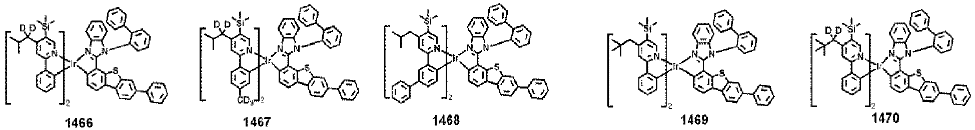

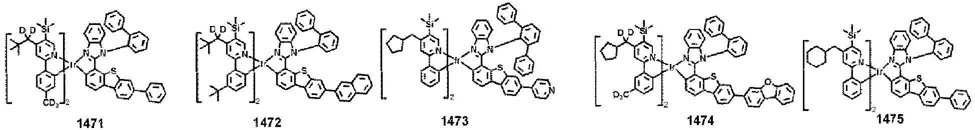

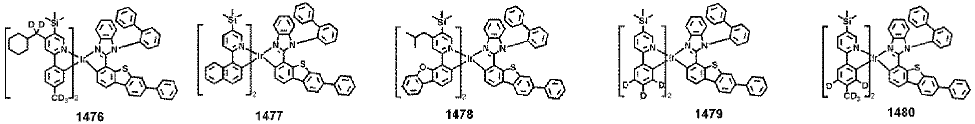

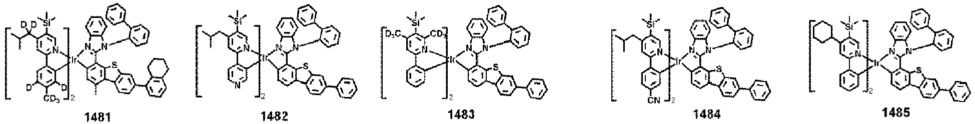

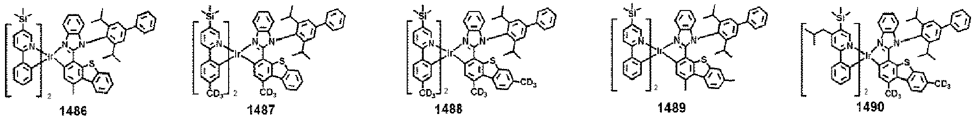

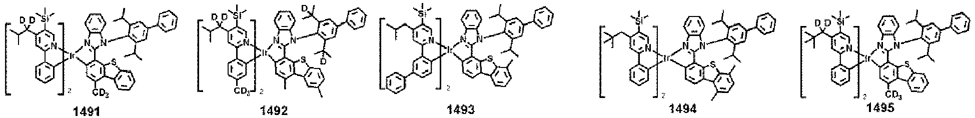

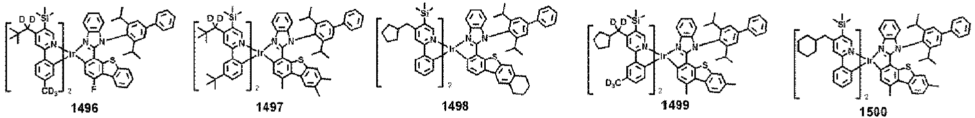

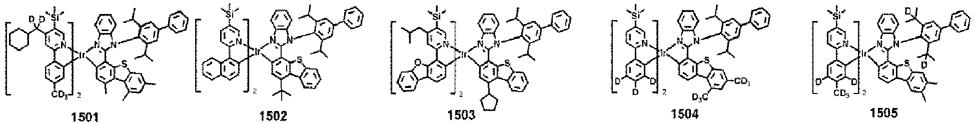

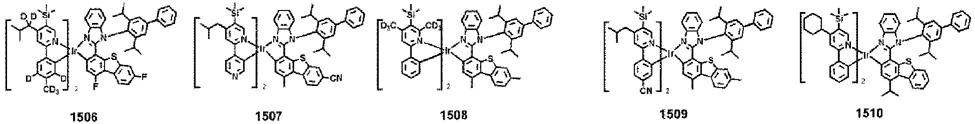

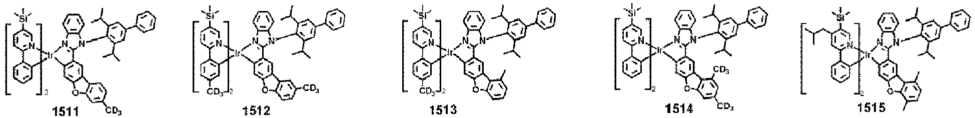

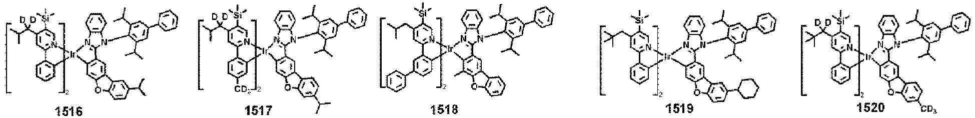

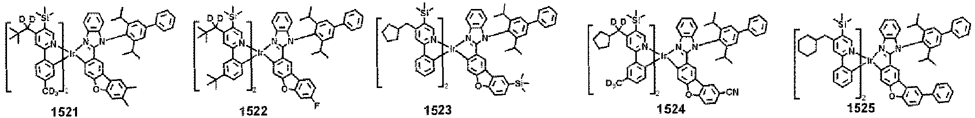

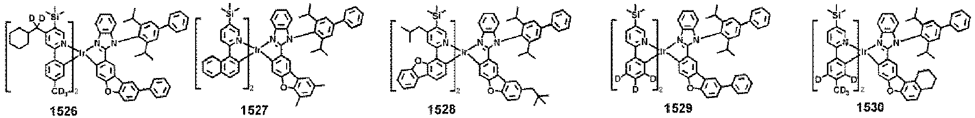

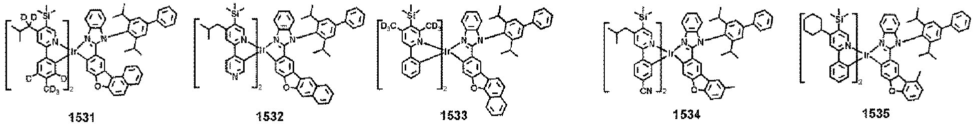

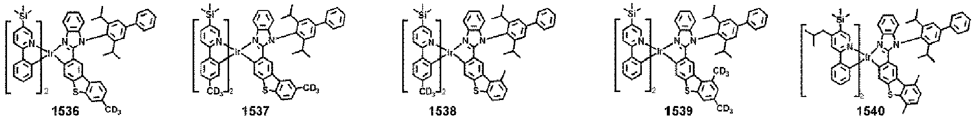

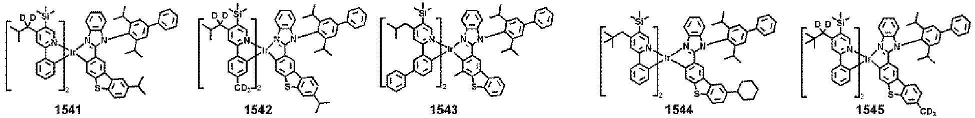

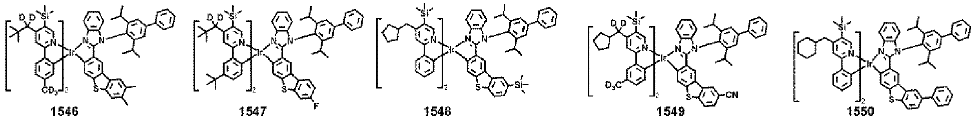

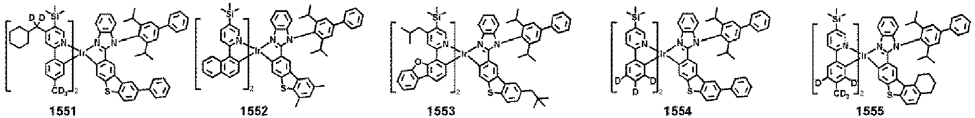

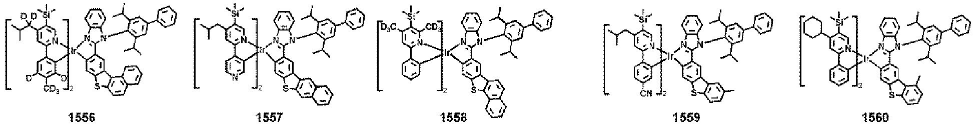

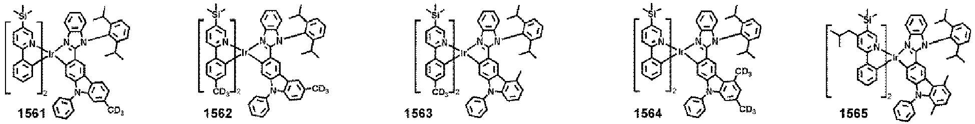

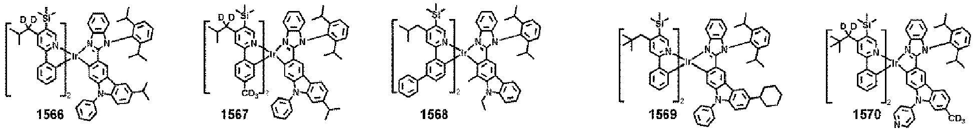

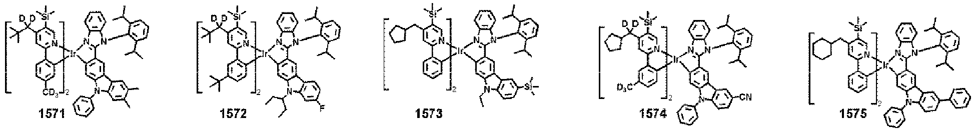

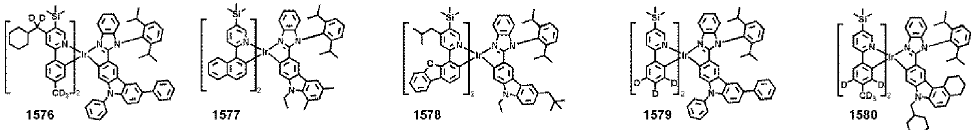

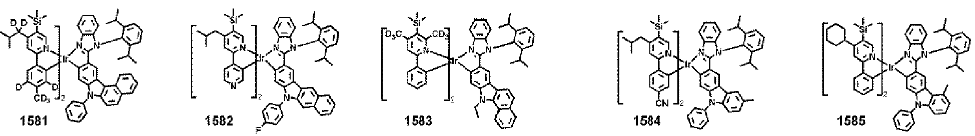

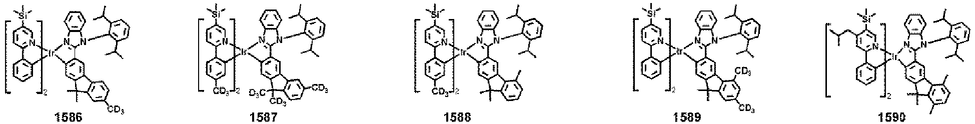

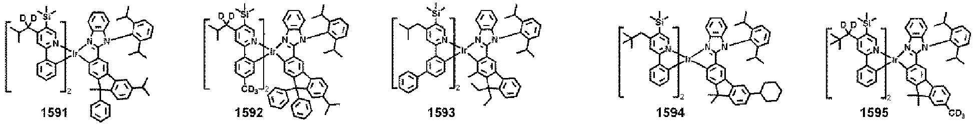

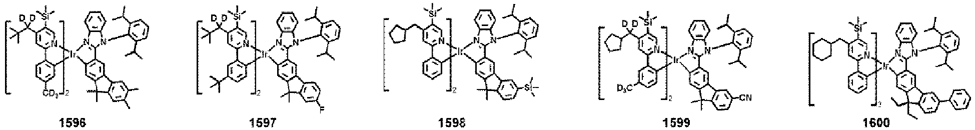

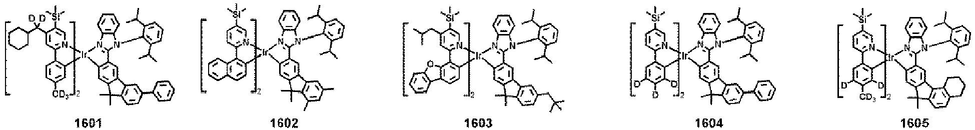

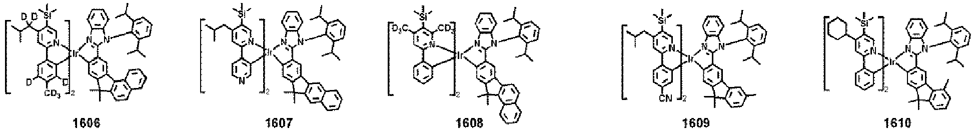

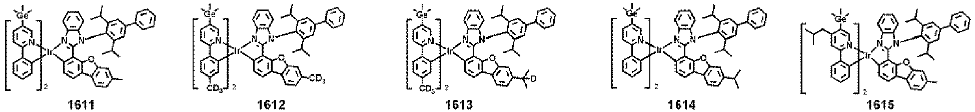

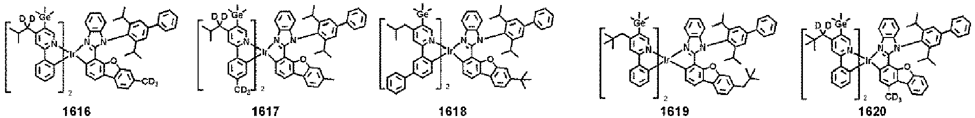

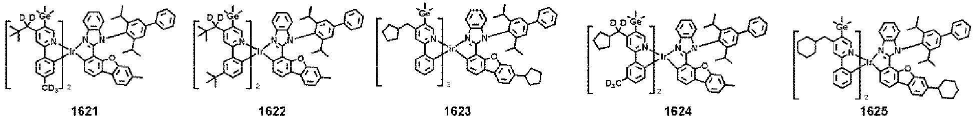

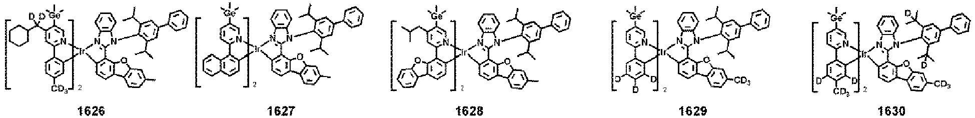

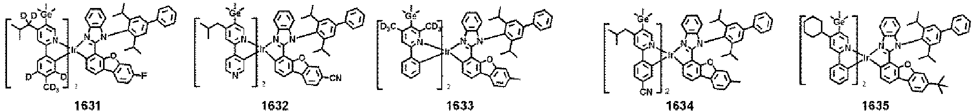

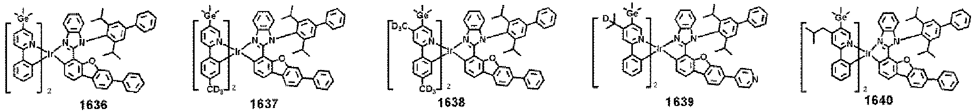

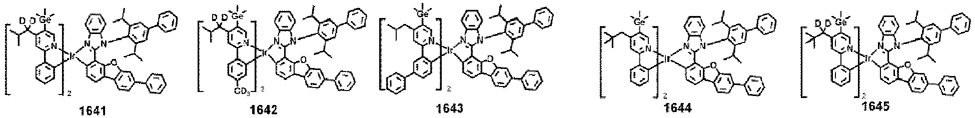

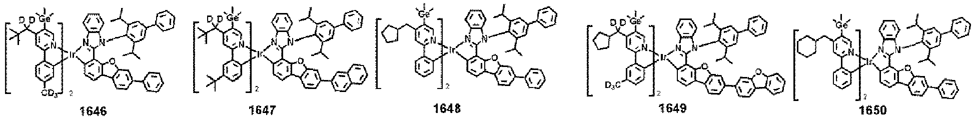

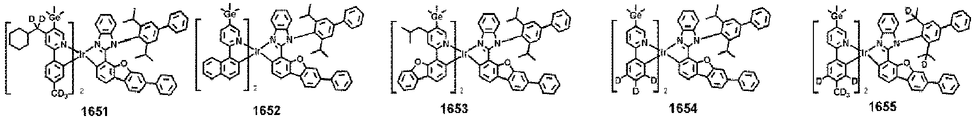

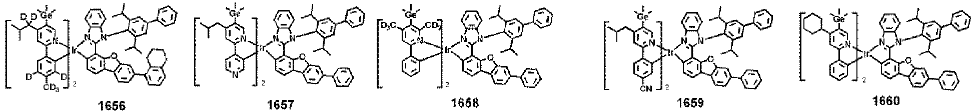

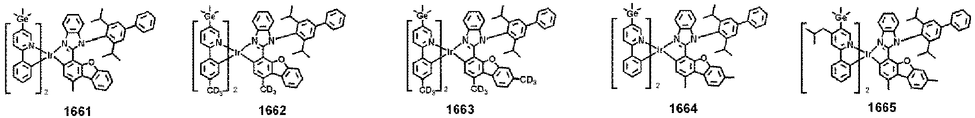

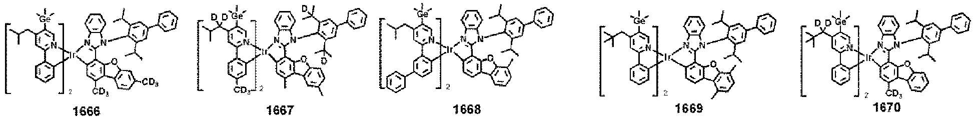

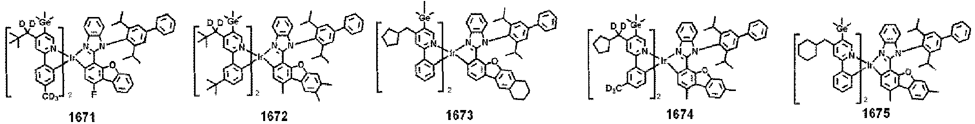

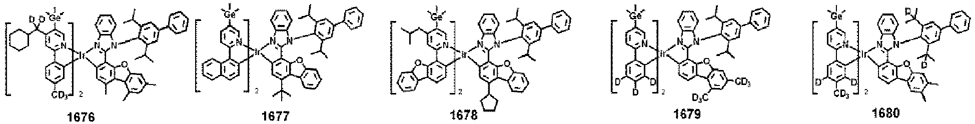

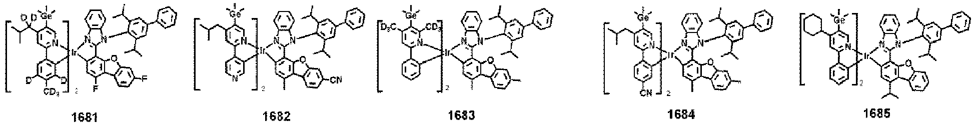

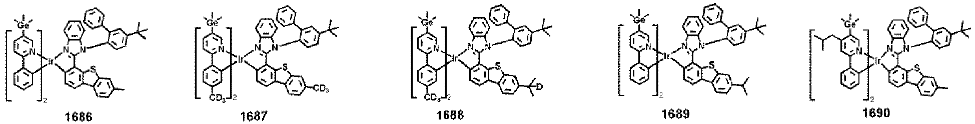

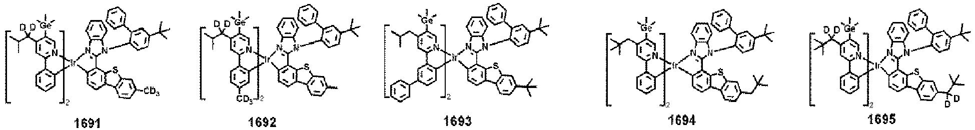

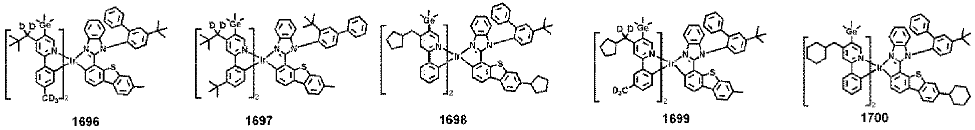

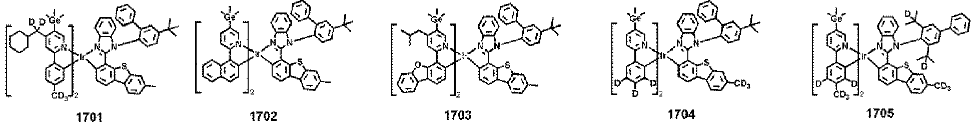

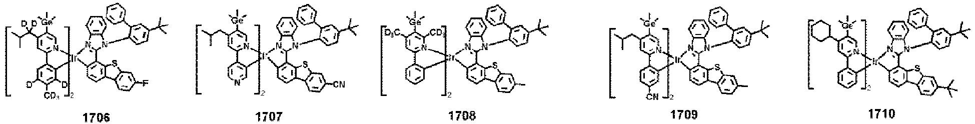

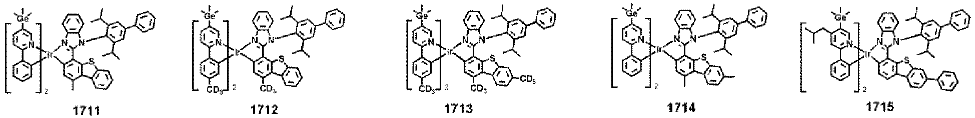

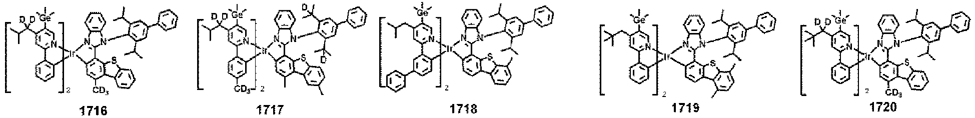

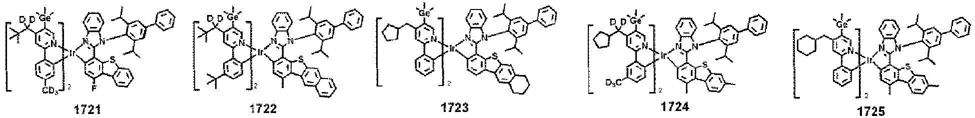

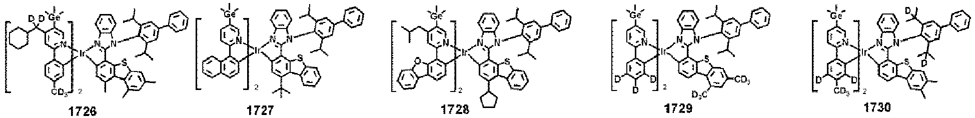

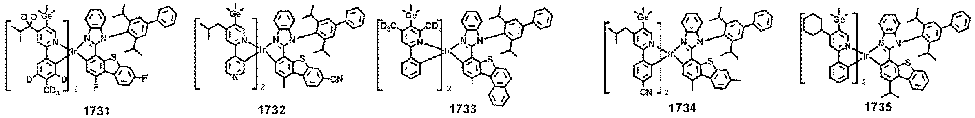

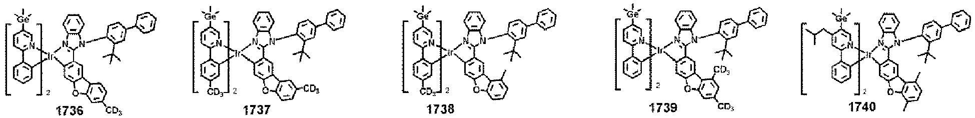

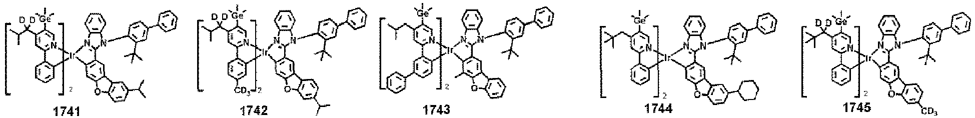

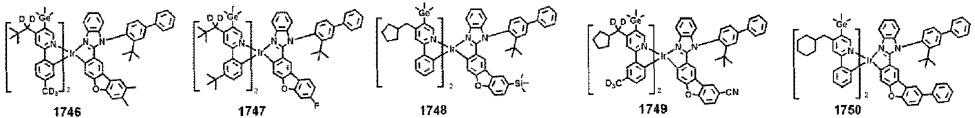

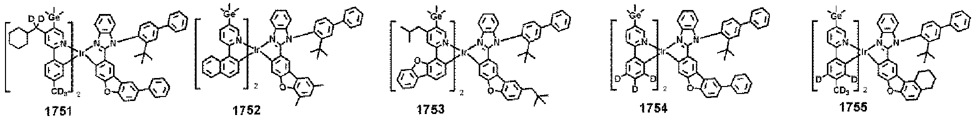

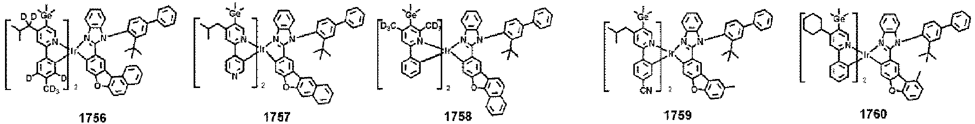

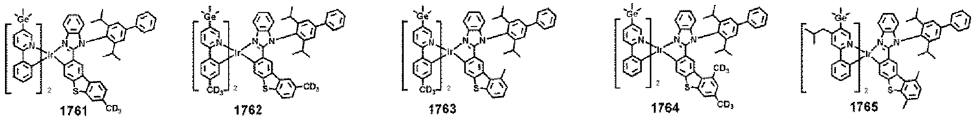

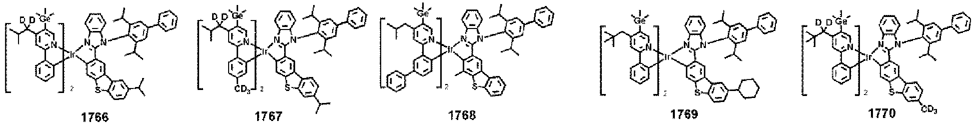

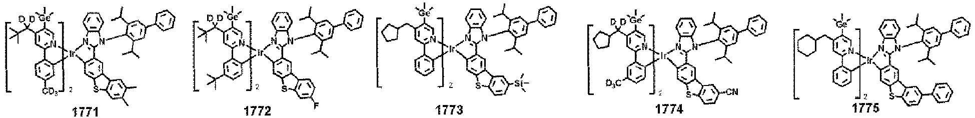

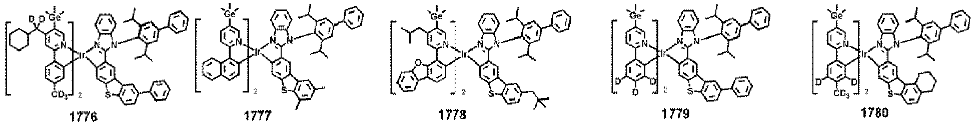

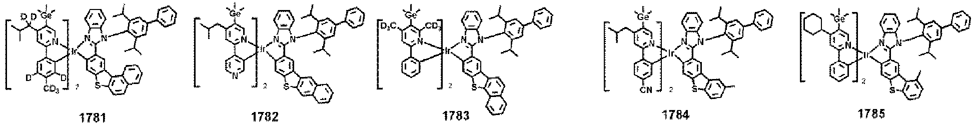

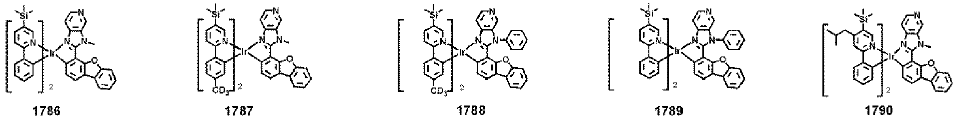

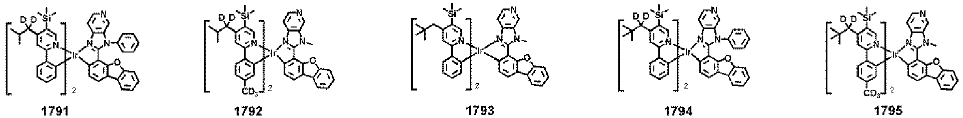

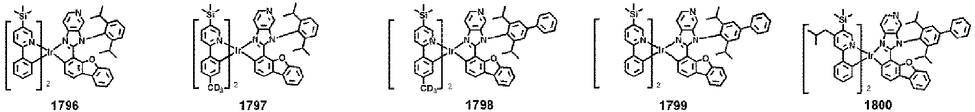

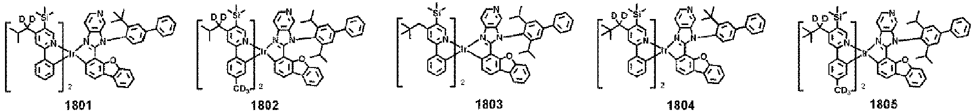

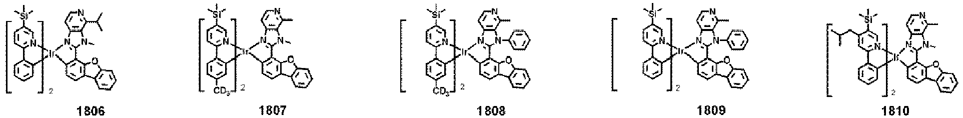

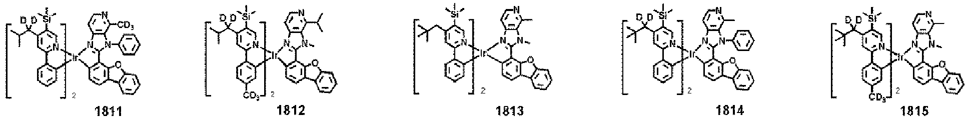

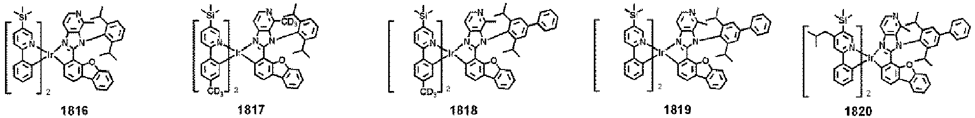

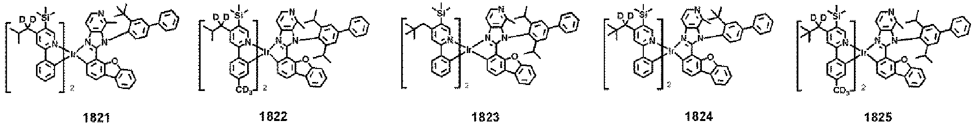

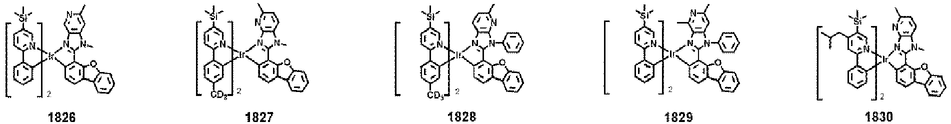

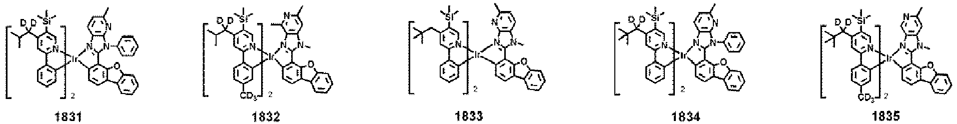

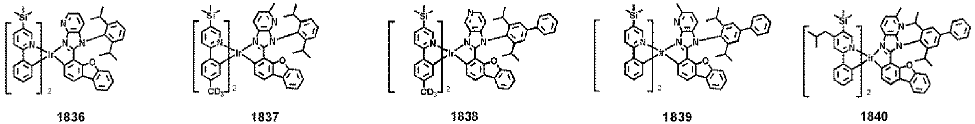

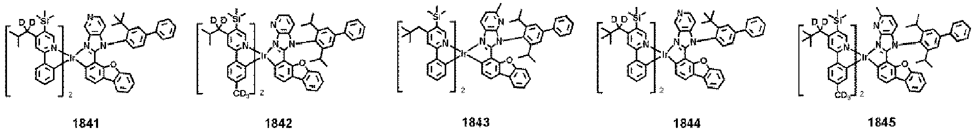

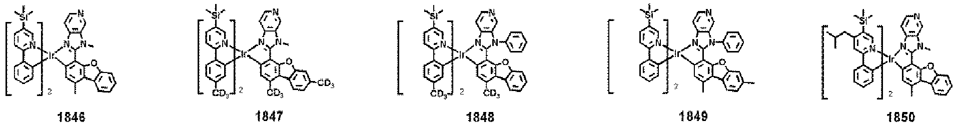

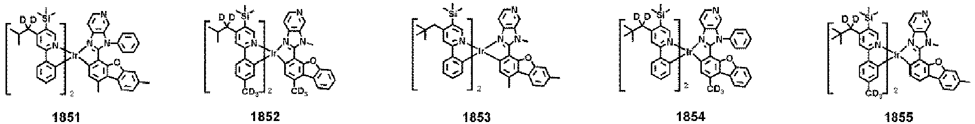

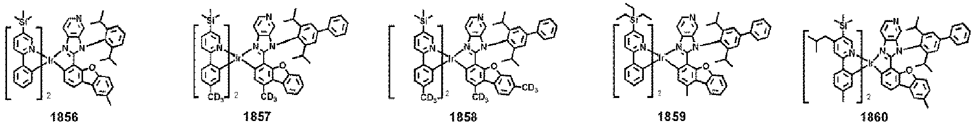

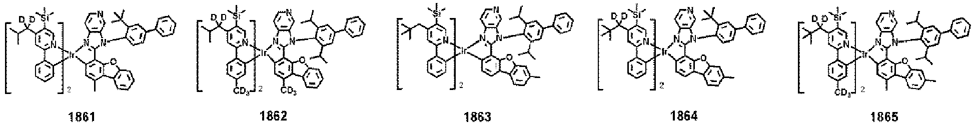

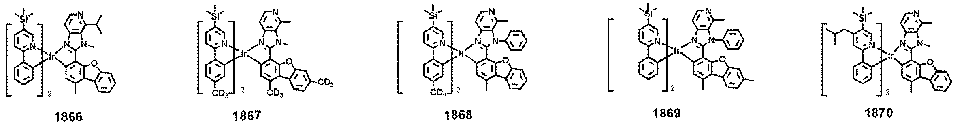

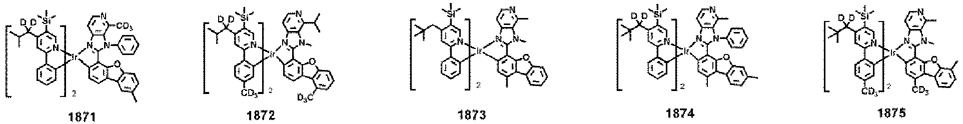

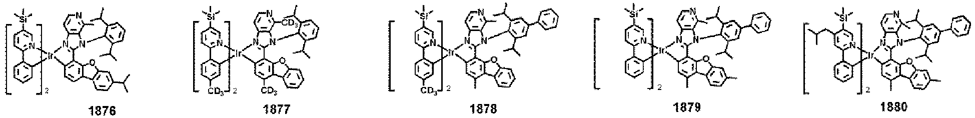

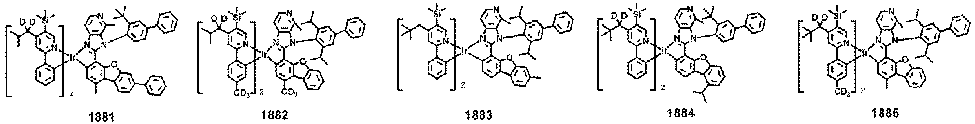

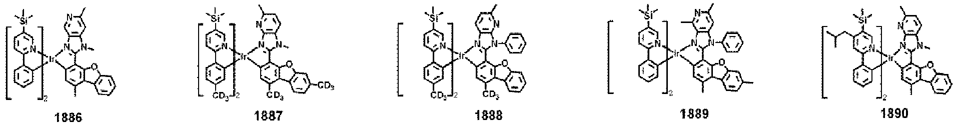

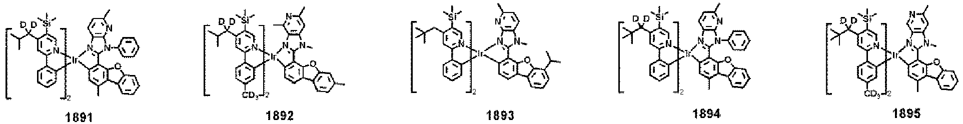

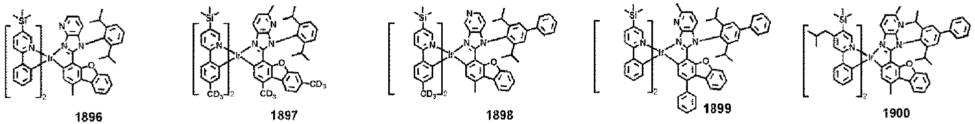

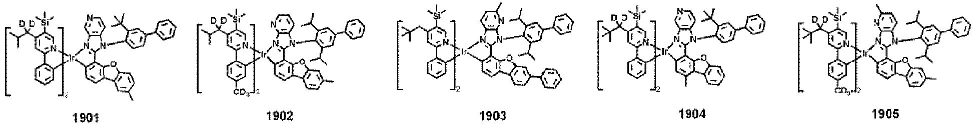

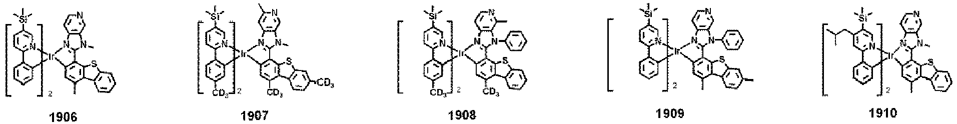

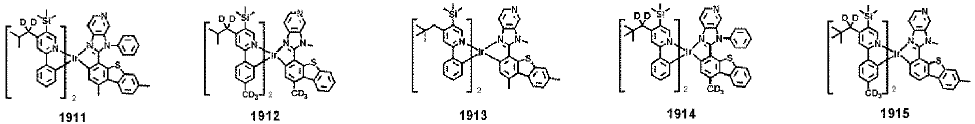

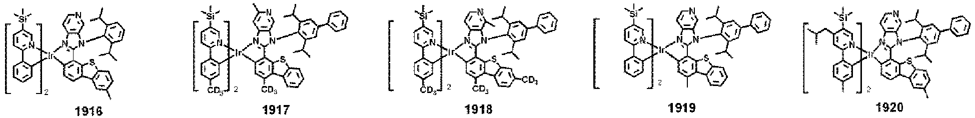

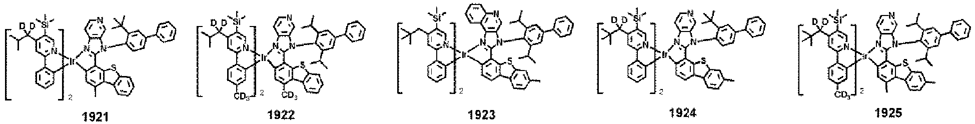

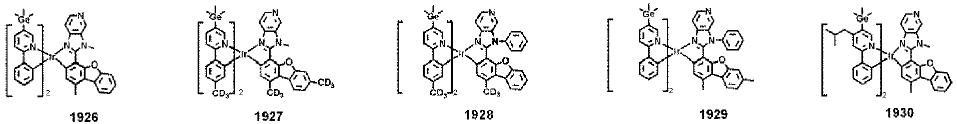

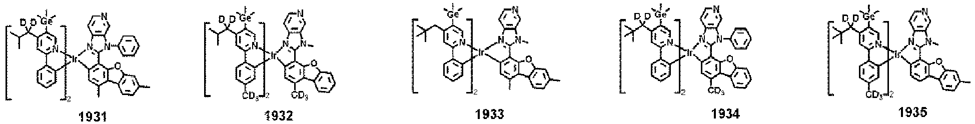

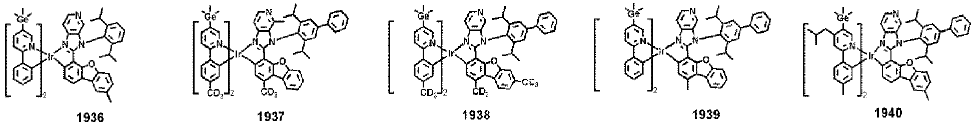

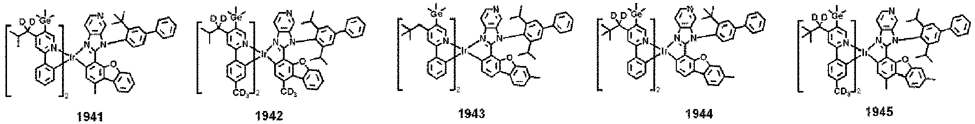

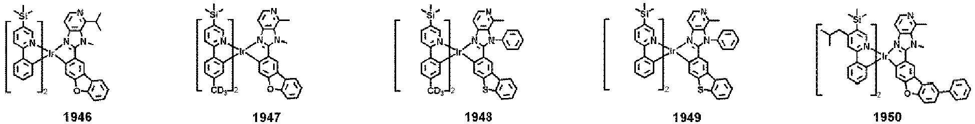

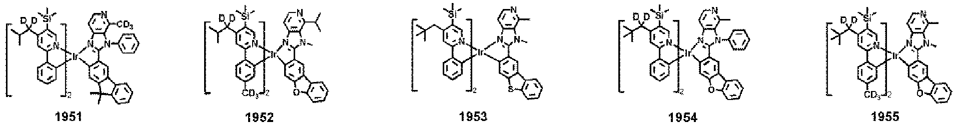

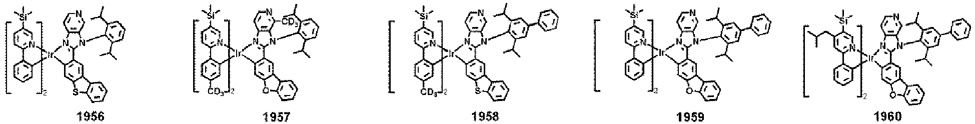

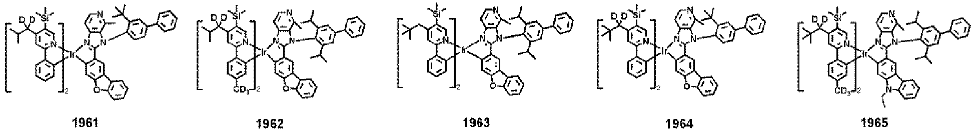

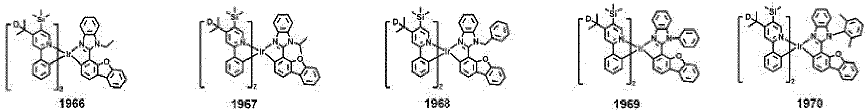

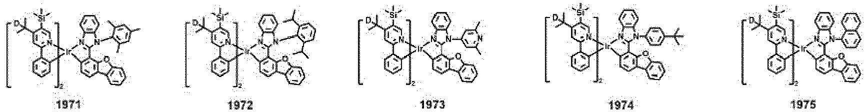

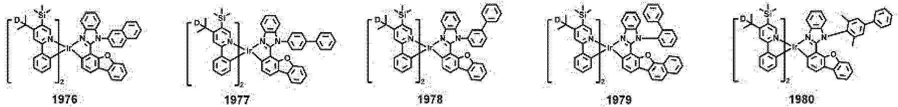

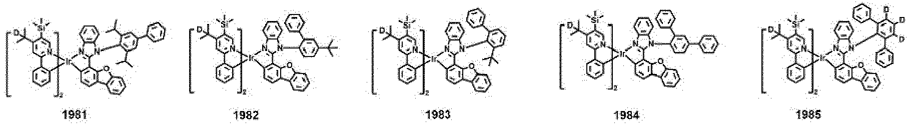

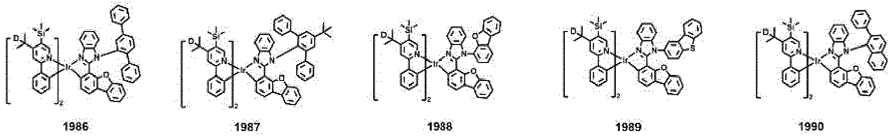

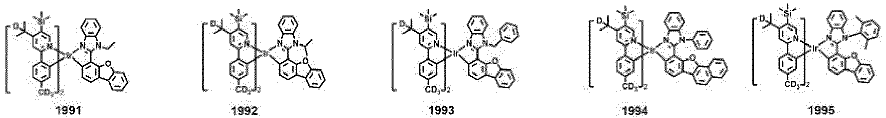

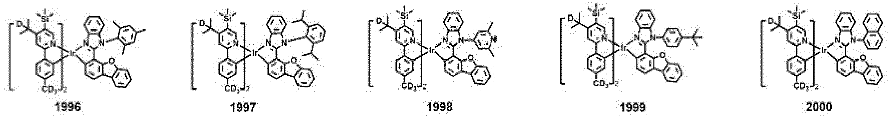

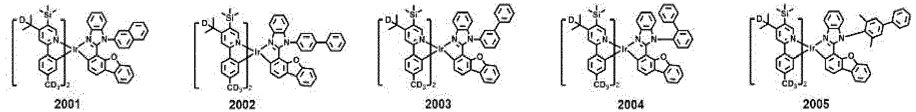

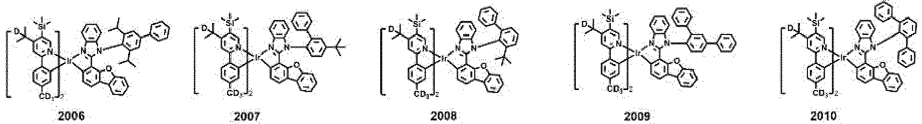

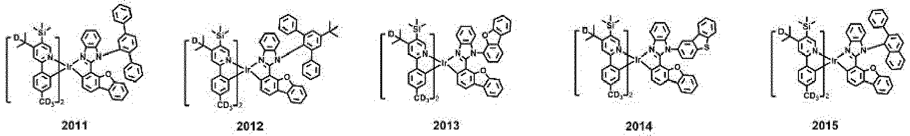

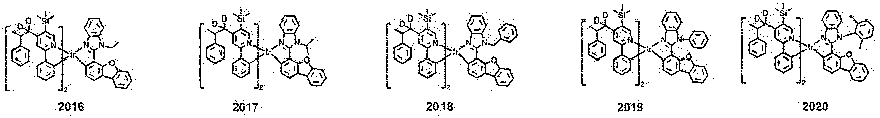

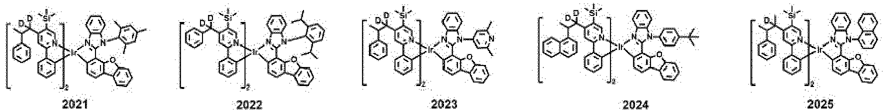

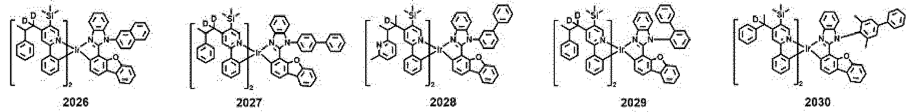

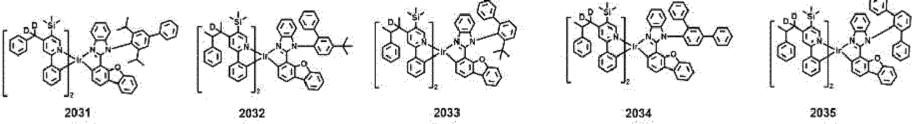

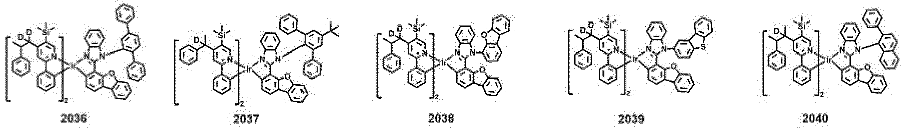

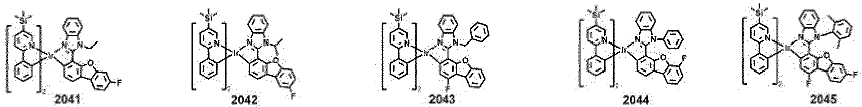

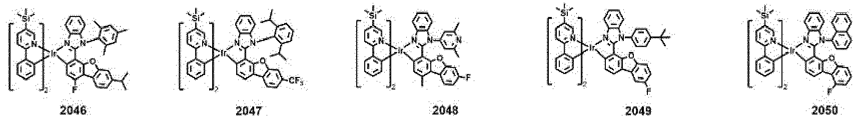

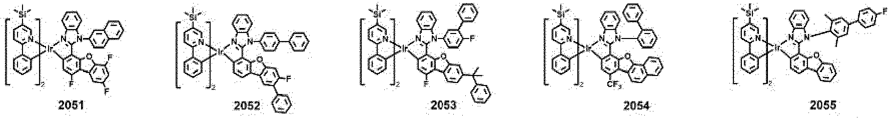

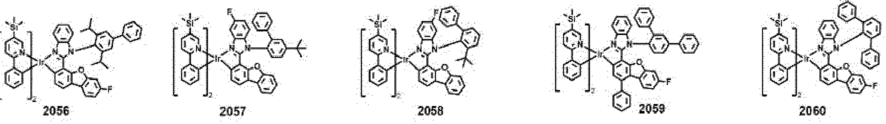

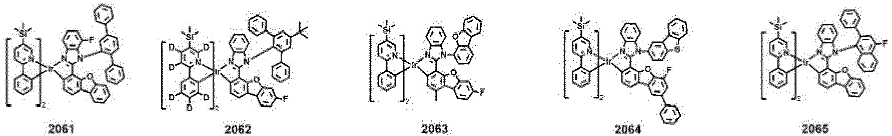

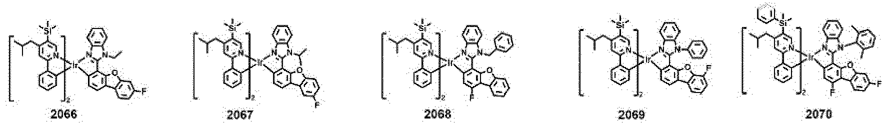

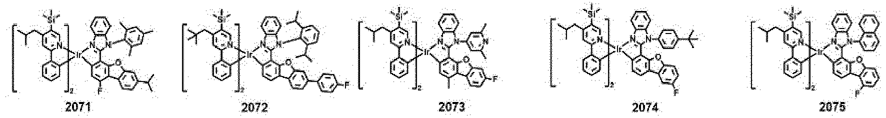

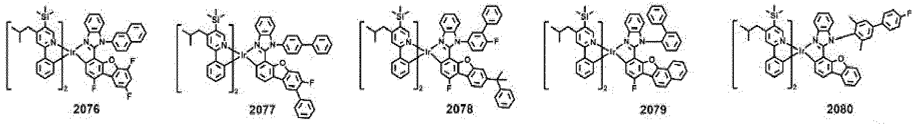

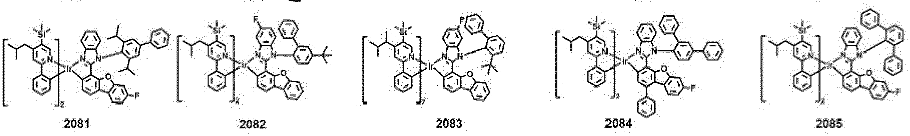

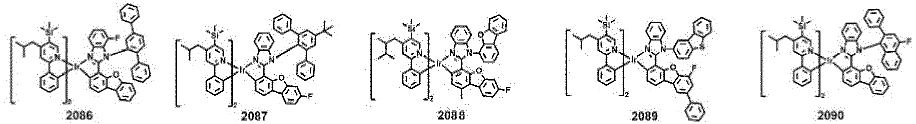

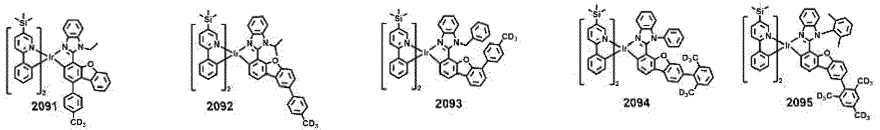

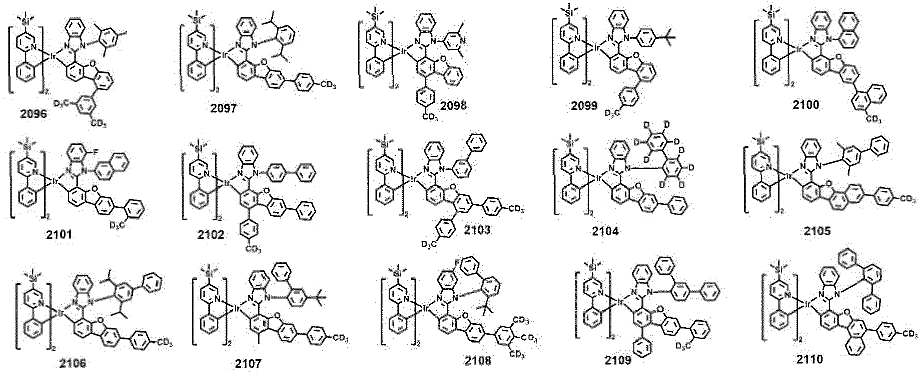

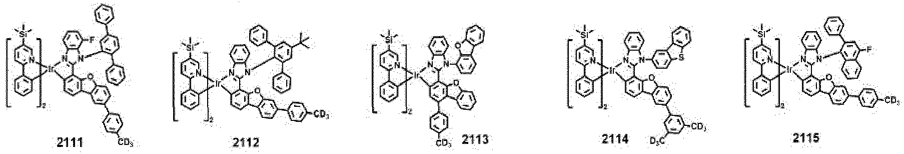

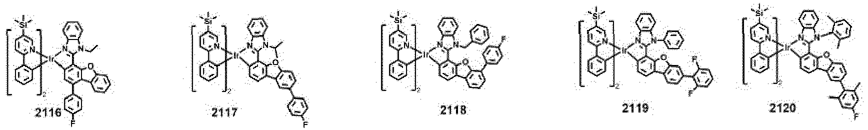

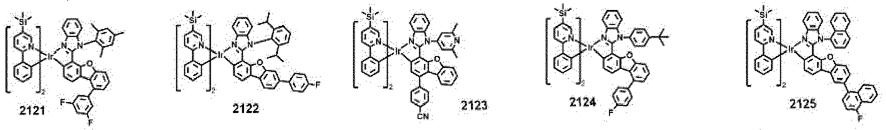

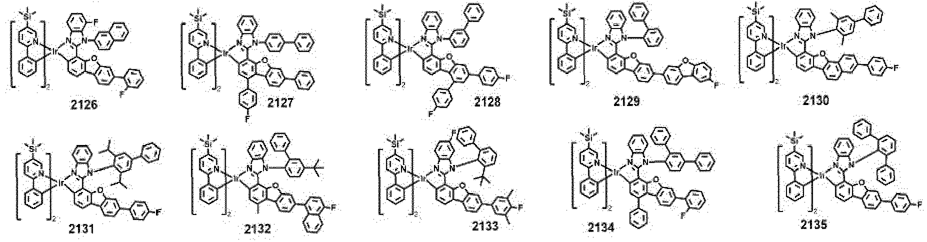

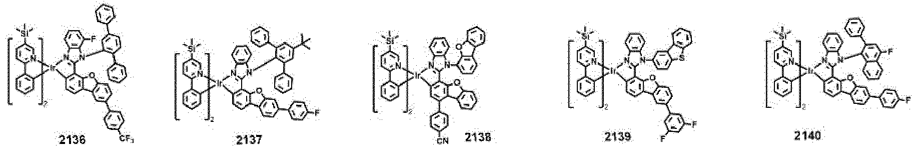

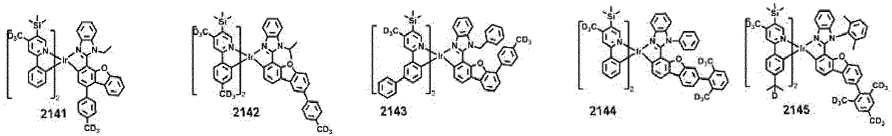

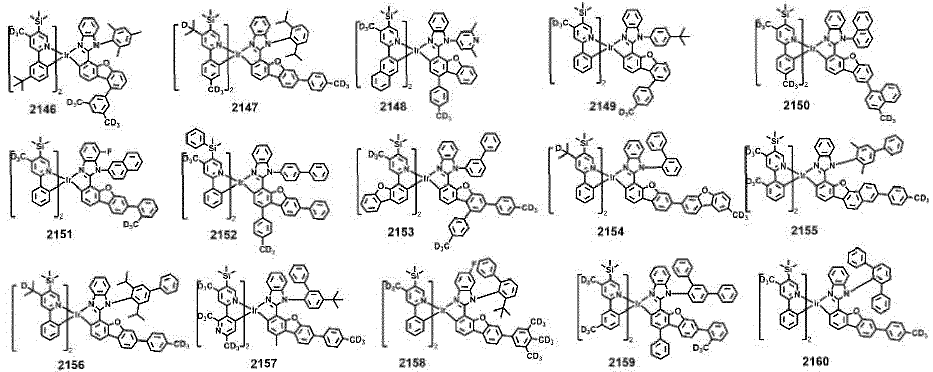

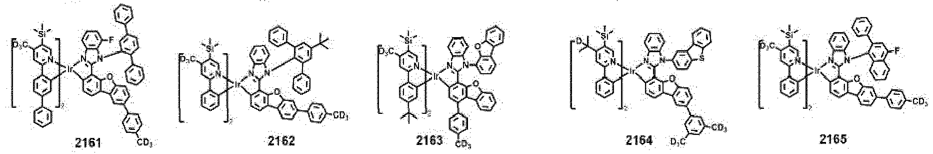

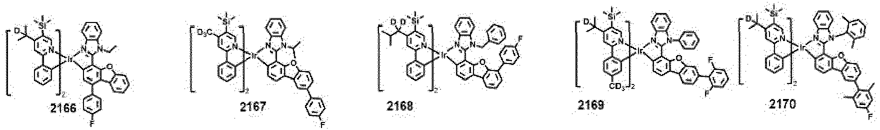

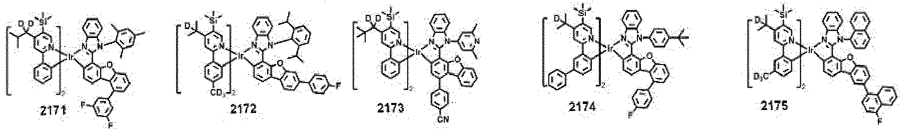

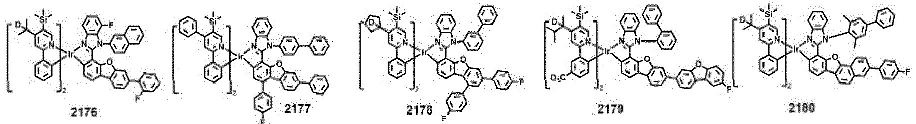

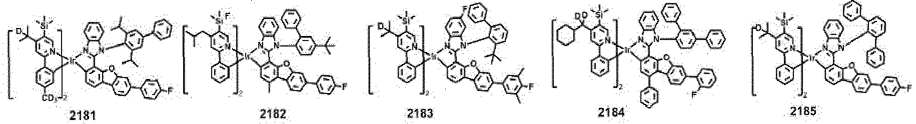

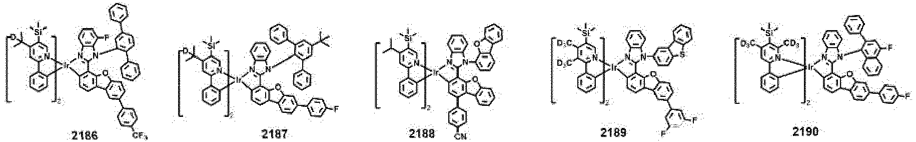

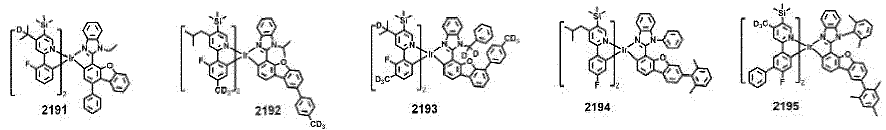

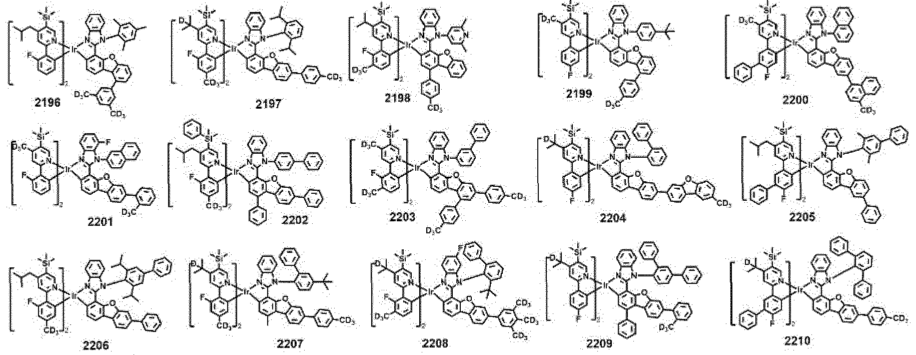

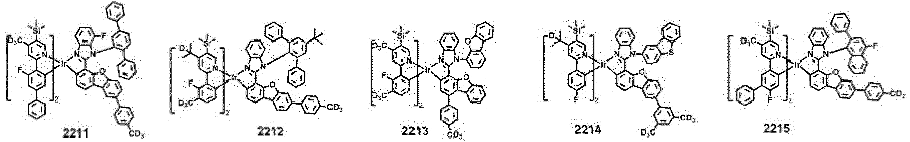

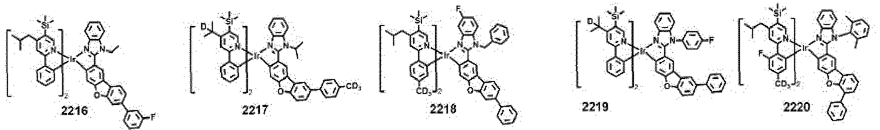

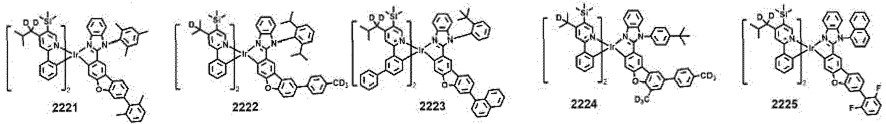

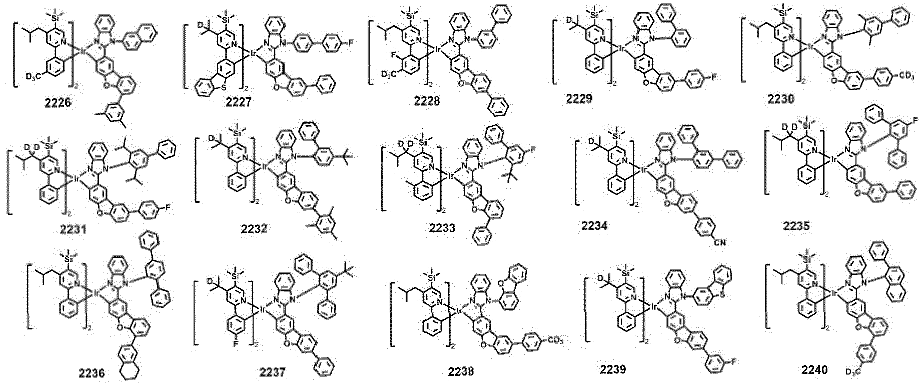

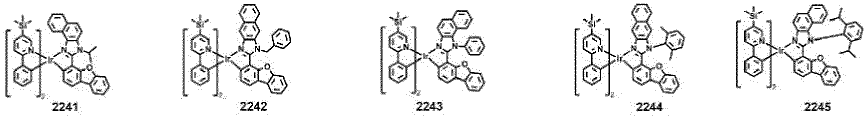

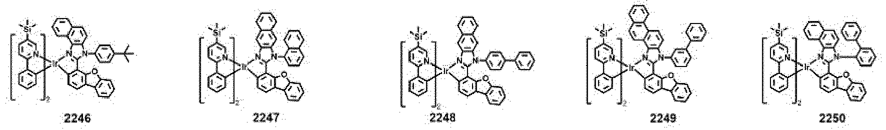

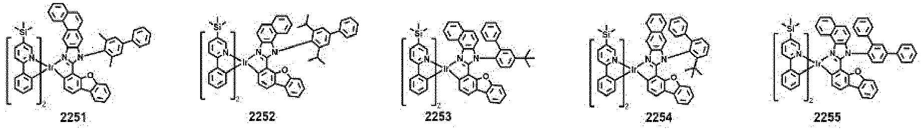

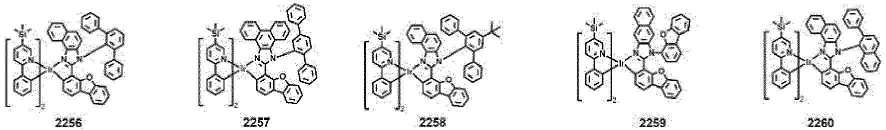

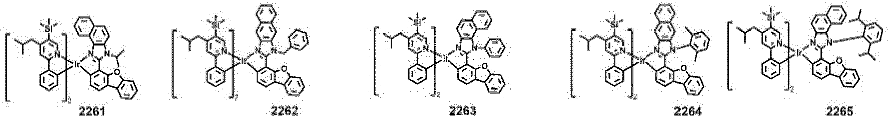

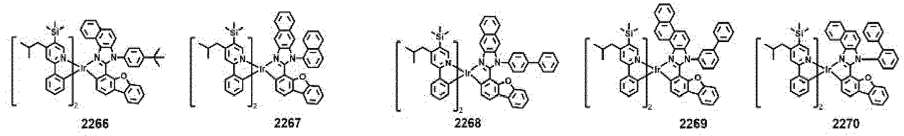

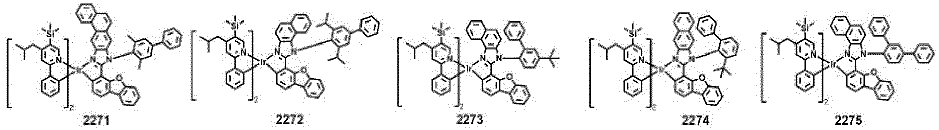

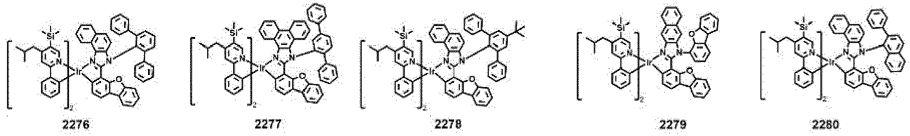

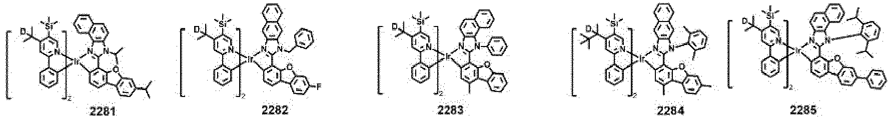

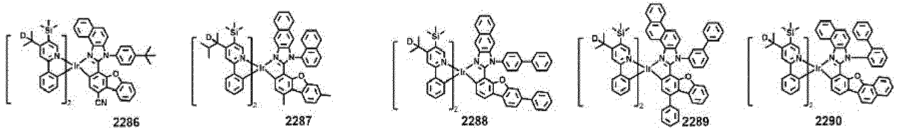

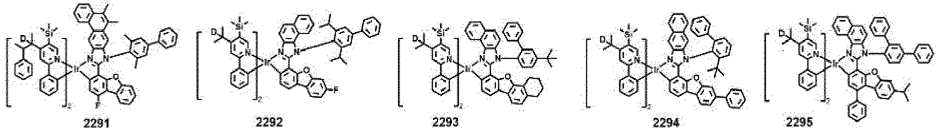

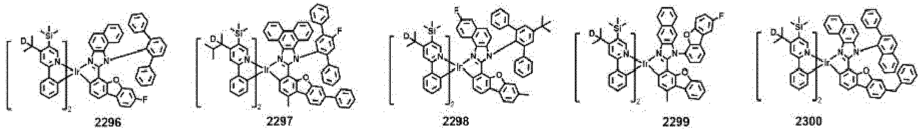

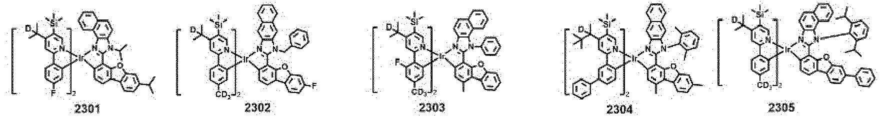

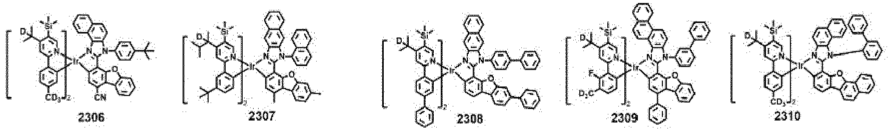

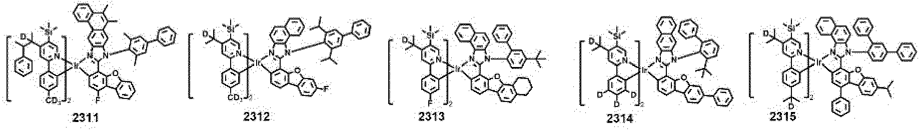

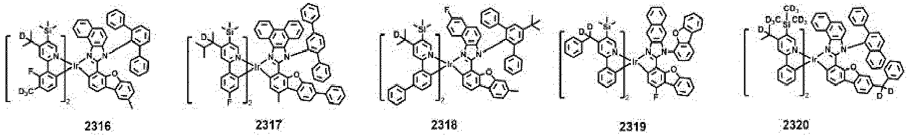

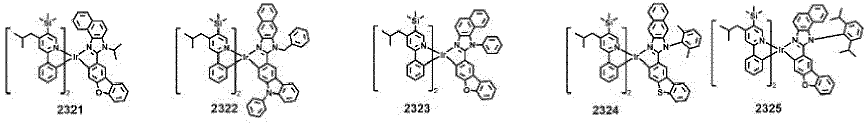

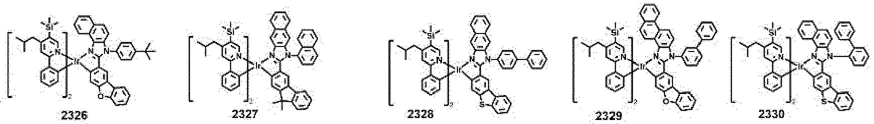

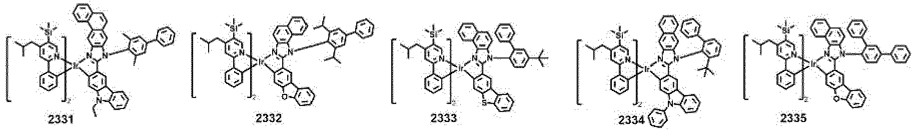

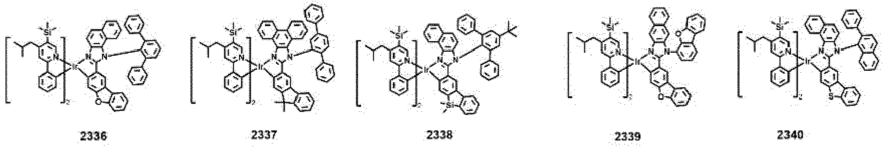

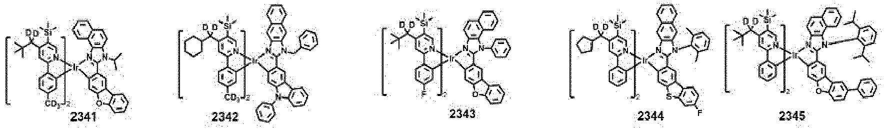

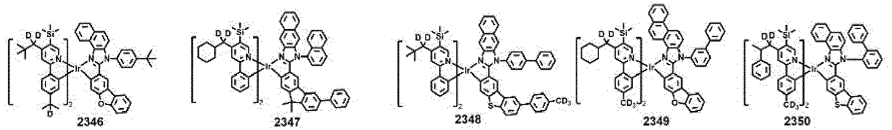

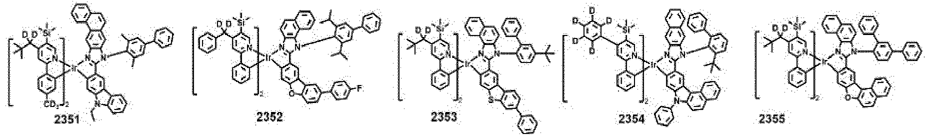

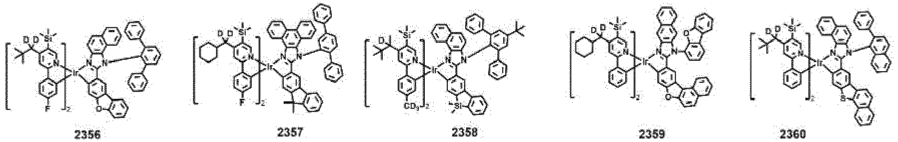

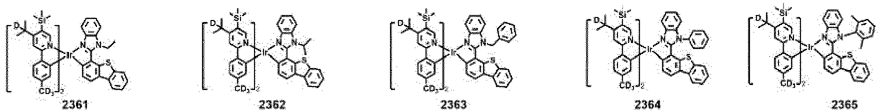

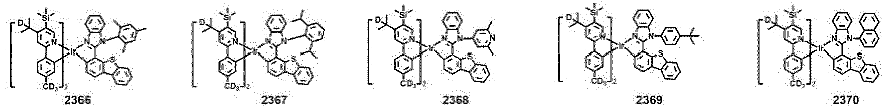

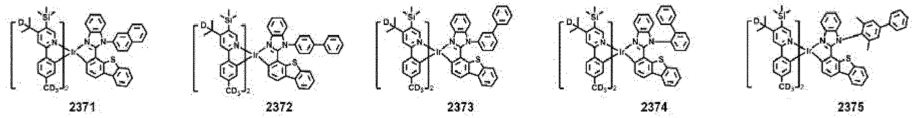

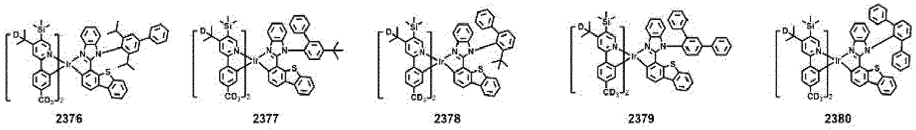

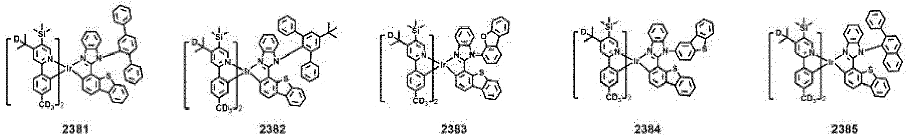

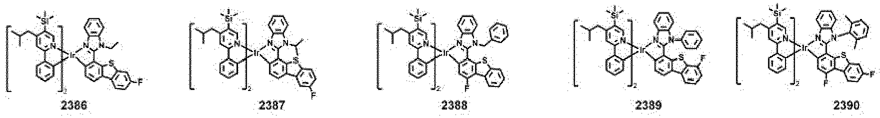

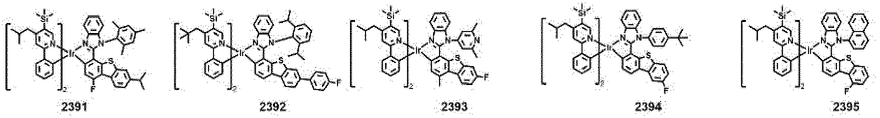

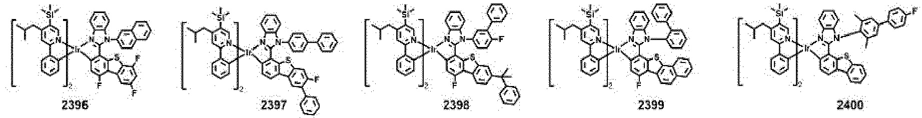

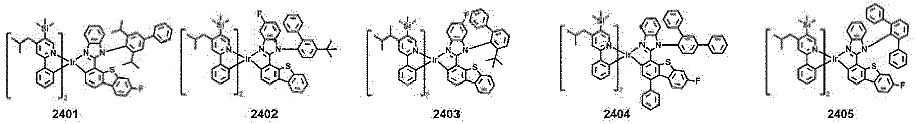

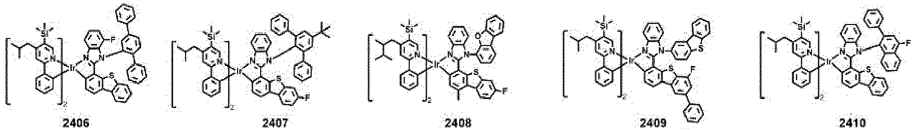

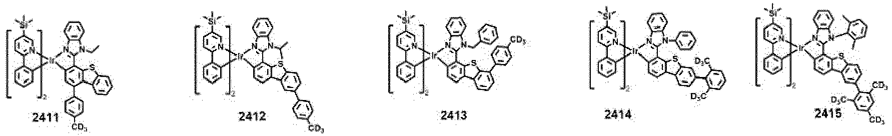

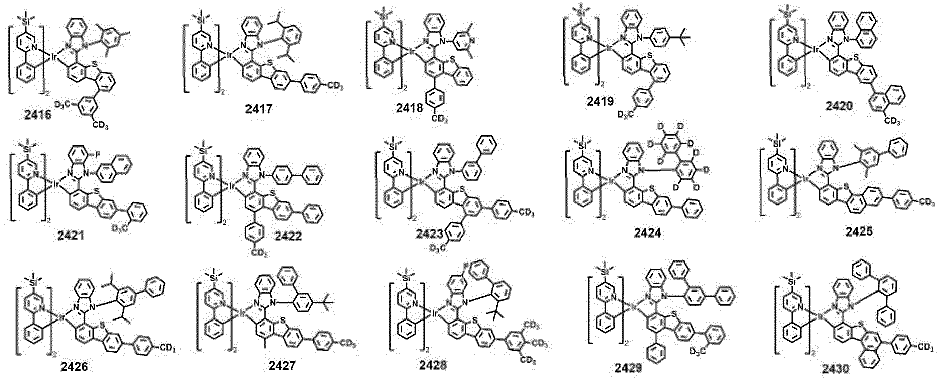

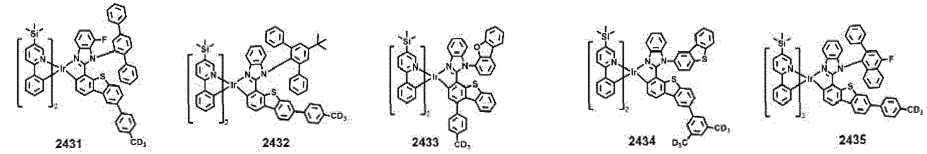

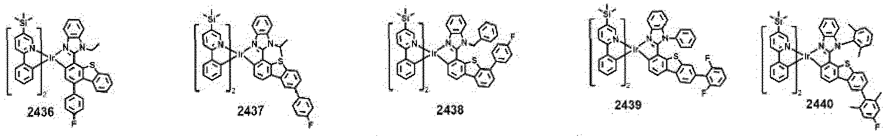

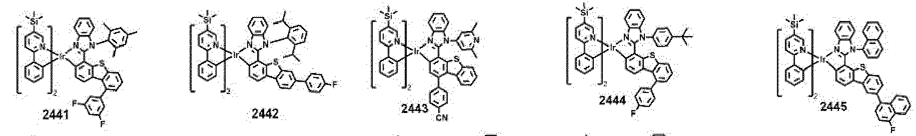

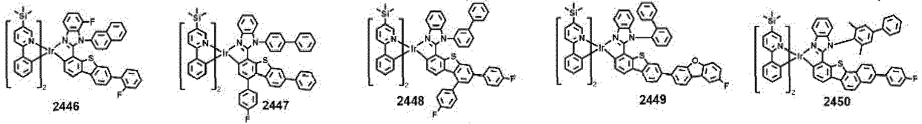

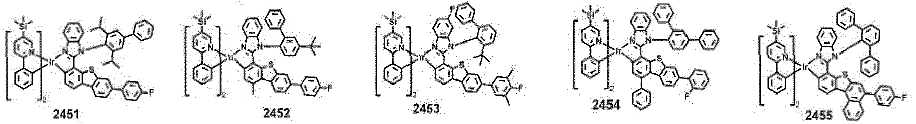

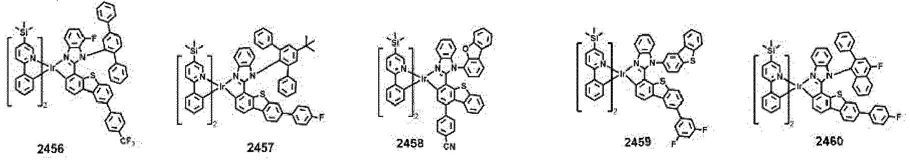

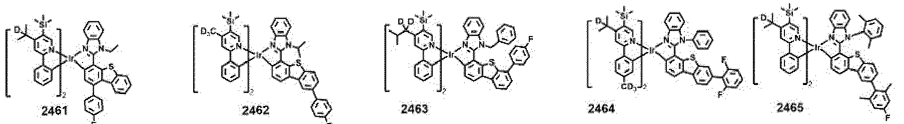

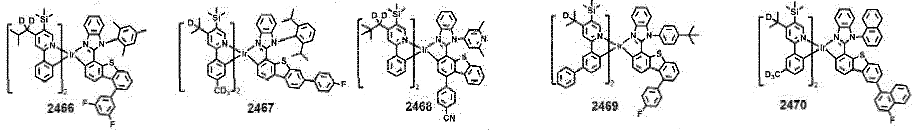

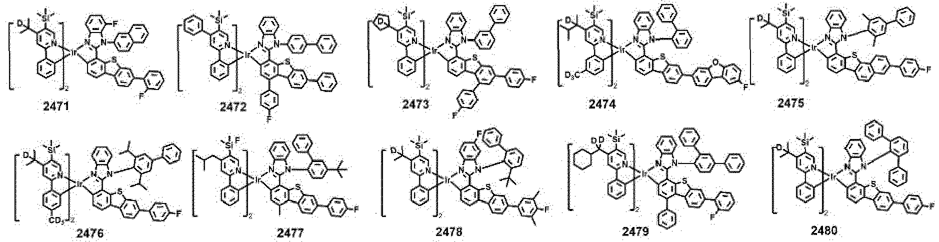

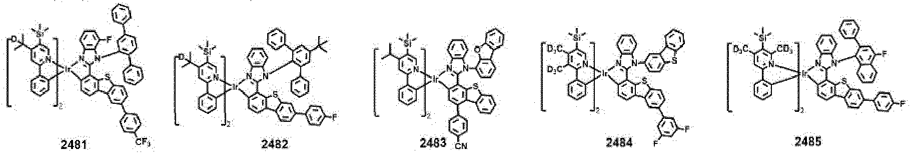

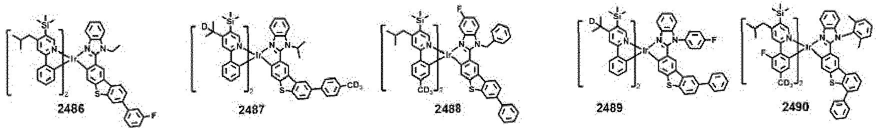

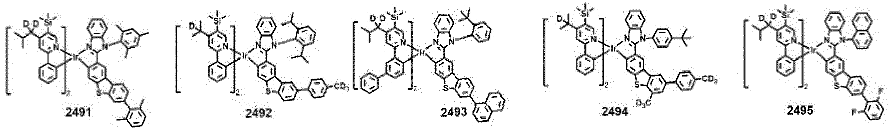

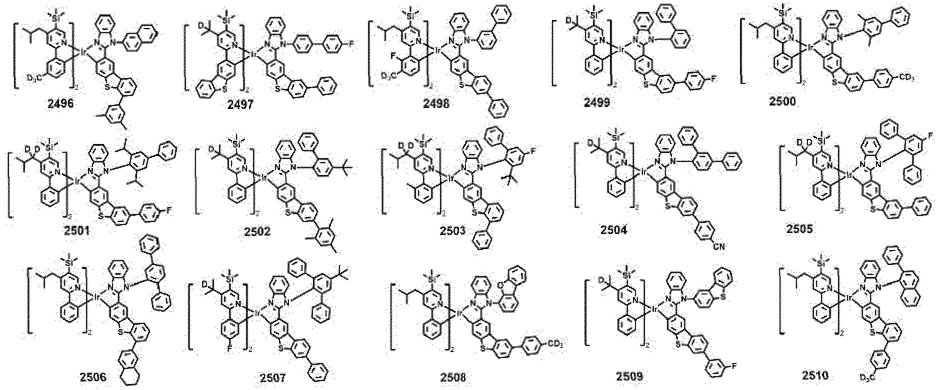

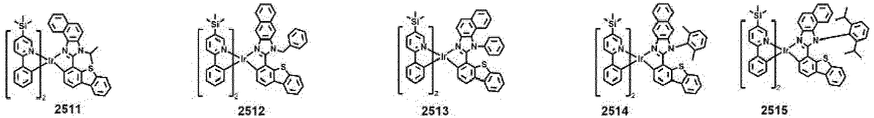

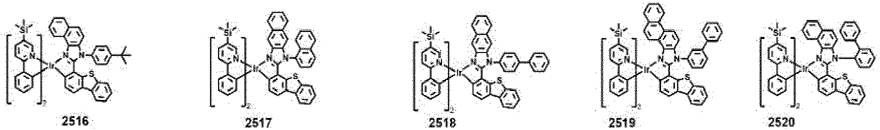

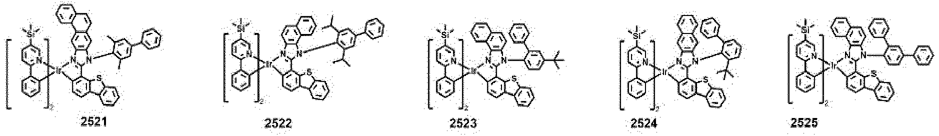

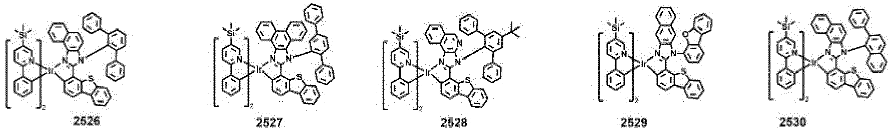

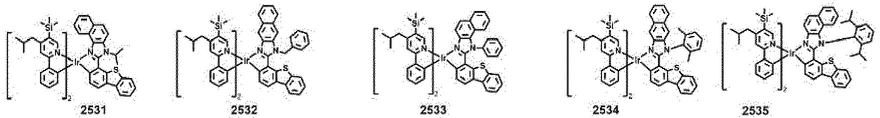

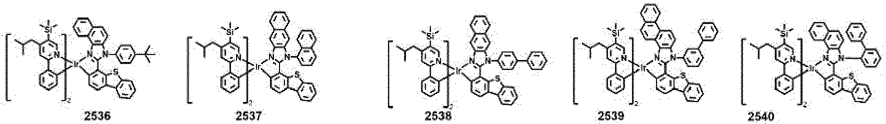

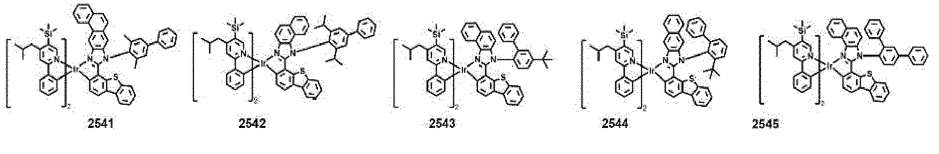

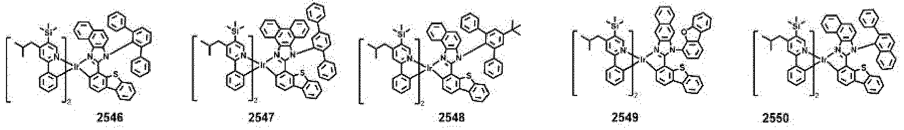

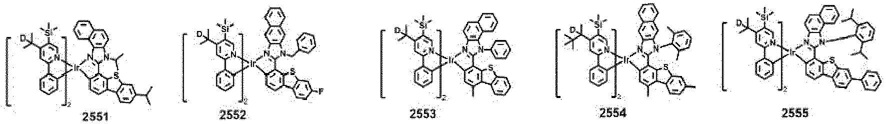

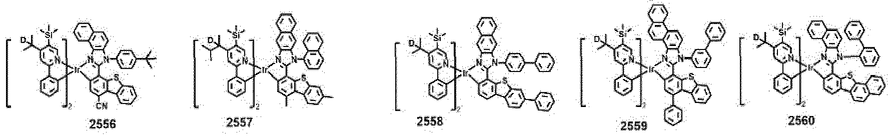

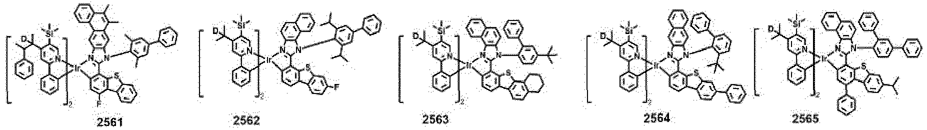

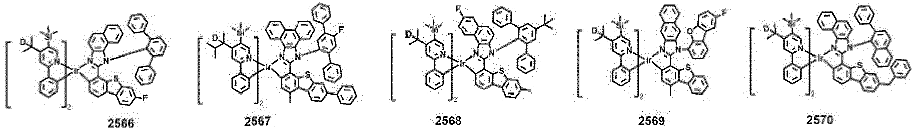

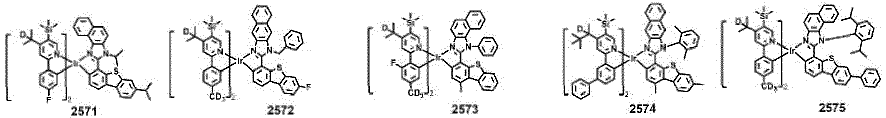

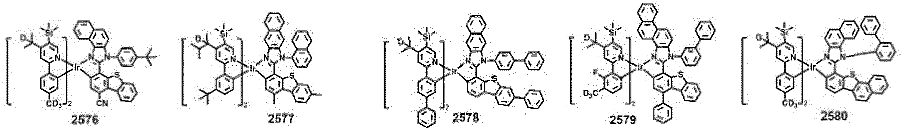

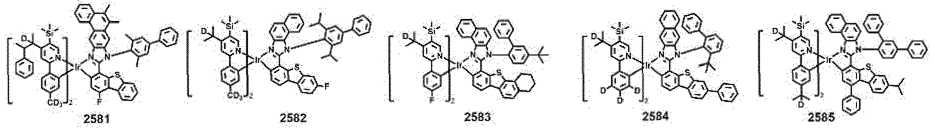

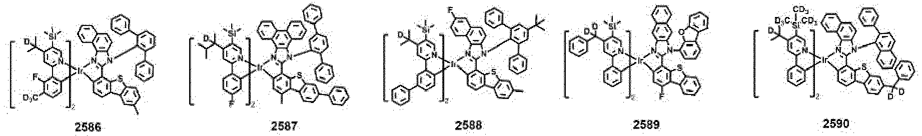

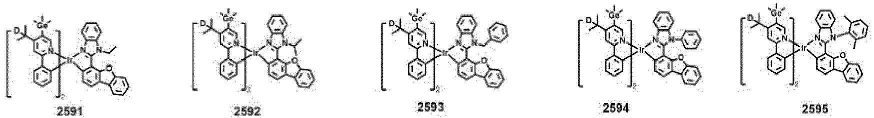

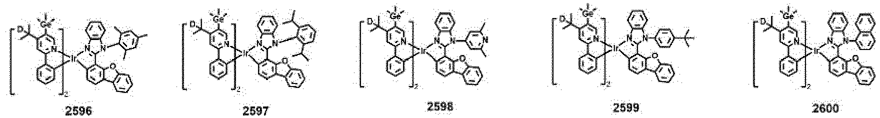

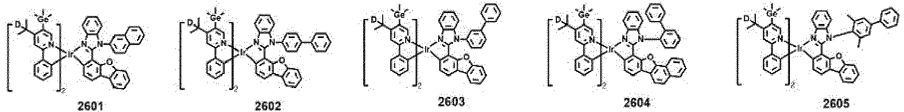

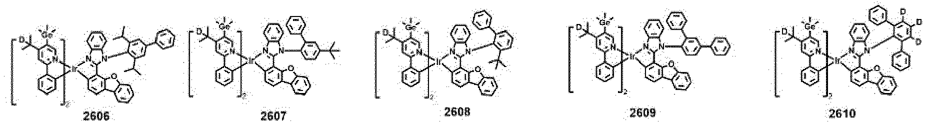

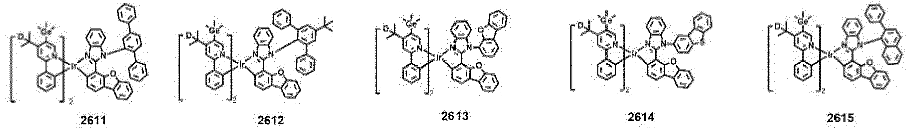

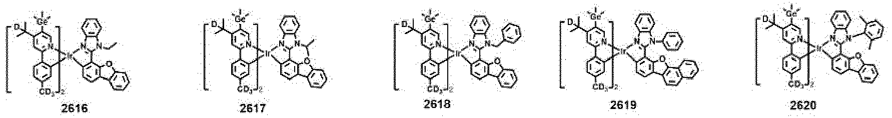

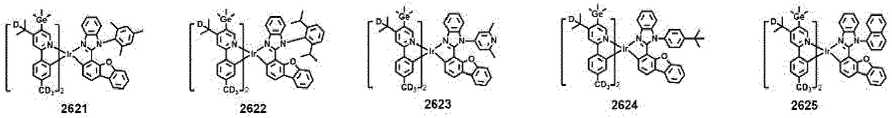

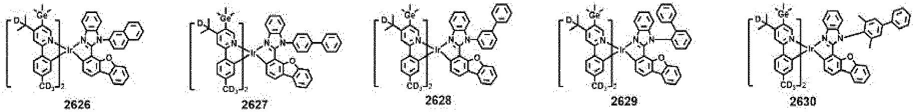

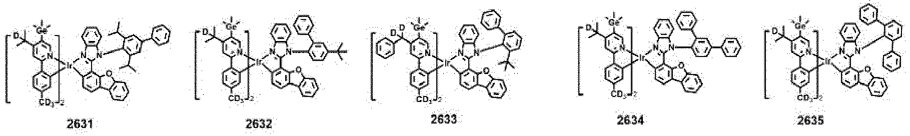

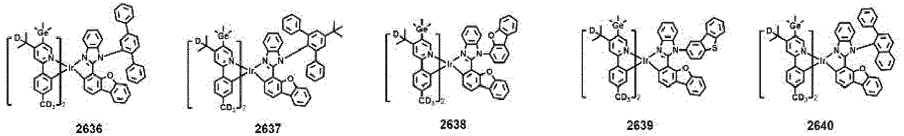

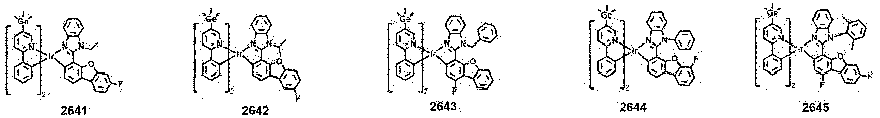

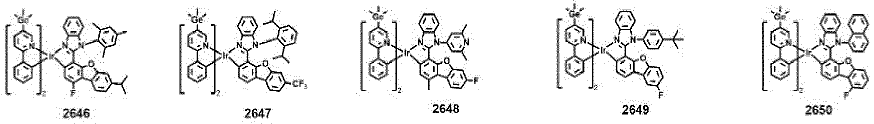

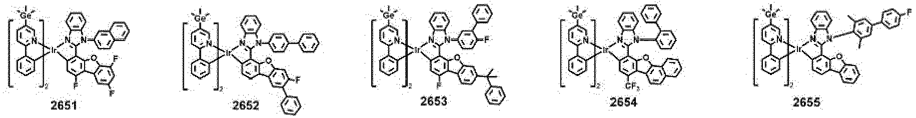

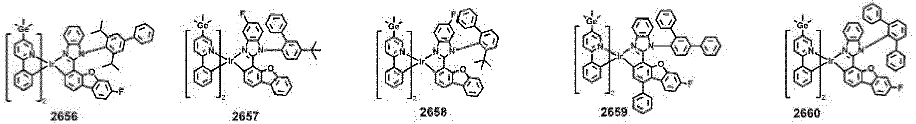

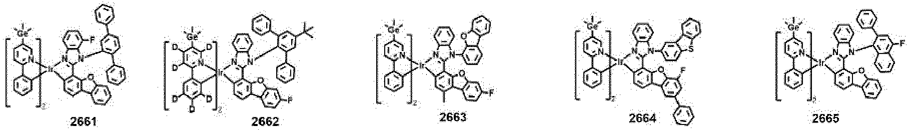

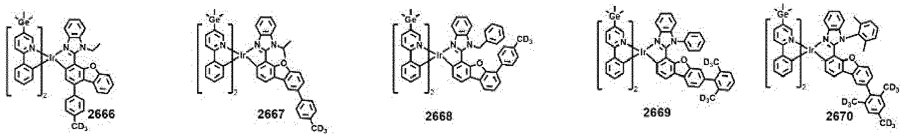

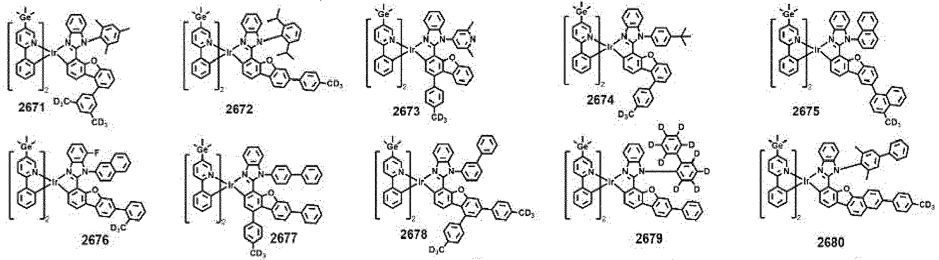

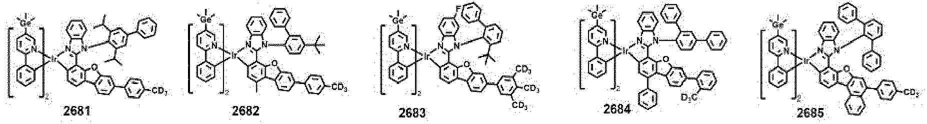

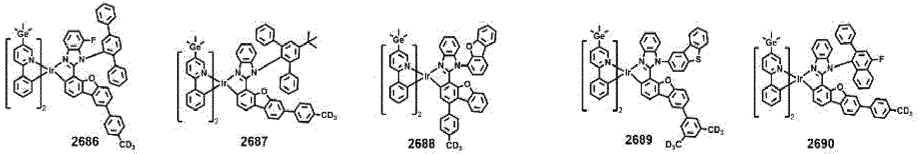

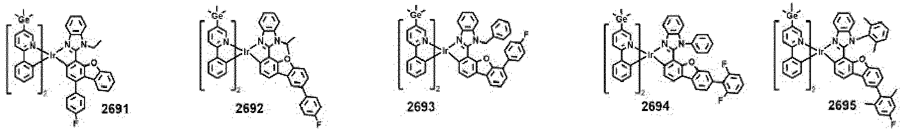

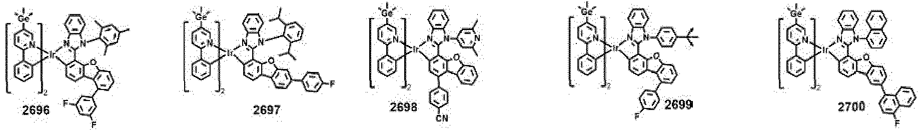

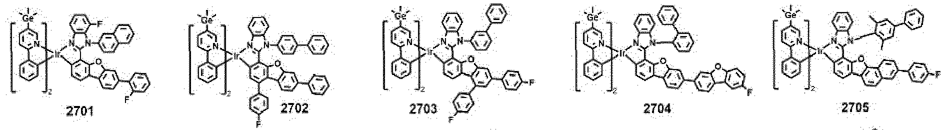

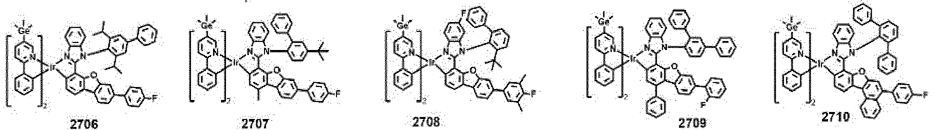

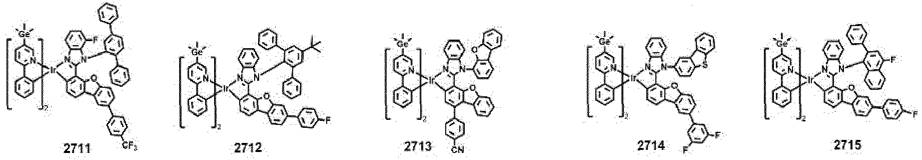

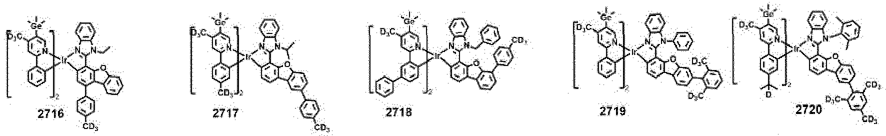

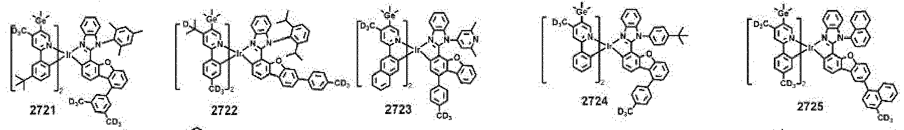

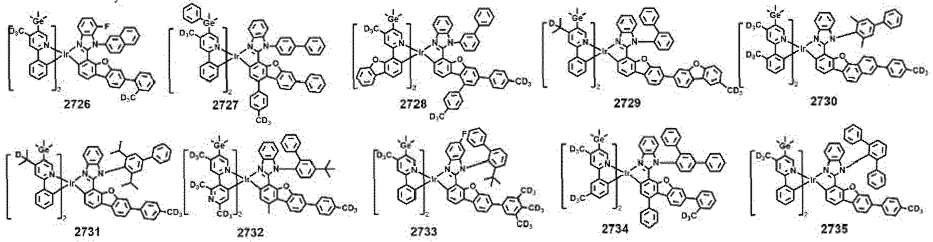

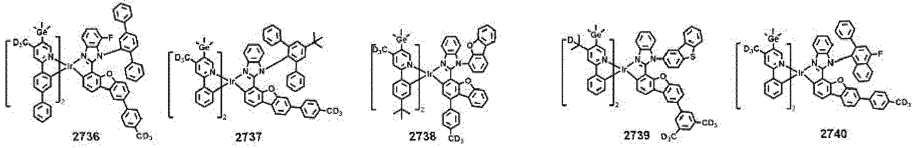

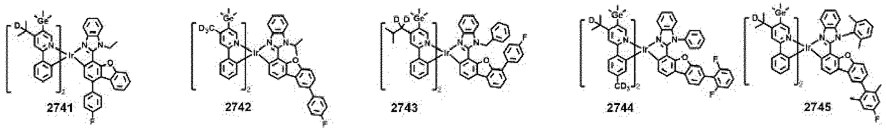

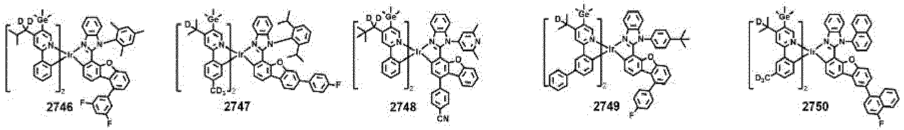

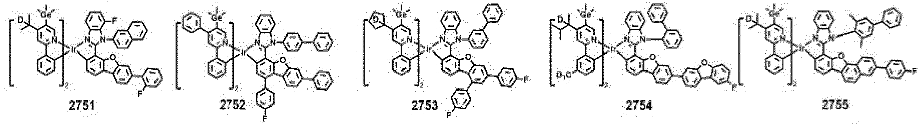

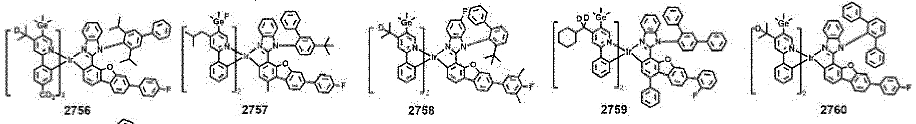

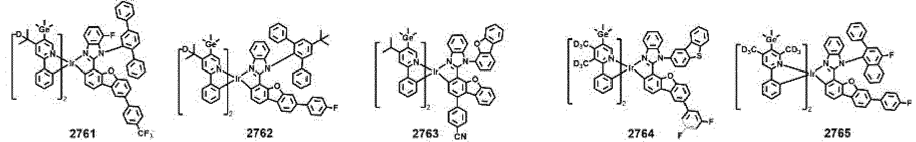

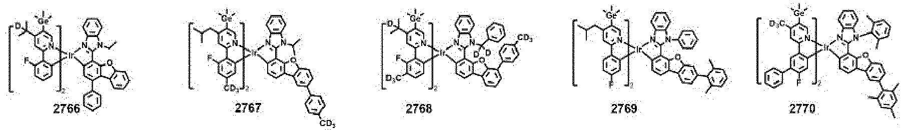

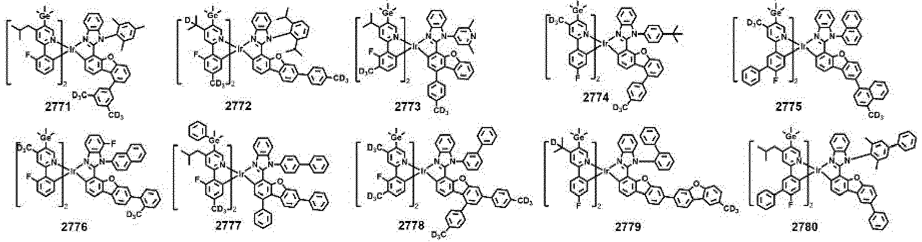

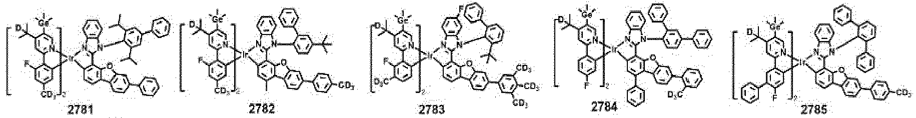

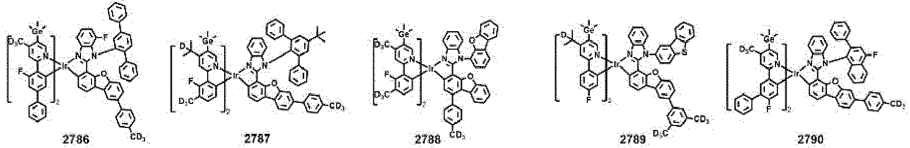

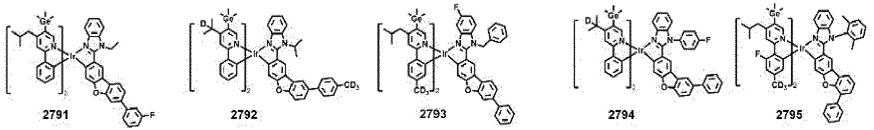

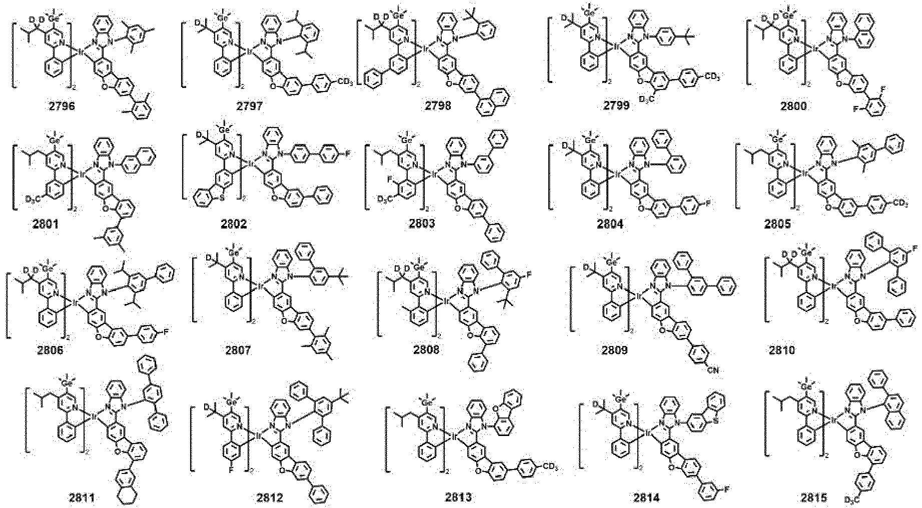

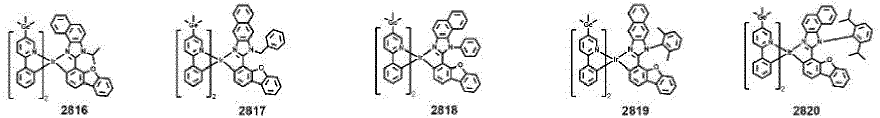

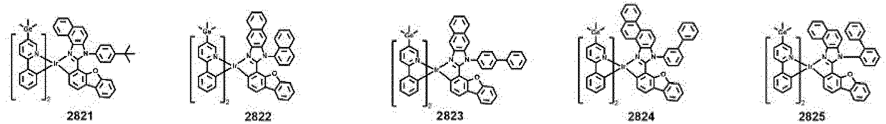

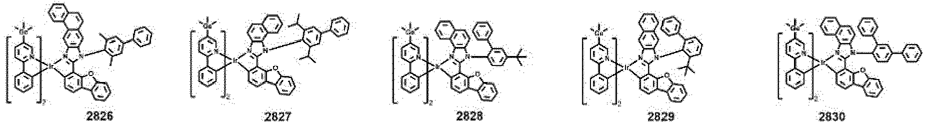

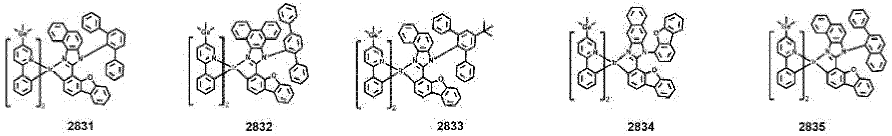

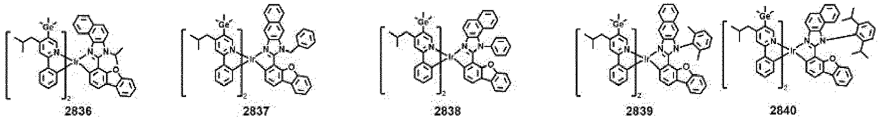

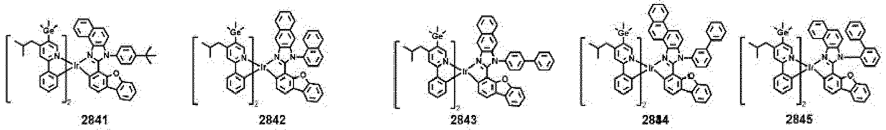

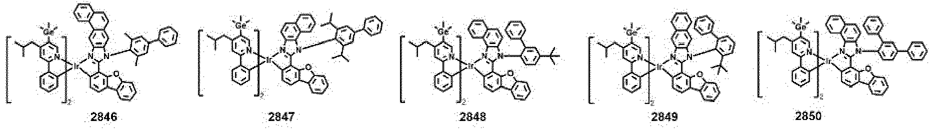

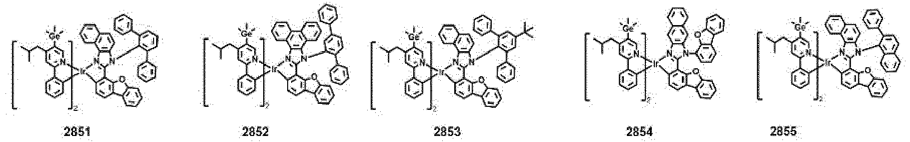

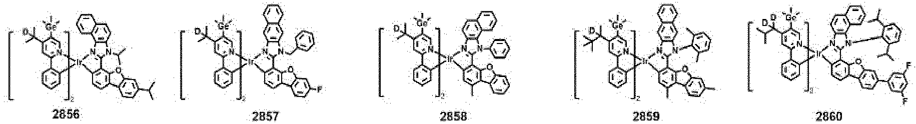

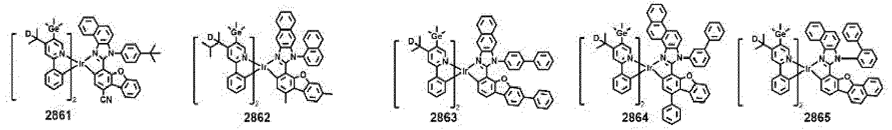

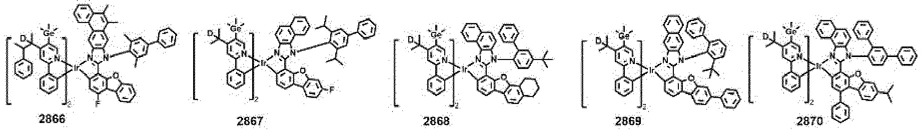

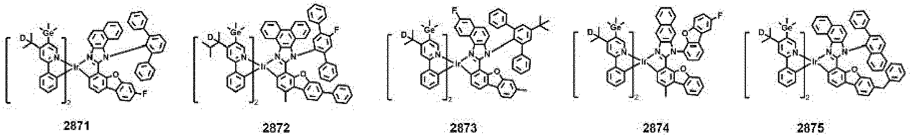

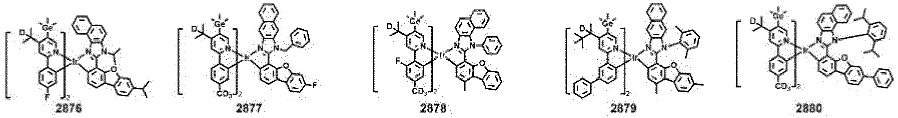

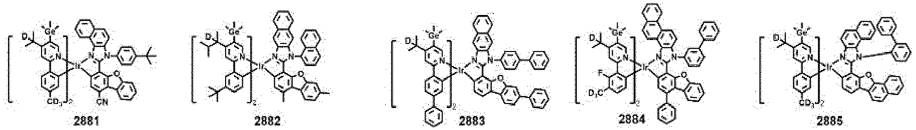

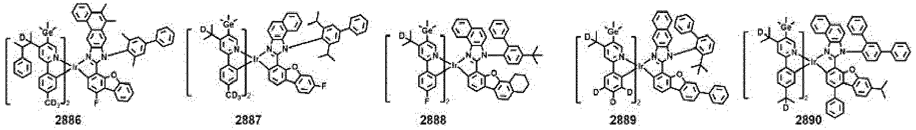

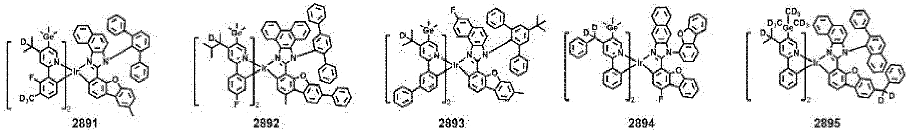

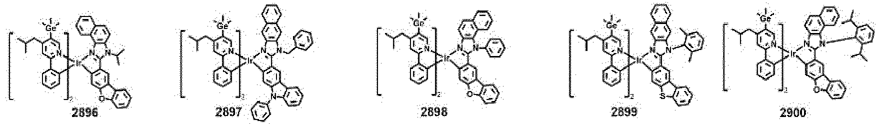

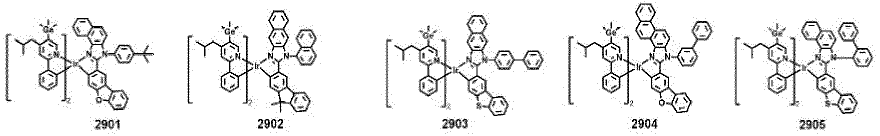

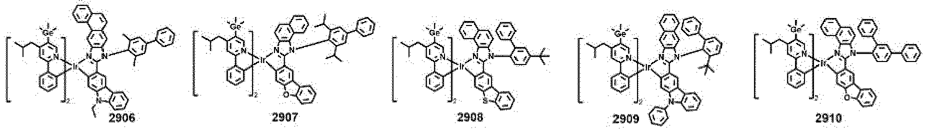

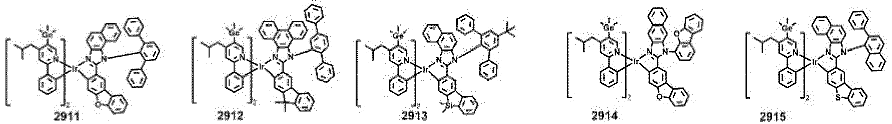

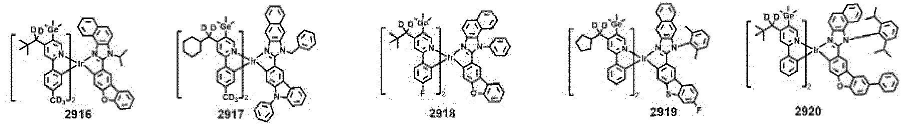

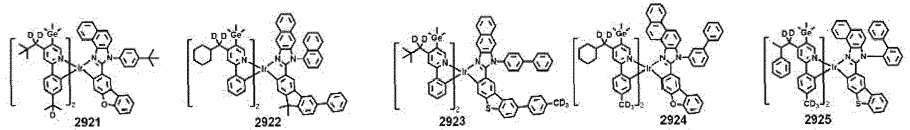

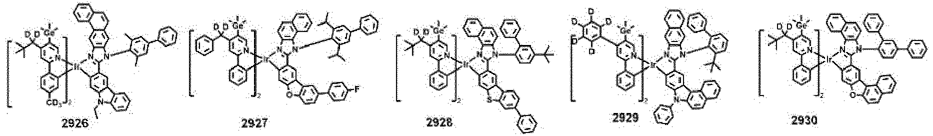

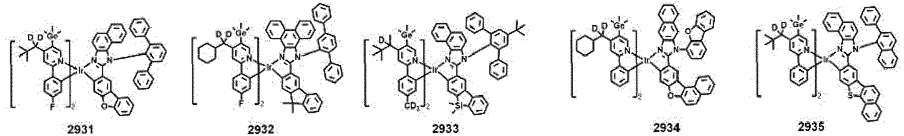

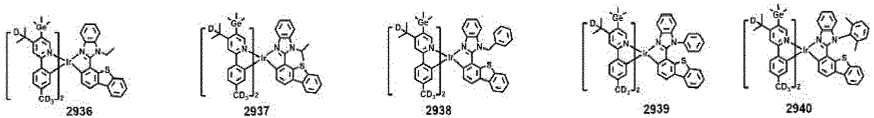

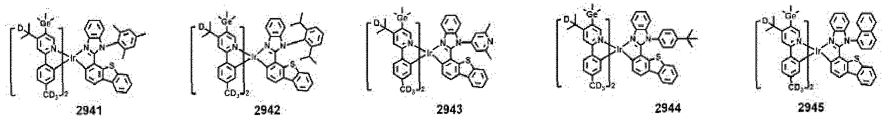

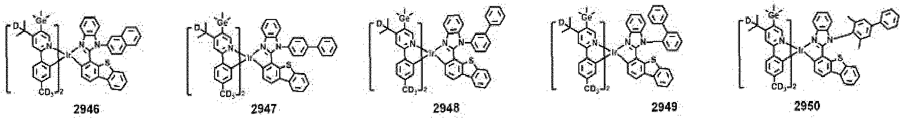

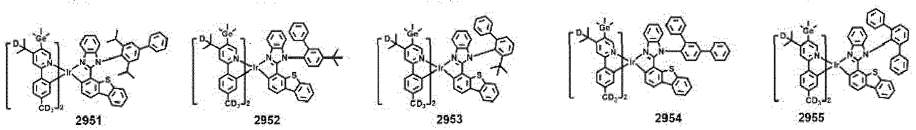

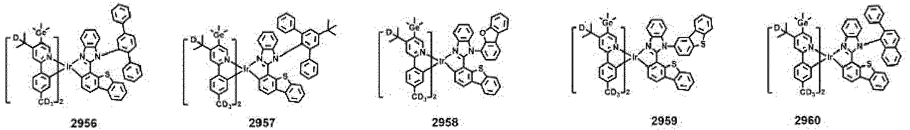

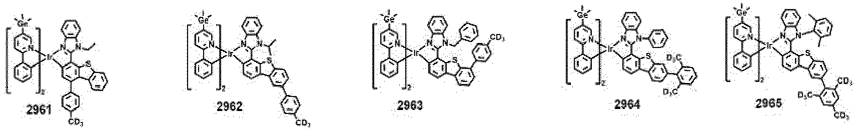

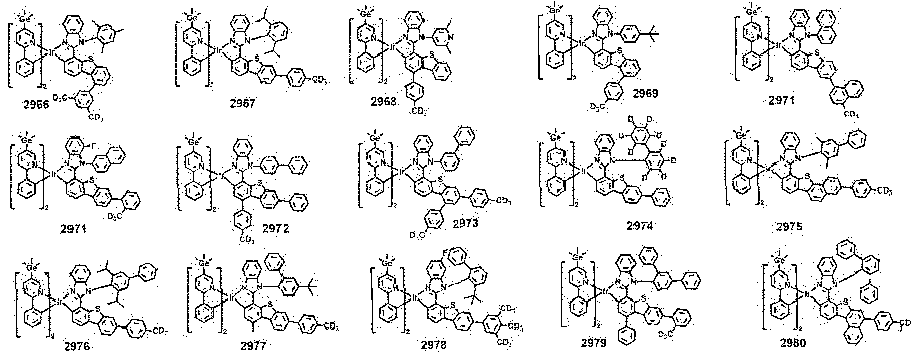

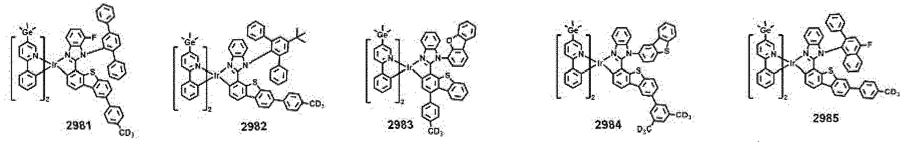

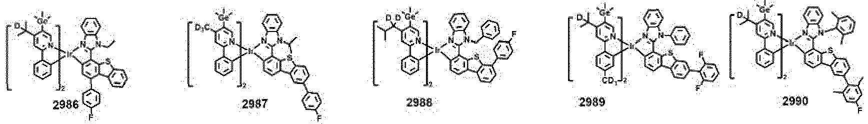

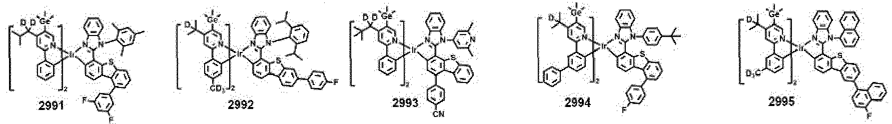

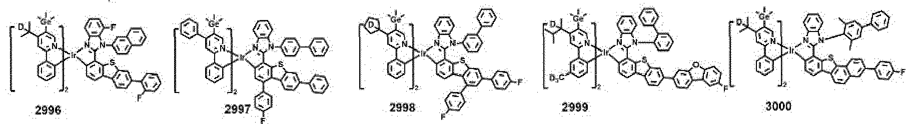

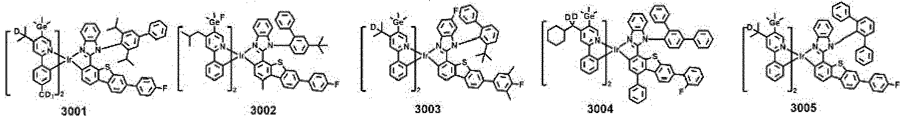

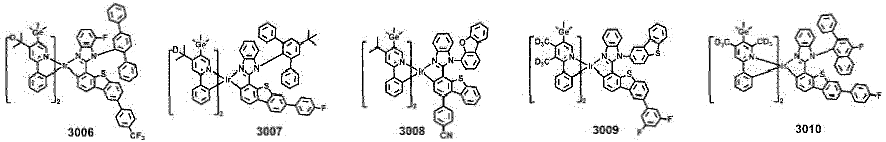

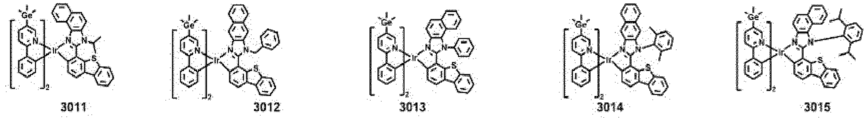

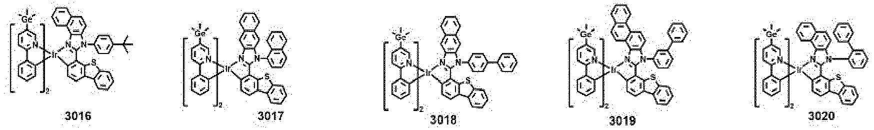

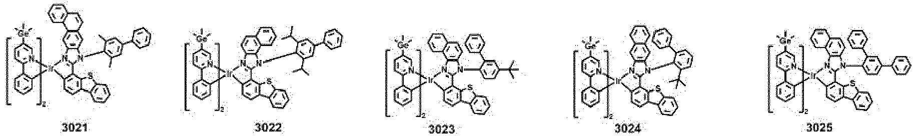

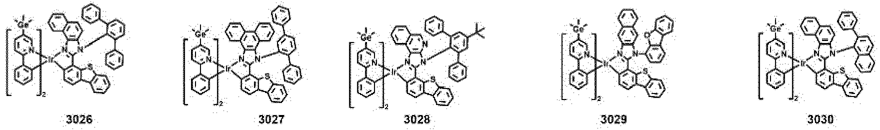

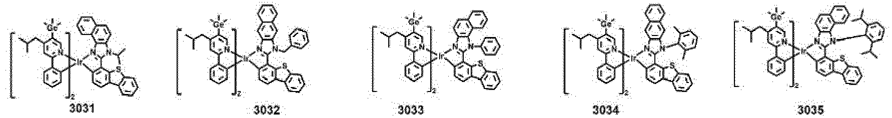

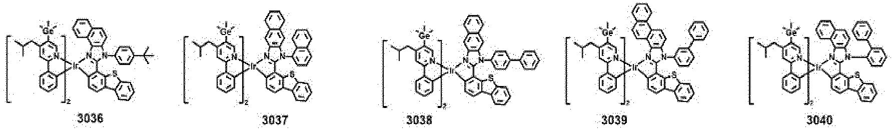

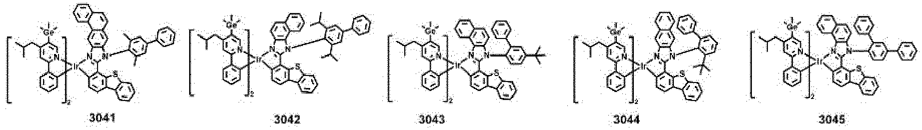

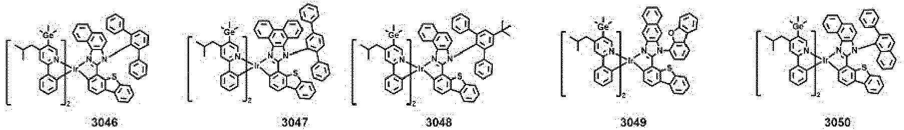

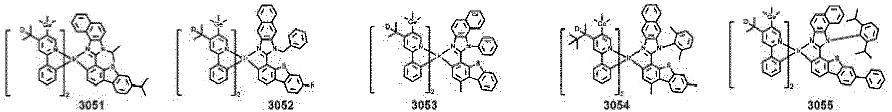

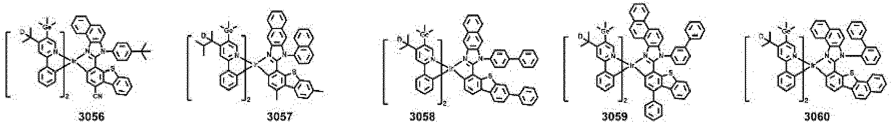

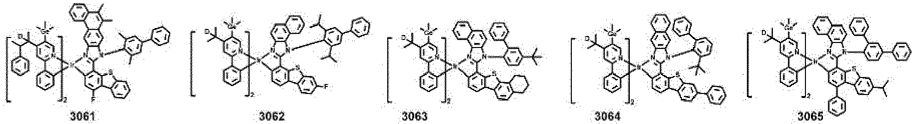

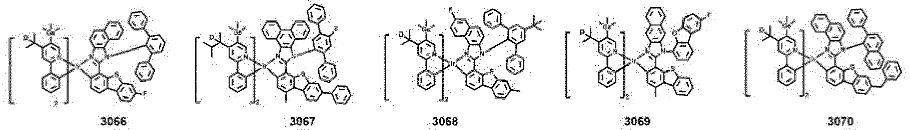

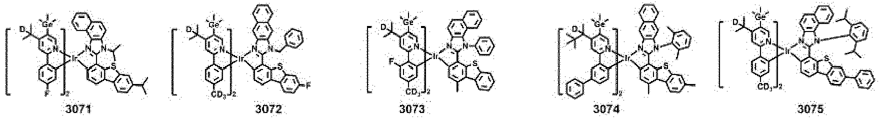

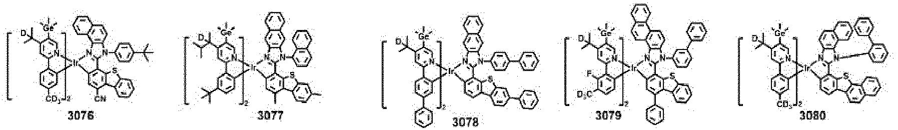

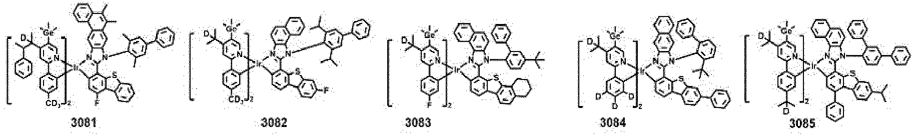

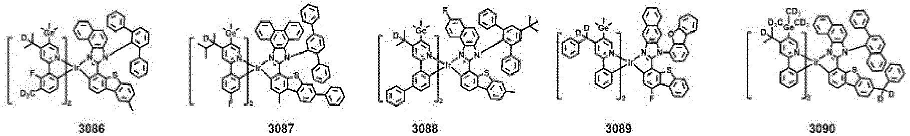

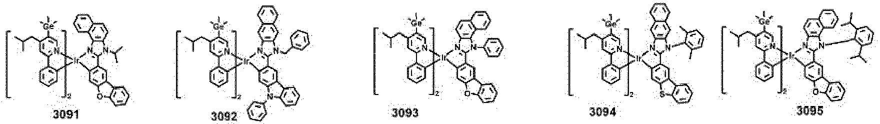

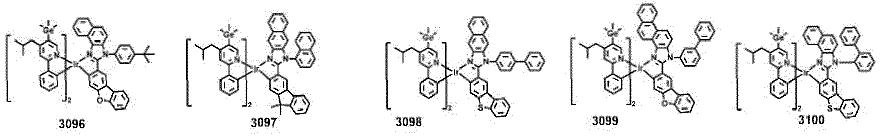

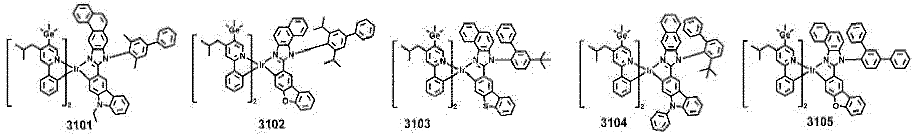

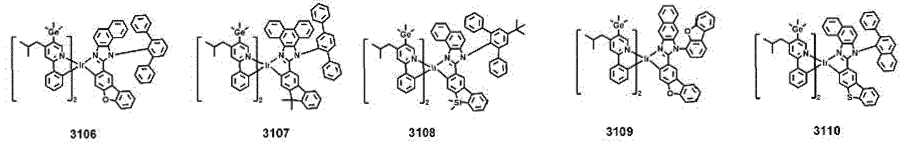

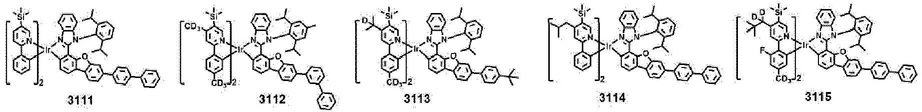

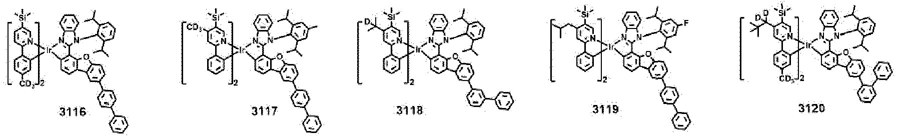

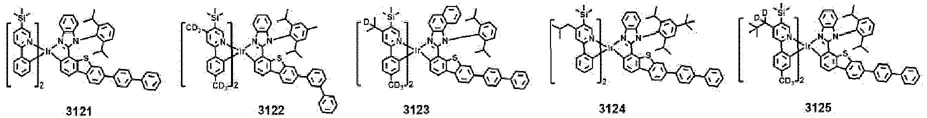

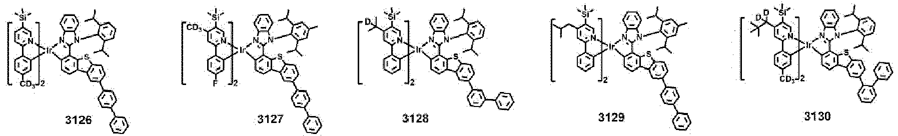

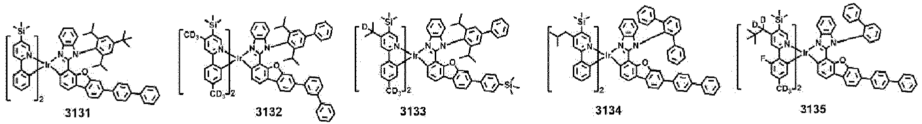

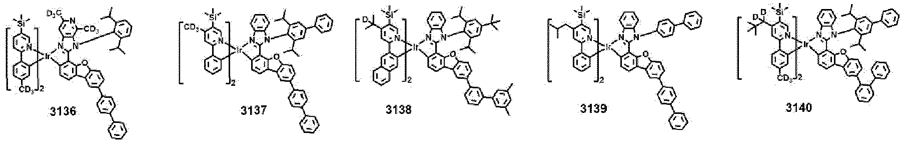

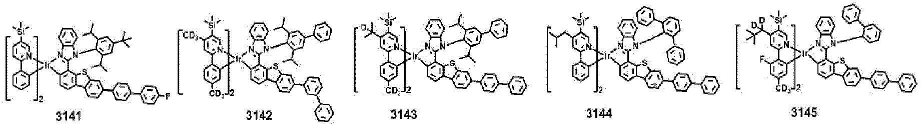

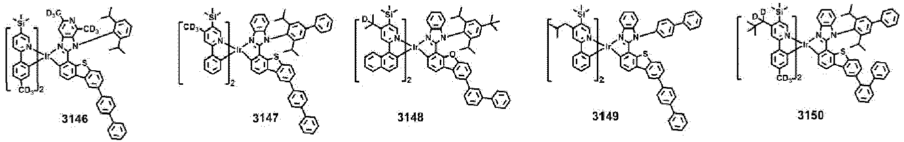

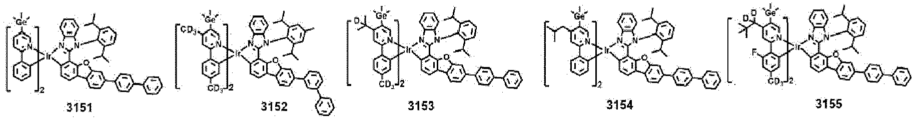

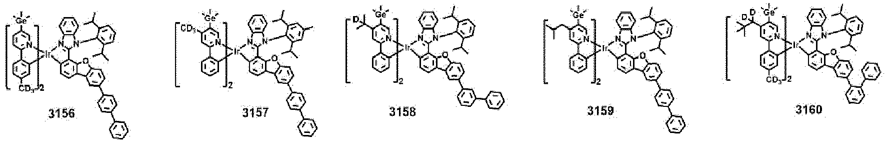

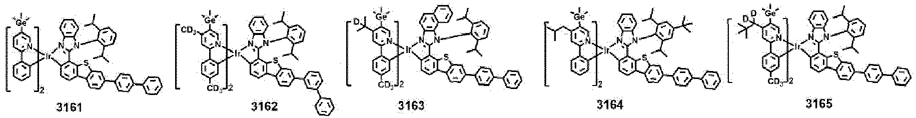

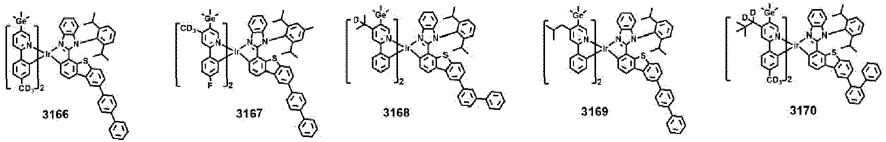

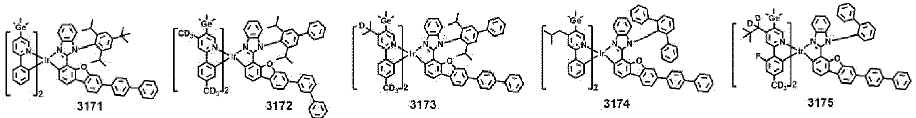

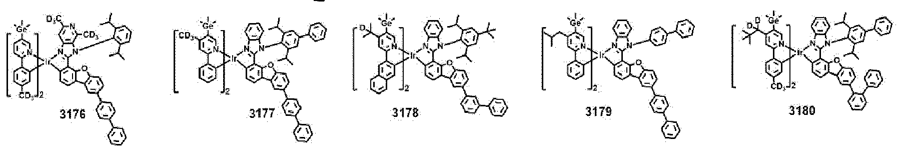

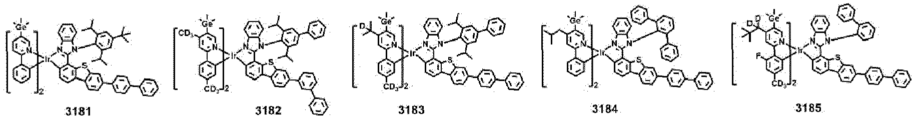

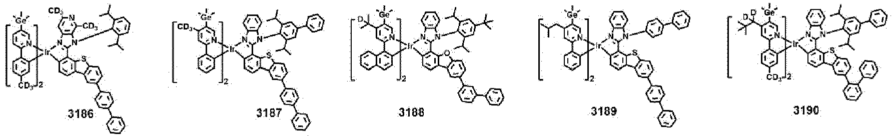

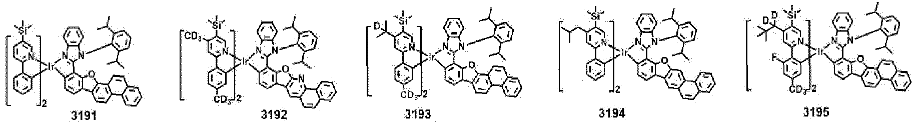

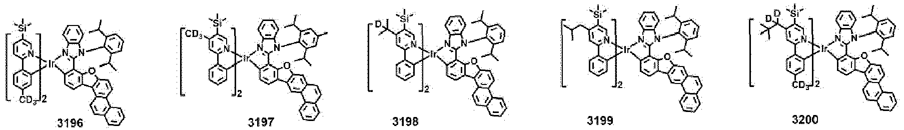

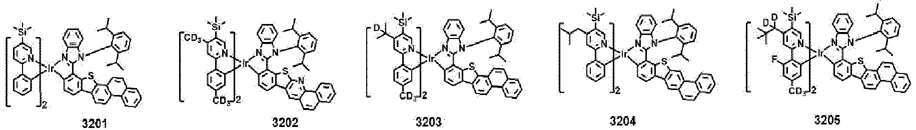

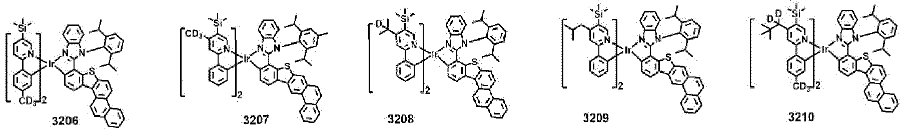

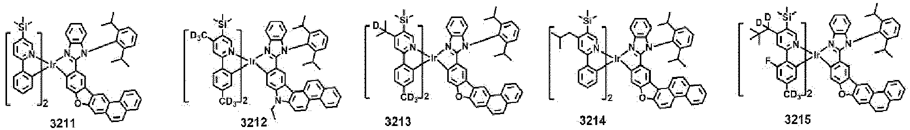

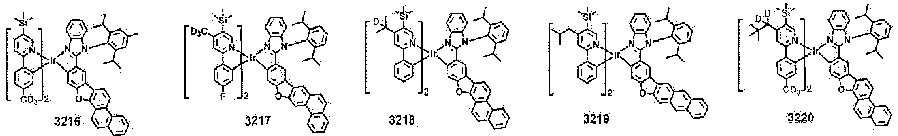

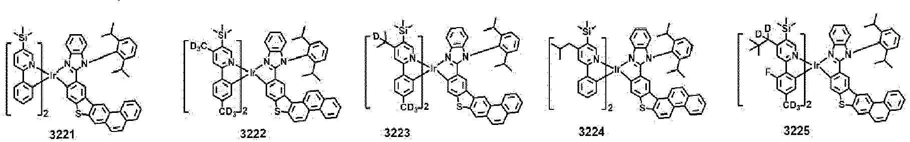

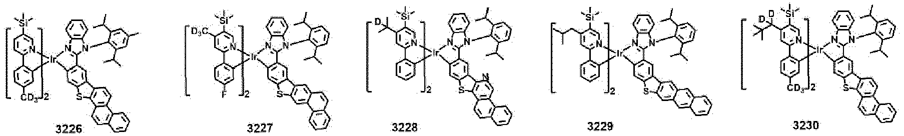

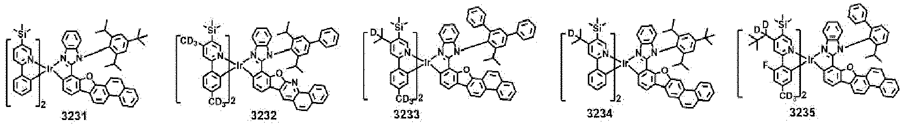

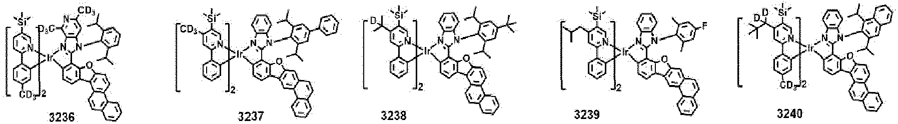

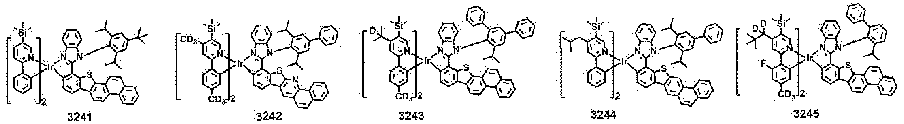

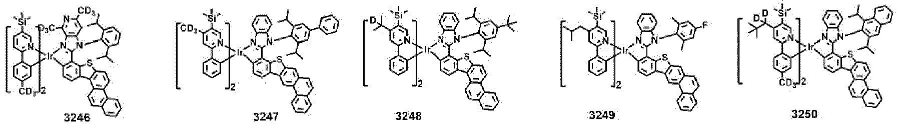

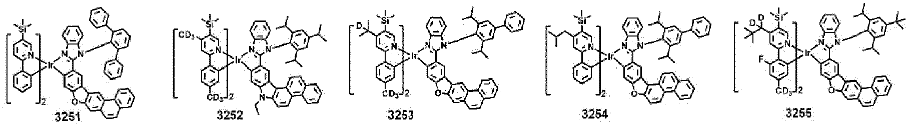

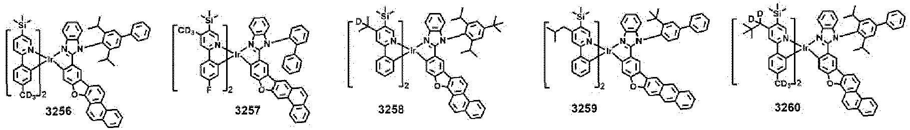

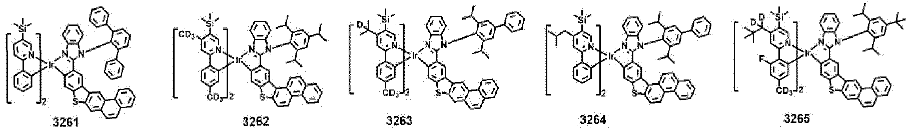

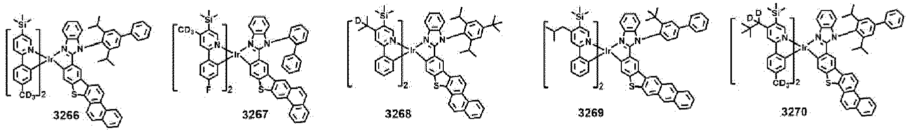

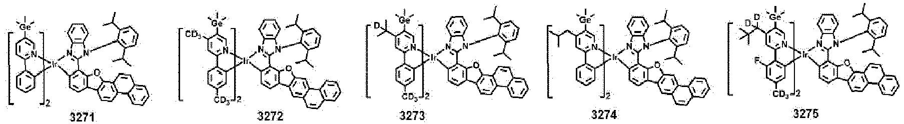

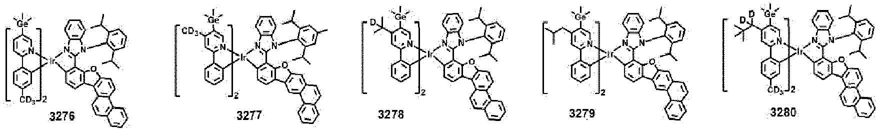

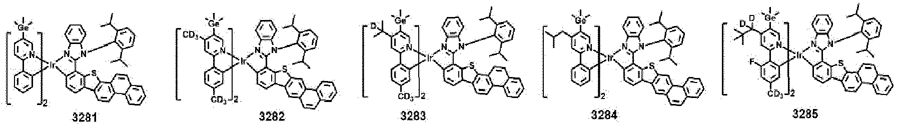

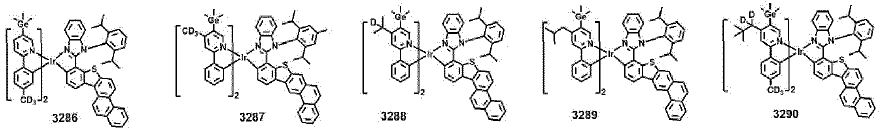

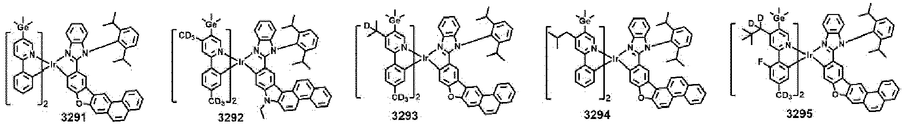

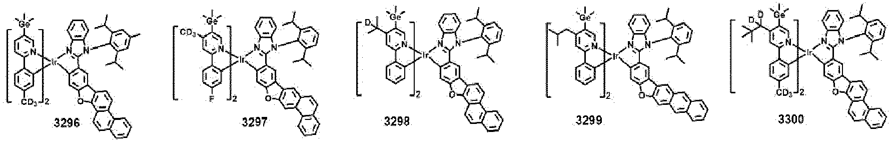

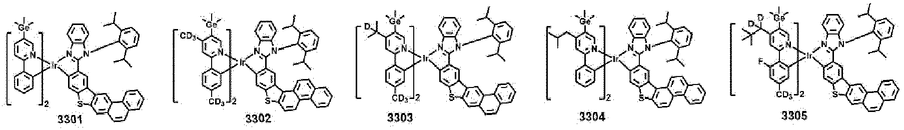

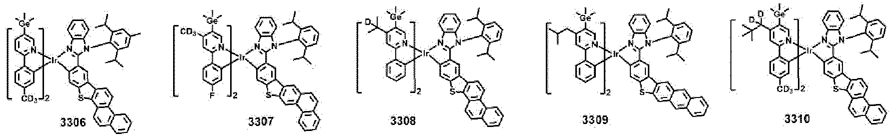

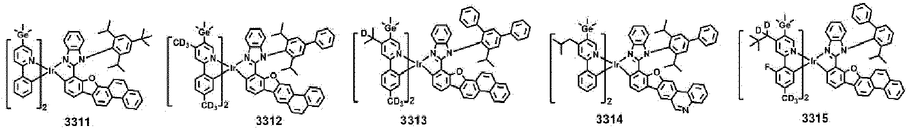

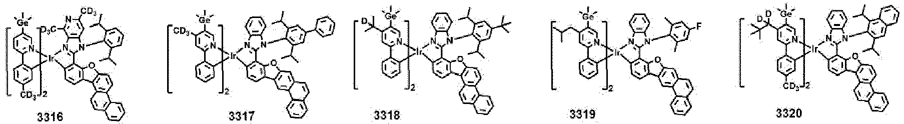

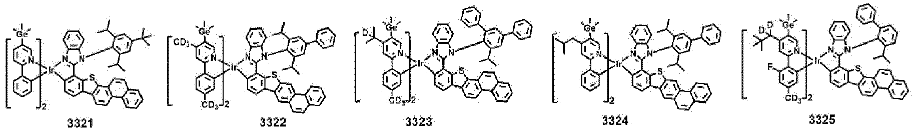

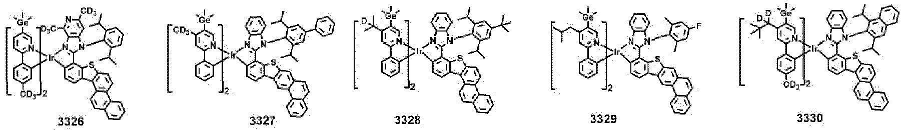

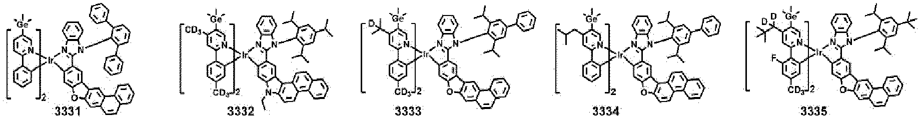

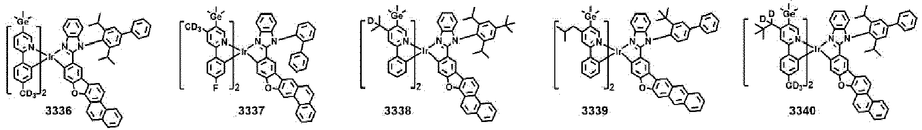

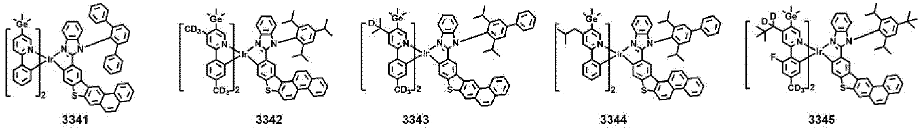

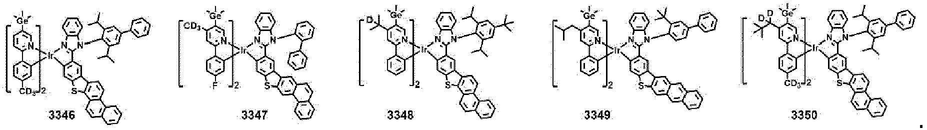

In the organometallic compound represented by Formula 1, L₁ and L₂ are ligands represented by Formulae 2 and 3, respectively, and n1 and n2 are the number of L₁ and L₂, respectively. n1 is 2 and n2 is 1 or n1 is 1 and n2 is 2. That is, the organometallic compound necessarily includes L₁(Formula 2) including a group represented by *-X₁₁(R₂₁)(R₂₂)(R₂₃) as a substituent and L₂(Formula 3). As a result, the molecular orientation and charge mobility of the organometallic compound represented by Formula 1 may be greatly improved, thereby improving the external quantum efficiency and lifespan of an electronic device, for example, an organic light-emitting device, including the organometallic compound represented by Formula 1.

The highest occupied molecular orbital (HOMO) energy level, lowest unoccupied molecular orbital (LUMO) energy level, S₁ energy level, and T₁ energy level of some of the organometallic compounds represented by Formula 1 are evaluated by using Gaussian 09 program which involves optimization of molecular structure by density functional theory (DFT) based on B3LYP. The evaluation results are shown in Table 1 below.

**Table 1**

| Compound No. | HOMO(eV) | LUMO(eV) | S₁(eV) | T₁(eV) |
|---|---|---|---|---|
| 16 | -4.750 | -1.239 | 2.812 | 2.538 |
| 91 | -4.703 | -1.154 | 2.855 | 2.534 |
| 1416 | -4.676 | -1.140 | 2.844 | 2.557 |
| 1491 | -4.683 | -1.140 | 2.846 | 2.539 |
| 1620 | -4.671 | -1.110 | 2.874 | 2.541 |
| 1800 | -4.830 | -1.319 | 2.814 | 2.496 |
| 2131 | -4.782 | -1.279 | 2.821 | 2.499 |
| 2252 | -4.724 | -1.244 | 2.800 | 2.552 |

From Table 1, it is confirmed that the organometallic compound represented by Formula 1 has such electric characteristics that are suitable for use as a dopant for an electronic device, for example, an organic light-emitting device.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes: a first electrode; a second electrode; and an organic layer including an emission layer and disposed between the first electrode and the second electrode, wherein the organic layer includes at least one of the organometallic compounds represented by Formula 1.

The organic light-emitting device has an organic layer containing the organometallic compound represented by Formula 1 as described above, thereby having improved external quantum efficiency and improved lifespan properties.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). The emission layer may emit red light or green light, for example, red light or green light, each having a maximum emission wavelength of about 500 nm or more, for example, from about 500 nm or more and about 850 nm or less. For example, the organometallic compound may emit green light.

The expression "(an organic layer) includes at least one of organometallic compounds" used herein may include a case in which "(an organic layer) includes identical organometallic compounds represented by Formula 1" and a case in which "(an organic layer) includes two or more different organometallic compounds represented by Formula 1."

For example, the organic layer may include, as the organometallic compound, only Compound 1. In this regard, Compound 1 may exist in an emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer further includes a hole transport region between the first electrode and the emission layer and an electron transport region between the emission layer and the second electrode, and the hole transport region includes a hole injection layer, a hole transport layer, an electron blocking layer, a buffer layer, or any combination thereof, and the electron transport region includes a hole blocking layer, an electron transport layer, an electron injection layer, or any combination thereof.

The term "organic layer" used herein refers to a single layer and/or a plurality of layers between the first electrode and the second electrode of the organic light-emitting device. The "organic layer" may include, in addition to an organic compound, an organometallic complex including metal.

FIGURE is a schematic view of an organic light-emitting device 10 in one or more embodiments. Hereinafter, the structure of an organic light-emitting device according to an embodiment and a method of manufacturing an organic light-emitting device according to an embodiment will be described in connection with FIGURE. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may include a material with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a threelayered structure of ITO/Ag/ITO.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 to about 500 °C, a vacuum pressure of about 1.33 × 10⁻⁶ Pa (about 10⁻⁸ torr) to about 0.133 Pa (about 10⁻³ torr), and a deposition rate of about 0.01 Å/sec to about 100 Å/sec.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or any combination thereof:

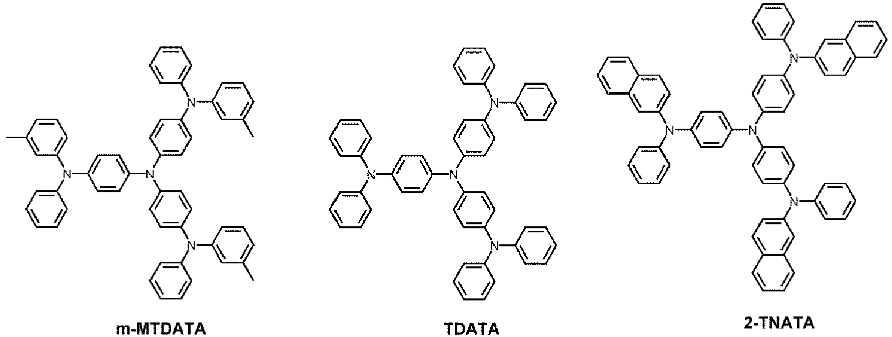

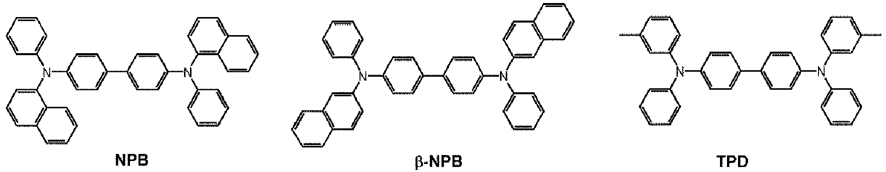

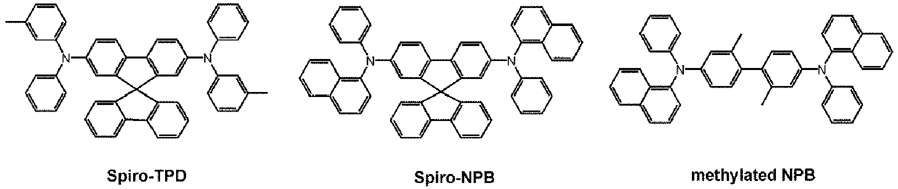

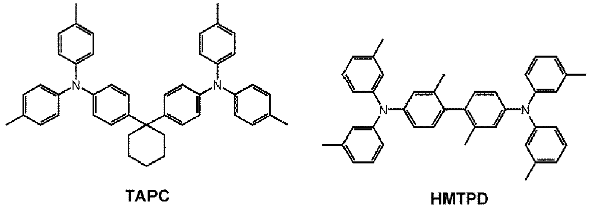

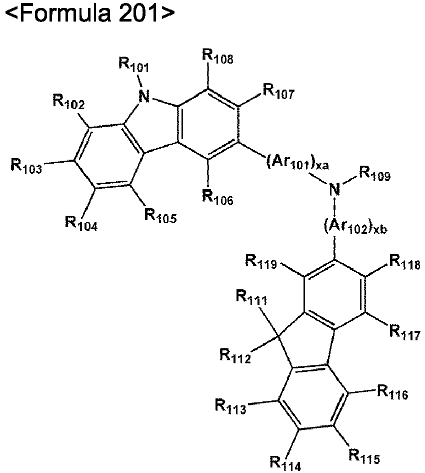

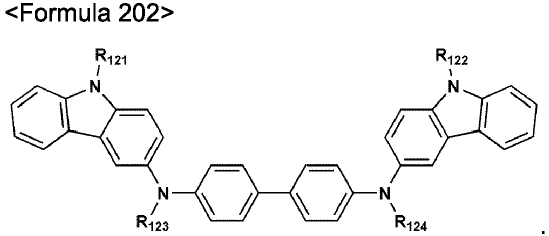

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

xa and xb in Formula 201 may each independently be an integer from 0 to 5, or 0, 1 or 2. For example, xa may be 1 and xb may be 0.

R₁₀₁ to R₁₀₈, R₁₁₁ to R₁₁₉ and R₁₂₁ to R₁₂₄ in Formulae 201 and 202 may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, or a hexyl group), or a C₁-C₁₀ alkoxy group (for example, a methoxy group, an ethoxy group, a propoxy group, a butoxy group, or a pentoxy group);
a C₁-C₁₀ alkyl group or a C₁-C₁₀ alkoxy group, each substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or
a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, or a C₁-C₁₀ alkoxy group.

R₁₀₉ in Formula 201 may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

According to an embodiment, the compound represented by Formula 201 may be represented by Formula 201A below:

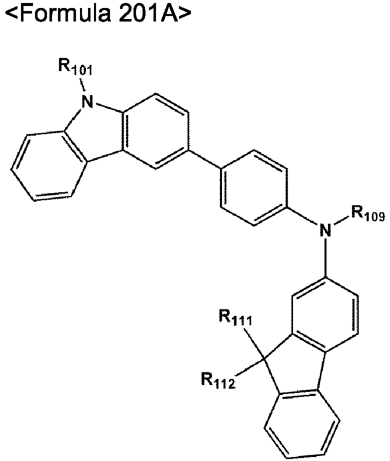

R₁₀₁, R₁₁₁, R₁₁₂, and R₁₀₉ in Formula 201A may be understood by referring to the description provided herein.

For example, the compound represented by Formula 201, and the compound represented by Formula 202 may include compounds HT1 to HT20 illustrated below:

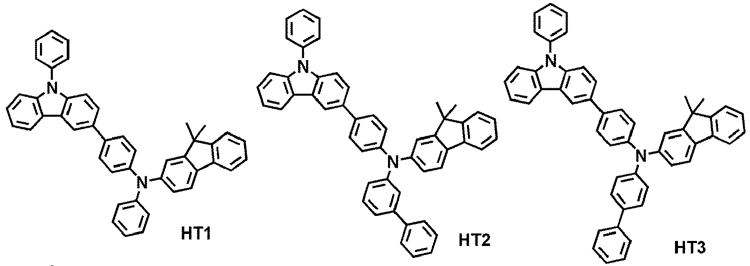

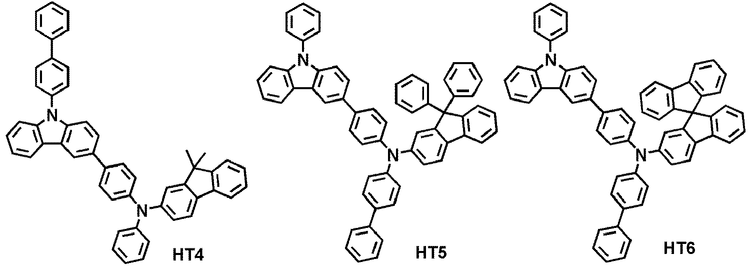

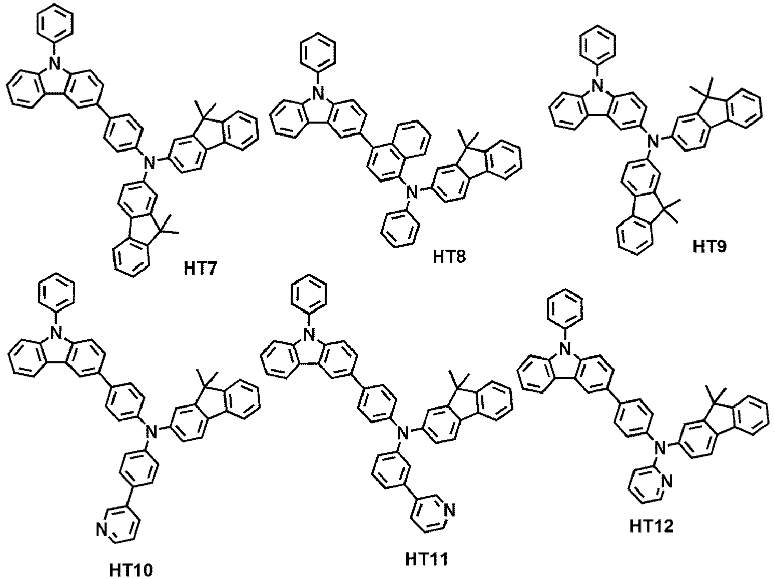

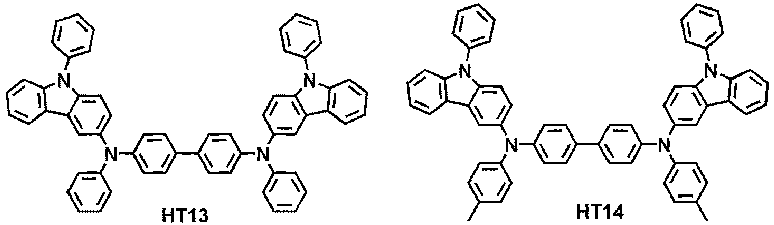

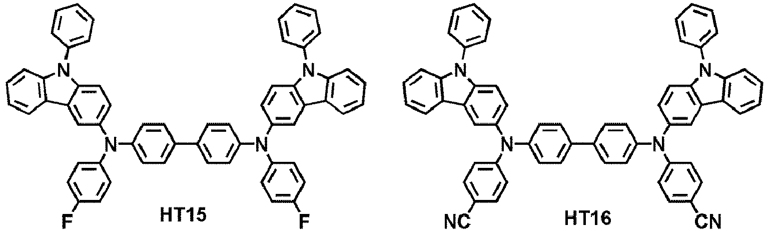

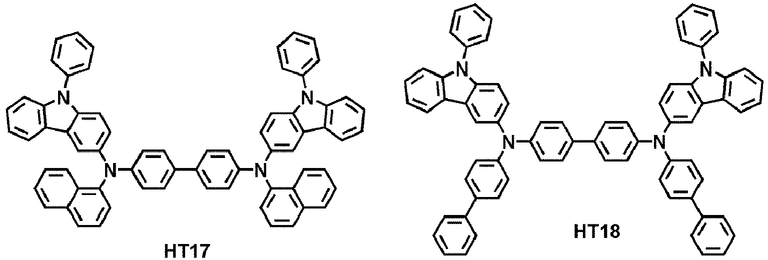

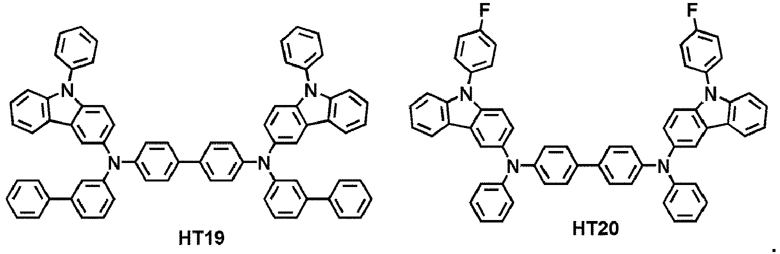

A thickness of the hole transport region may be in a range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one of a quinone derivative, a metal oxide, and a cyano group-containing compound. Non-limiting examples of the p-dopant are a quinone derivative, such as tetracyanoquinonedimethane (TCNQ), 2,3,5,6-tetrafluoro-tetracyano-1,4-benzoquinonedimethane (F4-TCNQ), or F6-TCNNQ; a metal oxide, such as a tungsten oxide or a molybdenum oxide; and a cyano group-containing compound, such as Compound HT-D1 below. 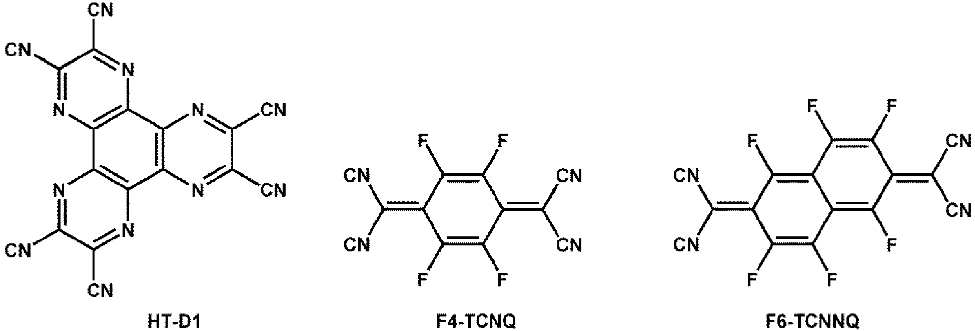 The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for the electron blocking layer may be a material for the hole transport region described above, a material for a host to be explained later, or any combination thereof. For example, when the hole transport region includes an electron blocking layer, a material for the electron blocking layer may be mCP, which will be explained later.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include a host and a dopant, and the dopant may include the organometallic compound represented by Formula 1.

The host may include TPBi, TBADN, ADN(also referred to as "DNA"), CBP, CDBP, TCP, mCP, Compound H50, Compound H51, Compound H52, or any combination thereof:

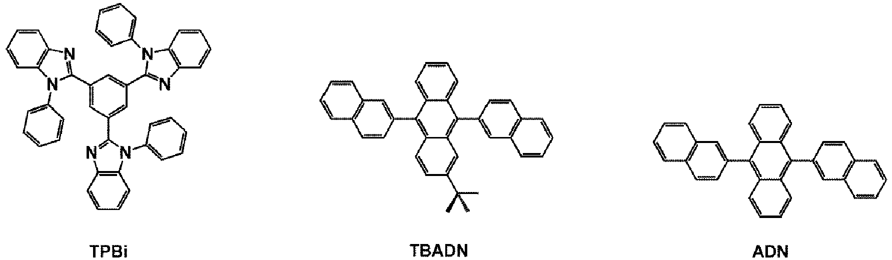

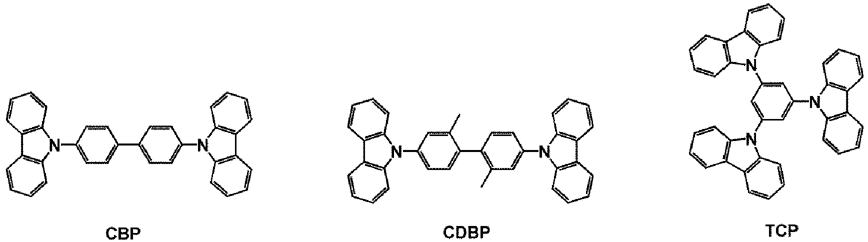

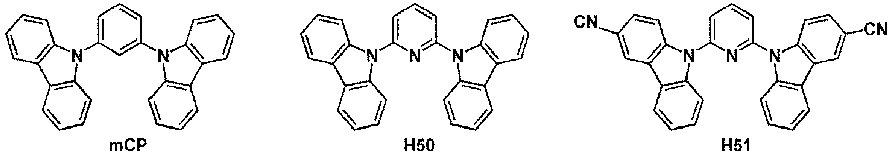

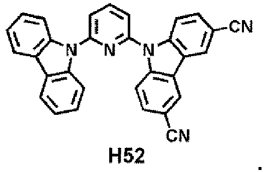

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be located on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, BCP, Bphen, BAIq, or any combination thereof.

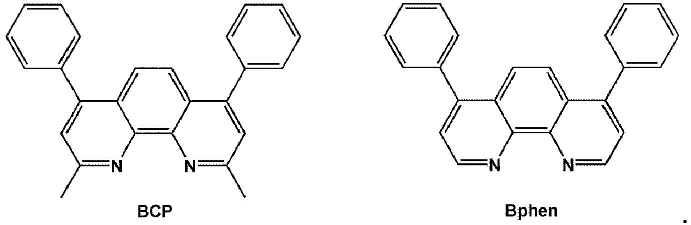

A thickness of the hole blocking layer may be in a range of about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer may include BCP, Bphen, Alq₃, BAIq, TAZ, NTAZ, or any combination thereof.

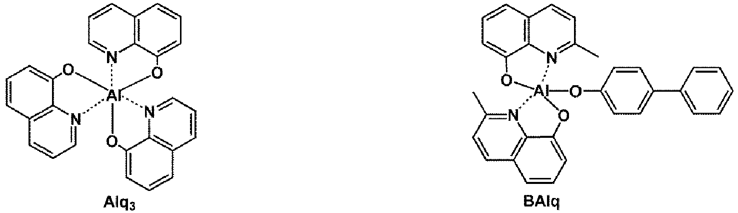

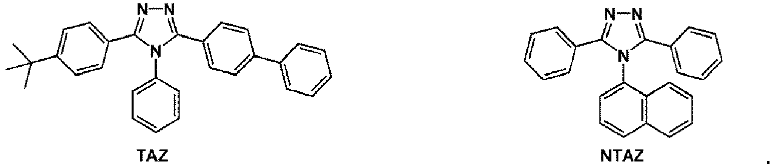

In one or more embodiments, the electron transport layer may include one or any combination of ET1 to ET25:

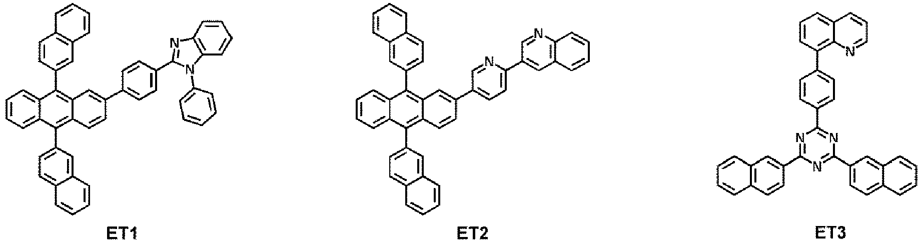

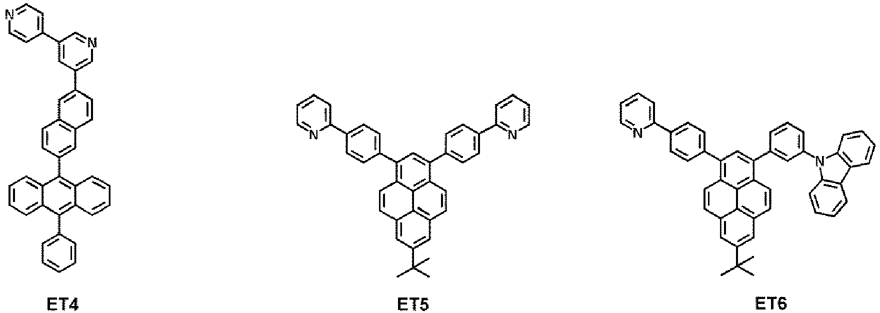

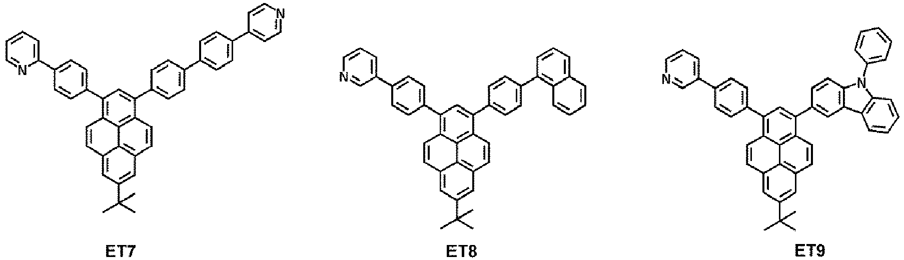

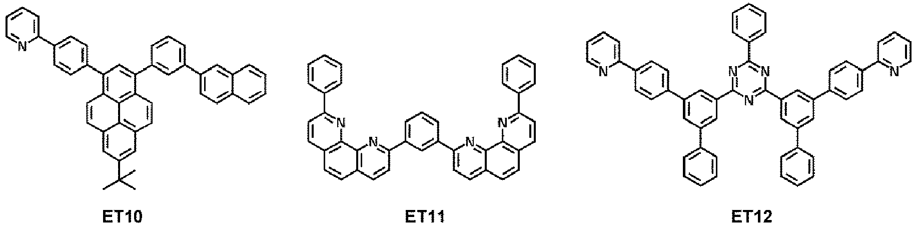

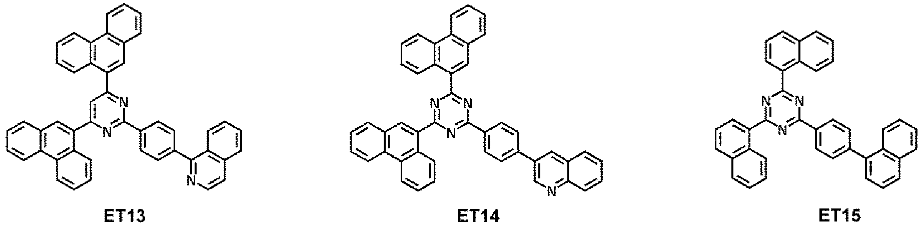

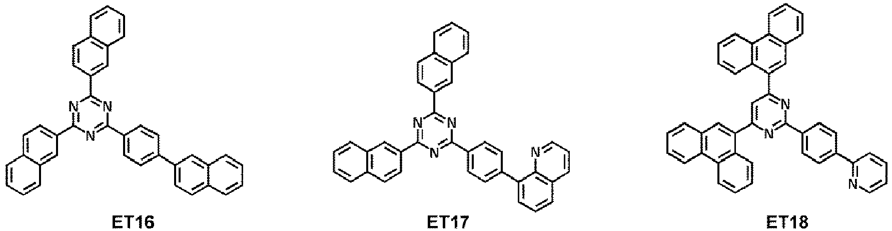

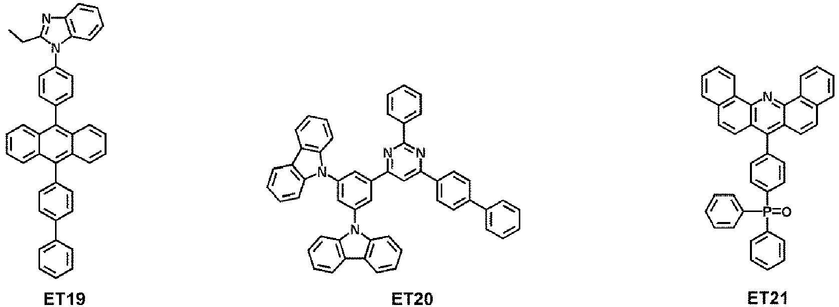

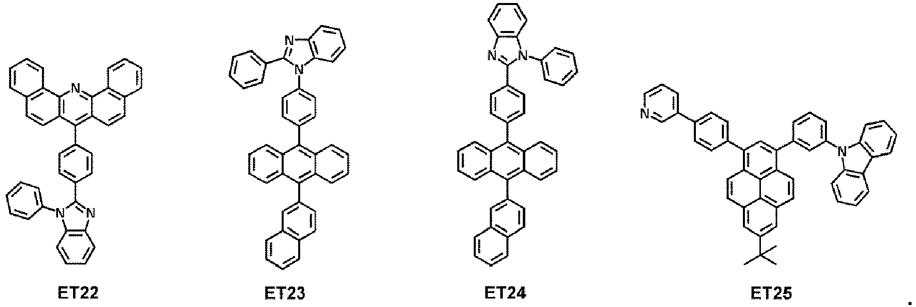

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (LiQ) or ET-D2.

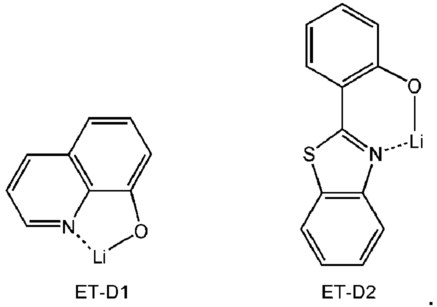

The electron transport region may include an electron injection layer (EIL) that promotes flow of electrons from the second electrode 19 thereinto.

The electron injection layer may include LiF, NaCl, CsF, Li₂O, BaO, or any combination thereof.

A thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

The second electrode 19 is located on the organic layer 15. The second electrode 19 may be a cathode. A material for forming the second electrode 19 may be metal, an alloy, an electrically conductive compound, or any combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a topemission type light-emitting device, a transmissive electrode formed using ITO or IZO may be used as the second electrode 19.

Hereinbefore, the organic light-emitting device has been described with reference to FIGURE.

According to an aspect of another embodiment, an electronic apparatus including the organic light-emitting device may be provided. The electronic apparatus may be used for various purposes such as a display, lighting, and a mobile phone.

Another aspect provides a diagnostic composition including at least one organometallic compound represented by Formula 1.

The organometallic compound represented by Formula 1 provides high luminescence efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbon monovalent group having 1 to 60 carbon atoms. The term "C₁-C₆₀ alkylene group" as used herein refers to a divalent group having the same structure as the C₁-C₆₀ alkyl group.

Examples of the C₁-C₆₀ alkyl group, the C₁-C₂₀ alkyl group, and/or the C₁-C₁₀ alkyl group as used herein may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or any combination thereof. In some embodiments, Formula 9-33 may be a branched C₆ alkyl group. Formula 9-33 may be a tert-butyl group substituted with two methyl groups.

The term "C₁-C₆₀ alkoxy group" as used herein refers to a monovalent group represented by -OA₁₀₁ (wherein A₁₀₁ is a C₁-C₆₀ alkyl group). Examples of the C₁-C₆₀ alkoxy group, the C₁-C₂₀ alkoxy group, or the C₁-C₁₀ alkoxy group as used herein may include a methoxy group, an ethoxy group, a propoxy group, a butoxy group, or a pentoxy group.

The term "C₂-C₆₀ alkenyl group" as used herein refers to a group formed by placing at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a group formed by placing at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent cyclic saturated hydrocarbon group including 3 to 10 carbon atoms. The term "C₃-C₁₀ cycloalkylene group" as used herein refers to a divalent group having the same structure as the C₃-C₁₀ cycloalkyl group.

Examples of the C₃-C₁₀ cycloalkyl group as used herein may include a cyclopropyl group, a cyclobutyl group, a cyclopentyl group, a cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, or a bicyclo[2.2.2]octyl group.

The term "C₁-C₁₀ heterocycloalkyl group" as used herein refers to a monovalent monocyclic group including at least one heteroatom selected from N, O, P, Si, Se, Ge, B and S as a ring-forming atom and 1 to 10 carbon atoms. The term "C₁-C₁₀ heterocycloalkylene group" as used herein refers to a divalent group having the same structure as the C₁-C₁₀ heterocycloalkyl group.

Examples of the C₁-C₁₀ heterocycloalkyl group as used herein may include a silolanyl group, a silinanyl group, a tetrahydrofuranyl group, a tetrahydro-2H-pyranyl group, or a tetrahydrothiophenyl group.

The term "C₃-C₁₀ cycloalkenyl group" as used herein refers to a monovalent monocyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group including at least one heteroatom selected from N, O, P, Si, Se, Ge, B and S as a ring-forming atom, 1 to 10 carbon atoms, and at least one double bond in its ring, wherein the molecular structure as a whole is non-aromatic. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include a plurality of rings, the plurality of rings may be fused to each other.

The term "C₇-C₆₀ alkyl aryl group" as used herein refers to a C₆-C₆₀ aryl group substituted with at least one C₁-C₆₀ alkyl group.

The term "C₁-C₆₀ heteroaryl group" as used herein refers to a monovalent group having a heterocyclic aromatic system having at least one heteroatom selected from N, O, P, Si, Se, Ge, B and S as a ring-forming atom and 1 to 60 carbon atoms. The term "C₁-C₆₀ heteroarylene group" as used herein refers to a divalent group having a heterocyclic aromatic system having at least one heteroatom selected from N, O, P, Si, Se, Ge, B and S as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include a plurality of rings, the plurality of rings may be fused to each other.

The term "C₂-C₆₀ alkyl heteroaryl group" as used herein refers to a C₁-C₆₀ heteroaryl group substituted with at least one C₁-C₆₀ alkyl group.

The term "C₆-C₆₀ aryloxy group" as used herein is represented by -OA₁₀₂ (wherein A₁₀₂ is the C₆-C₆₀ aryl group). The term "C₆-C₆₀ arylthio group" as used herein is represented by -SA₁₀₃ (wherein A₁₀₃ is the C₆-C₆₀ aryl group). The term "C₁-C₆₀ alkylthio group" as used herein is represented by -SA₁₀₄ (wherein A₁₀₄ is the C₁-C₆₀ alkyl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a heteroatom selected from N, O, P, Si, Se, Ge, B and S and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. Examples of the "C₅-C₃₀ carbocyclic group (unsubstituted or substituted with at least one R₁₀ₐ)" may include an adamantane group, a norbornene group, a norbornane group (a bicyclo[2.2.1]heptane group), a bicyclo[1.1.1]pentane group, a bicyclo[2.1.1]hexane group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group, each (unsubstituted or substituted with at least one R₁₀ₐ).

The term "C₁-C₃₀ heterocyclic group" as used herein refers to saturated or unsaturated cyclic group including 1 to 30 carbon atoms and at least one heteroatom selected from N, O, P, Si, Se, Ge, B and S as ring-forming atoms. The C₁-C₃₀ heterocyclic group may be a monocyclic group or a polycyclic group. Examples of the "C₁-C₃₀ heterocyclic group (unsubstituted or substituted with at least one R₁₀ₐ)" may include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, (each unsubstituted or substituted with at least one R₁₀ₐ).

Examples of the terms "C₅-C₃₀ carbocyclic group" and "C₁-C₃₀ heterocyclic group" as used herein may include i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,
the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

The "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group", and "fluorinated phenyl group" as used herein may respectively be a C₁-C₆₀ alkyl group (or C₁-C₂₀ alkyl group or the like), C₃-C₁₀ cycloalkyl group, a C₁-C₁₀ heterocycloalkyl group, and a phenyl group, each substituted with at least one fluoro group (-F). Examples of the "fluorinated C₁ alkyl group (i.e., a fluorinated methyl group)" may include -CF₃, -CF₂H, and - CFH₂. The "fluorinated C₁-C₆₀ alkyl group (or fluorinated C₁-C₂₀ alkyl group or the like)", "fluorinated C₃-C₁₀ cycloalkyl group", or "fluorinated C₁-C₁₀ heterocycloalkyl group" may respectively be: i) a fully fluorinated C₁-C₆₀ alkyl group (or fully fluorinated C₁-C₂₀ alkyl group or the like), fully fluorinated C₃-C₁₀ cycloalkyl group, or fully fluorinated C₁-C₁₀ heterocycloalkyl group, in which all hydrogen atoms are substituted with fluoro groups; or ii) a partially fluorinated C₁-C₆₀ alkyl group (or partially fluorinated C₁-C₂₀ alkyl group or the like), partially fluorinated C₃-C₁₀ cycloalkyl group, or partially fluorinated C₁-C₁₀ heterocycloalkyl group, in which some of hydrogen atoms are substituted with fluoro groups.

The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", and "deuterated phenyl group" as used herein may respectively be a C₁-C₆₀ alkyl group (or C₁-C₂₀ alkyl group or the like), C₃-C₁₀ cycloalkyl group, a C₁-C₁₀ heterocycloalkyl group, and a phenyl group, each substituted with at least one deuterium. Examples of the "deuterated C₁ alkyl group (i.e., a deuterated methyl group)" may include -CD₃, -CD₂H, and -CDH₂ and examples of the "deuterated C₃-C₁₀ cycloalkyl group" may refer to Formula 10-501 described in this disclosure. The " deuterated C₁-C₆₀ alkyl group (or deuterated C₁-C₂₀ alkyl group or the like)", " deuterated C₃-C₁₀ cycloalkyl group", or " deuterated C₁-C₁₀ heterocycloalkyl group" may respectively be: i) a fully deuterated C₁-C₆₀ alkyl group (or fully deuterated C₁-C₂₀ alkyl group or the like), fully deuterated C₃-C₁₀ cycloalkyl group, or fully deuterated C₁-C₁₀ heterocycloalkyl group, in which all hydrogen atoms are substituted with deuterium atoms; or ii) a partially deuterated C₁-C₆₀ alkyl group (or partially deuterated C₁-C₂₀ alkyl group or the like), partially deuterated C₃-C₁₀ cycloalkyl group, or partially deuterated C₁-C₁₀ heterocycloalkyl group, in which some of hydrogen atoms are substituted with deuterium(s). The "(C₁-C₂₀ alkyl)'X' group" refers to a 'X' group substituted with at least one C₁-C₂₀ alkyl group. For example, The "(C₁-C₂₀ alkyl)C₃-C₁₀ cycloalkyl group" as used herein refers to a C₃-C₁₀ cycloalkyl group substituted with at least one C₁-C₂₀ alkyl group, and the "(C₁-C₂₀ alkyl)phenyl group" as used herein refers to a phenyl group substituted with at least one C₁-C₂₀ alkyl group. Examples of the (C₁ alkyl)phenyl group may include a toluyl group.

In the present specification, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a hetero ring in which at least one ring-forming carbon atom is substituted with nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

A substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be :
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, - CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, - Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
any combination thereof.

In the present specification, Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group, unsubstituted or substituted with deuterium, -F, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group, unsubstituted or substituted with deuterium, -F, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉, and Q₃₁ to Q₃₉ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, 3-pentyl group, a sec-isopentyl group, a phenyl group, a biphenyl group, or a naphthyl group, each unsubstituted or substituted with deuterium, a C₁-C₂₀ alkyl group, a phenyl group, or any combination thereof.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### Examples

### Synthesis Example 1 (Compound 17)

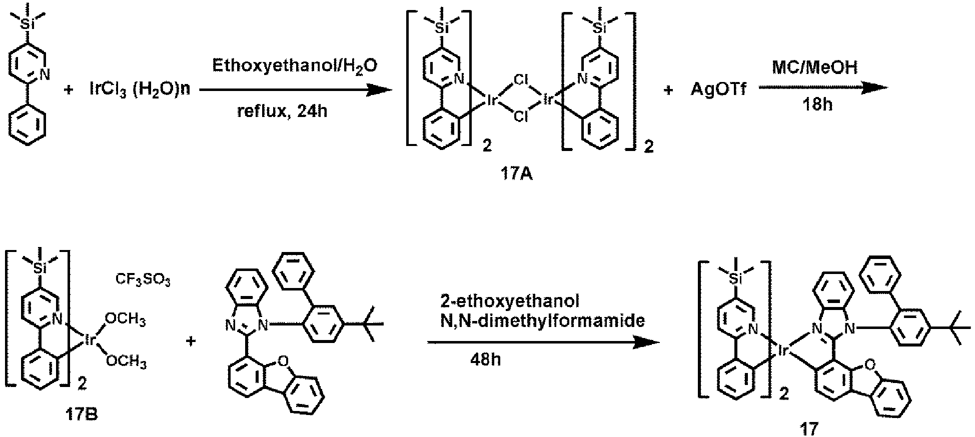

### Synthesis of compound 17A

2-phenyl-5-(trimethylsilyl)pyridine (7.5 g, 33.1 mmol) and iridium chloride (5.2 g, 14.7 mmol) were mixed with 120 mL of ethoxyethanol and 40 mL of distilled water, and then, the mixture was stirred under reflux for 24 hours, and then, the temperature was decreased to room temperature. The resulting solid was separated by filtration, and the solid was washed with water/methanol/hexane and dried in a vacuum oven to obtain 8.2 g (yield of 82%) of Compound 17A.

### Synthesis of Compound 17B

Compound 17A (1.6 g, 1.2 mmol) was mixed with 45 mL of methylene chloride, and then, AgOTf (silver triflate, 0.6 g, 2.3 mmol) was added thereto after being mixed with 15 mL of methanol. Thereafter, the mixture was stirred for 18 hours at room temperature while blocking light with aluminum foil, and then the resulting solid was removed by Celite filtration and the filtrate was concentrated under reduced pressure. The obtained resultant (Compound 17B) was used for the next reaction without further purification.

### Synthesis of Compound 17

Compound 17B (2.0 g, 2.3 mmol) and 1-(5-(tert-butyl)-[1,1'-biphenyl]-2-yl)-2-(dibenzo[b,d]furan-4-yl)-1H-benzo[d]imidazole (1.4 g, 2.8 mmol) were mixed with 50 mL of 2-ethoxyethanol and 50 mL of N,N-dimethylformamide, and then, the mixture was stirred under reflux for 48 hours and then, the temperature thereof was lowered to room temperature. The resulting mixture was subjected to reduced pressure to obtain a solid, which was then subjected to column chromatography (eluent: MC (methylene chloride) and hexane) to obtain 1.1 g (yield of 42%) of Compound 17. The obtained material was confirmed by Mass Spectrometry and HPLC analysis.

### HRMS(MALDI) calcd for C₆₃H₅₉IrN₄OSi₂: m/z 1136.3857 Found: 1136.3861 Synthesis Example 2 (Compound 91)

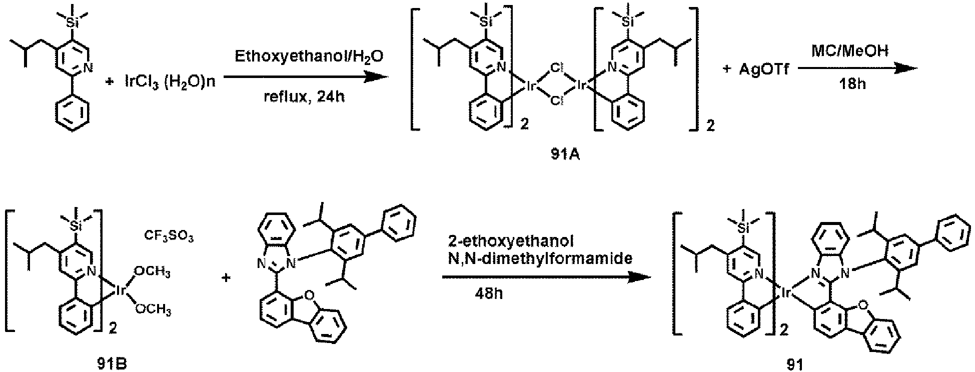

### Synthesis of Compound 91A

7.4 g (yield of 74%) of Compound 91A was obtained in the same manner as used to synthesize Compound 17A of Synthesis Example 1, except that 4-isobutyl-2-phenyl-5-(trimethylsilyl)pyridine was used instead of 2-phenyl-5-(trimethylsilyl)pyridine.

### Synthesis of Compound 91B

Compound 91B was obtained in the same manner as used to synthesize Compound 17B of Synthesis Example 1, except that Compound 91A was used instead of Compound 17A. The obtained Compound 91B was used in the next reaction without further purification. Synthesis of Compound 91

0.8 g (yield of 35%) of Compound 91 was obtained in the same manner as used to synthesize Compound 17 of Synthesis Example 1, except that Compound 91B was used instead of Compound 17B, and 2-(dibenzo[b,d]furan-4-yl)-1-(3,5-diisopropyl-[1,1'-biphenyl]-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₇₃H₇₉IrN₄OSi₂: m/z 1276.5422 Found: 1276.5416 Synthesis Example 3 (Compound 102)

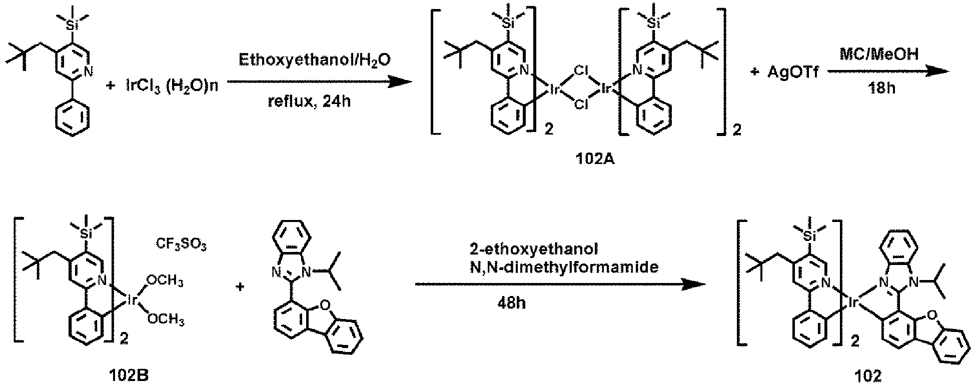

### Synthesis of Compound 102A

7.1 g (yield of 71%) of Compound 102A was obtained in the same manner as used to synthesize Compound 17A of Synthesis Example 1, except that 4-neopentyl-2-phenyl-5-(trimethylsilyl)pyridine was used instead of 2-phenyl-5-(trimethylsilyl)pyridine.

### Synthesis of Compound 102B

Compound 102B was obtained in the same manner as used to synthesize Compound 17B of Synthesis Example 1, except that Compound 102A was used instead of Compound 17A. The obtained Compound 102B was used in the next reaction without further purification.

### Synthesis of Compound 102

0.6 g (yield of 26%) of Compound 102 was obtained in the same manner as used to synthesize Compound 17 of Synthesis Example 1, except that Compound 102B was used instead of Compound 17B, and 2-(dibenzo[b,d]furan-4-yl)-1-isopropyl-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₆₆H₆₉IrN₄OSi₂: m/z 1110.4639 Found: 1110.4635 Synthesis Example 4 (Compound 472)

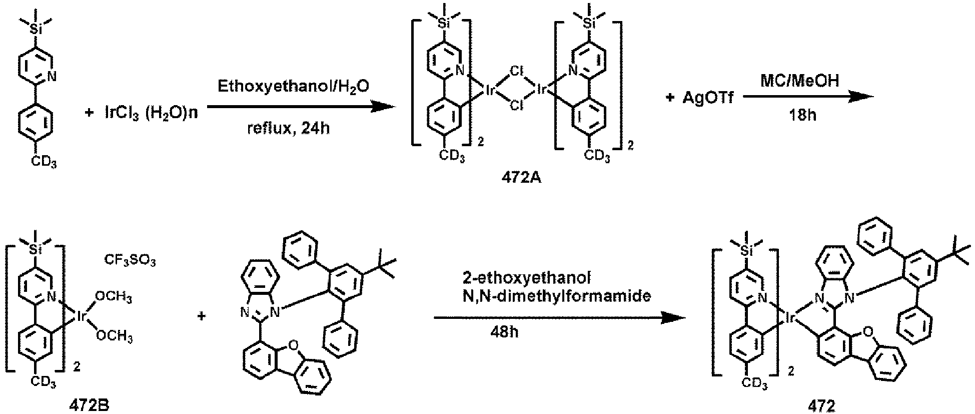

### Synthesis of Compound 472A

5.3 g (yield of 79%) of Compound 472A was obtained in the same manner as used to synthesize Compound 17A of Synthesis Example 1, except that 2-(p-tolyl-D₃)-5-(trimethylsilyl)pyridine was used instead of 2-phenyl-5-(trimethylsilyl)pyridine.

### Synthesis of Compound 472B

Compound 472B was obtained in the same manner as used to synthesize Compound 17B of Synthesis Example 1, except that Compound 472A was used instead of Compound 17A. The obtained Compound 472B was used in the next reaction without further purification.

### Synthesis of Compound 472

0.4 g (yield of 33%) of Compound 472 was obtained in the same manner as used to synthesize Compound 17 of Synthesis Example 1, except that Compound 472B was used instead of Compound 17B, and 1-(5'-(tert-butyl)-[1,1':3',1"-terphenyl]-2'-yl)-2-(dibenzo[b,d]furan-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₇₁H₆₁D₆IrN₄OSi₂: m/z 1246.4859 Found: 1246.4856 Synthesis Example 5 (Compound 532)

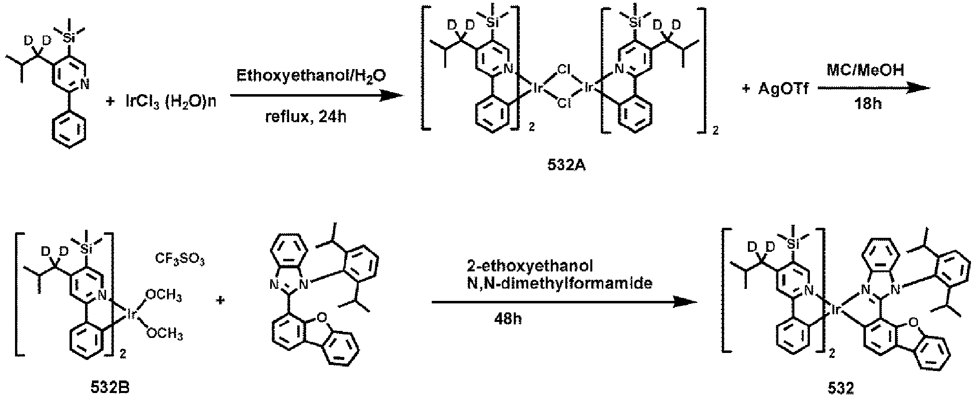

### Synthesis of Compound 532A

2.5 g (yield of 68%) of Compound 532A was obtained in the same manner as used to synthesize Compound 17A of Synthesis Example 1, except that 4-isobutyl(D₂)-2-phenyl-5-(trimethylsilyl)pyridine was used instead of 2-phenyl-5-(trimethylsilyl)pyridine.

### Synthesis of Compound 532B

Compound 532B was obtained in the same manner as used to synthesize Compound 17B of Synthesis Example 1, except that Compound 532A was used instead of Compound 17A. The obtained Compound 532B was used in the next reaction without further purification.

### Synthesis of Compound 532

0.31 g (yield of 39%) of Compound 532 was obtained in the same manner as used to synthesize Compound 17 of Synthesis Example 1, except that Compound 532B was used instead of Compound 17B, and 2-(dibenzo[b,d]furan-4-yl)-1-(2,6-diisopropylphenyl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₆₇H₇₁D₄IrN₄OSi₂: m/z 1204.5360 Found: 1204.5364 Synthesis Example 6 (Compound 666)

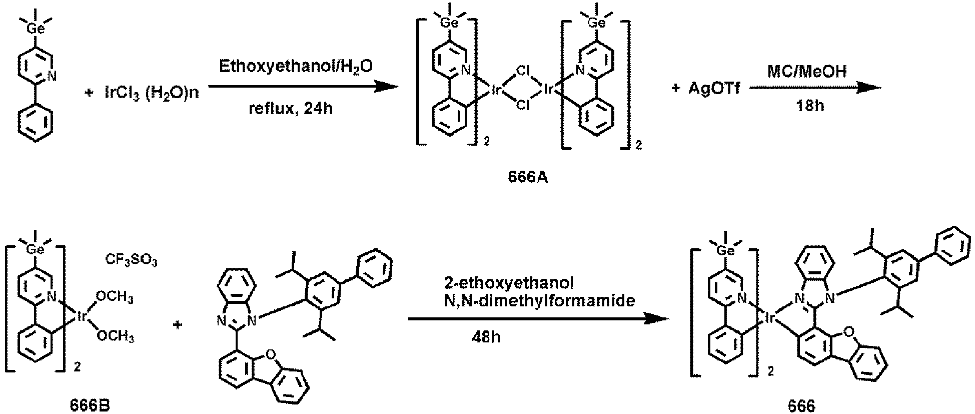

### Synthesis of Compound 666A

2.1 g (yield of 61%) of Compound 666A was obtained in the same manner as used to synthesize Compound 17A of Synthesis Example 1, except that 2-phenyl-5-(trimethylgermyl)pyridine was used instead of 2-phenyl-5-(trimethylsilyl)pyridine.

### Synthesis of Compound 666B

Compound 666B was obtained in the same manner as used to synthesize Compound 17B of Synthesis Example 1, except that Compound 666A was used instead of Compound 17A. The obtained Compound 666B was used in the next reaction without further purification.

### Synthesis of Compound 666

0.33 g (yield of 42%) of Compound 666 was obtained in the same manner as used to synthesize Compound 17 of Synthesis Example 1, except that Compound 666B was used instead of Compound 17B, and 2-(dibenzo[b,d]furan-4-yl)-1-(3,5-diisopropyl-[1,1'-biphenyl]-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₆₅H₆₃Ge₂IrN₄O: m/z 1256.3055 Found: 1256.3049 Synthesis Example 7 (Compound 812)

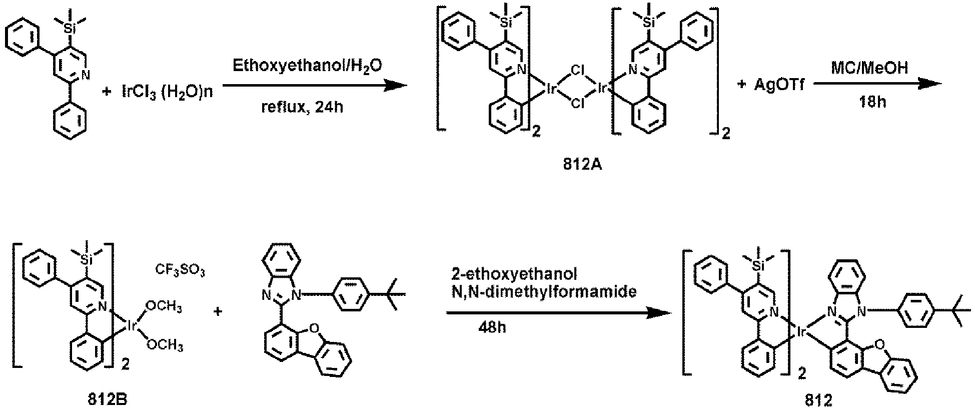

### Synthesis of Compound 812A

3.4 g (yield of 74%) of Compound 812A was obtained in the same manner as used to synthesize Compound 17A of Synthesis Example 1, except that 2,4-diphenyl-5-(trimethylsilyl)pyridine was used instead of 2-phenyl-5-(trimethylsilyl)pyridine.

### Synthesis of Compound 812B

Compound 812B was obtained in the same manner as used to synthesize Compound 17B of Synthesis Example 1, except that Compound 812A was used instead of Compound 17A. The obtained Compound 812B was used in the next reaction without further purification.

### Synthesis of Compound 812

0.50 g (yield of 45%) of Compound 812 was obtained in the same manner as used to synthesize Compound 17 of Synthesis Example 1, except that Compound 812B was used instead of Compound 17B, and 1-(4-(tert-butyl)phenyl)-2-(dibenzo[b,d]furan-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₆₉H₆₃IrN₄OSi₂: m/z 1256.3055 Found: 1256.3049 Synthesis Example 8 (Compound 980)

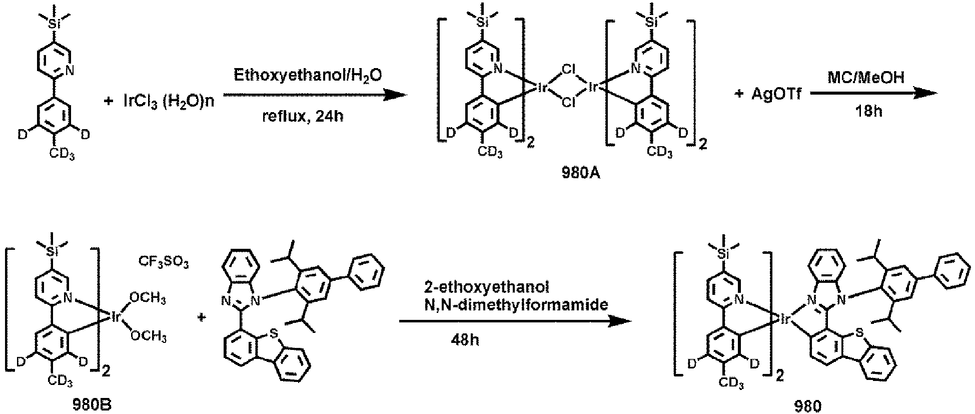

### Synthesis of Compound 980A

2.4 g (yield of 64%) of Compound 980A was obtained in the same manner as used to synthesize Compound 17A of Synthesis Example 1, except that 2-(p-tolyl-Ds)-5-(trimethylsilyl)pyridine was used instead of 2-phenyl-5-(trimethylsilyl)pyridine.

### Synthesis of Compound 980B

Compound 980B was obtained in the same manner as used to synthesize Compound 17B of Synthesis Example 1, except that Compound 980A was used instead of Compound 17A. The obtained Compound 980B was used in the next reaction without further purification.

### Synthesis of Compound 980

0.23 g (yield of 37%) of Compound 980 was obtained in the same manner as used to synthesize Compound 17 of Synthesis Example 1, except that Compound 980B was used instead of Compound 17B, and 2-(dibenzo[b,d]thiophen-4-yl)-1-(3,5-diisopropyl-[1,1'-biphenyl]-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₆₇H₅₇D₁₀IrN₄SSi₂: m/z 1218.4882 Found: 1218.4888 Synthesis Example 9 (Compound 1020)

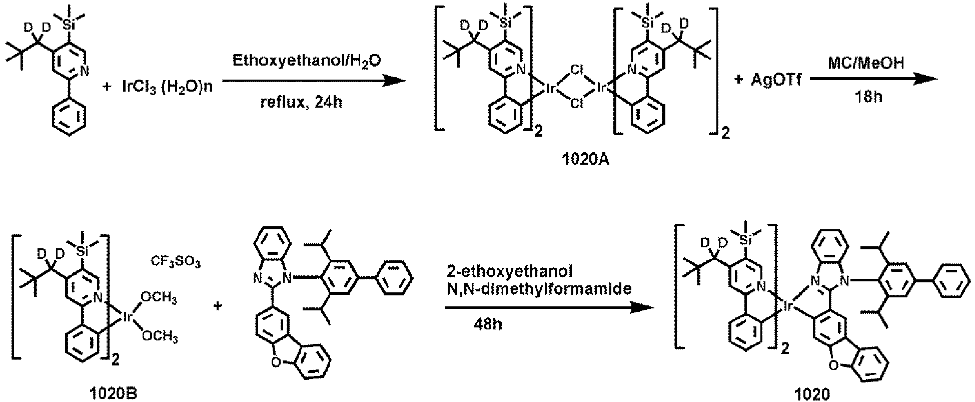

### Synthesis of Compound 1020A

4.2 g (yield of 81%) of Compound 1020A was obtained in the same manner as used to synthesize Compound 17A of Synthesis Example 1, except that 4-neopentyl(D₂)-2-phenyl-5-(trimethylsilyl)pyridine was used instead of 2-phenyl-5-(trimethylsilyl)pyridine.

### Synthesis of Compound 1020B

Compound 1020B was obtained in the same manner as used to synthesize Compound 17B of Synthesis Example 1, except that Compound 1020A was used instead of Compound 17A. The obtained Compound 1020B was used in the next reaction without further purification.

### Synthesis of Compound 1020

0.48 g (yield of 35%) of Compound 1020 was obtained in the same manner as used to synthesize Compound 17 of Synthesis Example 1, except that Compound 1020B was used instead of Compound 17B, and 2-(dibenzo[b,d]furan-2-yl)-1-(3,5-diisopropyl-[1,1'-biphenyl]-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₇₅H₇₉IrN₄D₄OSi₂: m/z 1308.5986 Found: 1308.5981 Synthesis Example 10 (Compound 1390)

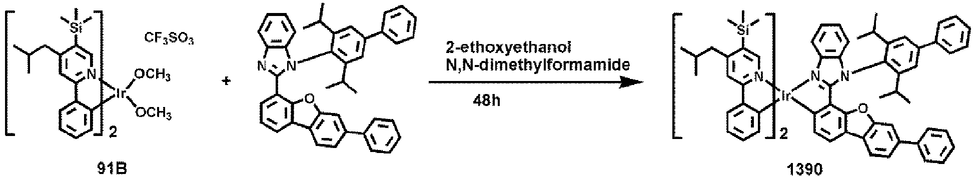

0.56 g (yield of 39%) of Compound 1390 was obtained in the same manner as used to synthesize Compound 17 of Synthesis Example 1, except that Compound 91B was used instead of Compound 17B, and 1-(3,5-diisopropyl-[1,1'-biphenyl]-4-yl)-2-(7-phenyldibenzo[b,d]furan-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.
HRMS(MALDI) calcd for C₇₉H₈₃IrN₄OSi₂: m/z 1352.5735 Found: 1352.5733

### Synthesis Example 11 (Compound 1666)

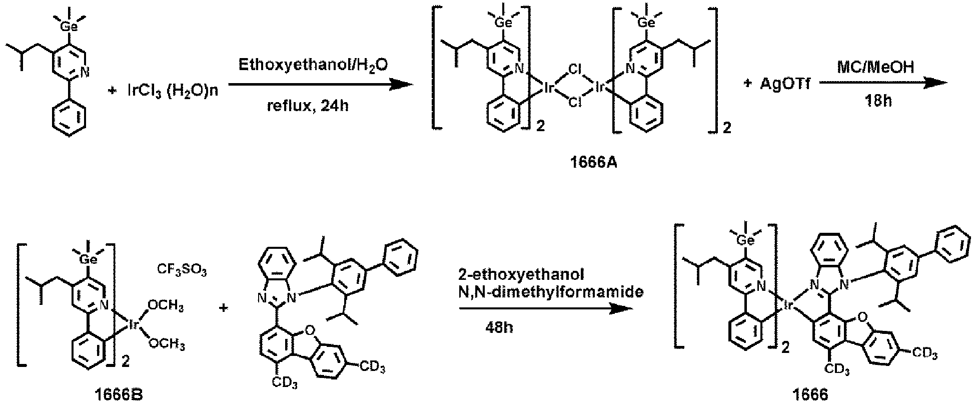

### Synthesis of Compound 1666A

3.3 g (yield of 65%) of Compound 1666A was obtained in the same manner as used to synthesize Compound 17A of Synthesis Example 1, except that 4-isobutyl-2-phenyl-5-(trimethylgermyl)pyridine was used instead of 2-phenyl-5-(trimethylsilyl)pyridine.

### Synthesis of Compound 1666B

Compound 1666B was obtained in the same manner as used to synthesize Compound 17B of Synthesis Example 1, except that Compound 1666A was used instead of Compound 17A. The obtained Compound 1666B was used in the next reaction without further purification.

### Synthesis of Compound 1666

0.42 g (yield of 27%) of Compound 1666 was obtained in the same manner as used to synthesize Compound 17 of Synthesis Example 1, except that Compound 1666B was used instead of Compound 17B, and 1-(3,5-diisopropyl-[1,1'-biphenyl]-4-yl)-2-(1,7-di(methyl-d3)dibenzo[b,d]furan-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.
HRMS(MALDI) calcd for C₇₅H₇₇D₆Ge₂IrN₄O: m/z 1402.4996 Found: 1402.4991

### Synthesis Example 12 (Compound 1857)

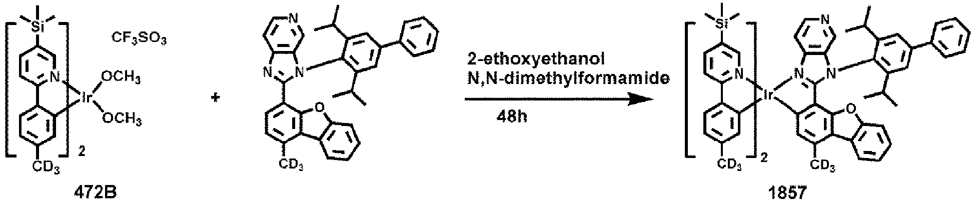

0.22 g (yield of 25%) of Compound 1857 was obtained in the same manner as used to synthesize Compound 17 of Synthesis Example 1, except that Compound 4277B was used instead of Compound 17B, and 3-(3,5-diisopropyl-[1,1'-biphenyl]-4-yl)-2-(1-(methyl-d3)dibenzo[b,d]furan-4-yl)-3H-imidazo[4,5-c]pyridine was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₆₇H₅₉D₉IrN₅OSi₂: m/z 1216.5157 Found: 1216.5159 Synthesis Example 13 (Compound 2010)

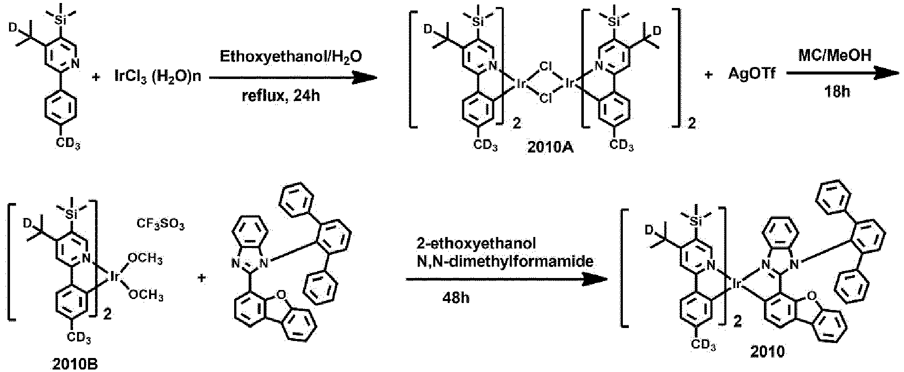

### Synthesis of Compound 2010A

3.1 g (yield of 74%) of Compound 2010A was obtained in the same manner as used to synthesize Compound 17A of Synthesis Example 1, except that 2-(4-(methyl-d3)phenyl)-4-(propan-2-yl-2-d)-5-(trimethylsilyl)pyridine was used instead of 2-phenyl-5-(trimethylsilyl)pyridine.

### Synthesis of Compound 2010B

Compound 2010B was obtained in the same manner as used to synthesize Compound 17B of Synthesis Example 1, except that Compound 2010A was used instead of Compound 17A. The obtained Compound 2010B was used in the next reaction without further purification.

### Synthesis of Compound 2010

0.45 g (yield of 42%) of Compound 2010 was obtained in the same manner as used to synthesize Compound 17 of Synthesis Example 1, except that Compound 2010B was used instead of Compound 17B, and 1-([1,1':3',1"-terphenyl]-2'-yl)-2-(dibenzo[b,d]furan-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₇₃H₆₃D₈IrN₄OSi₂: m/z 1276.5298 Found: 1276.5291 Synthesis Example 14 (Compound 2122)

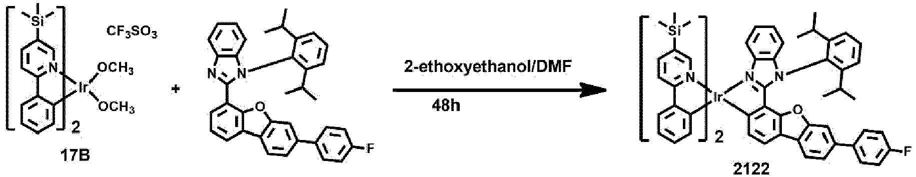

0.28 g (yield of 31%) of Compound 2122 was obtained in the same manner as used to synthesize Compound 17 of Synthesis Example 1, except that 1-(2,6-diisopropylphenyl)-2-(7-(4-fluorophenyl)dibenzo[b,d]furan-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.
HRMS(MALDI) calcd for C₆₅H₆₂FIrN₄OSi₂: m/z 1182.4075 Found: 1182.4082

### Synthesis Example 15 (Compound 2206)

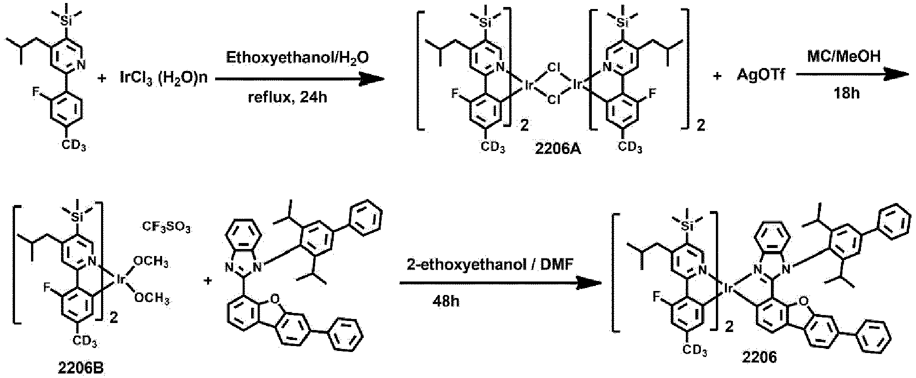

### Synthesis of Compound 2206A

2.8 g (yield of 64%) of Compound 2206A was obtained in the same manner as used to synthesize Compound 17A of Synthesis Example 1, except that 2-(2-fluoro-4-(methyl-d3)phenyl)-4-isobutyl-5-(trimethylsilyl)pyridine was used instead of 2-phenyl-5-(trimethylsilyl)pyridine.

### Synthesis of Compound 2206B

Compound 2206B was obtained in the same manner as used to synthesize Compound 17B of Synthesis Example 1, except that Compound 2206A was used instead of Compound 17A. The obtained Compound 2206B was used in the next reaction without further purification.

### Synthesis of Compound 2206

0.49 g (yield of 37%) of Compound 2206 was obtained in the same manner as used to synthesize Compound 17 of Synthesis Example 1, except that Compound 2206B was used instead of Compound 17B, and 1-(3,5-diisopropyl-[1,1'-biphenyl]-4-yl)-2-(7-phenyldibenzo[b,d]furan-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₈₁H₇₉D₆F₂IrN₄OSi₂: m/z 1422.6236 Found: 1422.6240 Synthesis Example 16 (Compound 2292)

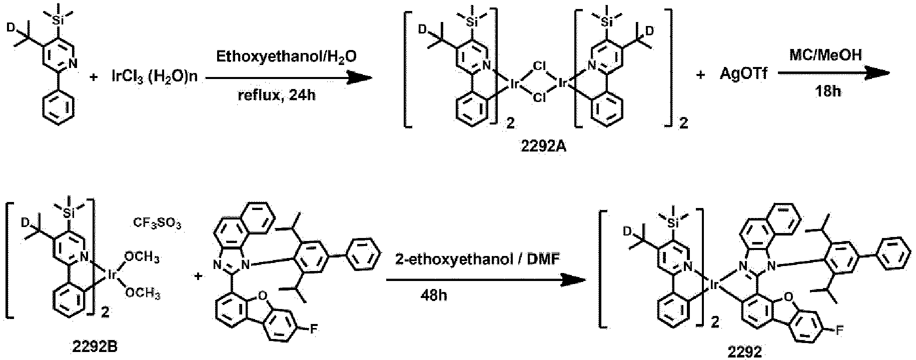

### Synthesis of Compound 2292A

5.4 g (yield of 84%) of Compound 2292A was obtained in the same manner as used to synthesize Compound 17A of Synthesis Example 1, except that 2-phenyl-4-(propan-2-yl-2-d)-5-(trimethylsilyl)pyridine was used instead of 2-phenyl-5-(trimethylsilyl)pyridine.

### Synthesis of Compound 2292B

Compound 2292B was obtained in the same manner as used to synthesize Compound 17B of Synthesis Example 1, except that Compound 2292A was used instead of Compound 17A. The obtained Compound 2292B was used in the next reaction without further purification.

### Synthesis of Compound 2292

0.61 g (yield of 35%) of Compound 2292 was obtained in the same manner as used to synthesize Compound 17 of Synthesis Example 1, except that Compound 2292B was used instead of Compound 17B, and 1-(3,5-diisopropyl-[1,1'-biphenyl]-4-yl)-2-(7-fluorodibenzo[b,d]furan-4-yl)-1H-naphtho[1,2-d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₇₅H₇₄D₂FIrN₄OSi₂: m/z 1318.5296 Found: 1318.5304 Synthesis Example 17 (Compound 2417)

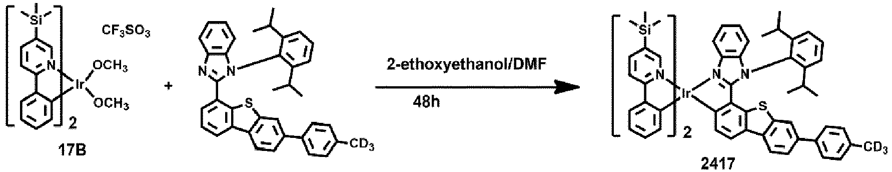

0.31 g (yield of 29%) of Compound 2417 was obtained in the same manner as used to synthesize Compound 17 of Synthesis Example 1, except that 1-(2,6-diisopropylphenyl)-2-(7-(4-(methyl-d3)phenyl)dibenzo[b,d]thiophen-4-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₆₆H₆₂D₃IrN₄SSi₂: m/z 1197.4286 Found: 1197.4281 Synthesis Example 18 (Compound 2860)

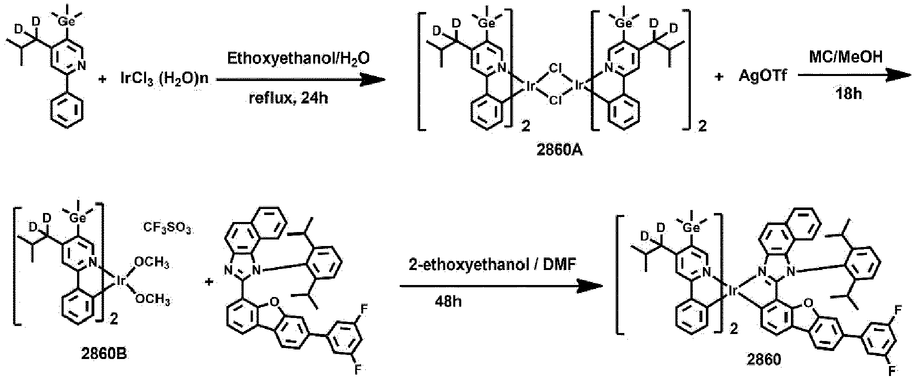

### Synthesis of Compound 2860A

4.4 g (yield of 74%) of Compound 2860A was obtained in the same manner as used to synthesize Compound 17A of Synthesis Example 1, except that 4-(2-methylpropyl-1,1-d2)-2-phenyl-5-(trimethylgermyl)pyridine was used instead of 2-phenyl-5-(trimethylsilyl)pyridine.

### Synthesis of Compound 2860B

Compound 2860B was obtained in the same manner as used to synthesize Compound 17B of Synthesis Example 1, except that Compound 2860A was used instead of Compound 17A. The obtained Compound 2860B was used in the next reaction without further purification.

### Synthesis of Compound 2860

0.39 g (yield of 28%) of Compound 2860 was obtained in the same manner as used to synthesize Compound 17 of Synthesis Example 1, except that Compound 2860B was used instead of Compound 17B, and 2-(7-(3,5-difluorophenyl)dibenzo[b,d]furan-4-yl)-1-(2,6-diisopropylphenyl)-1H-naphtho[1,2-d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₇₇H₇₅D₄F₂Ge₂IrN₄O: m/z 1458.4526 Found: 1458.4530 Synthesis Example 19 (Compound 3114)

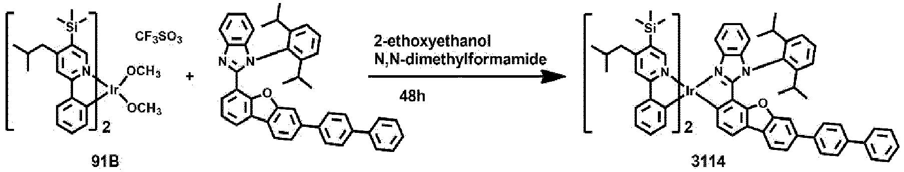

0.33 g (yield of 29%) of Compound 3114 was obtained in the same manner as used to synthesize Compound 17 of Synthesis Example 1, except that Compound 91B was used instead of Compound 17B, and 2-(7-([1,1'-biphenyl]-4-yl)dibenzo[b,d]furan-4-yl)-1-(2,6-diisopropylphenyl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectromety and HPLC analysis.
HRMS(MALDI) calcd for C₇₉H₈₃IrN₄OSi₂: m/z 1352.5735 Found: 1352.5740

### Synthesis Example 20 (Compound 3234)

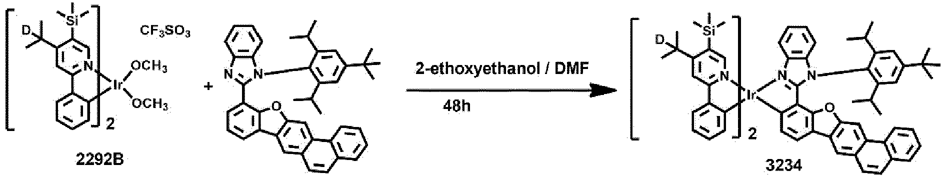

0.61 g (yield of 41%) of Compound 3114 was obtained in the same manner as used to synthesize Compound 17 of Synthesis Example 1, except that Compound 2292B was used instead of Compound 17B, and 1-(4-(tert-butyl)-2,6-diisopropylphenyl)-2-(phenanthro[3,2-b]benzofuran-11-yl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectromety and HPLC analysis.

### HRMS(MALDI) calcd for C₇₇H₈₁D₂IrN₄OSi₂: m/z 1330.5860 Found: 1330.5850 Comparative Synthesis Example A (Compound A)

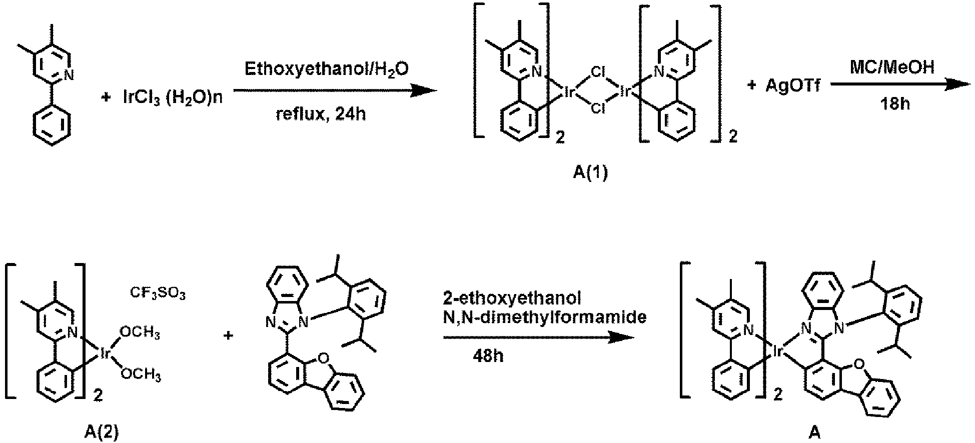

### Synthesis of Compound A(1)

2.0 g (yield of 70%) of Compound A(1) was obtained in the same manner as used to synthesize Compound 17A of Synthesis Example 1, except that 4,5-dimethyl-2-phenylpyridine was used instead of 2-phenyl-5-(trimethylsilyl)pyridine.

### Synthesis of Compound A(2)

Compound A(2) was obtained in the same manner as used to synthesize Compound 17B of Synthesis Example 1, except that Compound A(1) was used instead of Compound 17A. The obtained Compound A(2) was used in the next reaction without further purification. Synthesis of Compound A

0.27 g (yield of 34%) of Compound A was obtained in the same manner as used to synthesize Compound 17 of Synthesis Example 1, except that Compound A(2) was used instead of Compound 17B, and 2-(dibenzo[b,d]furan-4-yl)-1-(2,6-diisopropylphenyl)-1H-benzo[d]imidazole was used instead of 1-(5-(tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.

### HRMS(MALDI) calcd for C₅₇H₅₁IrN₄O: m/z 1000.3692 Found: 1000.3690 Comparative Synthesis Example C (Compound C)

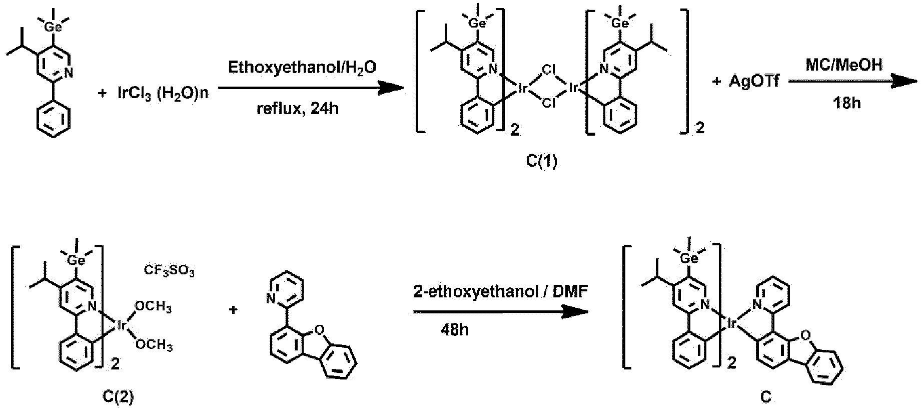

### Synthesis of Compound C(1)

1.9 g (yield of 65%) of Compound C(1) was obtained in the same manner as used to synthesize Compound 17A of Synthesis Example 1, except that 4-isopropyl-2-phenyl-5-(trimethylgermyl)pyridine was used instead of 2-phenyl-5-(trimethylsilyl)pyridine.

### Synthesis of Compound C(2)

Compound C(2) was obtained in the same manner as used to synthesize Compound 17B of Synthesis Example 1, except that Compound C(1) was used instead of Compound 17A. The obtained Compound C(2) was used in the next reaction without further purification. Synthesis of Compound C

0.29 g (yield of 31%) of Compound C was obtained in the same manner as used to synthesize Compound 17 of Synthesis Example 1, except that Compound C(2) was used instead of Compound 17B, and 2-(dibenzo[b,d]furan-4-yl)pyridine was used instead of 1-(5-tert-butyl)-[1,1'-biphenyl]-2-yl)-2-(dibenzo[b,d]furan-4-yl)-1H-benzo[d]imidazole. The obtained material was confirmed by Mass Spectrometry and HPLC analysis.
HRMS(MALDI) calcd for C₅₁H₅₄G₂₂IrN₃O: m/z 1065.2320 Found: 1065.2312

### Example 1

The glass substrate on which ITO was patterned as an anode was cut to a size of 50 mm x 50 mm x 0.5 mm and sonicated using isopropyl alcohol and deionized water, each for 5 minutes, and then ultraviolet rays were irradiated thereon for 30 minutes and exposed to ozone to be cleaned and mounted in a vacuum deposition apparatus.

Compound HT3 and F6-TCNNQ were vacuum co-deposited at a weight ratio of 98: 2 on the anode to form a hole injection layer having a thickness of 100 Å, and Compound HT3 was vacuum deposited on the hole injection layer to form a hole transport layer having a thickness of 1650 Å.

Subsequently, Compound CBP (host) and Compound 17 (dopant) were co-deposited on the hole transport layer at a weight ratio of 95: 5 to form an emission layer having a thickness of 400 Å.

Then, Compound ET3 and ET-D1 were co-deposited at a volume ratio of 50: 50 on the emission layer to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1000 Å, thereby completing the manufacture of an organic light-emitting device.

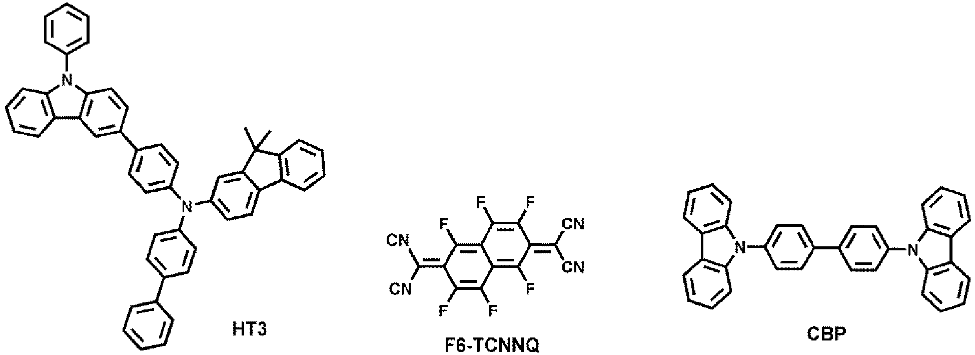

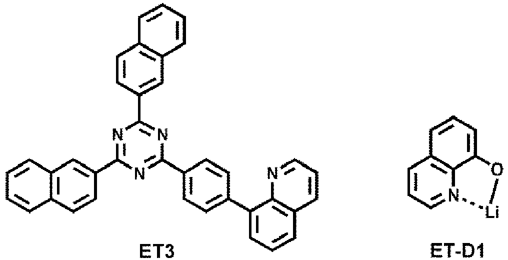

### Examples 2 to 20 and Comparative Examples A to C

Organic light-emitting devices were manufactured in the same manner as in Example 1, except that the compounds shown in Table 2 were used instead of Compound 17 as dopants when forming the emission layer.

### Evaluation Example 1: Evaluation of Properties of Organic Light-Emitting Devices

For each of the organic light-emitting devices manufactured in Examples 1 to 20 and Comparative Examples A to C, the maximum value of external quantum efficiency (Max EQE) and lifespan (LT₉₇) were evaluated. The results are shown in Table 2. A current-voltmeter (Keithley 2400) and a luminance meter (Minolta Cs-1000A) were used as an evaluation device, and the lifespan (LT₉₇) (at 8000 cd/m² [nit]) was expressed as a relative value (%) by evaluating the time (hr) for the luminance of 97% with respect to the initial luminance of 100%.

**Table 2**

| | Dopant in emission layer Compound No. | Max EQE (%) | LT₉₇ (%) (at 8000 cd/m² [nit]) (a relative value, %) |
|---|---|---|---|
| Example 1 | 17 | 97 | 125 |
| Example 2 | 91 | 103 | 105 |
| Example 3 | 102 | 90 | 85 |
| Example 4 | 472 | 96 | 115 |
| Example 5 | 532 | 100 | 100 |
| Example 6 | 666 | 96 | 100 |
| Example 7 | 812 | 100 | 80 |
| Example 8 | 980 | 98 | 120 |
| Example 9 | 1020 | 96 | 110 |
| Example 10 | 1390 | 105 | 100 |
| Example 11 | 1666 | 101 | 120 |
| Example 12 | 1857 | 97 | 90 |
| Example 13 | 2010 | 103 | 130 |
| Example 14 | 2122 | 100 | 150 |
| Example 15 | 2206 | 106 | 135 |
| Example 16 | 2292 | 103 | 110 |
| Example 17 | 2417 | 101 | 145 |
| Example 18 | 2860 | 104 | 105 |
| Example 19 | 3114 | 108 | 120 |
| Example 20 | 3234 | 107 | 145 |
| Comparative Example A | A | 85 | 45 |
| Comparative Example B | B | 72 | 28 |
| Comparative Example C | C | 72 | 20 |

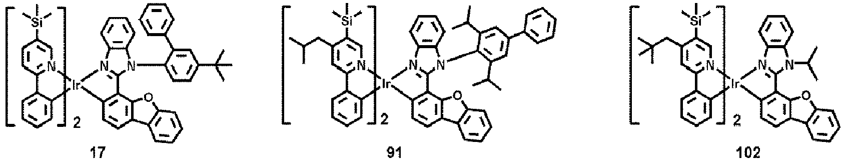

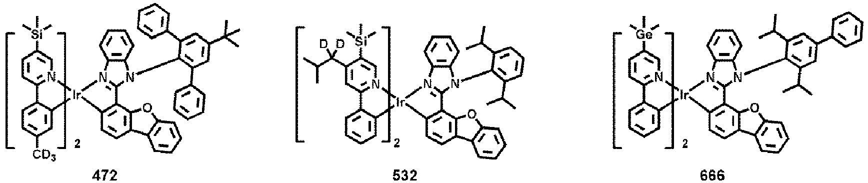

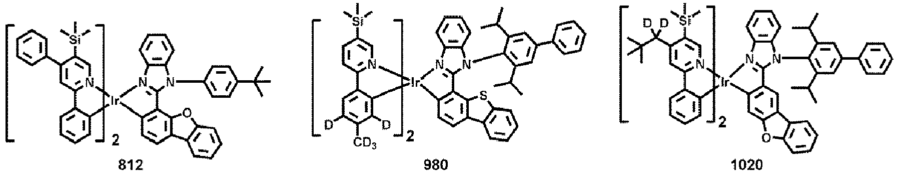

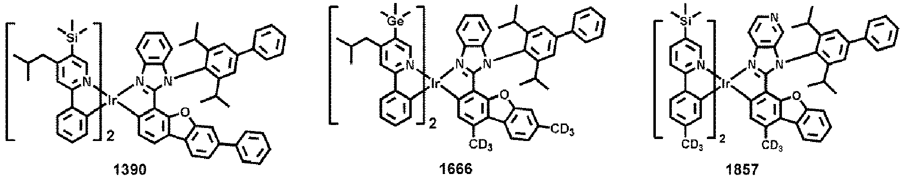

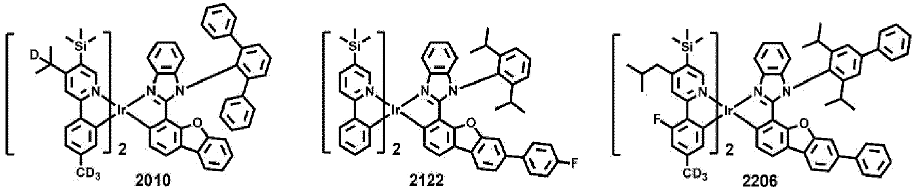

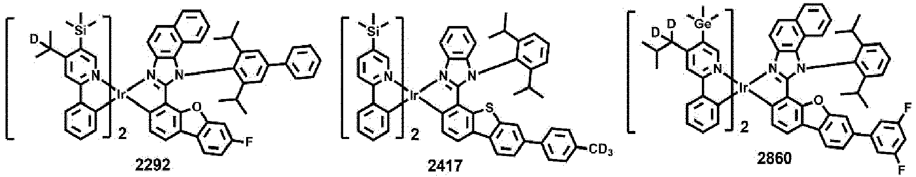

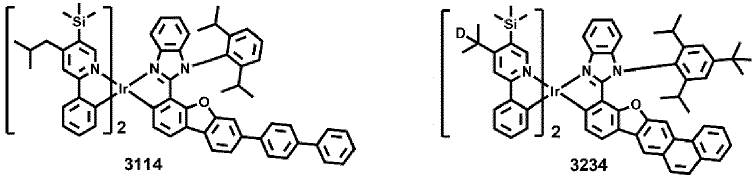

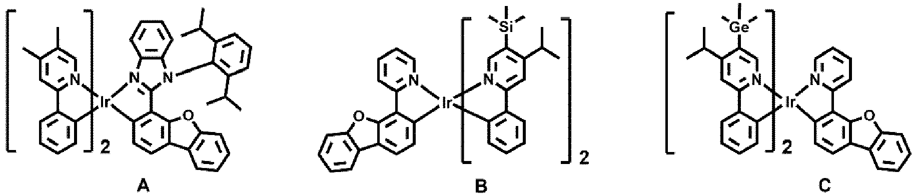

From Table 2, it can be seen that the organic light-emitting devices of Examples 1 to 20 emit green light and have an improved external quantum luminescence efficiency and improved lifespan characteristics compared to the organic light-emitting devices of Comparative Examples A to C.

The organometallic compound has excellent electrical properties, an electronic device, for example, organic light-emitting device using the organometallic compound can have improved external quantum efficiency and improved lifespan property, and an electronic apparatus having a high-quality by using the organic light-emitting device.

## Claims

1. An organometallic compound represented by Formula 1:
<Formula 1> M(L₁)ₙ₁(L₂)ₙ₂
wherein, in Formula 1,
M is Ir,
L₁ is a ligand represented by Formula 2,
L₂ is a ligand represented by Formula 3,
n1 is 2 and n2 is 1 or n1 is 1 and n2 is 2, wherein when n1 is 2, two L₁(s) are identical to or different from each other, and when n2 is 2, two L₂(s) are identical to or different from each other, 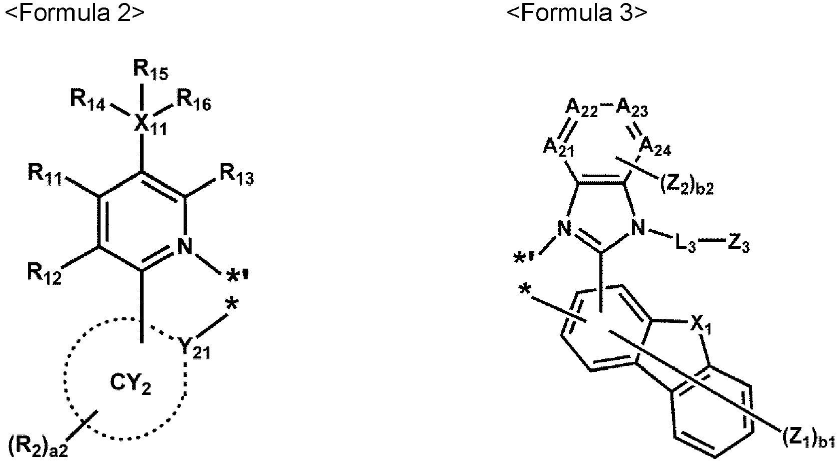 wherein, in Formulae 2 and 3,
Y₂₁ is C or N,
ring CY₂ is a C₅-C₃₀ carbocyclic group or a C₁-C₃₀ heterocyclic group,
X₁₁ is Si or Ge,
X₁ is O, S, Se, N(Z₁₉), C(Z₁₉)(Z₂₀), or Si(Z₁₉)(Z₂₀),
A₂₁ to A₂₄ are each independently C or N,
L₃ is a single bond, a C₅-C₃₀ carbocyclic group unsubstituted or substituted with at least one R₁₀ₐ, or a C₁-C₃₀ heterocyclic group unsubstituted or substituted with at least one R10a,
R₂, R₁₁ to R₁₆, Z₁ to Z₃, Z₁₉, and Z₂₀ are each independently hydrogen, deuterium,-F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂),-Si(Q₃)(Q₄)(Q₅), -Ge(Q₃)(Q₄)(Q₅), -B(Q₆)(Q₇), -P(=O)(Q₈)(Q₉₎, or -P(Q₈)(Q₉),
a2 is an integer from 0 to 20, and when a2 is 2 or more, two or more R₂(s) are identical to or different from each other,
b1 is an integer from 0 to 6, and when b1 is 2 or more, two or more Z₁(s) are identical to or different from each other,
b2 is an integer from 0 to 4, and when b2 is 2 or more, two or more Z₂(s) are identical to or different from each other,
R₁₁ and R₁₂ are optionally linked to form a C₅-C₃₀ carbocyclic group unsubstituted or substituted with at least one R₁₀ₐ, or a C₁-C₃₀ heterocyclic group unsubstituted or substituted with at least one R₁₀ₐ,
two or more of a plurality of R₂(s) are optionally linked to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of Z₁(s) are optionally linked to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of Z₂(s) are optionally linked to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is the same as defined in connection with Z₁,
* and *' each indicate a binding site to M in Formula 1, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is :
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂),-Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉),-P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉), or -P(Q₃₈)(Q₃₉); or
any combination thereof,
wherein Q₁ to Q₉, Q₁₁ to Q₁₉, Q₂₁ to Q₂₉, and Q₃₁ to Q₃₉ are each independently hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group, unsubstituted or substituted with deuterium, -F, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C_{1O} cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group, unsubstituted or substituted with deuterium, -F, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group;
or a monovalent non-aromatic condensed heteropolycyclic group.

2. The organometallic compound of claim 1, wherein
ring CY₂ is a benzene group, a naphthalene group, an anthracene group, a phenanthrene group, a 1,2,3,4-tetrahydronaphthalene group, a carbazole group, a fluorene group, a dibenzosilole group, a dibenzothiophene group, or a dibenzofuran group; and/or
wherein L₃ in Formula 1 is:
a single bond, or
a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

3. The organometallic compound of claims 1 or 2, wherein
R₂, R₁₁ to R₁₃, Z₁ to Z₃, Z₁₉ and Z₂₀ in Formulae 2 and 3 are each independently:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), -Ge(Q₃₃)(Q₃₄)(Q₃₅), or any combination thereof, and
R₁₄ to R₁₆ in Formula 2 are each independently a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

4. The organometallic compound of any of claims 1-3, wherein
R₁₁ is not hydrogen; and/or
wherein the compound satisfies at least one of <Condition A> and <Condition B> :
<Condition A>
L₃ is a C₅-C₃₀ carbocyclic group unsubstituted or substituted with at least one R₁₀ₐ, or a C₁-C₃₀ heterocyclic group unsubstituted or substituted with at least one R₁₀ₐ,
<Condition B>
Z₃ is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group; and/or
wherein
Z₁ is not hydrogen, and b1 is an integer from 1 to 6.

5. The organometallic compound of any of claims 1-4, wherein a group represented by 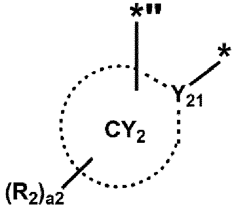 in Formula 2 is a group represented by one of Formulae CY2-1 to CY2-33: 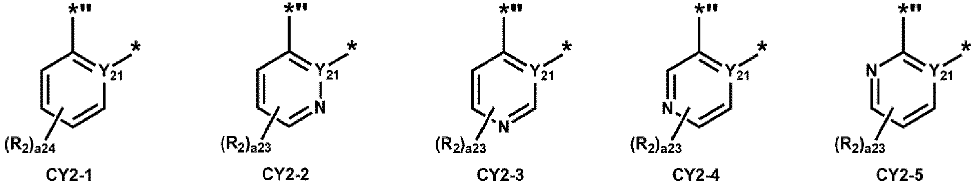 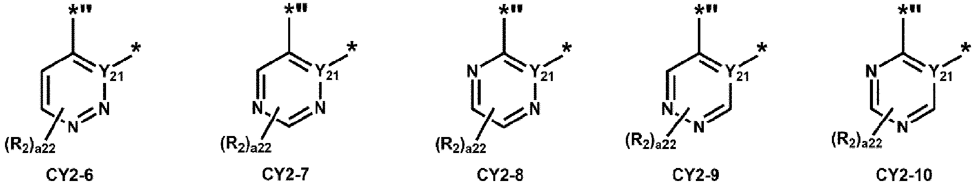 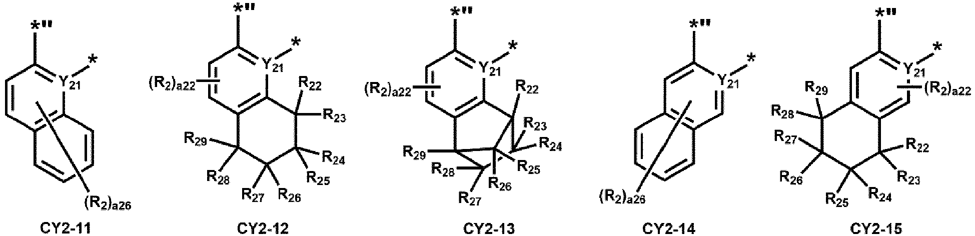 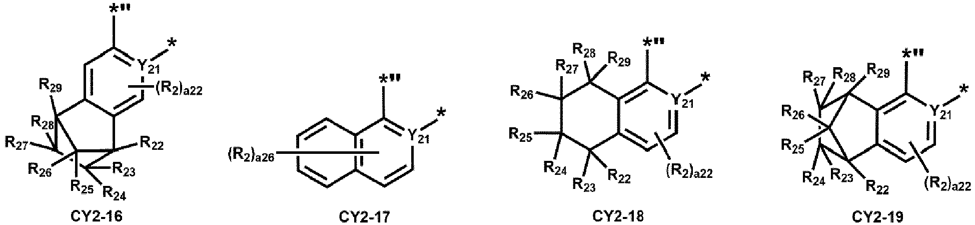 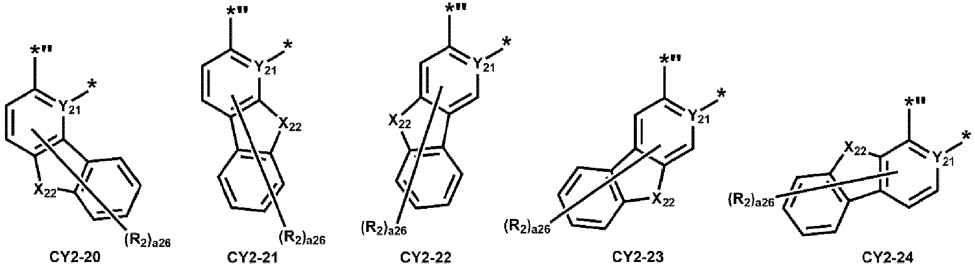 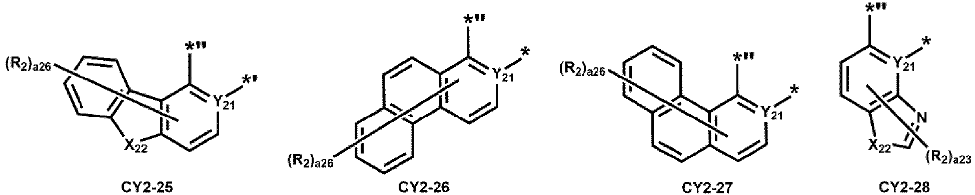 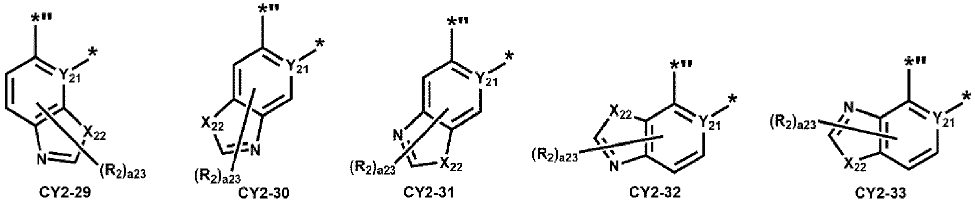 wherein, in Formulae CY2-1 to CY2-33,
Y₂₁ and R₂ are the same as described in claim 1,
X₂₂ is C(R₂₂)(R₂₃), N(R₂₂), O, S, or Si(R₂₂)(R₂₃),
R₂₂ to R₂₉ are the same as described in connection with R₂ in claim 1,
a28 is an integer from 0 to 8,
a26 is an integer from 0 to 6,
a24 is an integer from 0 to 4,
a23 is an integer from 0 to 3,
a22 is an integer from 0 to 2,
*" indicates a binding site to a neighboring atom in Formula 2, and
* indicates a binding site to M in Formula 1.

6. The organometallic compound of any of claims 1-5, wherein a group represented by 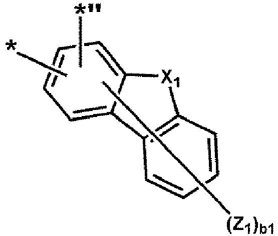 in Formula 3 is a group represented by one of Formulae CY3-1 to CY3-6: 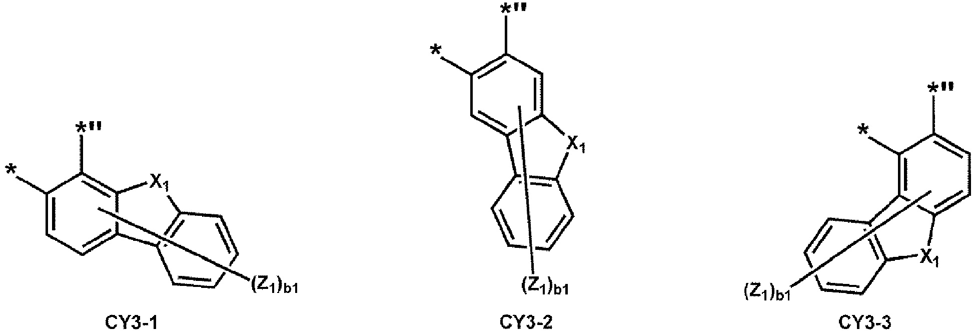 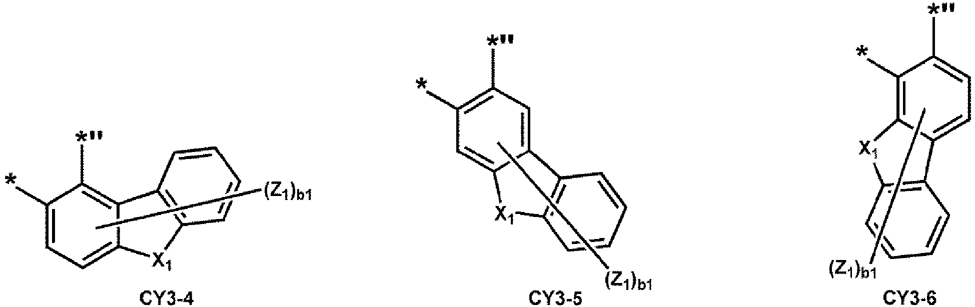 wherein, in Formulae CY3-1 to CY3-6,
X₁, Z₁, and b1 are the same as described in claim 1,
* indicates a binding site to M in Formula 1, and
*" indicates a binding site to a neighboring atom in Formula 3.

7. The organometallic compound of any of claims 1-5, wherein a group represented by 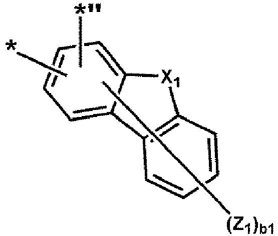 in Formula 3 is a group represented by one of Formulae CY3-1A to CY3-1D, CY3-2A to CY3-2D, CY3-3A to CY3-3D, CY3-4A to CY3-4D, CY3-5A to CY3-5D, and CY3-6A to CY3-6D: 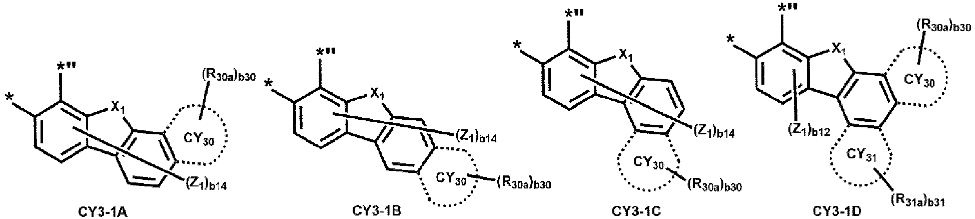 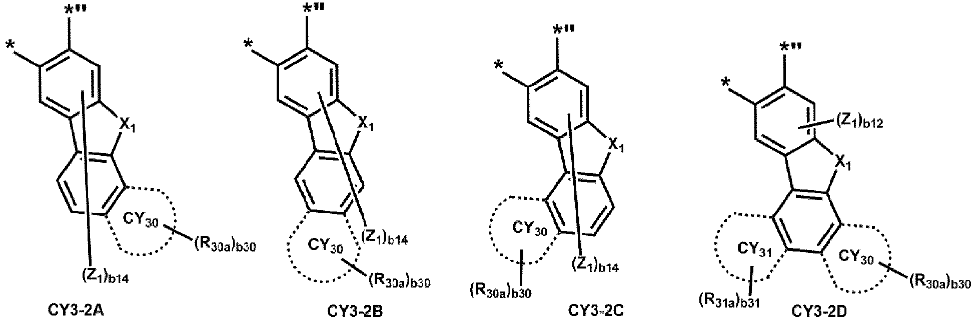 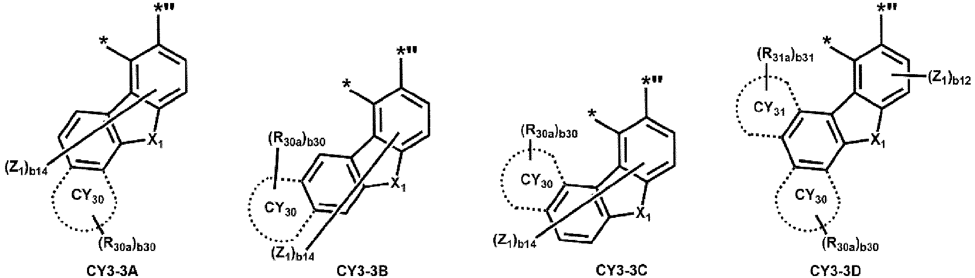 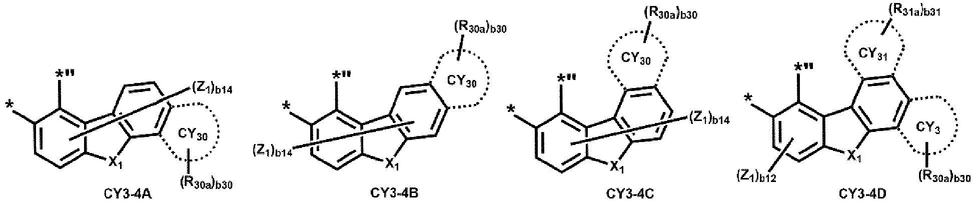 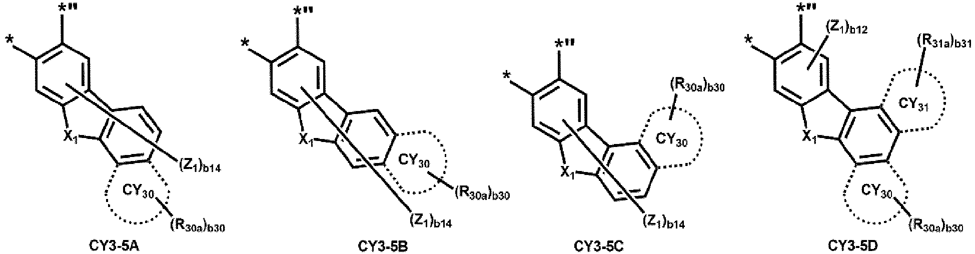 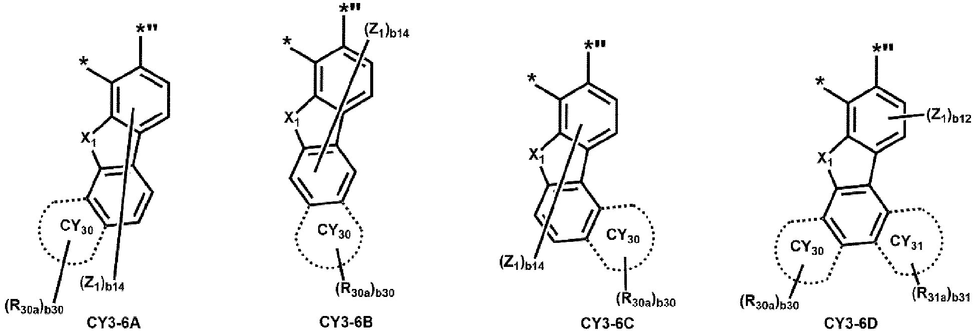 wherein, in Formulae CY3-1A to CY3-1D, CY3-2A to CY3-2D, CY3-3A to CY3-3D, CY3-4A to CY3-4D, CY3-5A to CY3-5D, and CY3-6A to CY3-6D,
X₁ and Z₁ are the same as described in claim 1,
ring CY₃₀ and ring CY₃₁ are each independently a C₅-C₃₀ carbocyclic group or a C₁-C₃₀ heterocyclic group,
R₃₀ₐ and R₃₁ₐ are each the same as described in connection with R₁₀ₐ in claim 1,
b12 may be an integer from 0 to 2,
b14 may be an integer from 0 to 4,
b30 and b31 may each independently be an integer from 0 to 20, when b30 is 2 or more, two or more R₃₀ₐ(s) may be identical to or different from each other, and when b31 is 2 or more, two or more R₃₁ₐ(s) may be identical to or different from each other,
* indicates a binding site to M in Formula 1, and
*" indicates a binding site to a neighboring atom in Formula 3.

8. The organometallic compound of any of claims 1-5, wherein a group represented by 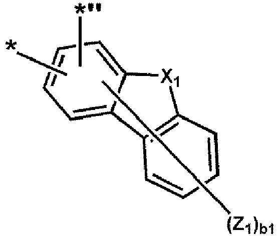 in Formula 3 is a group represented by one of Formulae CY3(1) to CY3(132): 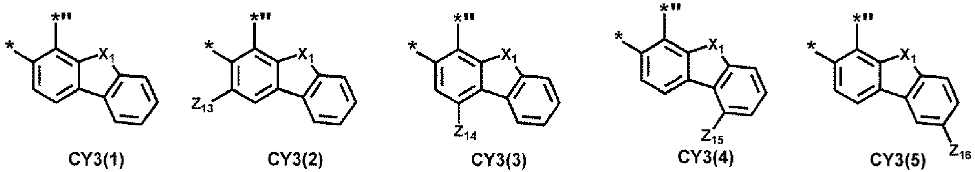 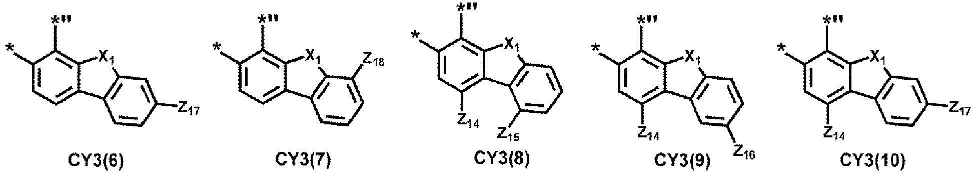 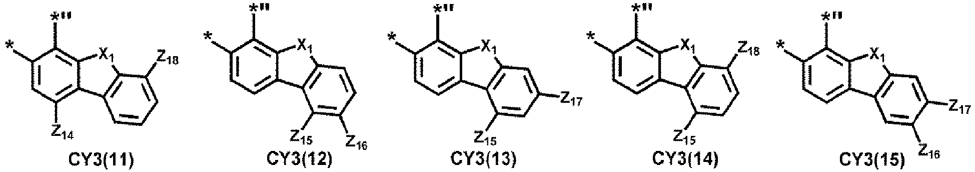 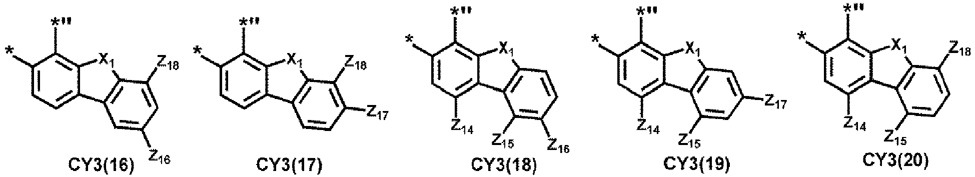 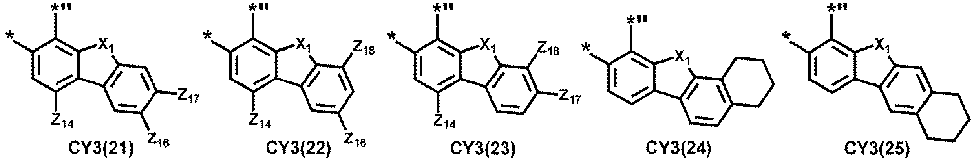 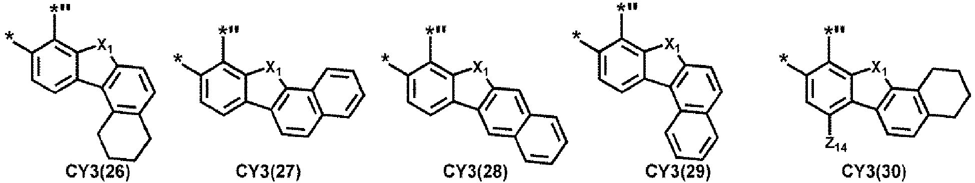 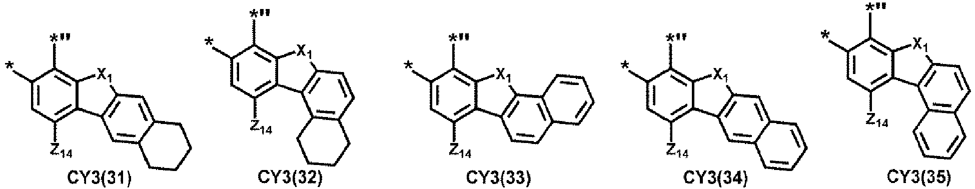 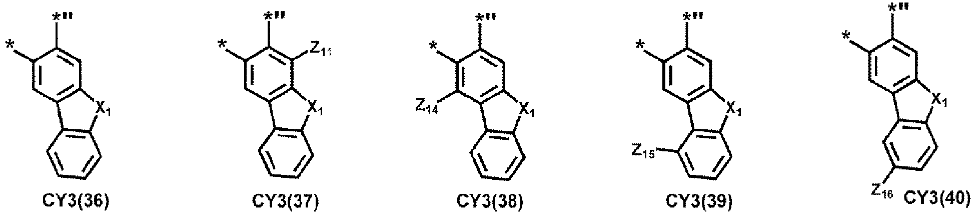 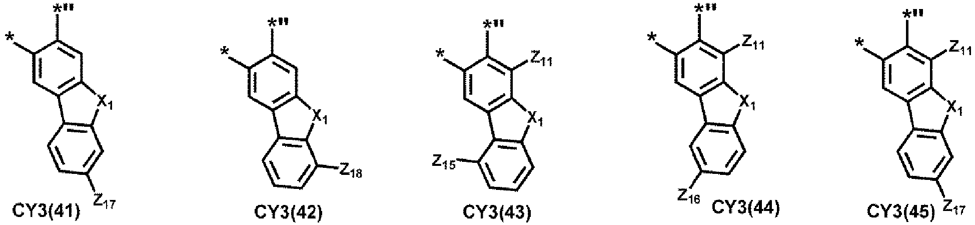 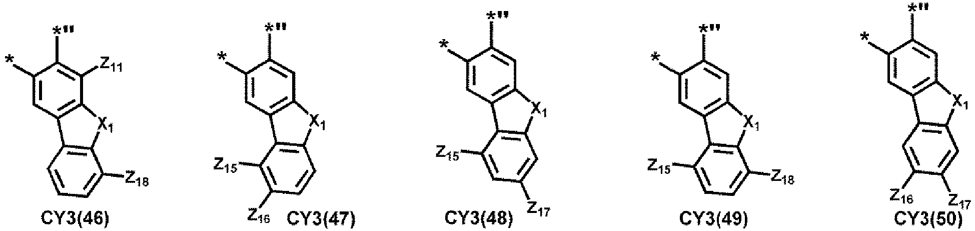 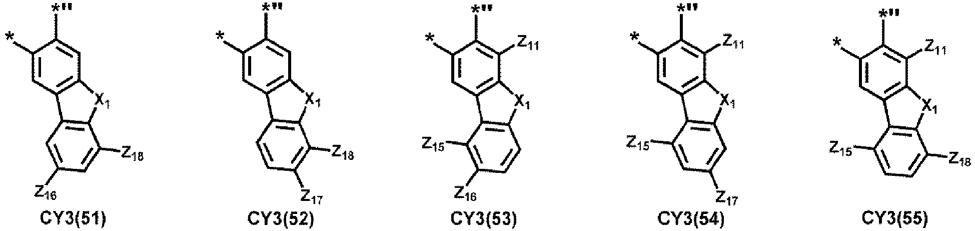 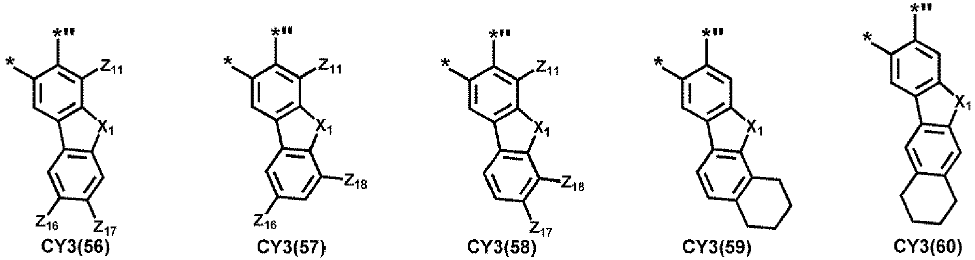 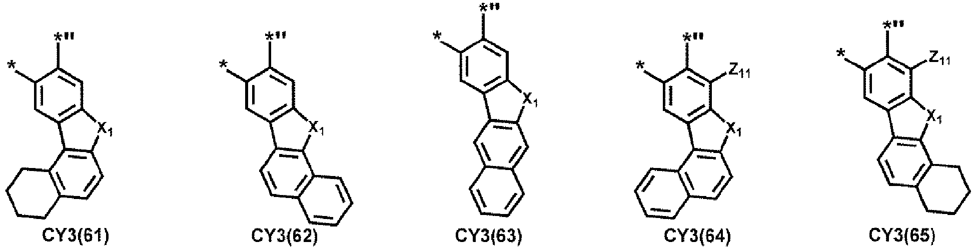 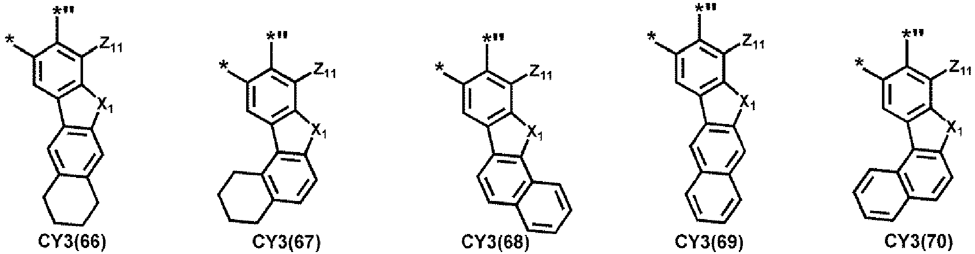 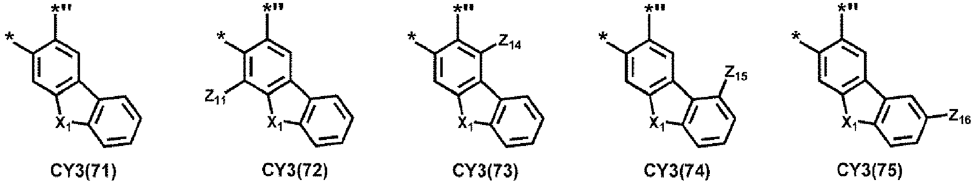 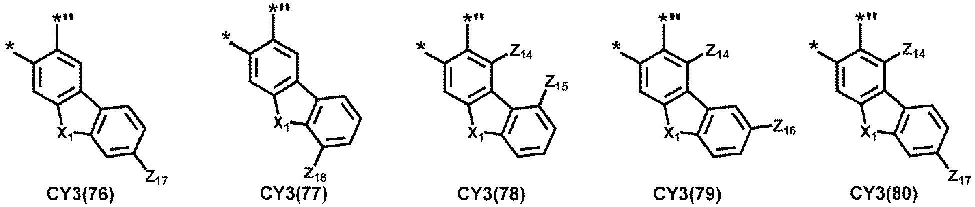 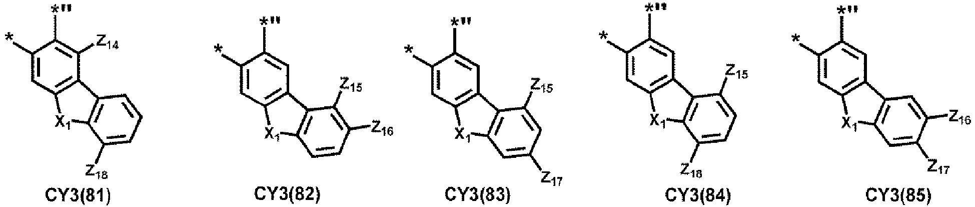 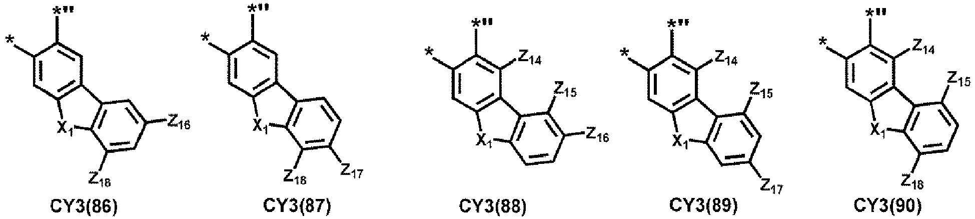 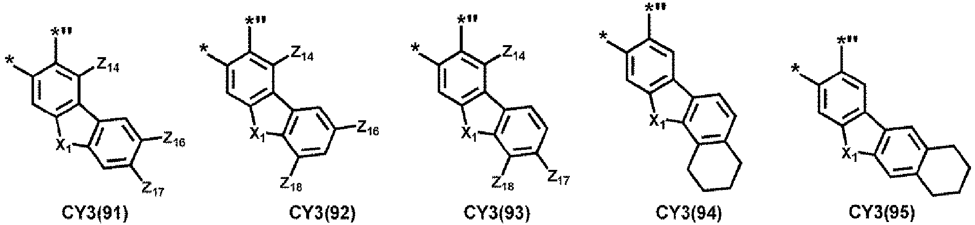 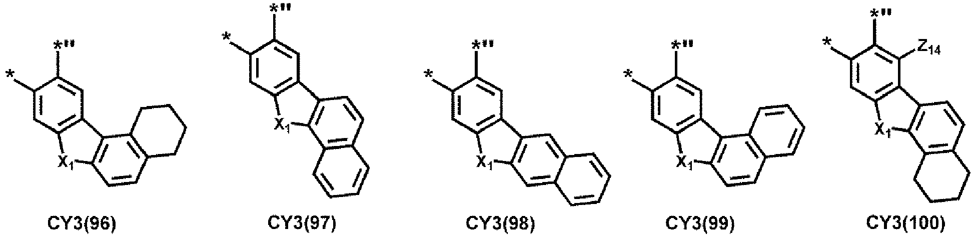 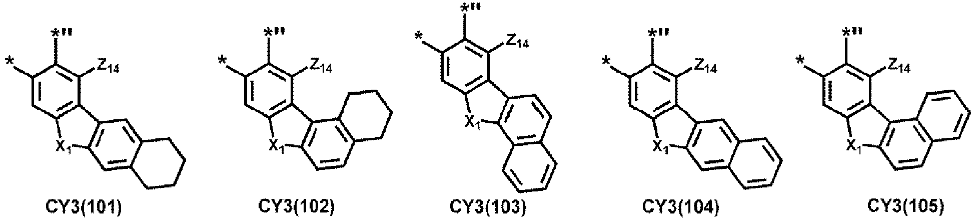 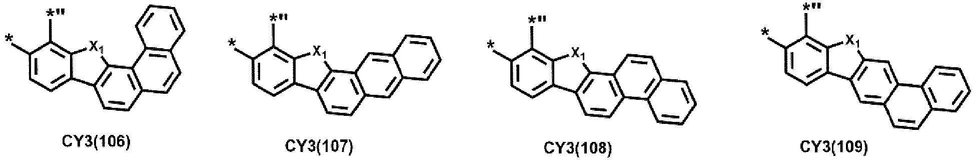 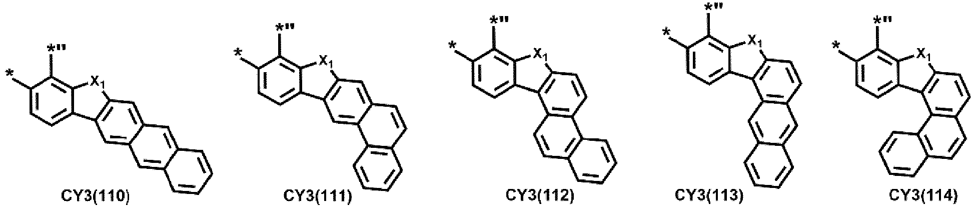 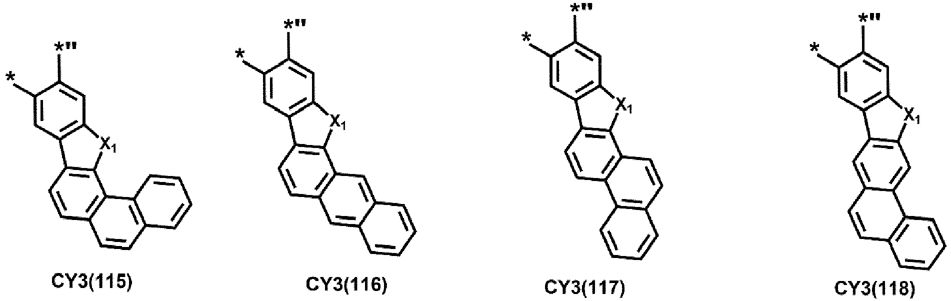 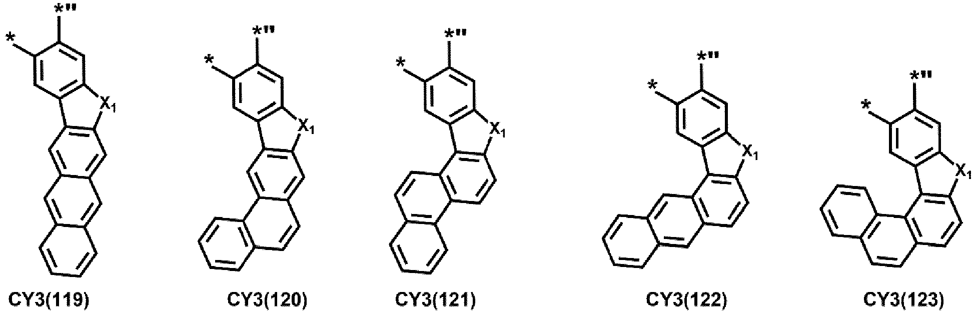 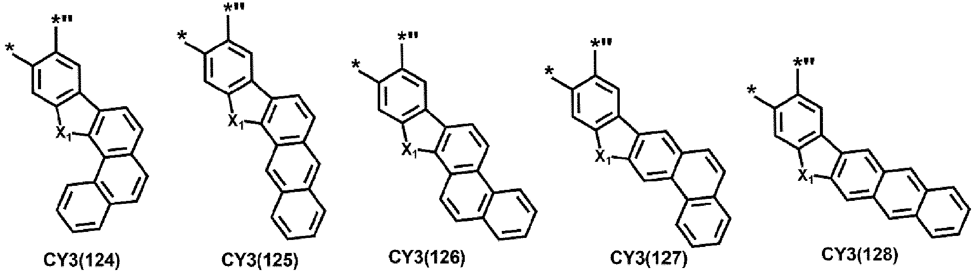 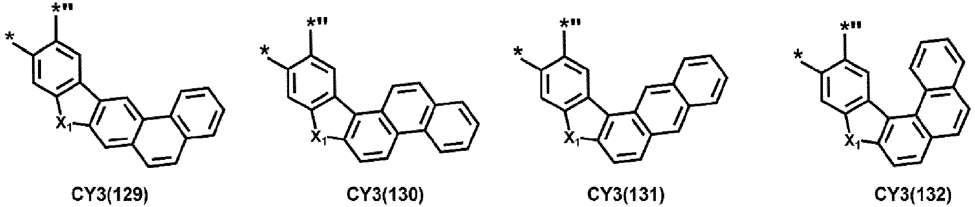 wherein, in Formulae CY3(1) to CY3(132),
X₁ is the same as described in claim 1,
Z₁₁ to Z₁₈ are the same as described in connection with Z₁ in claim 1, and each of Z₁₁ to Z₁₈ is not hydrogen,
* indicates a binding site to M in Formula 1, and
*" indicates a binding site to a neighboring atom in Formula 3.

9. The organometallic compound of any of claims 1-8, wherein a group represented by 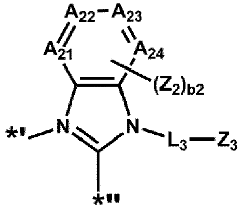 in Formula 3 is a group represented by one of Formulae CY4-1 to CY4-60: 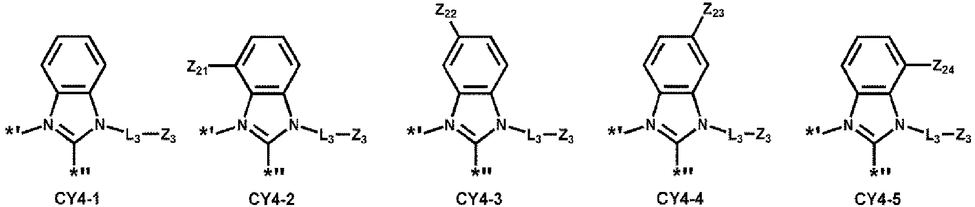 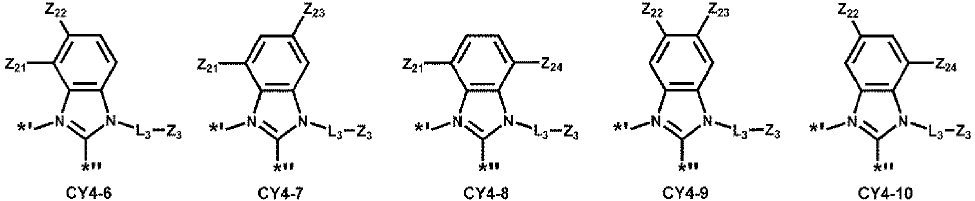 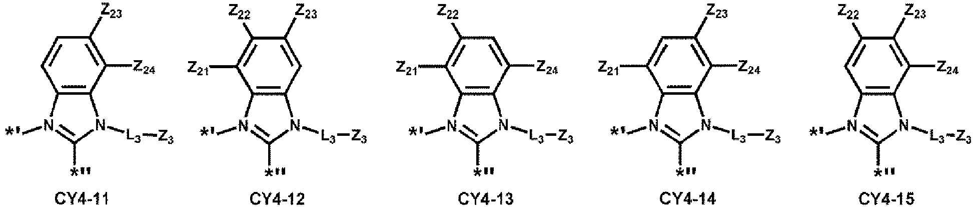 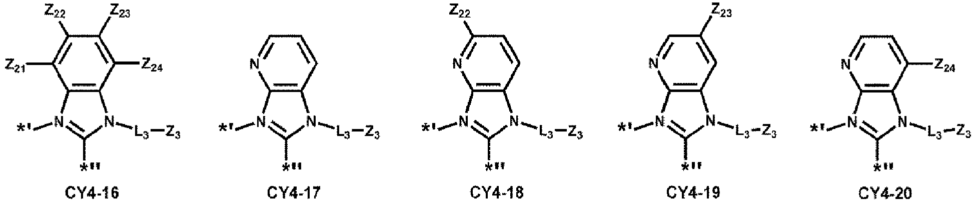 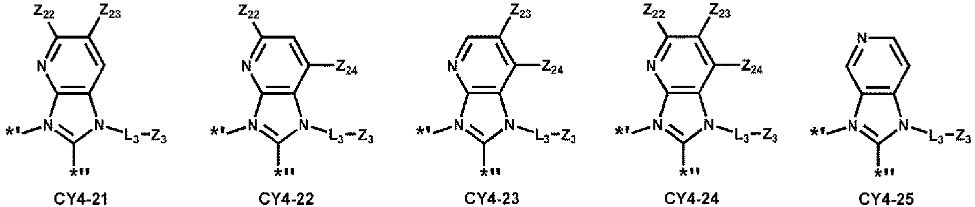 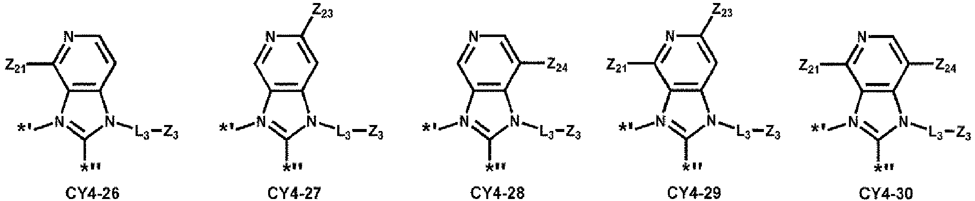 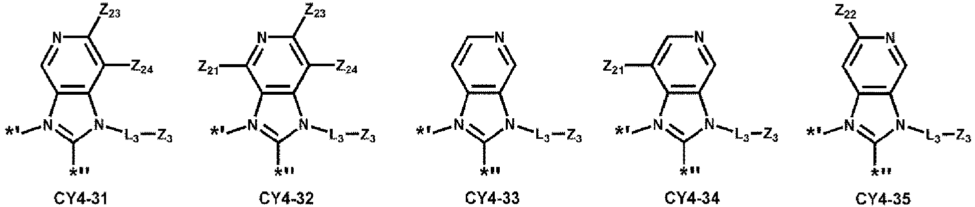 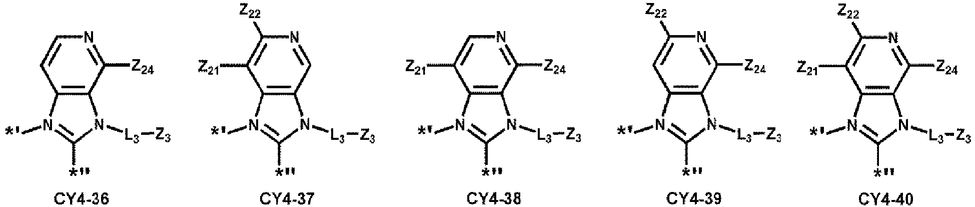 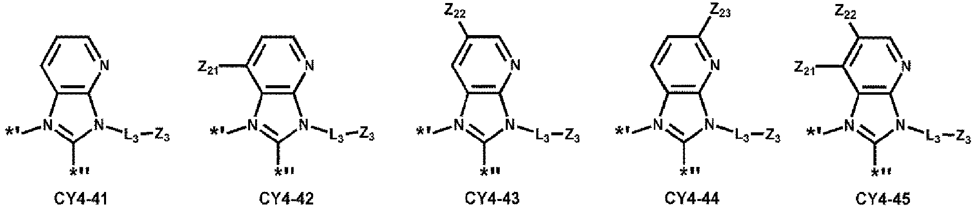 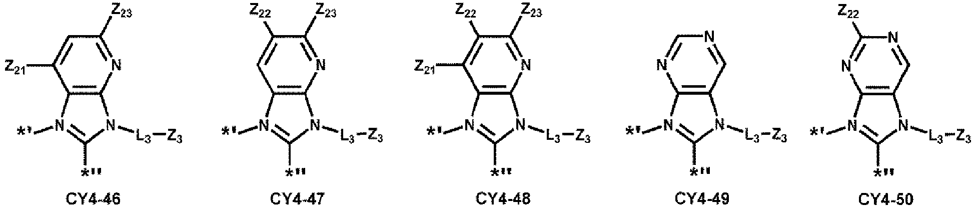 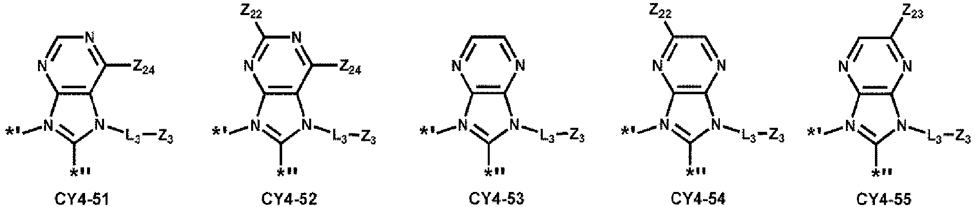 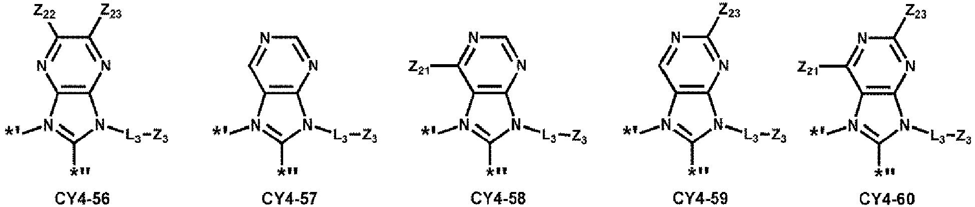 wherein, in Formulae CY4-1 to CY4-60,
L₃ and Z₃ are the same as described in claim 1,
Z₂₁ to Z₂₄ are the same as described in connection with Z₂ in claim 1, and each of Z₂₁ to Z₂₄ is not hydrogen,
*' indicates a binding site to M in Formula 1, and
*" indicates a binding site to a neighboring atom in Formula 3.

10. The organometallic compound of any of claims 1-8, wherein a group represented by 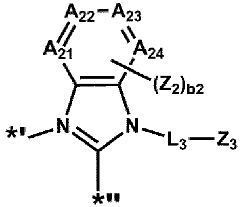 in Formula 3 is a group represented by one of Formulae CY4(1) to CY4(4): 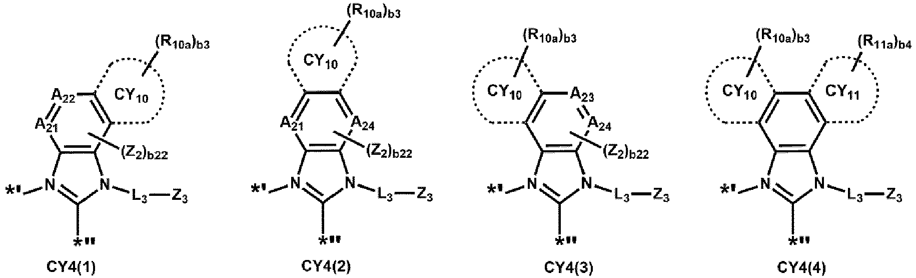 wherein, in Formulae CY4(1) to CY4(4),
A₂₁ to A₂₄, L₃, Z₂, Z₃ and R₁₀ₐ are the same as described in claim 1,
b22 is an integer from 0 to 2,
ring CY₁₀ and ring CY₁₁ are each independently a C₅-C₃₀ carbocyclic group or a C₁-C₃₀ heterocyclic group,
R₁₁ₐ is the same as described in connection with R₁₀ₐ,
b3 and b4 are each independently an integer from 0 to 20, when b3 is 2 or more, two or more R₁₀ₐ(s) are identical to or different from each other, and when b4 is 2 or more, two or more R₁₁ₐ(s) are identical to or different from each other,
*' indicates a binding site to M in Formula 1, and
*" indicates a binding site to a neighboring atom in Formula 3.

11. The organometallic compound of any of claims 1-8, wherein a group represented by 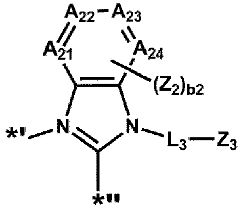 in Formula 3 is a group represented by one of Formulae CY4(1)-1 to CY4(1)-4, CY4(2)-1 to CY4(2)-4, CY4(3)-1 to CY4(3)-4 and CY4(4)-1: 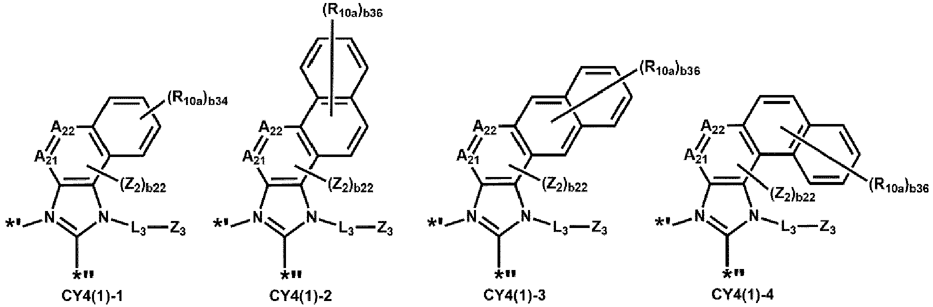 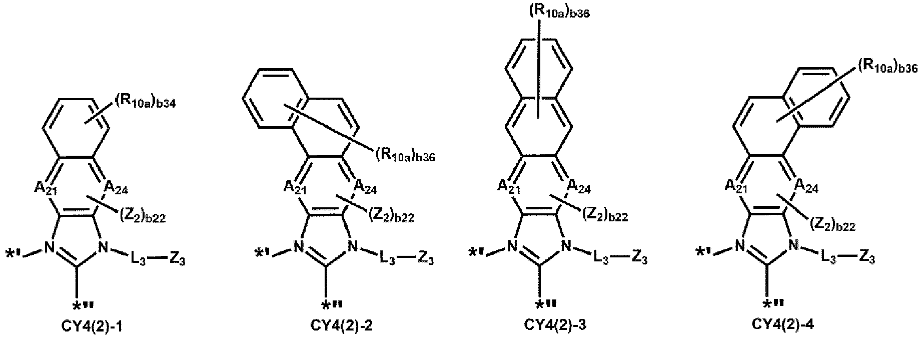 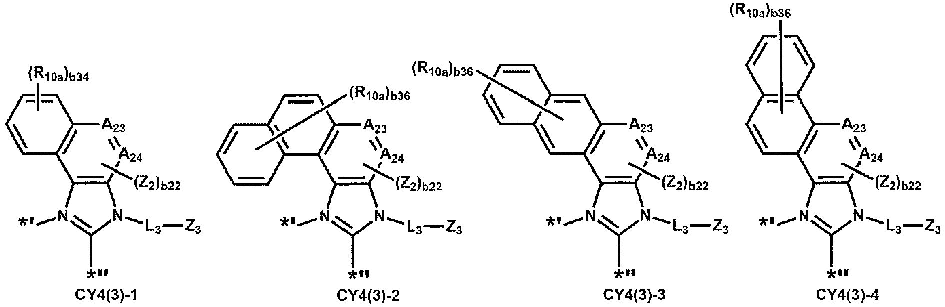 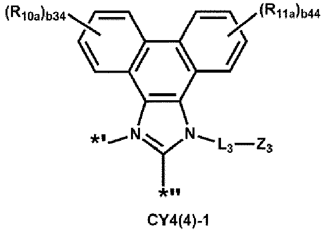 wherein, in Formulae CY4(1)-1 to CY4(1)-4, CY4(2)-1 to CY4(2)-4, CY4(3)-1 to CY4(3)-4 and CY4(4)-1,
A₂₁ to A₂₄, L₃, Z₂, Z₃ and R₁₀ₐ are the same as described in claim 1,
b22 is an integer from 0 to 2,
R₁₁ₐ is the same as described in connection with R₁₀ₐ,
b34 and b44 may each independently be an integer from 0 to 4, when b34 is 2 or more, two or more R₁₀ₐ(s) may be identical to or different from each other, and when b44 is 2 or more, two or more R₁₁ₐ(s) may be identical to or different from each other,
b36 may be an integer from 0 to 6, when b36 is 2 or more, two or more R₁₀ₐ(s) may be identical to or different from each other,
*' indicates a binding site to M in Formula 1, and
*" indicates a binding site to a neighboring atom in Formula 3.

12. An organic light-emitting device comprising:
a first electrode;
a second electrode; and
an organic layer located between the first electrode and the second electrode and comprising an emission layer,
wherein the organic layer comprises at least one of the organometallic compound of any of claims 1-11;
preferably wherein
the first electrode is an anode,
the second electrode is a cathode,
the organic layer comprises a hole transport region between the first electrode and the emission layer and an electron transport region between the emission layer and the second electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

13. The organic light-emitting device of claim 12, wherein
the organometallic compound is included in the emission layer.

14. The organic light-emitting device of claim 13, wherein
the emission layer emits green light; and/or
wherein
the emission layer further comprises a host and the amount of the host is greater than the amount of the organometallic compound.

15. An electronic apparatus comprising the organic light-emitting device of any of claims 12-14.

## Patentansprüche

1. Organometallische Verbindung, dargestellt durch Formel 1:
<Formel 1> M(L₁)ₙ₁(L₂)ₙ₂
wobei, in Formel 1,
M Ir ist,
L₁ ein durch Formel 2 dargestellter Ligand ist,
L₂ ein durch Formel 3 dargestellter Ligand ist,
n1 2 ist und n2 1 ist oder n1 1 ist und n2 2 ist, wobei, wenn n1 2 ist, zwei L₁(s) zueinander identisch oder voneinander verschieden sind und, wenn n2 2 ist, zwei L₂(s) zueinander identisch oder voneinander verschieden sind, 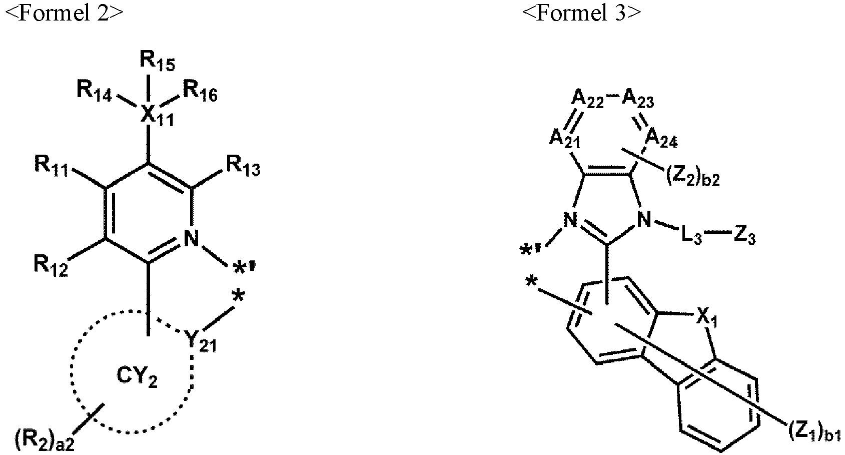 wobei, in Formeln 2 und 3,
Y₂₁ C oder N ist,
Ring CY₂ eine C₅-C₃₀-carbocyclische Gruppe oder eine C₁-C₃₀-heterocyclische Gruppe ist,
Xu Si oder Ge ist,
X₁ O, S, Se, N(Z₁₉), C(Z₁₉)(Z₂₀) oder Si(Z₁₉)(Z₂₀) ist,
A₂₁ bis A₂₄ jeweils unabhängig C oder N sind,
L₃ eine Einzelbindung, eine C₅-C₃₀-carbocyclische Gruppe unsubstituiert oder substituiert mit mindestens einem R₁₀ₐ oder eine C₁-C₃₀-heterocyclische Gruppe unsubstituiert oder substituiert mit mindestens einem R₁₀ₐ ist,
R₂, R₁₁ bis R₁₆, Z₁ bis Z₃, Z₁₉ und Z₂₀ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte monovalente nichtaromatische kondensierte polycyclische Gruppe, eine substituierte oder unsubstituierte monovalente nichtaromatische kondensierte heteropolycyclische Gruppe, -N(Q₁)(Q₂), -Si(Q₃)(Q₄)(Q₅),-Ge(Q₃)(Q₄)(Q₅), -B(Q₆)(Q₇), -P(=O)(Q₈)(Q₉) oder -P(Q₈)(Q₉) sind,
a2 eine ganze Zahl von 0 bis 20 ist und, wenn a2 2 oder mehr ist, zwei oder mehr R₂(s) zueinander identisch oder voneinander verschieden sind,
b1 eine ganze Zahl von 0 bis 6 ist und, wenn b1 2 oder mehr ist, zwei oder mehr Z₁(s) zueinander identisch oder voneinander verschieden sind,
b2 eine ganze Zahl von 0 bis 4 ist und, wenn b2 2 oder mehr ist, zwei oder mehr Z₂(s) zueinander identisch oder voneinander verschieden sind,
R₁₁ und R₁₂ optional verbunden sind zum Bilden einer C₅-C₃₀-carbocyclischen Gruppe, unsubstituiert oder substituiert mit mindestens einem R₁₀ₐ, oder einer C₁-C₃₀-heterocyclischen Gruppe, unsubstituiert oder substituiert mit mindestens einem R₁₀ₐ,
zwei oder mehr einer Vielzahl von R₂(s) optional verbunden sind zum Bilden einer C₅-C₃₀-carbocyclischen Gruppe, unsubstituiert oder substituiert mit mindestens einem R₁₀ₐ, oder einer C₁-C₃₀-heterocyclischen Gruppe, unsubstituiert oder substituiert mit mindestens einem R₁₀ₐ,
zwei oder mehr einer Vielzahl von Z₁(s) optional verbunden sind zum Bilden einer C₅-C₃₀-carbocyclischen Gruppe, unsubstituiert oder substituiert mit mindestens einem R₁₀ₐ, oder einer C₁-C₃₀-heterocyclischen Gruppe, unsubstituiert oder substituiert mit mindestens einem R₁₀ₐ,
zwei oder mehr einer Vielzahl von Z₂(s) optional verbunden sind zum Bilden einer C₅-C₃₀-carbocyclischen Gruppe, unsubstituiert oder substituiert mit mindestens einem R₁₀ₐ, oder einer C₁-C₃₀-heterocyclischen Gruppe, unsubstituiert oder substituiert mit mindestens einem R₁₀ₐ,
R₁₀ₐ das gleiche wie in Verbindung mit Z₁ definiert ist,
* und *' jeweils eine Bindungsstelle an M in Formel 1 angeben, und
ein Substituent der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten monovalenten nichtaromatischen kondensierten polycyclischen Gruppe und der substituierten monovalenten nichtaromatischen kondensierten heteropolycyclischen Gruppe ist:
Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinoguppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe,
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalente nichtaromatische kondensierte polycyclische Gruppe, eine monovalente nichtaromatische kondensierte heteropolycyclische Gruppe, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=0)(Q₁₈)(Q₁₉),-P(Q₁₈)(Q₁₉) oder eine beliebige Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalente nichtaromatische kondensierte polycyclische Gruppe oder eine monovalente nichtaromatische kondensierte heteropolycyclische Gruppe, jeweils unsubstituiert oder substituiert mit Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₁-C₆₀-Alkylthiogruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalente nichtaromatische kondensierte polycyclische Gruppe, eine monovalente nichtaromatische kondensierte heteropolycyclische Gruppe, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉),-P(Q₂₈)(Q₂₉) oder eine beliebige Kombination davon;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) oder -P(Q₃₈)(Q₃₉); oder
eine beliebige Kombination davon,
wobei Q₁ bis Q₉, Q₁₁ bis Q₁₉, Q₂₁ bis Q₂₉ und Q₃₁ bis Q₃₉ jeweils unabhängig Wasserstoff; Deuterium; -F; -Cl; -Br; -I; eine Hydroxylgruppe; eine Cyanogruppe; eine Nitrogruppe; eine Amidinogruppe; eine Hydrazingruppe; eine Hydrazongruppe; eine Carboxylsäuregruppe oder ein Salz davon; eine Sulfonsäuregruppe oder ein Salz davon; eine Phosphorsäuregruppe oder ein Salz davon; eine C₁-C₆₀-Alkylgruppe, unsubstituiert oder substituiert mit Deuterium, -F, eine C₁-C₆₀-Alkylgruppe, eine C₆-C₆₀-Arylgruppe oder eine beliebige Kombination davon; eine C₂-C₆₀-Alkenylgruppe; eine C₂-C₆₀-Alkinylgruppe, eine C₁-C₆₀-Alkoxygruppe, eine C₁-C₆₀-Alkylthiogruppe; eine C₃-C₁₀-Cycloalkylgruppe; eine C₁-C₁₀-Heterocycloalkylgruppe; eine C₃-C₁₀-Cycloalkenylgruppe; eine C₁-C₁₀-Heterocycloalkenylgruppe; eine C₆-C₆₀-Arylgruppe, unsubstituiert oder substituiert mit Deuterium, -F, eine C₁-C₆₀-Alkylgruppe, eine C₆-C₆₀-Arylgruppe oder eine beliebige Kombination davon; eine C₆-C₆₀-Aryloxygruppe; eine C₆-C₆₀-Arylthiogruppe, eine C₁-C₆₀-Heteroarylgruppe, eine monovalente nichtaromatische kondensierte polycyclische Gruppe; oder eine monovalente nichtaromatische kondensierte heteropolycyclische Gruppe sind.

2. Organometallische Verbindung nach Anspruch 1, wobei
Ring CY₂ eine Benzolgruppe, eine Naphthalingruppe, eine Anthracengruppe, eine Phenanthrengruppe, eine 1,2,3,4-Tetrahydronaphthalingruppe, eine Carbazolgruppe, eine Fluorengruppe, eine Dibenzosilolgruppe, eine Dibenzothiophengruppe oder eine Dibenzofurangruppe ist; und/oder wobei L₃ in Formel 1 ist: eine Einfachbindung ist, oder
eine Benzolgruppe, eine Naphthalingruppe, eine Dibenzofurangruppe oder eine Dibenzothiophengruppe, jeweils unsubstituiert oder substituiert mit Deuterium, -F, eine Cyanogruppe, eine C₁-C₂₀-Alkylgruppe, eine deuterierte C₁-C₂₀-Alkylgruppe, eine fluorierte C₁-C₂₀-Alkylgruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁-C₂₀-Alkyl)C₃-C₁₀-Cycloalkylgruppe, eine Phenylgruppe, eine deuterierte Phenylgruppe, a fluorierte Phenylgruppe, eine (C₁-C₂₀-Alkyl)Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe, eine Dibenzothiophenylgruppe oder eine beliebige Kombination davon.

3. Organometallische Verbindung nach Ansprüchen 1 oder 2, wobei
R₂, R₁₁ bis R₁₃, Z₁ bis Z₃, Z₁₉ und Z₂₀ in Formeln 2 und 3 jeweils unabhängig sind:
Wasserstoff, Deuterium, -F oder eine Cyanogruppe; oder
eine C₁-C₂₀-Alkylgruppe, eine C₃-C₁₀-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe, jeweils unsubstituiert oder substituiert mit Deuterium, -F, eine Cyanogruppe, eine C₁-C₂₀-Alkylgruppe, eine deuterierte C₁-C₂₀-Alkylgruppe, eine fluorierte C₁-C₂₀-Alkylgruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁-C₂₀-Alkyl)C₃-C₁₀-Cycloalkylgruppe, eine Phenylgruppe, eine deuterierte Phenylgruppe, eine fluorierte Phenylgruppe, eine (C₁-C₂₀-Alkyl)phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe, eine Dibenzothiophenylgruppe, -Si(Q₃₃)(Q₃₄)(Q₃₅), -Ge(Q₃₃)(Q₃₄)(Q₃₅) oder eine beliebige Kombination davon, und
R₁₄ bis R₁₆ in Formel 2 jeweils unabhängig eine C₁-C₂₀-Alkylgruppe, eine C₃-C₁₀-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe, jeweils unsubstituiert oder substituiert mit Deuterium, -F, eine Cyanogruppe, eine C₁-C₂₀-Alkylgruppe, eine deuterierte C₁-C₂₀-Alkylgruppe, eine fluorierte C₁-C₂₀-Alkylgruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁-C₂₀-Alkyl)C₃-C₁₀-Cycloalkylgruppe, eine Phenylgruppe, eine deuterierte Phenylgruppe, eine fluorierte Phenylgruppe, eine (C₁-C₂₀-Alkyl)phenylgruppe, eine Naphthylgruppe, eine Pyridinylgruppe, eine Furanylgruppe, a Thiophenylgruppe, eine Benzofuranylgruppe, eine Benzothiophenylgruppe, eine Dibenzofuranylgruppe, eine Dibenzothiophenylgruppe oder eine beliebige Kombination davon sind.

4. Organometallische Verbindung nach einem der Ansprüche 1-3, wobei R₁₁ nicht Wasserstoff ist; und/oder
wobei die Verbindung mindestens eine von <Bedingung A> und <Bedingung B> erfüllt:
<Bedingung A>
L₃ ist eine C₅-C₃₀-carbocyclische Gruppe unsubstituiert oder substituiert mit mindestens einem R₁₀ₐ oder eine C₁-C₃₀-heterocyclische Gruppe unsubstituiert oder substituiert mit mindestens einem R₁₀ₐ,
<Bedingung B>
Z₃ ist eine substituierte oder unsubstituierte C₆-C₆₀-Arylgruppe, eine substituierte oder unsubstituierte C₁-C₆₀-Heteroarylgruppe, einer substituierte oder unsubstituierte monovalente nichtaromatische kondensierte polycyclische Gruppe oder eine substituierte oder unsubstituierte monovalente nichtaromatische kondensierte heteropolycyclische Gruppe; und/oder wobei
Z₁ nicht Wasserstoff ist und b 1 eine ganze Zahl von 1 bis 6 ist.

5. Organometallische Verbindung nach einem der Ansprüche 1-4, wobei eine Gruppe dargestellt durch 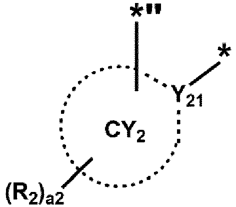 in Formel 2 eine Gruppe dargestellt durch eine der Formeln CY2-1 bis CY2-33 ist: 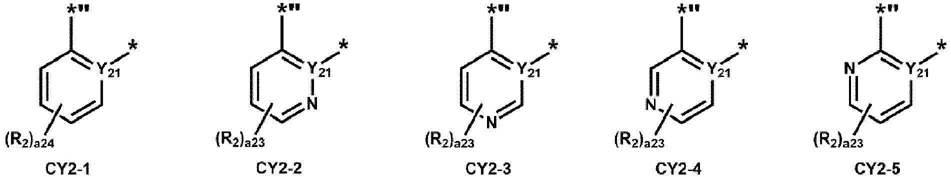 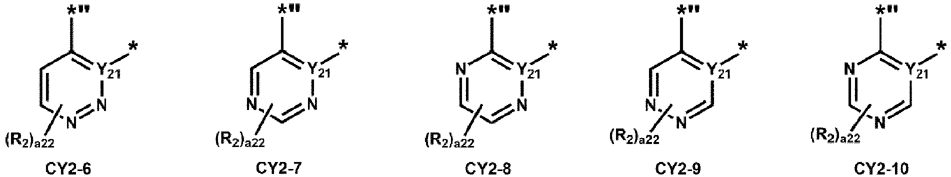 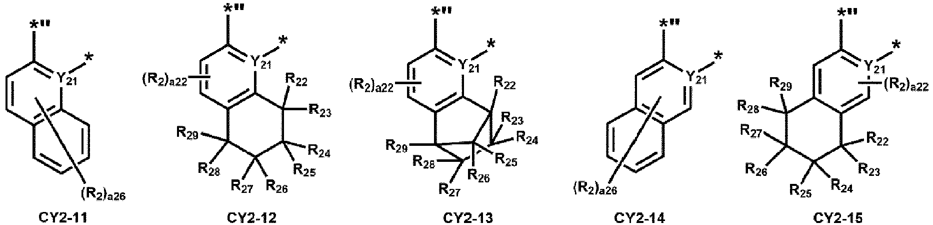 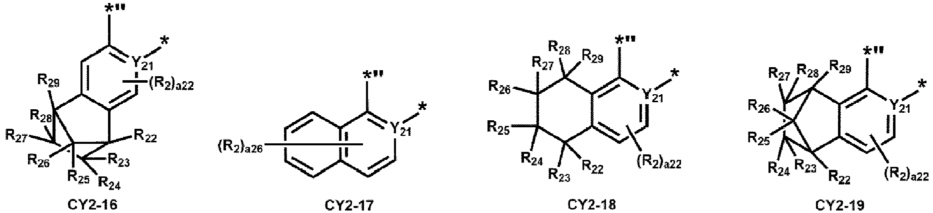 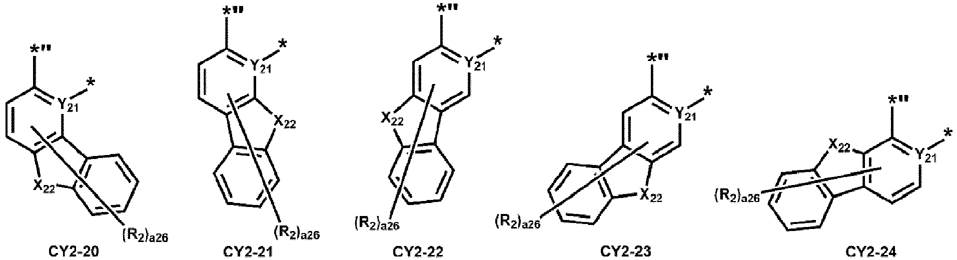 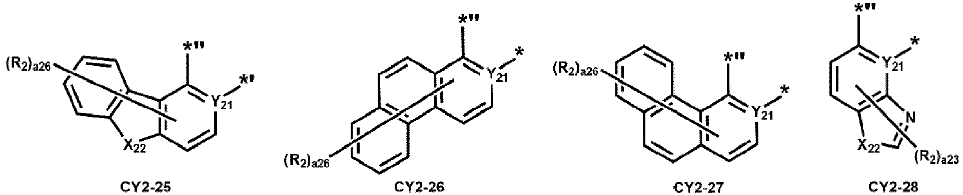 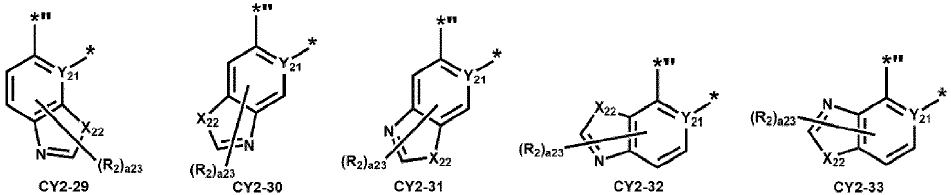 wobei, in Formeln CY2-1 bis CY2-33,
Y₂₁ und R₂ die gleichen wie in Anspruch 1 beschrieben sind,
X₂₂ C(R₂₂)(R₂₃), N(R₂₂), O, S oder Si(R₂₂)(R₂₃) ist,
R₂₂ bis R₂₉ die gleichen wie in Verbindung mit R₂ in Anspruch 1 beschrieben sind,
a28 eine ganze Zahl von 0 bis 8 ist,
a26 eine ganze Zahl von 0 bis 6 ist,
a24 eine ganze Zahl von 0 bis 4 ist,
a23 eine ganze Zahl von 0 bis 3 ist,
a22 eine ganze Zahl von 0 bis 2 ist,
*" eine Bindungsstelle an ein Nachbaratom in Formel 2 angibt und
* eine Bindungsstelle an M in Formel 1 angibt.

6. Organometallische Verbindung nach einem der Ansprüche 1-5, wobei eine Gruppe dargestellt durch 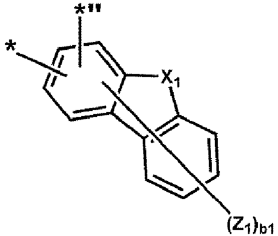 in Formel 3 eine Gruppe dargestellt durch eine der Formeln CY3-1 bis CY3-6 ist: 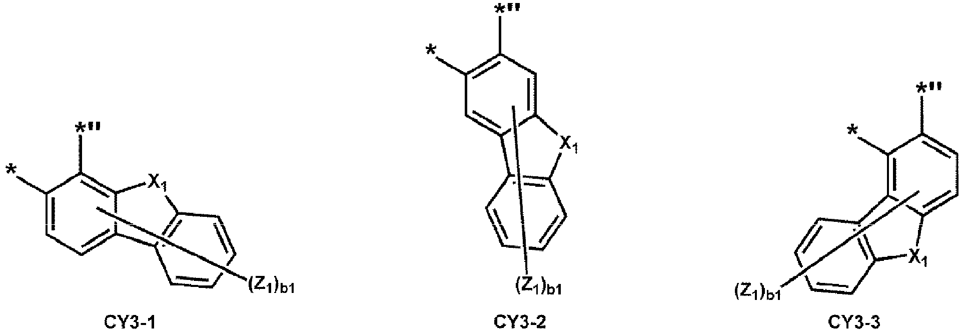 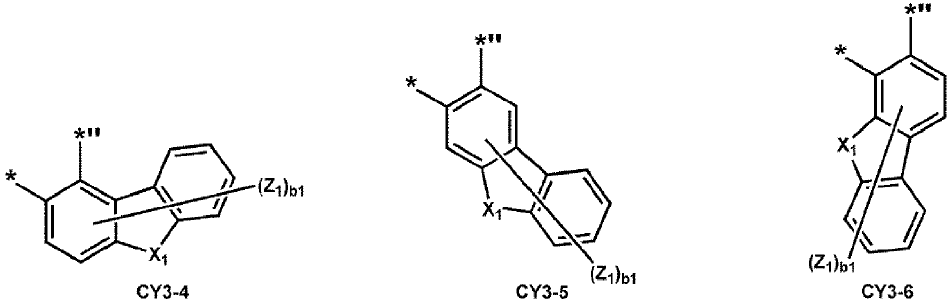 wobei, in Formeln CY3-1 bis CY3-6,
X₁, Z₁ und b1 die gleichen wie in Anspruch 1 beschrieben sind,
* eine Bindungsstelle an M in Formel 1 angibt, und
*" eine Bindungsstelle an ein Nachbaratom in Formel 3 angibt.

7. Organometallische Verbindung nach einem der Ansprüche 1-5, wobei eine Gruppe dargestellt durch 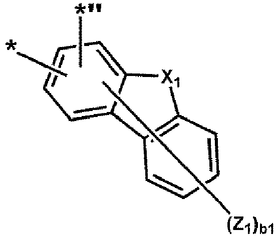 in Formel 3 eine Gruppe dargestellt durch eine der Formeln CY3-1A bis CY3-1D, CY3-2A bis CY3-2D, CY3-3A bis CY3-3D, CY3-4A bis CY3-4D, CY3-5A bis CY3-5D und CY3-6A bis CY3-6D ist: 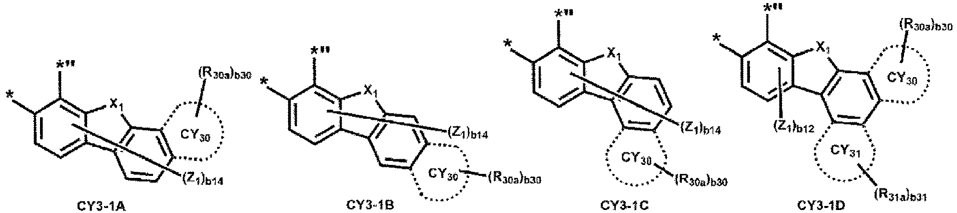 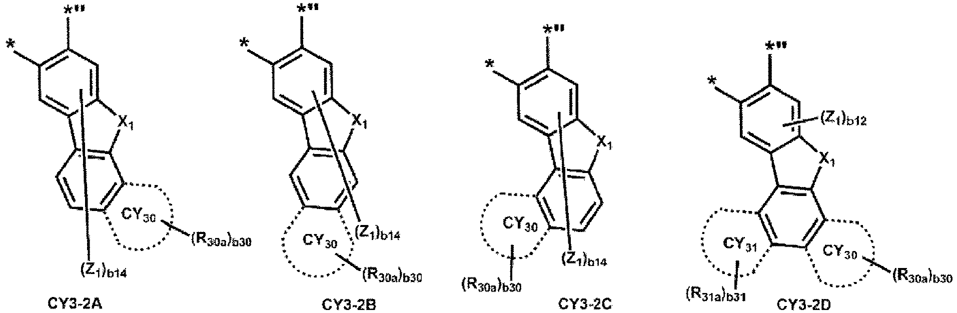 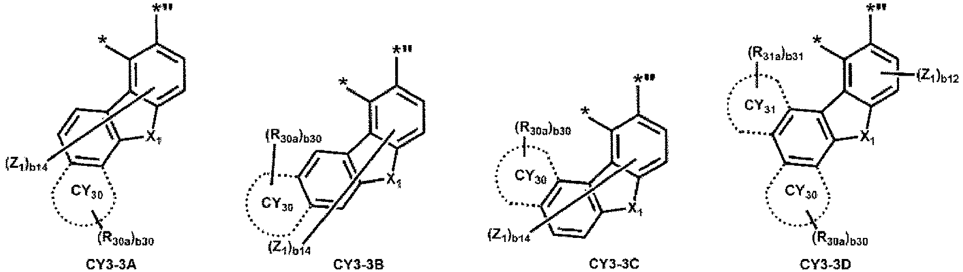 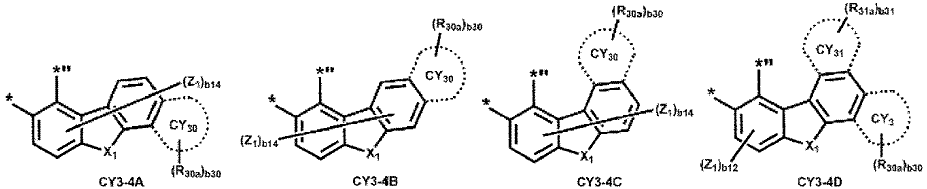 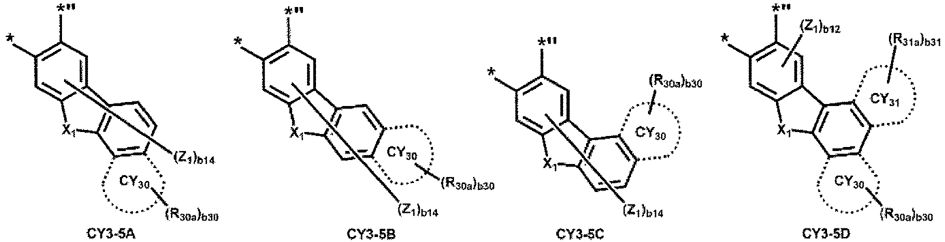 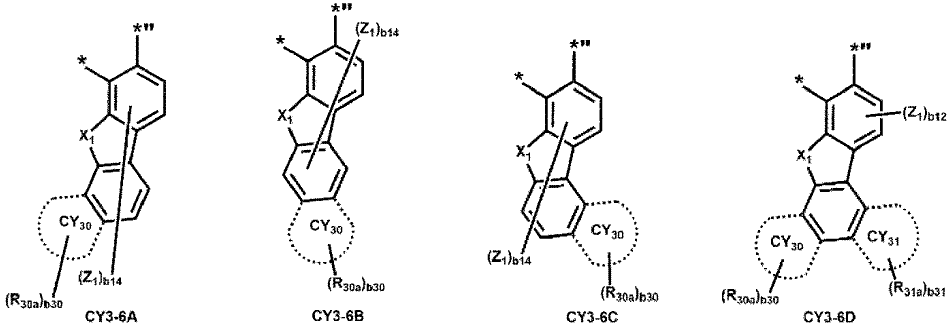 wobei, in Formeln CY3-1A bis CY3-1D, CY3-2A bis CY3-2D, CY3-3A bis CY3-3D, CY3-4A bis CY3-4D, CY3-5A bis CY3-5D und CY3-6A bis CY3-6D,
X₁ und Z₁ die gleichen wie in Anspruch 1 beschrieben sind,
Ring CY₃₀ und Ring CY₃₁ jeweils unabhängig eine C₅-C₃₀-carbocyclische Gruppe oder eine C₁-C₃₀-heterocyclische Gruppe sind,
R₃₀ₐ und R₃₁ₐ sind jeweils die gleichen wie in Verbindung mit R₁₀ₐ in Anspruch 1 beschrieben sind, b12 eine ganze Zahl von 0 bis 2 sein kann, b14 eine ganze Zahl von 0 bis 4 sein kann,
b30 und b31 jeweils unabhängig eine ganze Zahl von 0 bis 20 sein können, wenn b30 2 oder mehr ist, zwei oder mehr R₃₀ₐ(s) zueinander identisch oder voneinander verschieden sein können und, wenn b31 2 oder mehr ist, zwei oder mehr R₃₁ₐ(s) zueinander identisch oder voneinander verschieden sein können,
* eine Bindungsstelle an M in Formel 1 angibt, und
*" eine Bindungsstelle an ein Nachbaratom in Formel 3 angibt.

8. Organometallische Verbindung nach einem der Ansprüche 1-5, wobei eine Gruppe dargestellt durch 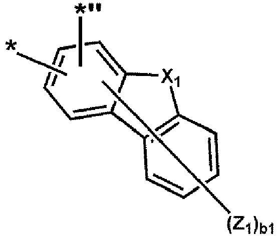 in Formel 3 eine Gruppe dargestellt durch eine der Formeln CY3(1) bis CY3(132) ist: 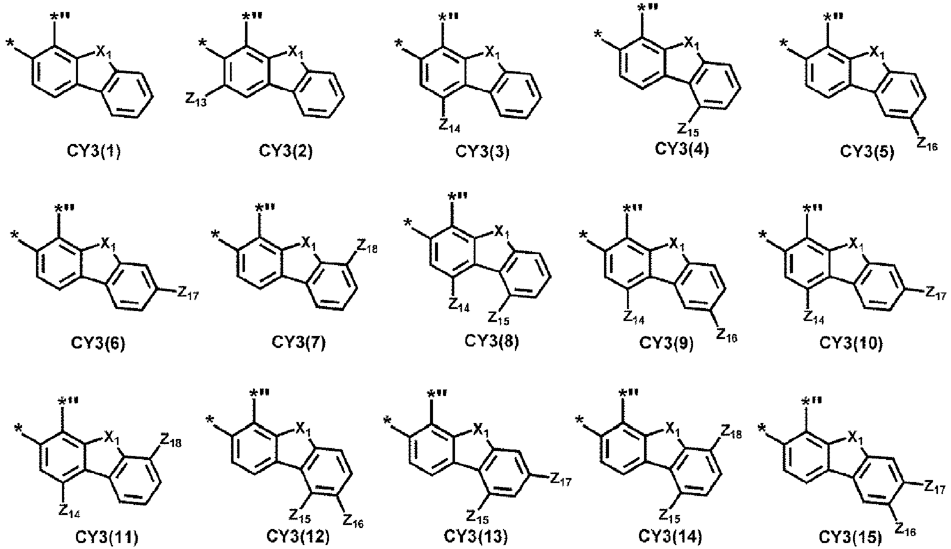 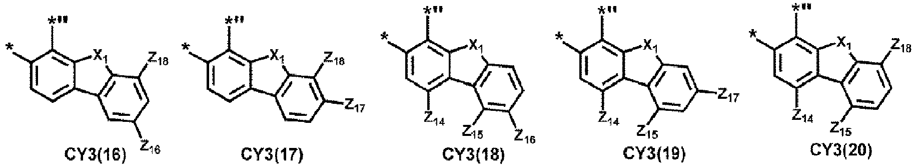 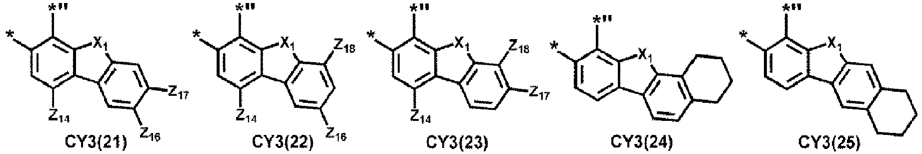 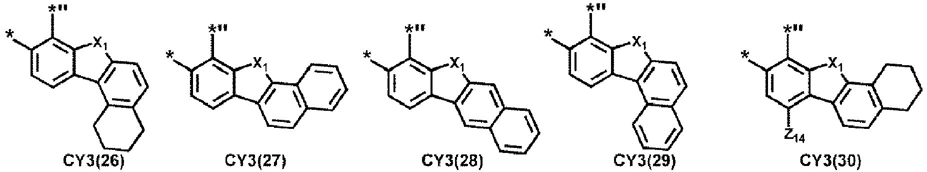 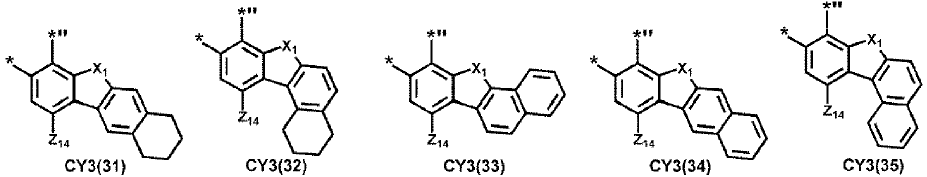 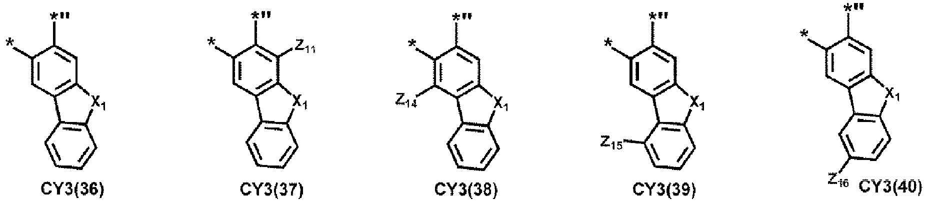 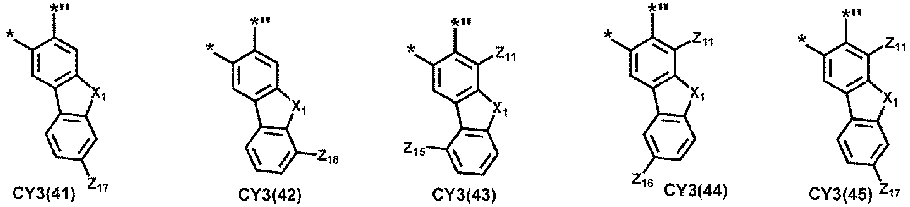 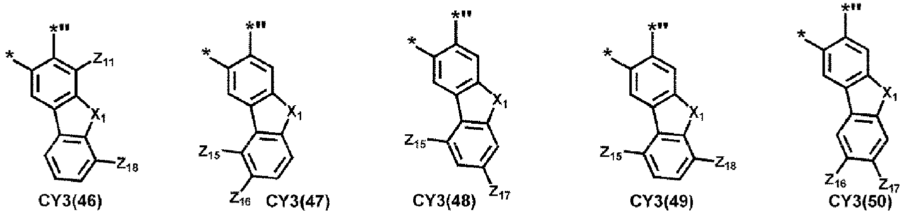 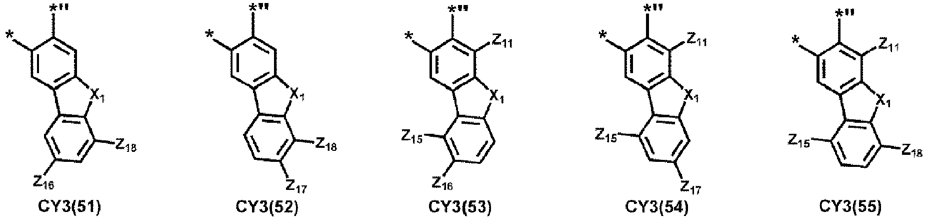 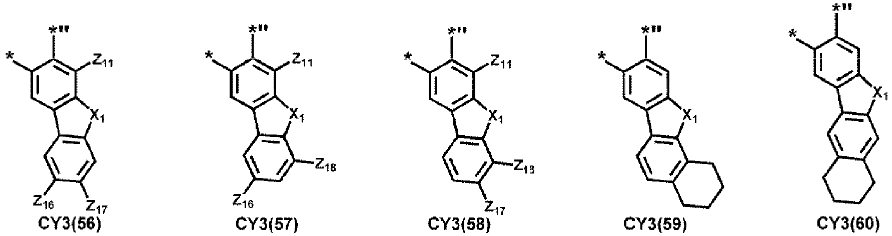 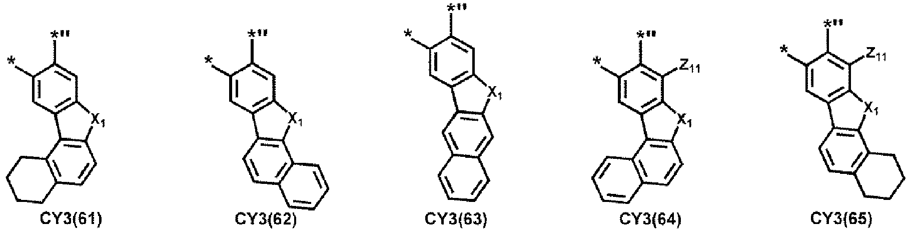 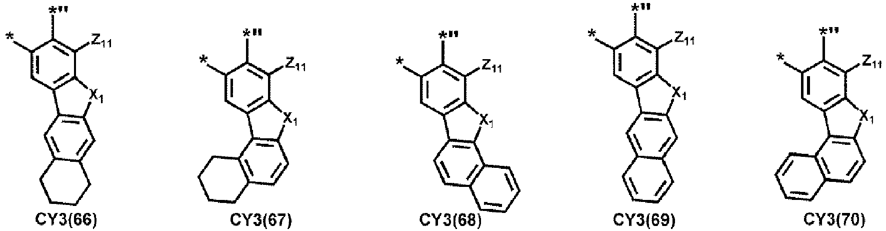 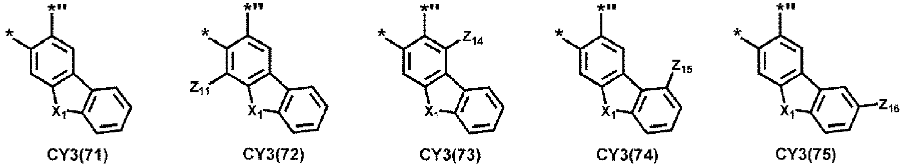 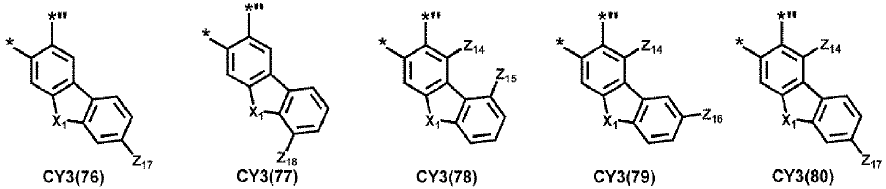 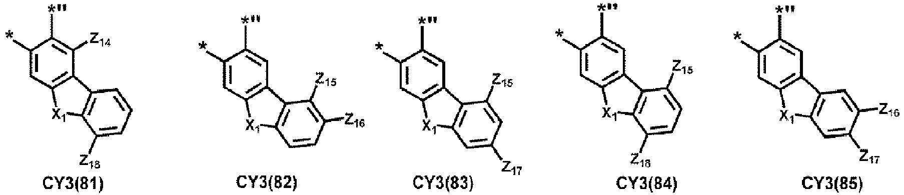 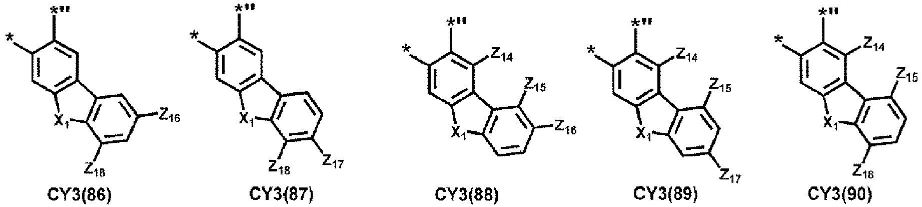 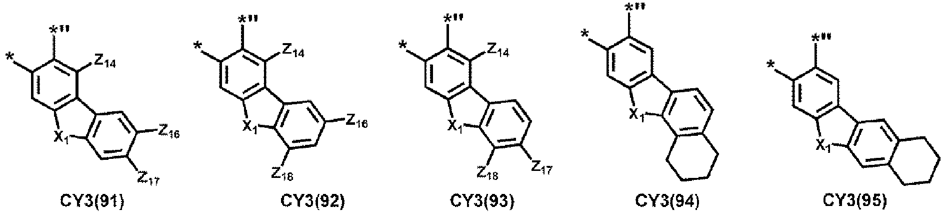 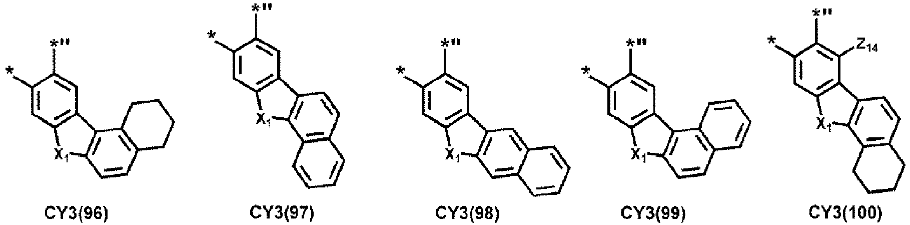 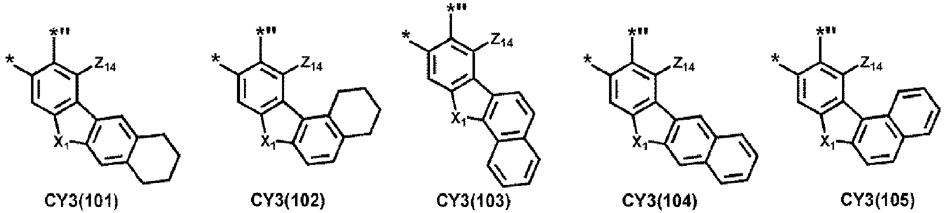 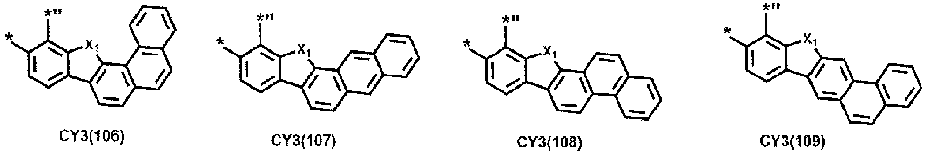 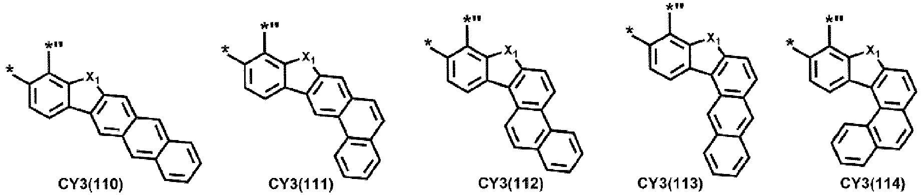 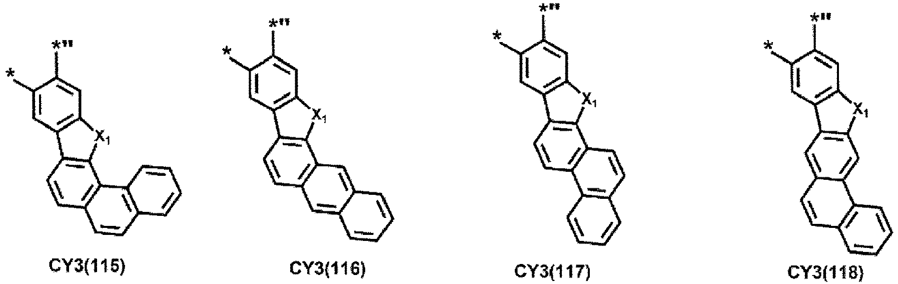 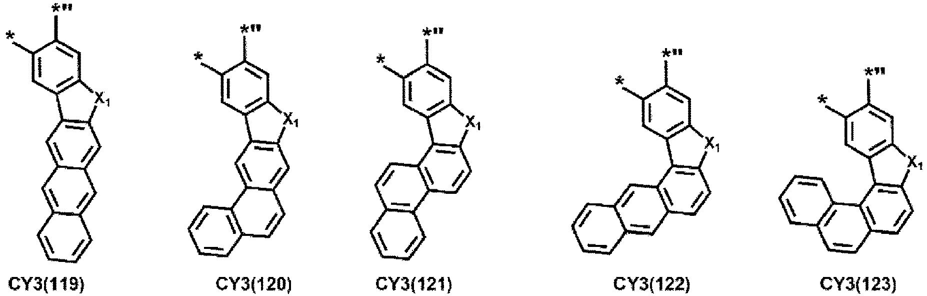 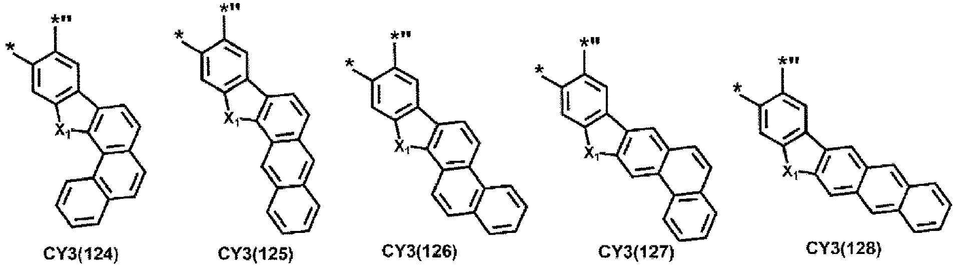 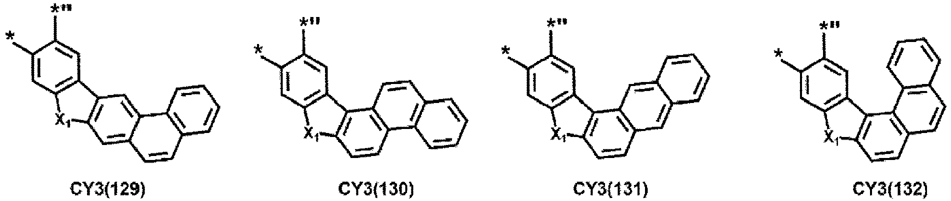 wobei, in Formeln CY3(1) bis CY3(132),
X₁ das gleiche wie in Anspruch 1 beschrieben ist,
Z₁₁ bis Z₁₈ die gleichen wie in Verbindung mit Z₁ in Anspruch 1 beschrieben sind und jedes von Z₁₁ bis Z₁₈ nicht Wasserstoff ist,
* eine Bindungsstelle an M in Formel 1 angibt, und
*" eine Bindungsstelle an ein Nachbaratom in Formel 3 angibt.

9. Organometallische Verbindung nach einem der Ansprüche 1-8, wobei eine Gruppe dargestellt durch 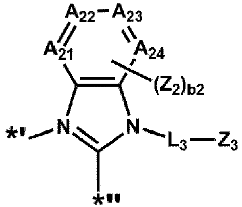 in Formel 3 eine Gruppe dargestellt durch eine der Formeln CY4-1 bis CY4-60 ist: 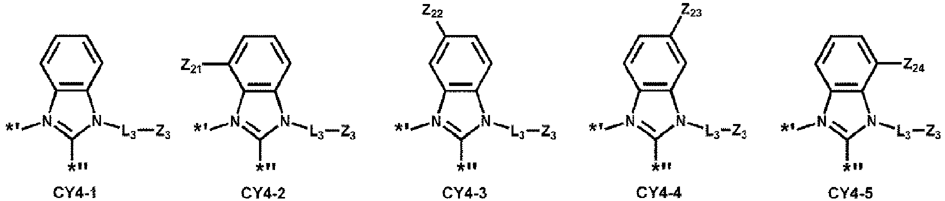 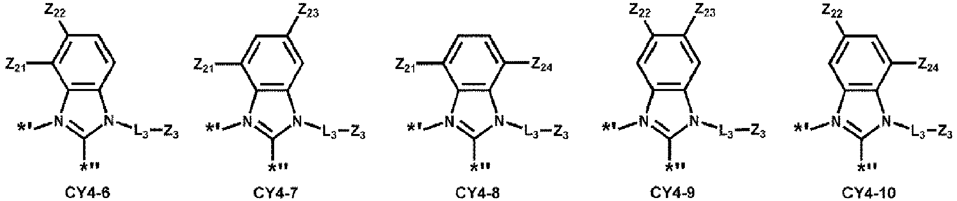 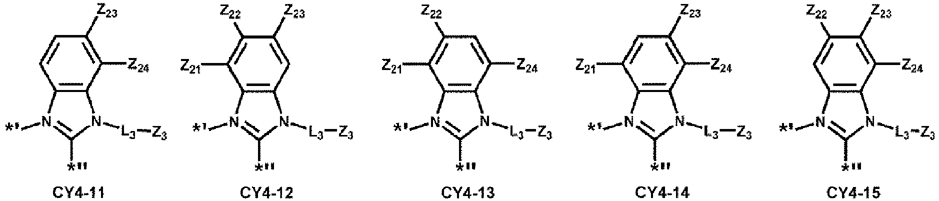 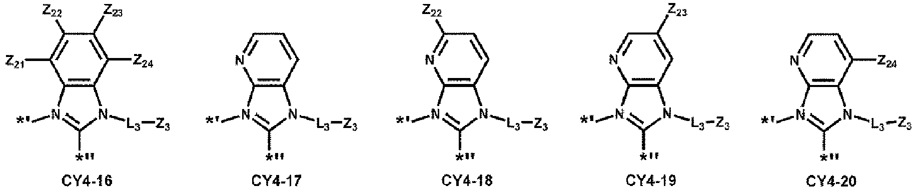 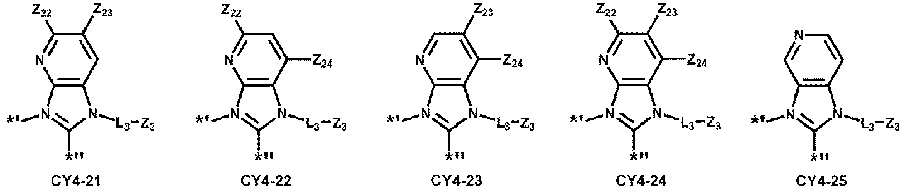 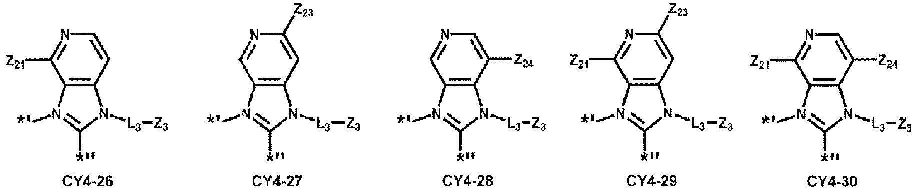 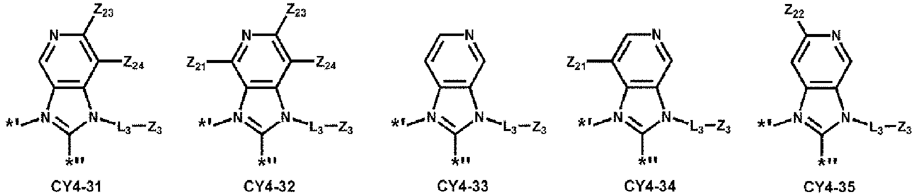 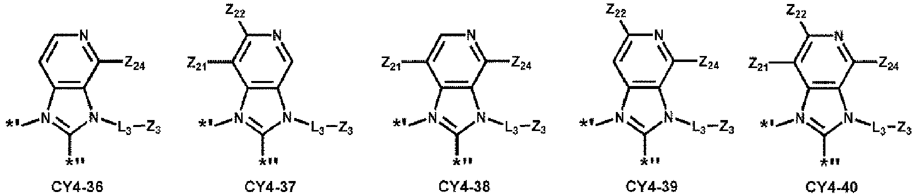 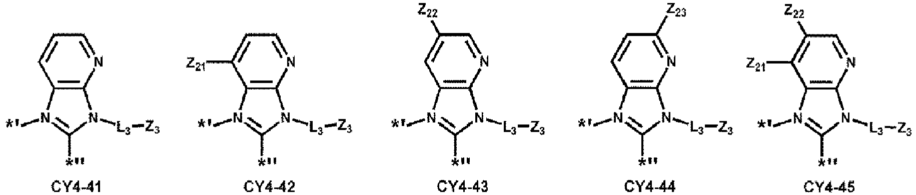 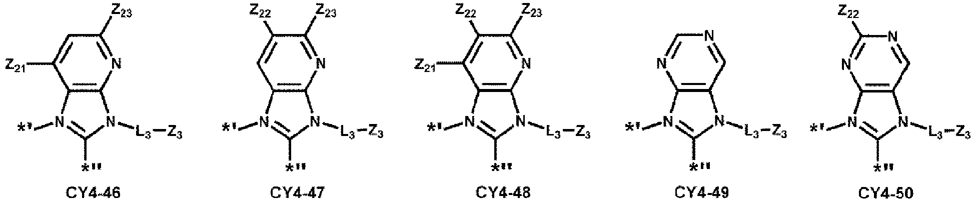 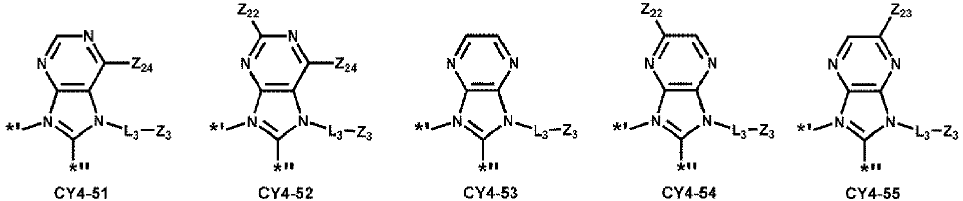 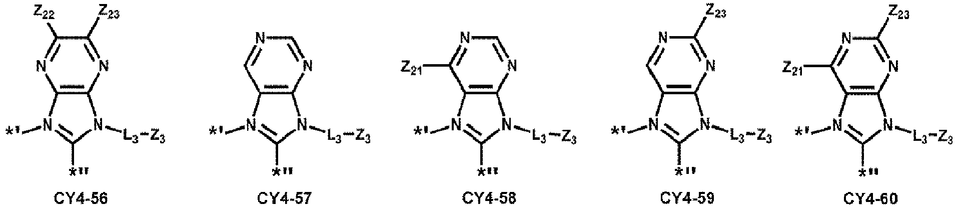 wobei, in Formeln CY4-1 bis CY4-60,
L₃ und Z₃ die gleichen wie in Anspruch 1 beschrieben sind,
Z₂₁ bis Z₂₄ die gleichen wie in Verbindung mit Z₂ in Anspruch 1 beschrieben sind und jedes von Z₂₁ bis Z₂₄ nicht Wasserstoff ist,
*' eine Bindungsstelle an M in Formel 1 angibt und
*" eine Bindungsstelle an ein Nachbaratom in Formel 3 angibt.

10. Organometallische Verbindung nach einem der Ansprüche 1-8, wobei eine Gruppe dargestellt durch 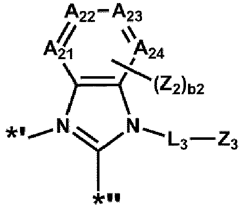 in Formel 3 eine Gruppe dargestellt durch eine der Formeln CY4(1) bis CY4(4) ist: 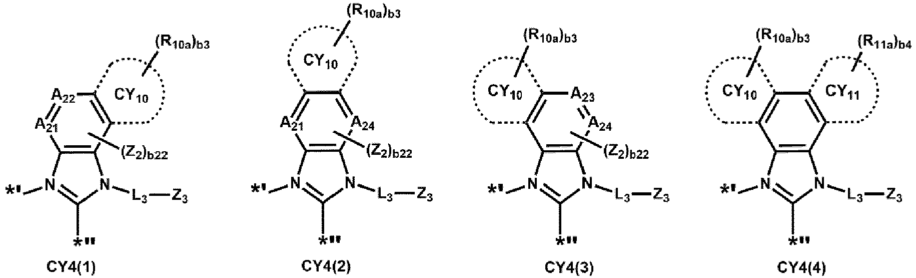 wobei, in Formeln CY4(1) bis CY4(4),
A₂₁ bis A₂₄, L₃, Z₂, Z₃ und R₁₀ₐ die gleichen wie in Anspruch 1 beschrieben sind, b22 eine ganze Zahl von 0 bis 2 ist,
Ring CY₁₀ und Ring CY₁₁ jeweils unabhängig eine C₅-C₃₀-carbocyclische Gruppe oder eine C₁-C₃₀-heterocyclische Gruppe sind,
R₁₁ₐ das gleiche wie in Verbindung mit R₁₀ₐ beschrieben ist,
b3 und b4 sind jeweils unabhängig eine ganze Zahl von 0 bis 20 sind, wenn b3 2 oder mehr ist, zwei oder mehr R₁₀ₐ(s) zueinander identisch oder voneinander verschieden sind und, wenn b4 2 oder mehr ist, zwei oder mehr R₁₁ₐ(s) zueinander identisch oder voneinander verschieden sind,
*' eine Bindungsstelle an M in Formel 1 angibt und
*" eine Bindungsstelle an ein Nachbaratom in Formel 3 angibt.

11. Organometallische Verbindung nach einem der Ansprüche 1-8, wobei eine Gruppe dargestellt durch 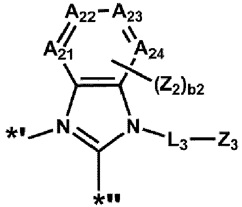 in Formel 3 eine Gruppe dargestellt durch eine der Formeln CY4(1)-1 bis CY4(1)-4, CY4(2)-1 bis CY4(2)-4, CY4(3)-1 bis CY4(3)-4 und CY4(4)-1 ist: 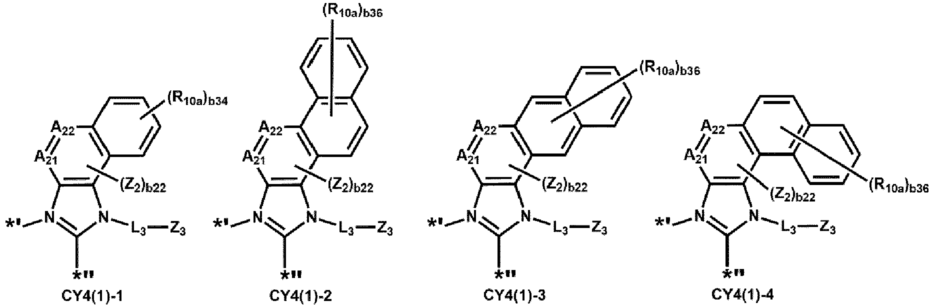 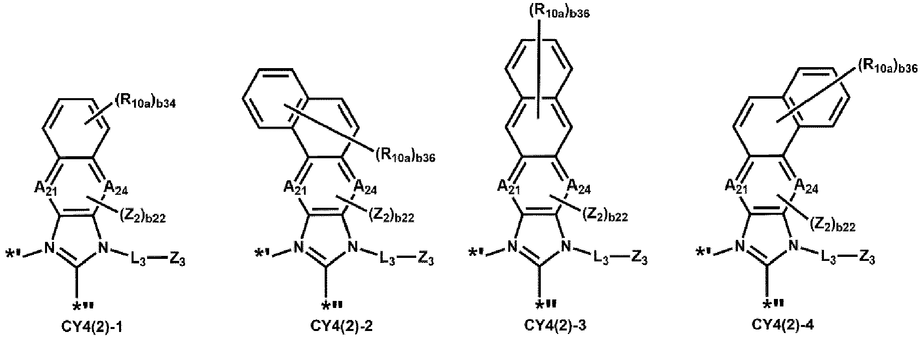 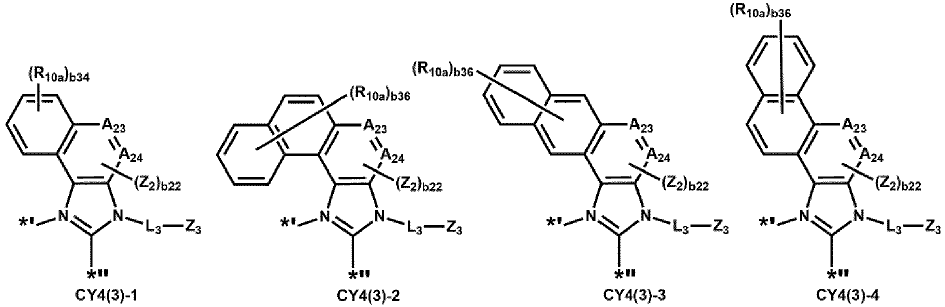 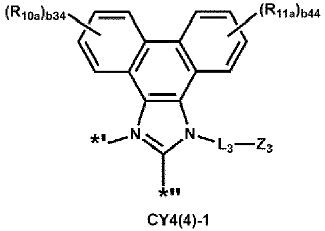 wobei, in Formeln CY4(1)-1 bis CY4(1)-4, CY4(2)-1 bis CY4(2)-4, CY4(3)-1 bis CY4(3)-4 und CY4(4)-1,
A₂₁ bis A₂₄, L₃, Z₂, Z₃ und R₁₀ₐ die gleichen wie in Anspruch 1 beschrieben sind, b22 ist eine ganze Zahl von 0 bis 2 ist,
R₁₁ₐ das gleiche wie in Verbindung mit R₁₀ₐ beschrieben ist,
b34 und b44 jeweils unabhängig eine ganze Zahl von 0 bis 4 sein können, wenn b34 2 oder mehr ist, zwei oder mehr R₁₀ₐ(s) zueinander identisch oder voneinander verschieden sein können und, wenn b44 2 oder mehr ist, zwei oder mehr R₁₁ₐ(s) zueinander identisch oder voneinander verschieden sein können, b36 eine ganze Zahl von 0 bis 6 sein kann, wenn b36 2 oder mehr ist, zwei oder mehr R₁₀ₐ(s) zueinander identisch oder voneinander verschieden sein können,
*' eine Bindungsstelle an M in Formel 1 angibt und
*" eine Bindungsstelle an ein Nachbaratom in Formel 3 angibt.

12. Organische lichtemittierende Vorrichtung, umfassend:
eine erste Elektrode;
eine zweite Elektrode; und
eine organische Schicht, die zwischen der ersten Elektrode und der zweiten Elektrode angeordnet ist und eine Emissionsschicht umfasst,
wobei die organische Schicht mindestens eine der organometallischen Verbindung nach einem der Ansprüche 1-11 umfasst;
bevorzugt, wobei
die erste Elektrode eine Anode ist,
die zweite Elektrode eine Kathode ist,
die organische Schicht einen Lochtransportbereich zwischen der ersten Elektrode und der Emissionsschicht und einen Elektronentransportbereich zwischen der Emissionsschicht und der zweiten Elektrode umfasst,
der Lochtransportbereich eine Lochinjektionsschicht, eine Lochtransportschicht, eine Elektronenblockierschicht, eine Pufferschicht oder eine beliebige Kombination davon umfasst, und
der Elektronentransportbereich eine Lochblockierschicht, eine Elektronentransportschicht, eine Elektroneninjektionsschicht oder eine beliebige Kombination davon umfasst.

13. Organische lichtemittierende Vorrichtung nach Anspruch 12, wobei die organometallische Verbindung in der Emissionsschicht beinhaltet ist.

14. Organische lichtemittierende Vorrichtung nach Anspruch 13, wobei die Emissionsschicht grünes Licht emittiert; und/oder
wobei
die Emissionsschicht ferner einen Wirt umfasst und die Menge des Wirts größer als die Menge der organometallischen Verbindung ist.

15. Elektronische Vorrichtung, umfassend die organische lichtemittierende Vorrichtung nach einem der Ansprüche 12-14.

## Revendications

1. Composé organométallique représenté par la Formule 1 :
<Formule 1> M(L₁)ₙ₁(L₂)ₙ₂
dans lequel, dans la Formule 1,
M est Ir,
L₁ est un ligand représenté par la Formule 2,
L₂ est un ligand représenté par la Formule 3,
n1 est 2 et n2 est 1 ou n1 est 1 et n2 est 2, dans lequel lorsque n1 est 2, deux L₁ sont identiques ou différents l'un de l'autre, et lorsque n2 est 2, deux L₂ sont identiques ou différents l'un de l'autre, 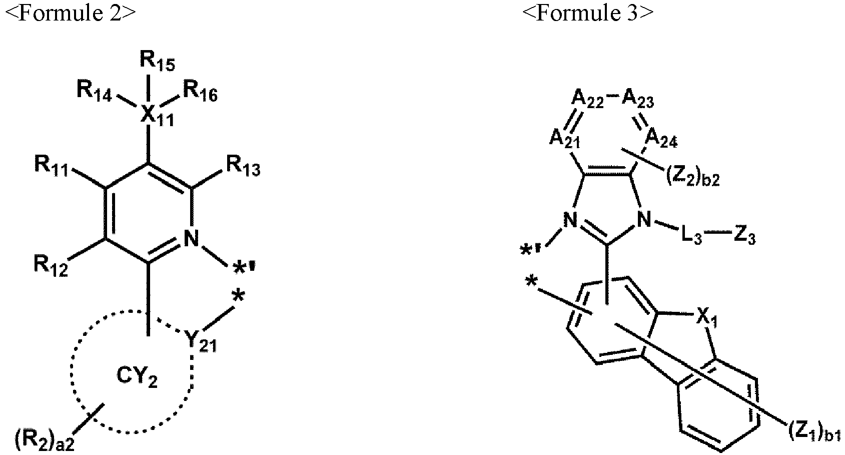 dans lequel, dans les Formules 2 et 3,
Y₂₁ est C ou N,
le cycle CY₂ est un groupe carbocyclique en C₅ à C₃₀ ou un groupe hétérocyclique en C₁ à C₃₀,
X₁₁ est Si ou Ge,
X₁ est O, S, Se, N(Z₁₉), C(Z₁₉)(Z₂₀) ou Si(Z₁₉)(Z₂₀),
A₂₁ à A₂₄ sont chacun indépendamment C ou N,
L₃ est une liaison simple, un groupe carbocyclique en C₅ à C₃₀ non substitué ou substitué par au moins un R₁₀ₐ ou un groupe hétérocyclique en C₁ à C₃₀ non substitué ou substitué par au moins un R₁₀ₐ,
R₂, R₁₁ à R₁₆, Z₁ à Z₃, Z₁₉ et Z₂₀ sont chacun indépendamment l'hydrogène, le deutérium,-F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -Ge(Q₃)(Q₄)(Q₅), -B(Q₆)(Q₇),-P(=O)(Q₈)(Q₉), ou -P(Q₈)(Q₉),
a2 est un nombre entier de 0 à 20, et lorsque a2 vaut 2 ou plus, deux ou plus R₂ sont identiques ou différents l'un de l'autre,
b1 est un nombre entier de 0 à 6, et lorsque b 1 vaut 2 ou plus, deux ou plus Z₁ sont identiques ou différents l'un de l'autre,
b2 est un nombre entier de 0 à 4, et lorsque b2 vaut 2 ou plus, deux ou plus Z₂ sont identiques ou différents l'un de l'autre,
R₁₁ et R₁₂ sont une liaison simple pour former un groupe carbocyclique en C₅ à C₃₀ substitué ou non substitué par au moins un R₁₀ₐ ou un groupe hétérocyclique en C₁ à C₃₀ substitué ou non substitué par au moins un R₁₀ₐ,
deux ou plus d'une pluralité de R₂ sont éventuellement liés l'un à l'autre pour former un groupe carbocyclique en C₅ à C₃₀ substitué ou non substitué par au moins un R₁₀ₐ ou un groupe hétérocyclique en C₁ à C₃₀ substitué ou non substitué par au moins un R₁₀ₐ,
deux ou plus d'une pluralité de Z₁ sont éventuellement liés l'un à l'autre pour former un groupe carbocyclique en C₅ à C₃₀ substitué ou non substitué par au moins un R₁₀ₐ ou un groupe hétérocyclique en C₁ à C₃₀ substitué ou non substitué par au moins un R₁₀ₐ,
deux ou plus d'une pluralité de Z₂ sont éventuellement liés l'un à l'autre pour former un groupe carbocyclique en C₅ à C₃₀ substitué ou non substitué par au moins un R₁₀ₐ ou un groupe hétérocyclique en C₁ à C₃₀ substitué ou non substitué par au moins un R₁₀ₐ,
R₁₀ₐ est le même que celui défini en relation avec Z₁,
* et *' indiquent chacun un site de liaison à M dans la Formule 1, et
un substituant du groupe alkyle en C₁ à ₆₀ substitué, du groupe alcényle en C₂ à C₆₀ substitué, du groupe alcynyle en C₂ à C₆₀ substitué, du groupe alcoxy en C₁ à C₆₀ substitué, du groupe alkylthio en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe aryloxy en C₆ à C₆₀ substitué, du groupe arylthio en C₆ à C₆₀ substitué, du groupe hétéroaryle en C₁ à C₆₀ substitué, du groupe polycyclique condensé non aromatique monovalent substitué et le groupe hétéropolycyclique condensé non aromatique monovalent substitué est :
deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀ ou un groupe alkylthio en C₁ à C₆₀ ;
un groupe alkyle en C₁ à C₆₀, un groupe alcényle en C₂ à C₆₀, un groupe alcynyle en C₂ à C₆₀, un groupe alcoxy en C₁ à C₆₀ ou un groupe alkylthio en C₁ à C₆₀, chacun substitué par le deutérium, -F, -Cl, -Br, -I, -CD₃, - CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇),-P(=O)(Q₁₈)(Q₁₉), -P(Q₁₈)(Q₁₉), ou une combinaison de ceux-ci ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, ou un groupe hétéropolycyclique condensé non aromatique monovalent, chacun substitué ou non substitué par le deutérium, -F, - Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀, un groupe alkylthio en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅),-Ge(Q₂₃)(Q₂₄)(Q₂₅), -B(Q₂₆)(Q₂₇), -P(=O)(Q₂₈)(Q₂₉), -P(Q₂₈)(Q₂₉), ou toute combinaison de ceux-ci ;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉), ou -P(Q₃₈)(Q₃₉) ; ou
toute combinaison de ceux-ci,
dans lequel Q₁ à Q₉, Q₁₁ à Q₁₉, Q₂₁ à Q₂₉ et Q₃₁ à Q₃₉ sont chacun indépendamment l'hydrogène ; le deutérium ; -F ; -Cl ; -Br ; -I ; un groupe hydroxyle ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe alkyle en C₁ à C₆₀, substitué ou non substitué par le deutérium, -F, un groupe alkyle en C₁ à C₆₀, un groupe aryle en C₆ à C₆₀, ou toute combinaison de ceux-ci ; un groupe alcényle en C₂ à C₆₀ ; un groupe alcynyle en C₂ à C₆₀ ; un groupe alcoxy en C₁ à C₆₀ ; un groupe alkylthio en C₁ à C₆; un groupe cycloalkyle en C₃ à C₁₀ ; un groupe hétérocycloalkyle en C₁ à C₁₀ ; un groupe cycloalcényle en C₃ à C₁₀; un groupe hétérocycloalcényle en C₁ à C₁₀ ; un groupe aryle en C₆ à C₆₀, substitué ou non substitué par le deutérium, -F, un groupe alkyle en C₁ à C₆₀, un groupe aryle en C₆ à C₆₀, ou toute combinaison de ceux-ci ; un groupe aryloxy en C₆ à C₆₀ ; un groupe arylthio en C₆ à C₆₀ ; un groupe hétéroaryle en C₁ à C₆₀; un groupe polycyclique condensé non aromatique monovalent ; ou un groupe hétéropolycyclique condensé non aromatique monovalent.

2. Composé organométallique selon la revendication 1, dans lequel
le cycle CY₂ est un groupe benzène, un groupe naphtalène, un groupe anthracène, un groupe phénanthrène, un groupe 1,2,3,4-tétrahydronaphtalène, un groupe carbazole, un groupe fluorène, un groupe dibenzosilole, un groupe dibenzothiophène ou un groupe dibenzofurane ; et/ou dans lequel L₃ dans la Formule 1 représente : une simple liaison, ou
un groupe benzène, un groupe naphtalène, un groupe dibenzofurane ou un groupe dibenzothiophène, chacun non substitué ou substitué par le deutérium, -F, un groupe cyano, un groupe alkyle en C₁ à C₂₀, un groupe alkyle en C₁ à C₂₀ deutéré, un groupe alkyle en C₁ à C₂₀, fluoré, un groupe cycloalkyle en C₃ à C₁₀, un groupe cycloalkyle en C₃ à C₁₀ deutéré, un groupe cycloalkyle en C₃ à C₁₀ fluoré, un groupe cycloalkyle en C₃ à C₁₀ (alkyle en C₁ à C₂₀), un groupe phényle, un groupe phényle deutéré, un groupe phényle fluoré, un groupe phényle (alkyle en C₁ à C₂₀), un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, ou toute combinaison de ceux-ci.

3. Composé organométallique selon les revendications 1 ou 2, dans lequel
R₂, R₁₁ à R₁₃, Z₁ à Z₃, Z₁₉ et Z₂₀ dans les Formules 2 et 3 sont chacun indépendamment :
l'hydrogène, le deutérium, -F ou un groupe cyano ; ou
un groupe alkyle en C₁ à C₂₀, un groupe cycloalkyle en C₃ à C₁₀, un groupe phényle, un groupe naphtyle, un groupe pyridinyle, un groupe furanyle, un groupe thiophényle, un groupe benzofuranyle, un groupe benzothiophényle, un groupe dibenzofuranyle ou un groupe dibenzothiophényle, chacun non substitué ou substitué par deutérium, -F, un groupe cyano, un groupe alkyle en C₁ à C₂₀, un groupe alkyle en C₁ à C₂₀ deutéré, un groupe alkyle en C₁ à C₂₀ fluoré, un groupe cycloalkyle en C₃ à C₁₀, un groupe cycloalkyle en C₃ à C₁₀ deutéré, un groupe cycloalkyle en C₃ à C₁₀ fluoré, un groupe cycloalkyle en C₃ à C₁₀ (alkyle en C₁ à C₂₀), un groupe phényle, un groupe phényle deutéré, un groupe phényle fluoré, un groupe phényle (alkyle en C₁ à C₂₀), un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, -Si(Q₃₃)(Q₃₄)(Q₃₅), -Ge(Q₃₃)(Q₃₄)(Q₃₅), ou toute combinaison de ceux-ci, et
R₁₄ à R₁₆ dans la Formule 2 représentent chacun indépendamment un groupe alkyle en C₁ à C₂₀, un groupe cycloalkyle en C₃ à C₁₀, un groupe phényle, un groupe naphtyle, un groupe pyridinyle, un groupe furanyle, un groupe thiophényle, un groupe benzofuranyle, un groupe benzothiophényle, un groupe dibenzofuranyle ou un groupe dibenzothiophényle, chacun non substitué ou substitué par le deutérium, -F, un groupe cyano, un groupe alkyle en C₁ à C₂₀, un groupe alkyle en C₁ à C₂₀ deutéré, un groupe alkyle en C₁ à C₂₀ fluoré, un groupe cycloalkyle en C₃ à C₁₀, un groupe cycloalkyle en C₃ à C₁₀ deutéré, un groupe cycloalkyle en C₃ à C₁₀ fluoré, un groupe cycloalkyle en C₃ à C₁₀ (alkyle en C₁ à C₂₀), un groupe phényle, un groupe phényle deutéré, un groupe phényle fluoré, un groupe phényle (alkyle en C₁ à C₂₀), un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, ou toute combinaison de ceux-ci.

4. Composé organométallique selon l'une quelconque des revendications 1 à 3, dans lequel R₁₁ n'est pas un hydrogène ; et/ou
dans lequel le composé satisfait à au moins l'une des <Condition A> et <Condition B> :
<Condition A>
L₃ est un groupe carbocyclique en C₅ à C₃₀ substitué ou non substitué par au moins un R₁₀ₐ ou un groupe hétérocyclique en C₁ à C₃₀ substitué ou non substitué par au moins un R₁₀ₐ,
<Condition B>
Z₃ est un groupe aryle en C₆ à C₆₀ substitué ou non substitué, un groupe hétéroaryle en C₁ à C₆₀ substitué ou non substitué, un groupe polycyclique condensé non aromatique monovalent substitué ou non substitué, ou un groupe hétéropolycyclique condensé non aromatique monovalent substitué ou non substitué ; et/ou dans lequel
Z₁ n'est pas un hydrogène et b1 est un nombre entier de 1 à 6.

5. Composé organométallique selon l'une quelconque des revendications 1 à 4, dans lequel un groupe représenté par 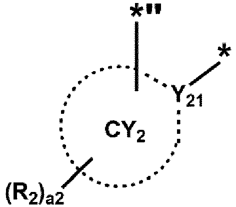 dans la Formule 2 est un groupe représenté par l'une des Formules CY2-1 à CY2-33 : 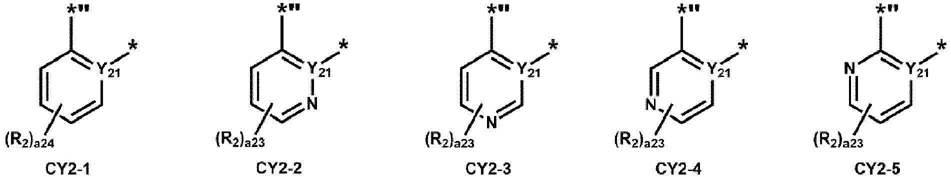 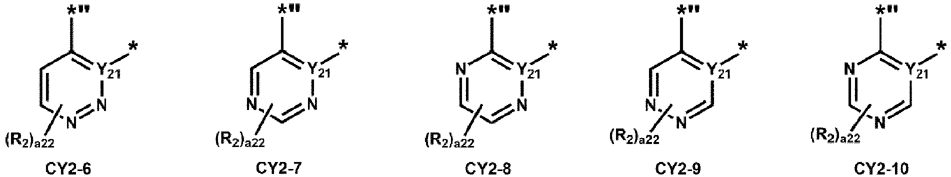 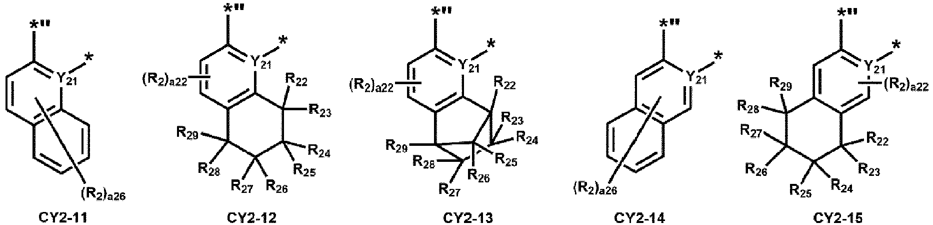 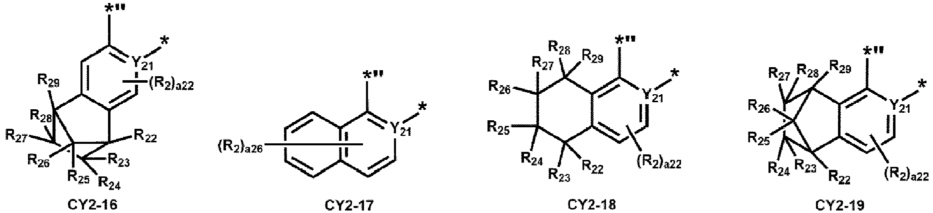 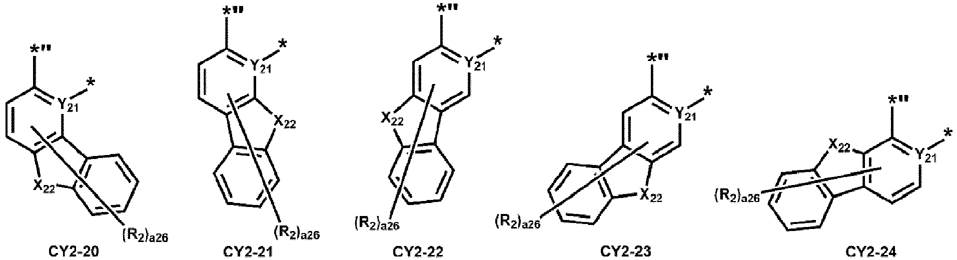 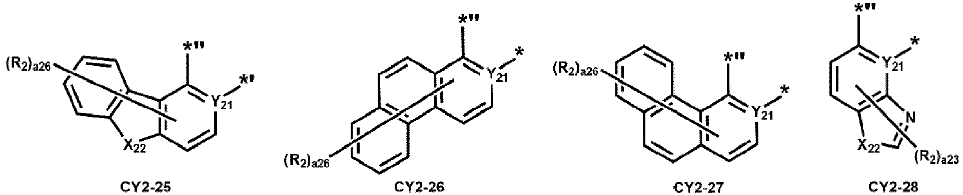 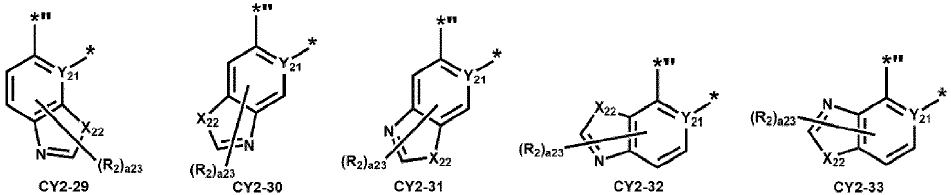 dans lequel dans les Formules CY2-1 à CY2-33,
Y₂₁ et R₂ sont identiques à ceux décrits dans la revendication 1,
X₂₂ est C(R₂₂)(R₂₃), N(R₂₂), O, S, ou Si(R₂₂)(R₂₃),
R₂₂ à R₂₉ sont les mêmes que ceux décrits en relation avec R₂ dans la revendication 1,
a28 est un nombre entier allant de 0 à 8,
a26 est un nombre entier allant de 0 à 6,
a24 est un nombre entier allant de 0 à 4,
a23 est un nombre entier allant de 0 à 3,
a22 est un nombre entier allant de 0 à 2,
*" indique un site de liaison à un atome voisin dans la Formule 2, et * indique un site de liaison à M dans la Formule 1.

6. Composé organométallique selon l'une quelconque des revendications 1 à 5, dans lequel un groupe représenté par 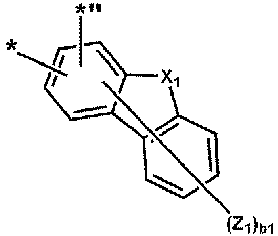 dans la Formule 3 est un groupe représenté par l'une des Formules CY3-1 à CY3-6 : 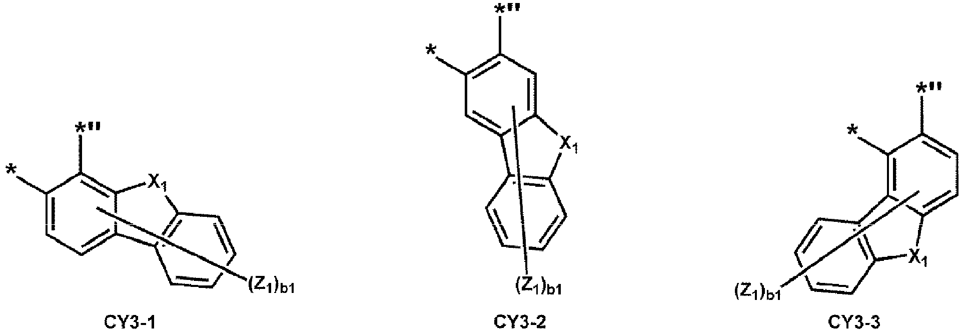 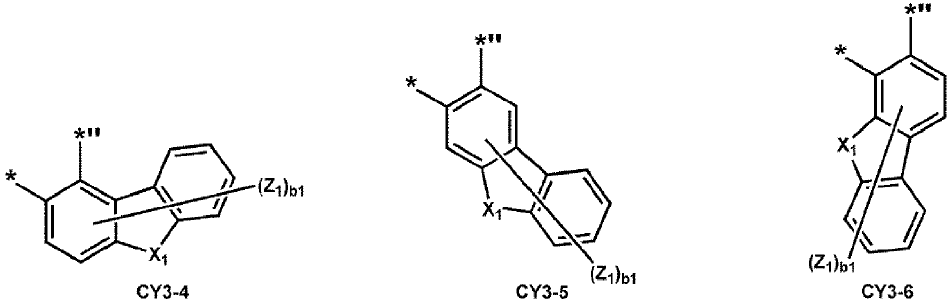 dans lequel dans les Formules CY3-1 à CY3-6,
X₁, Z₁, et b1 sont identiques à ceux décrits dans la revendication 1,
* indique un site de liaison à M dans la Formule 1, et
*" indique un site de liaison à un atome voisin dans la Formule 3.

7. Composé organométallique selon l'une quelconque des revendications 1 à 5, dans lequel un groupe représenté par 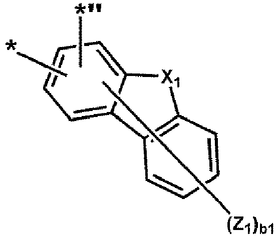 dans la Formule 3 est un groupe représenté par l'une des Formules CY3-1A à CY3-1D, CY3-2A à CY3-2D, CY3-3A à CY3-3D, CY3-4A à CY3-4D, CY3-5A à CY3-5D et CY3-6A à CY3-6D : 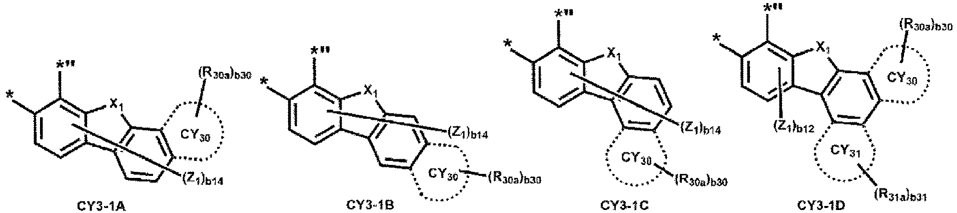 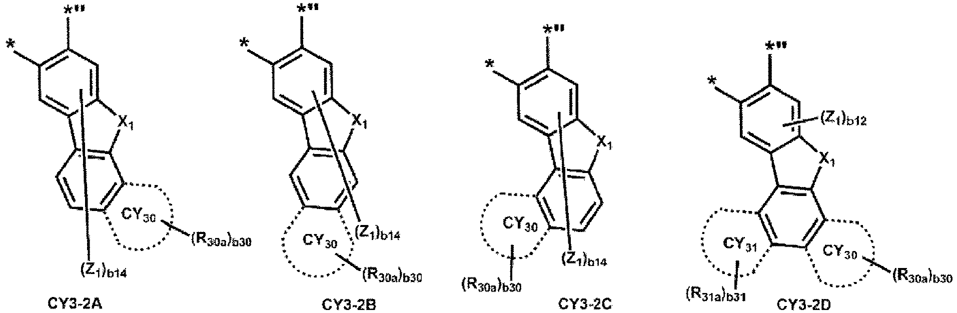 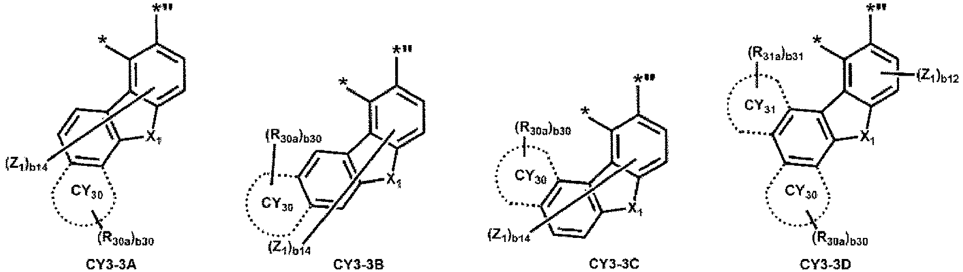 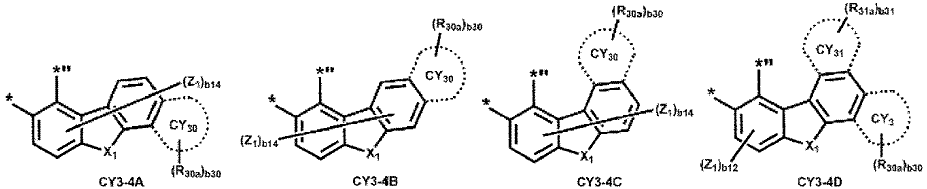 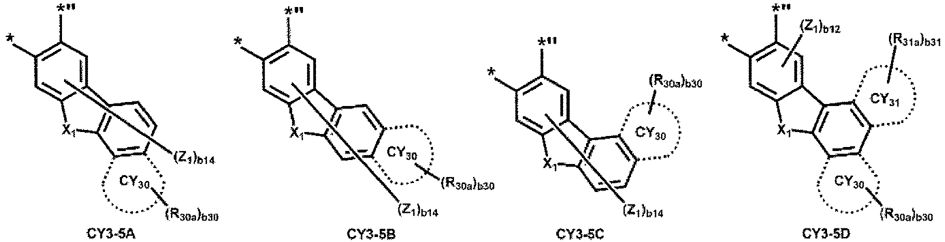 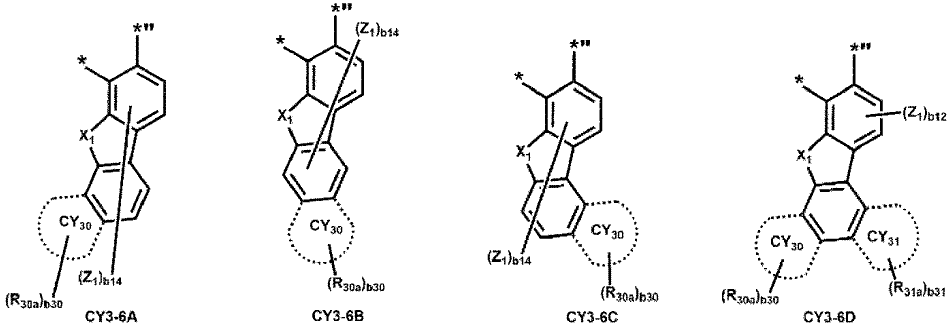 dans lequel, dans les Formules CY3-1A à CY3-1D, CY3-2A à CY3-2D, CY3-3A à CY3-3D, CY3-4A à CY3-4D, CY3-5A à CY3-5D et CY3-6A à CY3 -6D,
X₁ et Z₁ sont identiques à ceux décrits dans la revendication 1,
le cycle CY₃₀ et le cycle CY₃₁ sont chacun indépendamment un groupe carbocyclique en C₅ à C₃₀ ou un groupe hétérocyclique en C₁ à C₃₀,
R₃₀ₐ et R₃₁ₐ sont chacun identiques à ceux décrits en relation avec R₁₀ₐ dans la revendication 1, b12 peut être un nombre entier de 0 à 2, b14 peut être un nombre entier de 0 à 4,
b30 et b31 peuvent chacun indépendamment être un nombre entier de 0 à 20, lorsque b30 vaut 2 ou plus, deux ou plus R₃₀ₐ peuvent être identiques ou différents l'un de l'autre, et lorsque b31 est 2 ou plus, deux ou plusieurs R₃₁ₐ peuvent être identiques ou différents l'un de l'autre,
* indique un site de liaison à M dans la Formule 1, et
*" indique un site de liaison à un atome voisin dans la Formule 3.

8. Composé organométallique selon l'une quelconque des revendications 1 à 5, dans lequel un groupe représenté par 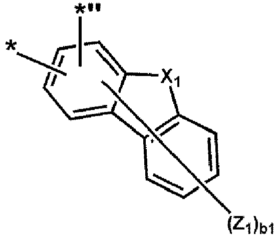 dans la Formule 3 est un groupe représenté par l'une des Formules CY3(1) à CY3(132) : 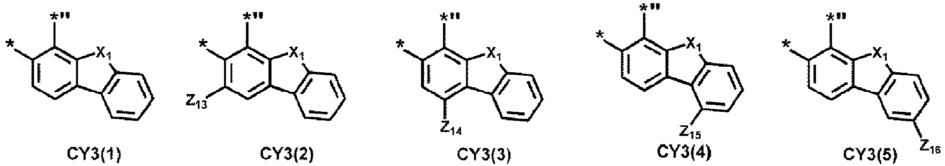 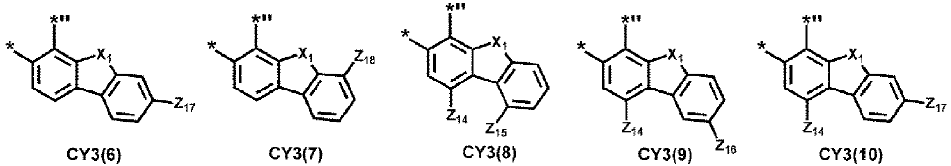 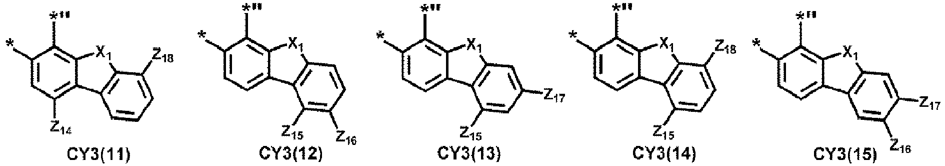 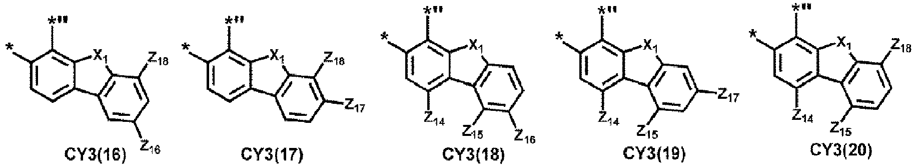 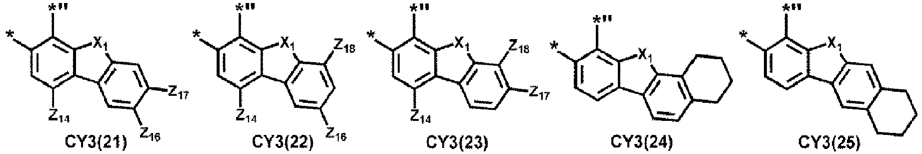 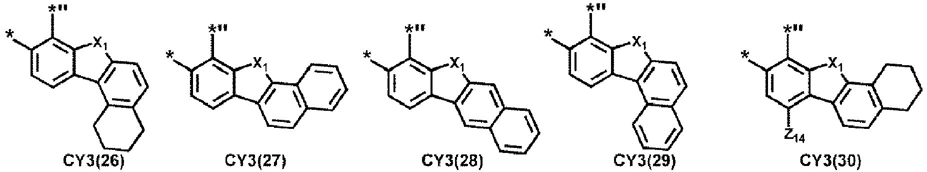 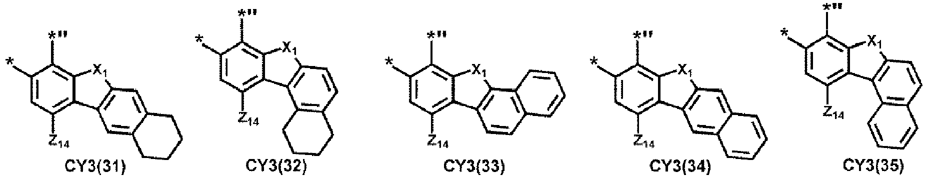 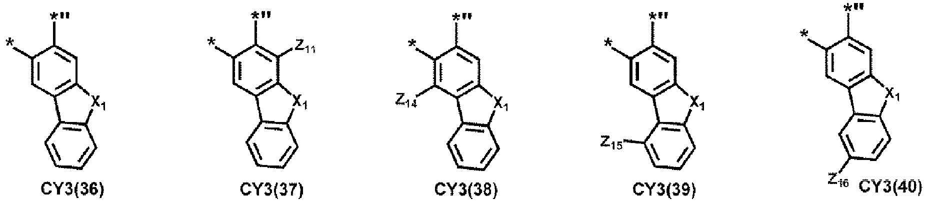 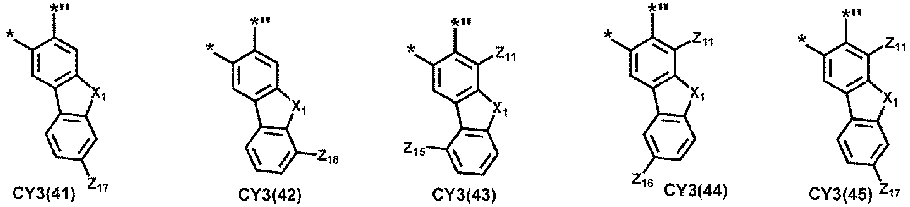 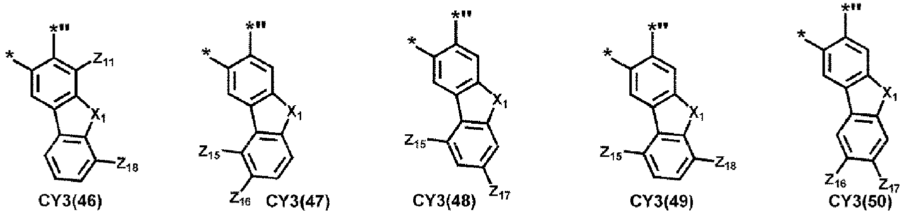 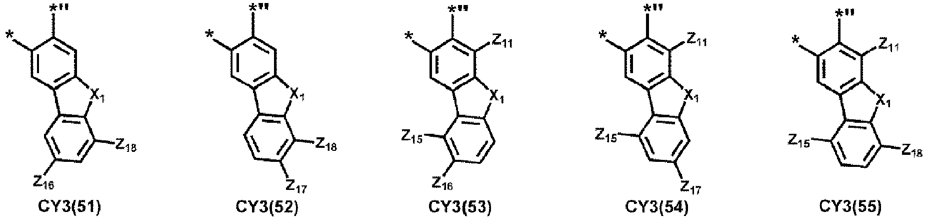 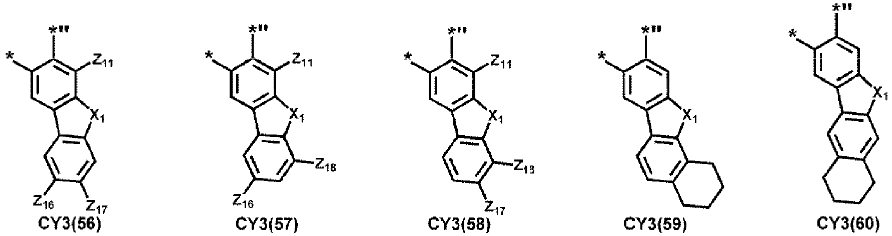 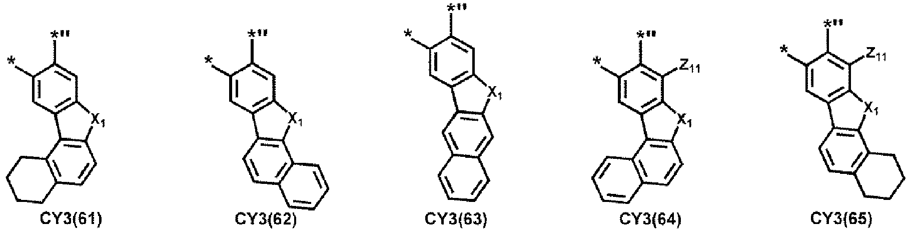 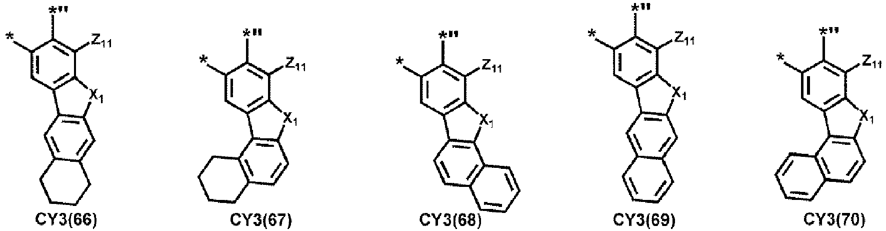 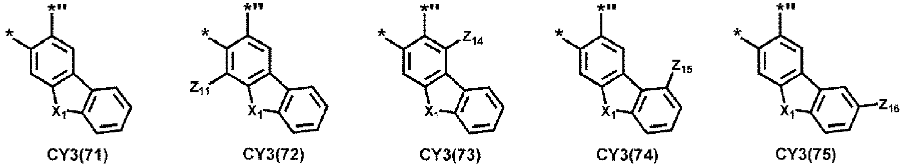 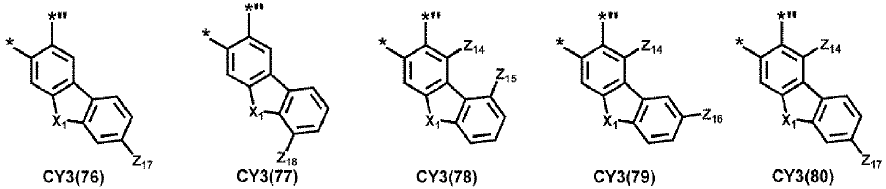 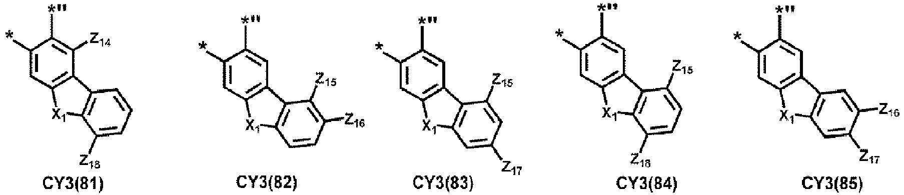 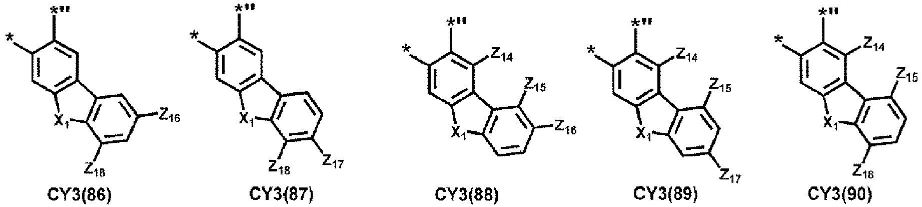 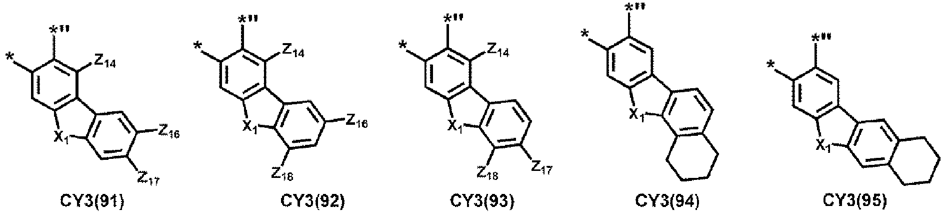 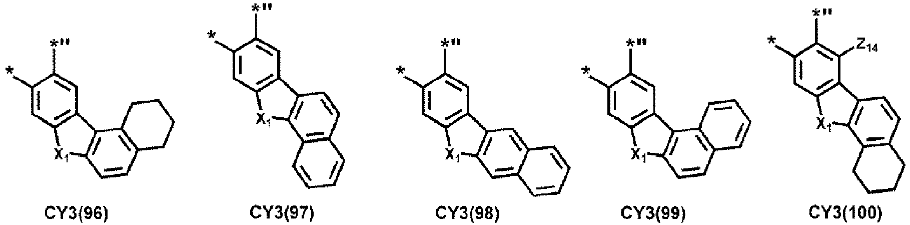 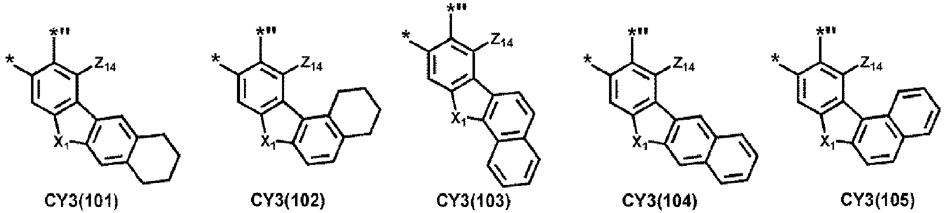 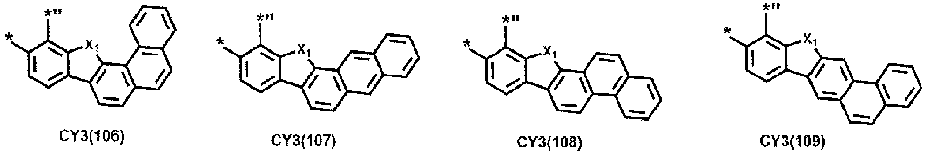 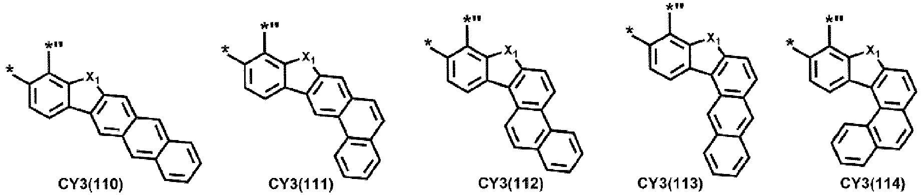 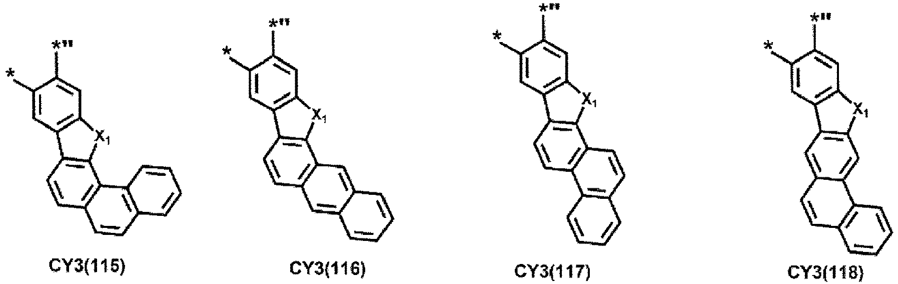 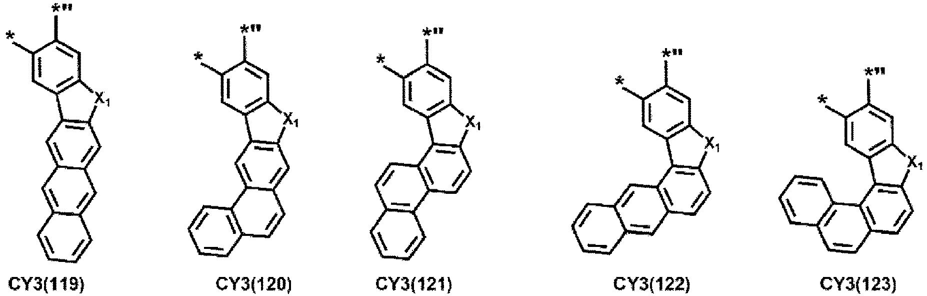 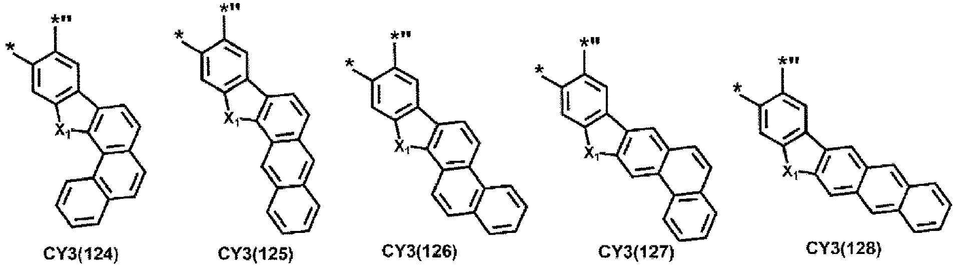 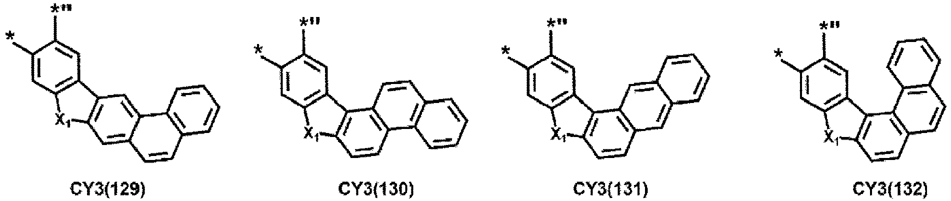 dans lequel, dans les Formules CY3(1) à CY3(132),
X₁ est le même que celui décrit dans la revendication 1,
Z₁₁ à Z₁₈ sont les mêmes que ceux décrits en relation avec Z₁ dans la revendication 1, et chacun de Z₁₁ à Z₁₈ n'est pas un hydrogène,
* indique un site de liaison à M dans la Formule 1, et
*" indique un site de liaison à un atome voisin dans la Formule 3.

9. Composé organométallique selon l'une quelconque des revendications 1 à 8, dans lequel un groupe représenté par 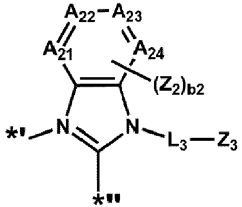 dans la Formule 3 est un groupe représenté par l'une des Formules CY4-1 à CY4-60 : 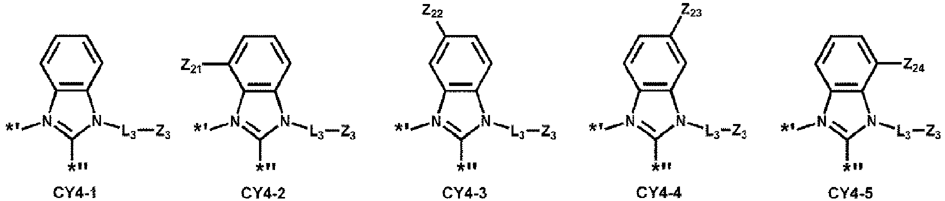 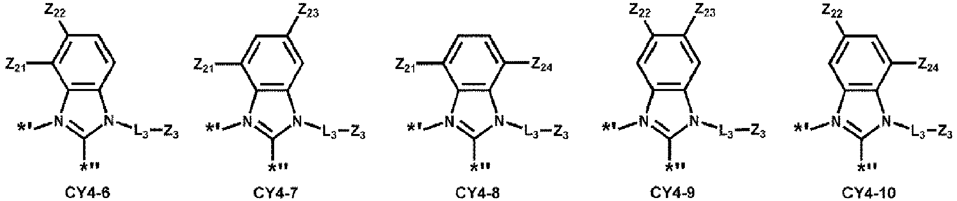 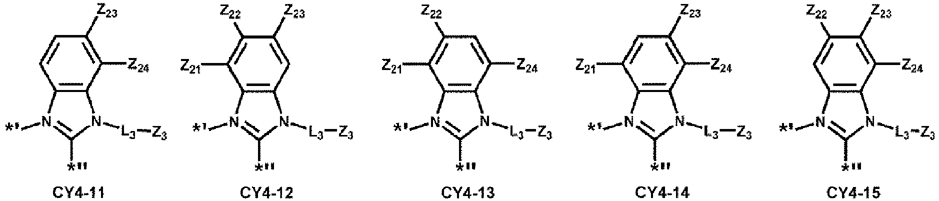 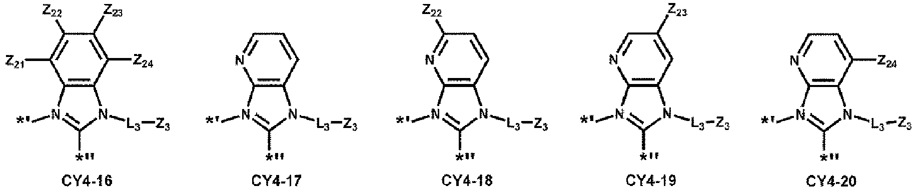 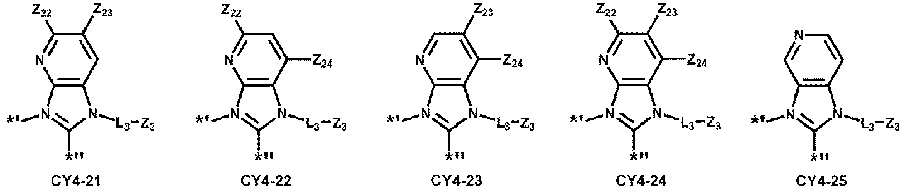 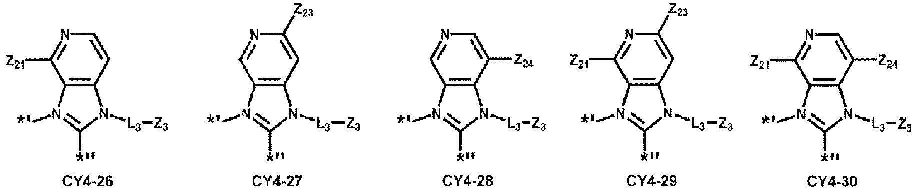 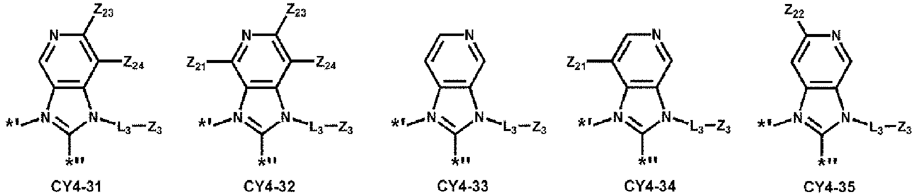 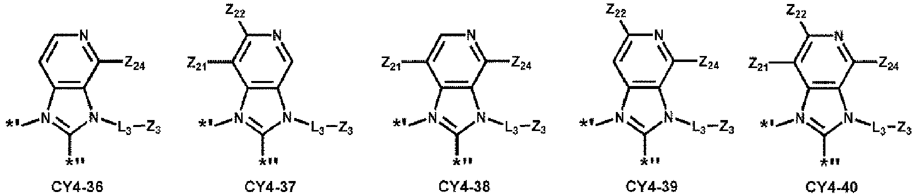 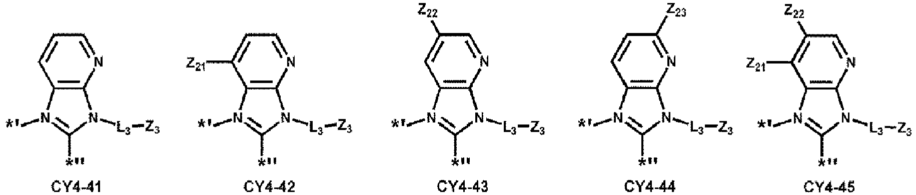 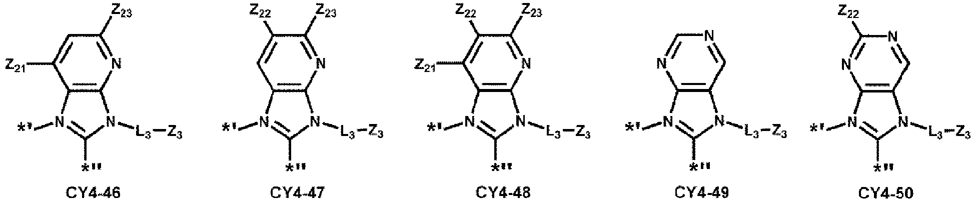 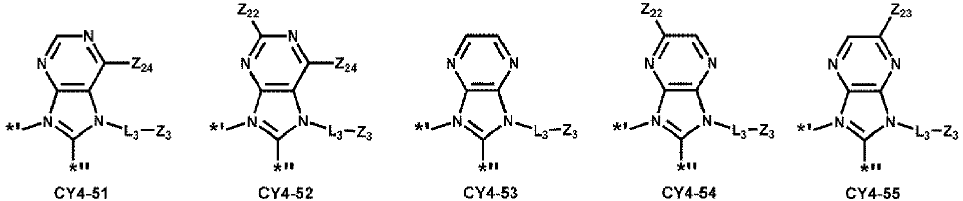 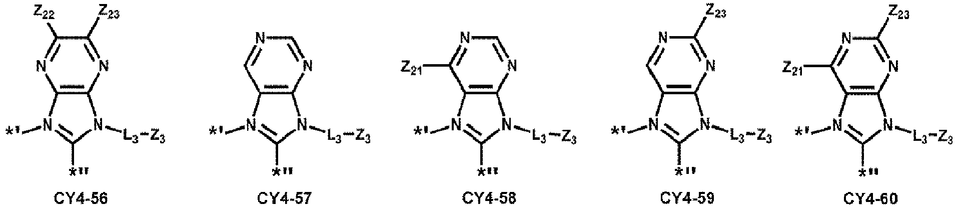 dans lequel dans les Formules CY4-1 à CY4-60,
L₃ et Z₃ sont identiques à ceux décrits dans la revendication 1,
Z₂₁ à Z₂₄ sont les mêmes que ceux décrits en relation avec Z₂ dans la revendication 1, et chacun de Z₂₁ à Z₂₄ n'est pas un hydrogène,
*' indique un site de liaison à M dans la Formule 1, et
*"indique un site de liaison à un atome voisin dans la Formule 3.

10. Composé organométallique selon l'une quelconque des revendications 1 à 8, dans lequel un groupe représenté par 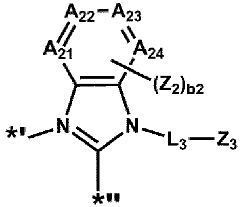 dans la Formule 3 est un groupe représenté par l'une des Formules CY4(1) à CY4(4) : 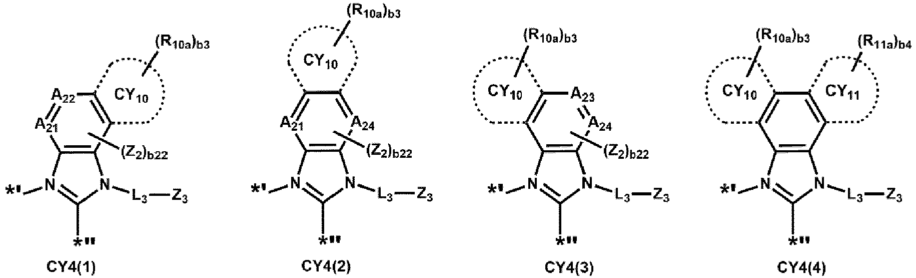 dans lequel dans les Formules CY4-1 à CY4-4,
A₂₁ à A₂₄, L₃, Z₂, Z₃ et R₁₀ₐ sont identiques à ceux décrits dans la revendication 1, b22 est un nombre entier de 0 à 2,
le cycle CY₁₀ et le cycle CY₁₁ sont chacun indépendamment un groupe carbocyclique en C₅ à C₃₀ ou un groupe hétérocyclique en C₁ à C₃₀,
R₁₁ₐ est le même que celui décrit en relation avec R₁₀ₐ,
b3 et b4 sont chacun indépendamment un nombre entier de 0 à 20, lorsque b3 vaut 2 ou plus, deux ou plusieurs R₁₀ₐ sont identiques ou différents les uns des autres, et lorsque b4 vaut 2 ou plus, deux ou plus R₁₁ₐ sont identiques ou différents les uns des autres,
*' indique un site de liaison à M dans la Formule 1, et
*" indique un site de liaison à un atome voisin dans la Formule 3.

11. Composé organométallique selon l'une quelconque des revendications 1 à 8, dans lequel un groupe représenté par 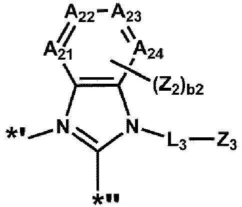 dans la Formule 3 est un groupe représenté par l'une des Formules CY4(1)-1 à CY4(1)-4, CY4(2)-1 à CY4(2)-4, CY4(3)-1 à CY4(3)-4 et CY4(4)-1 : 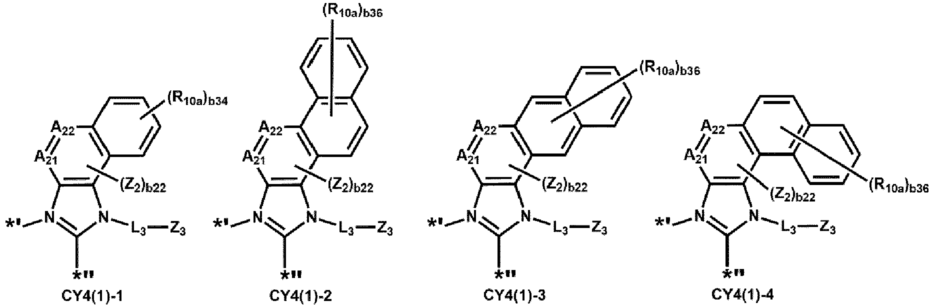 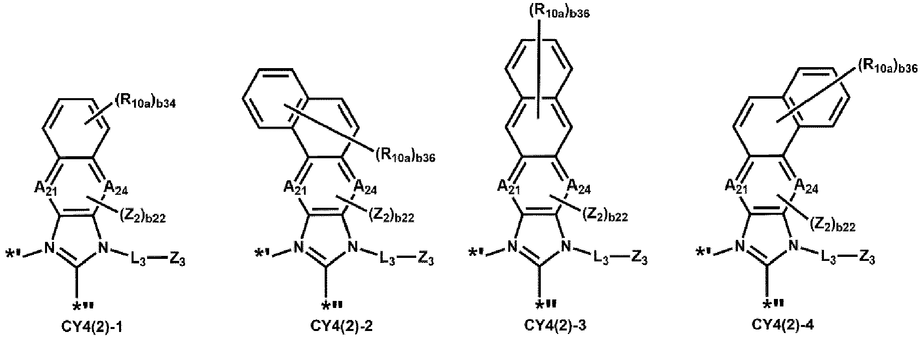 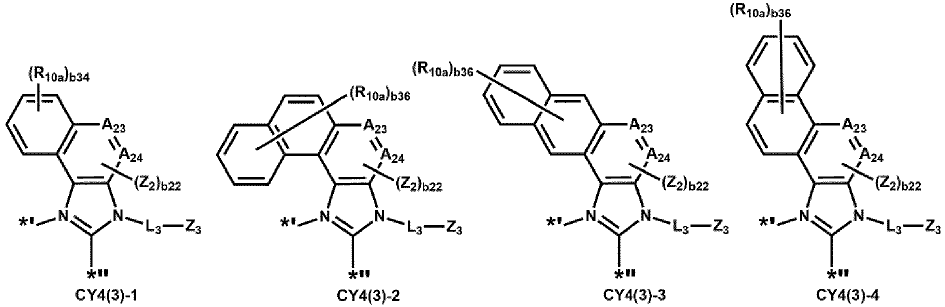 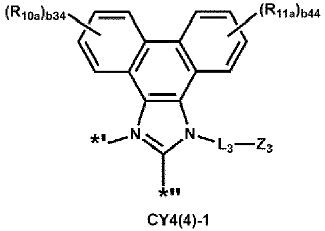 dans lequel, dans les Formules CY4(1)-1 à CY4(1)-4, CY4(2)-1 à CY4(2)-4, CY4(3)-1 à CY4(3)-4 et CY4(4)-1,
A₂₁ à A₂₄, L₃, Z₂, Z₃ et R₁₀ₐ sont identiques à ceux décrits dans la revendication 1,
b22 est un nombre entier de 0 à 2,
R₁₁ₐ est le même que celui décrit en relation avec R₁₀ₐ,
b34 et b44 peuvent chacun indépendamment être un nombre entier de 0 à 4, lorsque b34 vaut 2 ou plus, deux R₁₀ₐ ou plus peuvent être identiques ou différents les uns des autres, et lorsque b44 vaut 2 ou plus, deux ou plus R₁₁ₐ peuvent être identiques ou différents les uns des autres,
b36 peut être un nombre entier de 0 à 6, lorsque b36 vaut 2 ou plus, deux ou plus R₁₀ₐ peuvent être identiques ou différents les uns des autres,
*' indique un site de liaison à M dans la Formule 1, et
*" indique un site de liaison à un atome voisin dans la Formule 3.

12. Dispositif électroluminescent, comprenant :
une première électrode ;
une seconde électrode ; et
une couche organique disposée entre la première électrode et la seconde électrode et comprenant une couche d'émission,
dans lequel la couche organique comprend au moins l'un du composé organométallique selon l'une quelconque des revendications 1 à 11 ;
de préférence dans lequel
la première électrode est une anode,
la seconde électrode est une cathode,
la couche organique comprend une région de transport de trous disposée entre la première électrode et la couche d'émission et une région de transport d'électrons disposée entre la couche d'émission et la seconde électrode,
la région de transport de trous comprend une couche d'injection de trous, une couche de transport de trous, une couche de blocage d'électrons, une couche tampon, ou une combinaison de celles-ci, et
la région de transport d'électrons comprend une couche de blocage de trous, une couche de transport d'électrons,
une couche d'injection d'électrons, ou toute combinaison de celles-ci.

13. Dispositif électroluminescent organique selon la revendication 12, dans lequel le composé organométallique est compris dans la couche d'émission.

14. Dispositif électroluminescent organique selon la revendication 13, dans lequel
la couche d'émission émet de la lumière verte ; et/ou
dans lequel
la couche d'émission comprend en outre un hôte et la quantité de l'hôte est supérieure à la quantité du composé organométallique.

15. Appareil électronique, comprenant le dispositif électroluminescent organique selon l'une quelconque des revendications 12 à 14.
